(19) Europäisches Patentamt
European Patent Office
Office européen des brevets

(11) EP 4 764 626 A1

(12) EUROPEAN PATENT APPLICATION

(43) Date of publication:
**24.06.2026 Bulletin 2026/26**

(21) Application number: **25224216.9**

(22) Date of filing: **17.12.2025**

(51) International Patent Classification (IPC):
***G02B 5/18*** (2006.01) ***G02B 5/30*** (2006.01)

(52) Cooperative Patent Classification (CPC):
**G02B 5/1833; G02B 5/3016; G02B 5/3083**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **20.12.2024 EP 24222095**

(71) Applicant: **Merck Patent GmbH**
**64293 Darmstadt (DE)**

(72) Inventors:
- **Mulcahy, Stephen**
  **FELTHAM, TW14 8HA (GB)**
- **Wyatt, Peter**
  **FELTHAM, TW14 8HA (GB)**
- **Parri, Owain Llyr**
  **FELTHAM, TW14 8HA (GB)**

(74) Representative: **Merck Patent Association**
**Merck Patent GmbH**
**64271 Darmstadt (DE)**

(54) **DIFFRACTIVE OPTICAL ELEMENT**

(57) The invention relates to a diffractive optical element comprising at least one achromatic half-wave plate and at least one chromatic half-wave plate, each half-wave plate comprising at least two layers of a polymerized chiral liquid crystal (LC) material on a substrate, wherein at least one of the substrates has a periodic surface grating, a method for its preparation, and its use in optical or electrooptical components or devices, especially for digital optics or augmented reality or virtual reality (AR/VR) applications like non-mechanical beam steering elements, optical waveguides, optical couplers, optical combiners, optical deflectors, polarization beam splitters, partial mirrors or lenses.

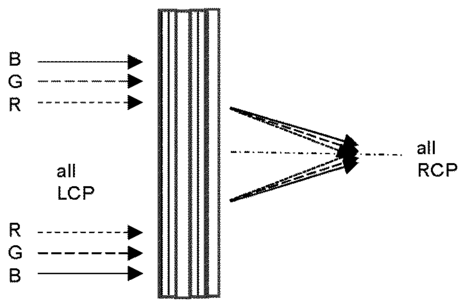


**305**

**e)**

**Fig.** 3

EP 4 764 626 A1

## Description

Technical Field of the Invention

The invention relates to a diffractive optical element comprising at least one achromatic half-wave plate and at least one chromatic half-wave plate, each half-wave plate comprising at least two layers of a polymerized chiral liquid crystal (LC) material on a substrate, wherein at least one of the substrates contains a periodic surface grating, a method for its preparation, and its use in optical or electrooptical components or devices, especially for digital optics or augmented reality or virtual reality (AR/VR) applications like non-mechanical beam steering elements, optical waveguides, optical couplers, optical combiners, optical deflectors, polarization beam splitters, partial mirrors or lenses.

Background and Prior Art

Waveplates like half-wave plates (HWP, HWF) and quarter-wave plates (QWP, QWF) are important components in the field of digital optics. They are suitable for use in Pancharatnam-Berry (PB) optical elements (PBOEs), also known as cycloidal diffractive waveplates, as described for example in Yun-Han Lee et al., Opt. Data Process. Storage; 3, 79-88 (2017). The PBOEs can be designed as patterned waveplates, e.g. patterned HWPs, where the director profile continuously changes as a function across the X-Y plane. The PBOEs include, e.g., PB lenses (PBL) and PB gratings (PBG) or PB deflectors (PBD). In a PBL, typically the director continuously changes along a radial axis in a parabolic fashion, whereas in a PBG or PBD typically the director profile changes linearly in a longitudinal direction.

PBOEs such as PBLs or PBGs are suitable for use in or as optical waveguides for augmented reality (AR), virtual reality (VR) or extended reality (XR) headsets or other AR/VR devices, head-up-displays or other automotive display devices. They can be active devices made from LC materials such as LC mixtures which can be electrically switched. Alternatively they can be static devices made from polymerizable LCs, also known as reactive mesogens (RMs), to provide thin lenses and gratings on plastic substrates. These RM films are advantageous due to their high versatility, easier manufacturing process and usually higher mechanical and chemical stability.

The control of the polarization state of the light is very important in such applications. For a ray of light with specific wavelength ranges, the polarization conversions must be perfect for a red, green and blue (RGB) colors as the light ray goes through an optical stack. Normally this is done using negative dispersion type materials but these are only passably good at green and blue wavelengths. The red wavelengths generally do not have good polarization conversion to the required polarization state.

Also, it has been found that waveplates utilising a single RM film have issues with chromaticity due to the optical dispersion of the RMs. Thus, an RM film with a thickness designed to be effective as HWP for a specific wavelength will not act as HWP for all other wavelengths, resulting in light leakage. As mentioned above, one way to improve this light leakage is to use a negative dispersion RM film. This has advantages in that a single film can compensate across the blue and green areas of the visible spectrum. However there is always a trade off in the red wavelengths as the dispersion flattens in this area. While the green and blue regions of the visible spectrum will show low light leakage, the red region of the visible spectrum will leak through the device which is unwanted. Moreover, the individual RM singles used in negative dispersion RM films are very expensive and of low birefringence. This makes a HWP made from a negative dispersion RM film prohibitively expensive.

It is known in prior art that by utilising multi-twist retarders comprising multiple layers of CLC RM films it is possible to improve the achromaticity compared to even a negative dispersion RM film. However, using this approach, usually three or more layers are required to achieve good achromaticity across the visible spectrum.

For example, Z. Luo et al., Light: Science & Applications (2023)12:230 describe an achromatic diffractive LC optical element which should compensate the chromatic aberration that causes different diffraction angles for the different colors of RGB lights, and thereby should reduce the lateral color shift. The LC optical element consists of three PBOE films stacked together. The first component is a broadband PBL which is effective to all the RGB wavelengths but provides different optical powers to the input RGB beams. As a result a chromatic aberration occurs since the red light experiences the highest optical power and the blue light the lowest one, and the polarization states of the RGB light are reversed from left-handed circular polarized (LCP) to right-handed circular polarized (RCP). The second component is an unpatterned blue HWP (B HWP) placed after the broadband PBL, which is designed to only convert the polarization state of the blue light back from RCP to LCP but without causing effect to the red and green lights. The third component is a red/bue BL (RB PBL), which is effective only for the red and blue lights, and diverges the red light while converging the blue light. By stacking these three components together an achromatic LC diffractive optical element is reported to be achieved.

Z. Luo et al. further describe that the individual components are each made from RM layers provided on a photoalignment layer to induce the desired LC director orientation. The RM layers for the broadband PBL and the RB PBL additionally contain a chiral dopant to induce a twisted structure. The broadband PBL has a multi-twist structure induced by the interference pattern of the respective photoalignment layer.

The RM layer for the B HWP shows a uniform, untwisted structure. The individual RM layers are UV photopolymerized to fix the respective orientation.

To produce such a multilayer PBOE, multiple RM coating steps must be undertaken where the first RM layer is coated on an alignment layer or a patterned substrate, typically a photo-alignment layer (PAL) or lithographically fabricated alignment layer or substrate, e.g. with a PB grating. The RM layer adopts the alignment direction promoted by the alignment layer or substrate and the RM material is cured to give a polymer film. The next layer of RM is then coated directly on top of the previously polymerized RM layer.

However, including so many layers introduces complexity when preparing the multilayer stacks. The process of coating and curing the multiple RM layers can also introduce issues such as dewetting and alignment problems, which will get worse as more layers are added on to the stack.

To achieve good quality alignment, strong intermolecular interactions are necessary to take place between the RM layers to impart the alignment direction from one layer to the next. At the same time, it is necessary for each individual RM layer being coated not to damage the previous RM layer.

Apart of dewetting of the RM materials on the surface of the previous layer, another serious issue is the migration of substances, like for example chiral dopants added to the RM material, from one layer to the next. Such unwanted "chiral migration" can change the desired twist angles in both layers. As a consequence, the lower layers and/or the currently coated layer have to be doped with additional chiral material. This makes the entire production process more complex and difficult to reproduce, and thus not suitable for mass production.

Another problem is undesired spontaneous crystallization which can occur when using an RM material containing a high amount, or consisting entirely, of direactive RMs which tend to be less soluble than monoreactive RMs. Moreover, high amounts of direactive RMs can also negatively impact the alignment quality of the polymerized film.

Therefore, there is still a need for improved waveplates and PBOEs made from RM materials and methods for their production, which can be used as diffractive optical components, especially PBGs, PBDs and PBLs, and show reduced chromaticity across a large part of the visible spectrum. Moreover, there is a need for diffractive deflectors and lenses, especially PBDs and PBLs, which show reduced chromaticity and can be used in optical waveguides for AR, VR or XR devices. These waveplates and PBOEs should not exhibit the drawbacks of prior art materials, methods and films, or if they do so, only exhibit them to a lesser extent, and should be obtainable by simple, time- and cost-effective methods with reproducible quality and large quantity which is compatible for mass production. In particular, there is a need for improved waveplates and PBOEs comprising multiple RM layers deposited onto each other which show high quality alignment and constant optical properties and do not show the drawbacks of RM multilayer stacks of prior art like unwanted spontaneous crystallization, dewetting, or unwanted chiral migration between the RM layers resulting in undesired changes of the twist angle.

One aim of the present invention is to provide improved diffractive optical elements, in particular PBOEs, comprising two or more multilayer RM waveplates and methods for their production,. Another aim of the present invention is to provide improved RM multilayer waveplates and PBOEs with reduced chromaticity comprising them. Other aims of the present invention are immediately evident to the person skilled in the art from the following detailed description.

Surprisingly, the inventors of the present invention have found that one or more of these aims can be achived by providing a diffractive optical element combining two or more RM multilayer waveplates and methods for its preparation as disclosed and claimed hereinafter.

## Summary of the Invention

The invention relates to a diffractive optical element (DOE) comprising

- at least one achromatic half-wave plate (HWP), and
- at least one, preferably two or more, chromatic HWPs,

  wherein each HWP comprises, preferably consists of, a substrate and provided on the substrate two or more cholesteric liquid crystal (CLC) layers, the first CLC layer deposited directly on the substrate and the second and further CLC layers deposited directly onto the respective previous CLC layer,

  wherein each CLC layer consists of a polymerized chiral reactive mesogen (RM) mixture wherein the LC director exhibits a helical twist with a defined twist angle along a helix axis in a thickness direction of the CLC layer, said chiral RM mixture comprising one or more RMs selected from mono-, di- and multireactive RMs, preferably one or more direactive RMs and one or more monoreactive RMs, and further comprising one or more chiral compounds selected from chiral RMs, and a photoinitiator,

wherein in at least one of the achromatic and chromatic HWP the substrate contains a periodic surface grating that induces a rotation of the LC director in an in-plane direction of the first CLC layer, and is preferably a PB deflector or PB lens grating, and

wherein preferably in at least one, very preferably in each, of the chromatic and achromatic HWPs at least two, preferably all, CLC layers have a different twist angle (i.e., a twist angle that is different from the twist angle in the other CLC layers).

The invention further relates to a process of preparing a DOE as described above and below.

The invention further relates to a PB optical element (PBOE), preferably a PB lens or a PB deflector, comprising a DOE as described above and below.

The invention further relates to an individual chromatic or achromatic HWP or grating as described above and below.

The invention further relates to an optical, electronic or electro optical component or device as such, comprising a DOE as described above and below. The invention further relates to an optical, electrooptical or electronic device or a component comprising a DOE as described above and below.

Said components include, without limitation, optical retardation films like quarter-wave plates (QWP) or half-wave plates (HWP), polarizers, optical compensators, reflective films, diffraction or surface gratings such as Bragg polarization gratings (Bragg PG), polarization volume gratings (PVG), polarization volume holograms (PVH), Pancharatnam Berry (PB) gratings, furthermore nonmechanical beam steering elements, optical waveguides, optical couplers, deflectors or combiners, polarization beam splitters, partial mirrors, reflective films, alignment layers, colour filters, antistatic protection sheets, electromagnetic interference protection sheets, lenses for light guides, focusing and optical effects, polarization controlled lenses, PB deflectors, PB lenses and IR reflection films; for example for use in LC displays (LCDs), organic light emitting diodes (OLEDs), autostereoscopic 3D displays, see-through near-eye displays, augmented reality( AR) or virtual reality (VR) systems, switchable windows, spatial light modulators, optical data storage, remote optical sensing, holography, spectroscopy, optical telecommunications, polarimetry or front/back-lighting.

Said devices include, without limitation, electro optical displays, especially LCDs, OLEDs, non-linear optic (NLO) devices, autostereoscopic 3D displays, see-through near-eye displays, head-up-displays, AR/VR systems, goggles for AR/VR applications, switchable windows, spatial light modulators, optical data storage devices, optical sensors, holographic devices, spectrometers, optical telecommunication systems, polarimeters or front-/backlights.

## Brief Description of the Drawings

**Fig. 1a and 1b** exemplarily and schematically illustrate the LC director orientation in a PBOE according to the present invention, the grating pitch being indicated by the bold black lines, with (a) the pitch being constant across the area, corresponding to a PB grating or PB deflector, and (b) the pitch increasing radially symmetric for the centre, corresponding to a PB lens.

**Fig. 2** exemplarily and schematically illustrates a DOE according to the present invention which functions as an achromatic PBD, comprising an achromatic HWP (201), a blue HWP (202), a red & blue HWP (203), and a red HWP (204), all as described above and below, wherein the achromatic HWP and the RB HWP each contain a substrate containing a PB deflector grating. The arrows indicate incident circularly polarized red (R, dotted line), green (G, dashed line), and blue (B, solid line) light, respectively. The angles $\alpha_{R,G,B}$ indicate the deflection angle of the red, green and blue light, respectively, relative to the normal direction of incidence. The polarization state of the respective coloured light is given as RCP (right handed circularly polarized) or LCP (left-handed circularly polarized).

**Fig. 3a-e** exemplarily and schematically illustrates a DOE (305) according to the present invention which functions as an achromatic PBL, comprising an achromatic HWP (301), a blue HWP (302), a red & blue HWP (303), and a red HWP (304), all as described above and below, wherein the achromatic HWP and the RB HWP each contain a substrate containing a PB lens grating. The arrows indicate incident circularly polarized red (R, dotted line), green (G, dashed line), and blue (B, solid line) light, respectively, incidence. The polarization state of the respective coloured light is given as RCP (right handed circularly polarized) or LCP (left-handed circularly polarized).

## Terms and Definitions

As used herein, the term "diffractive" refers to optical components and devices that manipulate light through the

principle of diffraction. In diffractive liquid crystal lenses and gratings, a spatially varying phase profile is created across the lens aperture by modulating the orientation of liquid crystal molecules using an applied electric field. This modulation introduces specific phase delays to different portions of the incoming light waves. As a result, the light exhibits constructive and destructive interference patterns, allowing the lens or grating to focus, shape or guide the light via diffraction. These components and devices affect light not by bending rays through changes in refractive index, but by controlling the interference of light waves to achieve the desired optical effect.

As used herein, the term "achromatic" in connection with an optical element such as a waveplate or a lens means that optical element has substantially the same effect on all of R, G and B lights. In contrast, the term "chromatic" in connection with an optical element, such as a waveplate or a lens, means that optical element has different effects on at least two of R, G and B lights.

The term "achromatic waveplate" means a waveplate which is effective, e.g., acting as a quarter-wave plate, half-wave plate or full-wave plate, upon each of R, G and B light. The term "chromatic waveplate" means a waveplate which is effective, e.g., acting as a quarter-wave plate, half-wave plate or full-wave plate, only on one or more, but not all, of R, G and B light, and a different effect on the other(s) of R, G and B light.

The term "broadband deflector/lens/PBD/PBL, PB-HWP" means a deflector, lens, PBD, PBL or PB-HWP which deflects or converges/diverges all of R, G and B, but may deflect or converge/diverge one or more of R, G and B light at different angles.

In case of an PB-HWP comprising an HWP provided on a PB deflector or PB lens grating, even if the HWP is an achromatic HWP, i.e., which is effective as HWP on all of R, G and B light, the resulting PB-HWP may still be chromatic in the sense that it deflects or converges/diverges one or more of R, G and B light at different angles. For the avoidance of doubt, such a component is therefore hereinafter referred to as "broadband PB-HWP/PBD/PBL".

The term "achromatic deflector/lens/PBD/PBL/PB-HWP" means a deflector, lens, PBD, PBL or PB-HWP which deflects or converges/diverges all of R, G and B at substantially the same angle or to the same focal point.

Unless stated otherwise, the optical elements as described hereinafter and as disclosed in the examples are optimized for the wavelengths of "red (R)" light being in the range from 630 to 670nm, preferably 650$\pm$10nm, "green (G)" light being in the range from 500 to 540nm, preferably 520$\pm$10nm, and "blue (B)" light being in the range from 430 to 470nm, preferably 450$\pm$10nm. For other wavelengths the optical elements can be adapted and/or optimized accordingly.

As used herein, "LCP" means left-handed circularly polarized light, "RCP" means right-handed circularly polarized light, "LxP" means linearly polarized light wherein the polarization plane is parallel to the x direction, "LyP" means linearly polarized light wherein the polarization plane is parallel to the y direction and "LzP" means linearly polarized light wherein the polarization plane is parallel to the z direction.

Throughout the description and claims of this specification, the words "comprise" and "contain" and variations of the words, for example "comprising" and "comprises", mean "including but not limited to", and are not intended to (and do not) exclude other components.

Unless the context clearly indicates otherwise, as used herein plural forms of the terms herein are to be construed as including the singular form and vice versa.

The term "film" as used herein includes rigid or flexible, self-supporting or freestanding films with mechanical stability, as well as coatings or layers on a supporting substrate or between two substrates.

The term "multilayer" (as opposed to monolithic) means a waveplate or film which is consisting of a multiple layers of a specific material, like for example a polymerized chiral RM mixture as described above and below.

As used herein, the terms "reactive mesogen" and "RM" will be understood to mean a compound containing a mesogenic or liquid crystalline skeleton, and one or more functional groups attached thereto, optionally via spacer groups, which are suitable for polymerization and are also referred to as "polymerizable group" or "P".

Unless stated otherwise, the term "polymerizable compound" as used herein will be understood to mean a polymerizable monomeric compound.

Polymerizable compounds or RMs with one polymerizable group are also referred to as "monoreactive" compounds, polymerizable compounds or RMs with two polymerizable groups as "direactive" compounds, and polymerizable compounds or RMs with more than two polymerizable groups as "multireactive" compounds. Compounds without a polymerizable group are also referred to as "non-reactive" compounds.

The terms "liquid crystal", "mesogen" and "mesogenic compound" as used herein mean a compound that under suitable conditions of temperature, pressure and concentration can exist as a mesophase or in particular as a LC phase.

The term "clearing point" means the temperature at which the transition between the mesophase with the highest temperature range and the isotropic phase occurs.

The term "mesogenic group" as used herein is known to the person skilled in the art and described in the literature, and means a group which, due to the anisotropy of its attracting and repelling interactions, essentially contributes to causing a liquid-crystal (LC) phase in low-molecular-weight or polymeric substances. Compounds containing mesogenic groups (mesogenic compounds) do not necessarily have to have an LC phase themselves. It is also possible for mesogenic compounds to exhibit LC phase behaviour only after mixing with other compounds and/or after

polymerization. Typical mesogenic groups are, for example, rigid rod- or disc-shaped units. An overview of the terms and definitions used in connection with mesogenic or LC compounds is given in Pure Appl. Chem. 2001, 73(5), 888 and C. Tschierske, G. Pelzl, S. Diele, Angew. Chem. 2004, 116, 6340-6368.

The term "spacer group", hereinafter also referred to as "Sp", as used herein is known to the person skilled in the art and is described in the literature, see, for example, Pure Appl. Chem. 2001, 73(5), 888 and C. Tschierske, G. Pelzl, S. Diele, Angew. Chem. 2004, 116, 6340-6368. As used herein, the terms "spacer group" or "spacer" mean a flexible group, for example an alkylene group, which connects the mesogenic group and the polymerizable group(s) in a polymerizable mesogenic compound.

As used herein, the term "RM mixture" means a mixture comprising one or more, preferably two or more, more preferably two to ten, very preferably two to six RMs.

As used herein, the term "RM formulation" means at least one RM or RM mixture, and one or more other materials added to the at least one RM or RM mixture to provide, or to modify, specific properties of the RM formulation and/or of the at least one RM therein. It will be understood that an RM formulation is also a vehicle for carrying the RM to a substrate to enable the forming of layers or structures thereon. Exemplary materials include, but are not limited to, solvents, polymerization initiators, surfactants and adhesion promoters, etc. as described in more detail below.

As used herein, the term "polymerized (chiral) RM mixture" means the polymerization product of an RM mixture, which is obtainable for example by a polymerization process, especially a photopolymerization process, as described above or below, preferably in its aligned LC phase, whereas, unless stated otherwise, the ingredients of the RM mixture, like the mono-, di- or multireactive RMs, chiral dopants, photoinitiators or other additives, and their concentrations refer to the RM mixture before polymerization.

Unless stated otherwise, the percentage of a compound in an RM mixture as given above and below means % by weight of the total RM mixture, excluding solvents or additives as described above and below that are used in the RM formulation.

Unless stated otherwise, the percentage of a compound in an RM formulation as given above and below means % by weight of all solids in the RM formulation, including liquid additives as described below but excluding solvents.

The term "per- and/or polyfluoroalkyl substance (PFAS)" as used herein (following the definition by the OECD) means a substance or compound that contains at least one fully fluorinated methyl or methylene C atom (without any H/Cl/Br/I atom attached to it), i.e., a compound with at least one $CF_3$ or $CF_2$ group.

The expression "polyfluorinated alkyl or aryl group" as used herein means an alkyl or aryl group which is substituted by two or more F atoms (wherein the F atoms may be attached either to the same or different C atoms), thus including perfluorocarbon groups.

As used herein, the term "polymer" will be understood to mean a molecule that encompasses a backbone of one or more distinct types of repeating units (the smallest constitutional unit of the molecule) and is inclusive of the commonly known terms "oligomer", "copolymer", "homopolymer" and the like. Further, it will be understood that the term polymer is inclusive of, in addition to the polymer itself, residues from initiators, catalysts, and other elements attendant to the synthesis of such a polymer, where such residues are understood as not being covalently incorporated thereto. Further, such residues and other elements, while normally removed during post polymerization purification processes, are typically mixed or co-mingled with the polymer such that they generally remain with the polymer when it is transferred between vessels or between solvents or dispersion media.

The term "polymerization" means the chemical process to form a polymer by bonding together multiple polymerizable groups or polymer precursors (polymerizable compounds) containing such polymerizable groups.

The term "chiral" in general is used to describe an object that is non-superimposable on its mirror image.

"Achiral" (non- chiral) objects are objects that are identical to their mirror image.

The terms "chiral nematic" and "cholesteric" are used synonymously in this application, unless explicitly stated otherwise.

The term "isomerizable / photoisomerizable compound" means a compound comprising one or more isomerizable or photoisomerizable groups, respectively.

The term "isomerizable group" means a functional group of a molecule that causes a change of the geometry of the molecule, i.e. isomerization, either by bond rotation, skeletal rearrangement or atom- or group- transfer, or by dimerization, which can be induced, e.g., thermally or photochemically or by adding a catalyst.

The term "photoisomerizable group" means a functional group of a molecule that causes a change of the geometry of the molecule, i.e. isomerization, either by bond rotation, skeletal rearrangement or atom- or group- transfer, or by dimerization, upon irradiation with light of a suitable wavelength that can be absorbed by the molecule (photoisomerization).

Examples of photoisomerizable groups are -C=C- double bonds and azo groups (-N=N-). Examples of molecular structures and sub-structures comprising such photoisomerizable groups are stilbene, (1,2-difluoro-2-phenyl-vinyl)-benzene, cinnamate, $\alpha$-cyanocinnamate, 4-phenylbut-3-en-2-one, Schiff base (i.e., a group $R^iR^{ii}C=NR^{iii}$, wherein $R^{iii}$ is different from H, and is for example alkyl or aryl), 2-benzyliden-1-indanone, chalcone, coumarin, chromone, pentalenone

and azobenzene.

A chiral RM mixture in accordance with the present invention can be prepared, for example, by doping a host mixture comprising one or more RMs with a chiral compound having a high twisting power.

The pitch p (in nm) of the induced cholesteric helix, hereinafter also referred to as "chiral pitch" or "helical pitch", is then given by the concentration c (in %) and the helical twisting power HTP (in $nm^{-1}$) of the chiral compound in accordance with the following equation:

$$p = (HTP\ c)^{-1}$$

A low value of the pitch is hereinafter also referred to as "short pitch", and a high value of the pitch is hereinafter also referred to as "long pitch". A short pitch corresponds to a highly twisted structure, i.e., a higher twist angle, and a long pitch corresponds to a slowly twisted structure, i.e., a lower twist angle, around the helix axis within a given distance.

The twist angle, θ, through a thickness, d, is defined by the following equation:

$$\theta = \frac{(360 * d)}{p}$$

where p is the pitch as defined above.

In case more than one chiral compound is used, the total HTP of the chiral compounds having the same configuration or twist sense ($HTP_{total}$) holds then approximately the following equation:

$$HTP_{total} = \sum_i c_i\, HTP_i$$

wherein $c_i$ is the concentration of each individual chiral compound and $HTP_i$ is the helical twisting power of each individual chiral compound.

The HTP of all chiral compounds within a mixture of different configurations or different twist sense ($IHTP_\Delta I$) holds then approximately the following equation:

$$IHTP_\Delta I = (\sum_s c_s\, HTP_s) - ((\sum_r c_r\, HTP_r)$$

wherein $c_s$ is the concentration of each individual chiral compound with S configuration, $HTP_s$ is the helical twisting power of each individual chiral compound having S configuration and wherein $c_r$ is the concentration of each individual chiral compound with R configuration and $HTP_R$ is the helical twisting power of each individual chiral compound having R configuration.

The birefringence Δn is defined as follows

$$\Delta n = n_e - n_o$$

wherein $n_e$ is the extraordinary refractive index and $n_o$ is the ordinary refractive index, and the effective average refractive index $n_{av.}$ is given by the following equation:

$$n_{av.} = ((2n_o^2 + n_e^2)/3)^{1/2}$$

The average refractive index $n_{av.}$ and the ordinary refractive index $n_o$ can be measured using an Abbe refractometer. Δn can then be calculated from the above equations.

The central wavelength λ and bandwidth Δλ of a reflectance band of cholesteric RM or LC material or a cholesteric polymer film are given by the pitch p of the cholesteric helix, the average refractive index $n_{av.}$ and the birefringence Δn of the cholesteric liquid crystal in accordance with the following equations:

$$\lambda = n_{av.} \cdot p$$

$$\Delta\lambda = \Delta n \cdot p$$

The term "visible light" means electromagnetic radiation with a wavelength in a range from about 400 nm to about 740 nm. "Ultraviolet (UV) light" means electromagnetic radiation with a wavelength in a range from about 200 nm to about 450 nm.

According to the present application, the term "linearly polarized light" means light, which is at least partially linearly polarized. Preferably, the aligning light is linearly polarized with a degree of polarization of more than 5:1. Wavelengths, intensity and energy of the linearly polarised light are chosen depending on the photosensitivity of the photoalignable material. Typically, the wavelengths are in the UV-A, UV-B and/or UV-C range or in the visible range. Preferably, the linearly polarised light comprises light of wavelengths less than 450 nm, more preferably less than 420 nm at the same time the linearly polarised light preferably comprises light of wavelengths longer than 280nm, preferably more than 320nm, more preferably over 350nm.

The Irradiance ($E_e$) or radiation power is defined as the power of electromagnetic radiation (dθ) per unit area (dA) incident on a surface:

$$E_e = d\theta/dA.$$

The radiant exposure or radiation dose ($H_e$), is as the irradiance or radiation power ($E_e$) per time (t):

$$H_e = E_e \cdot t.$$

On the molecular level, the birefringence of a liquid crystal depends on the anisotropy of the polarizability ($\Delta\alpha=\alpha_{\parallel} -\alpha\perp$). "Polarisability" means the ease with which the electron distribution in the atom or molecule can be distorted. The polarizability increases with greater number of electrons and a more diffuse electron cloud. The polarizability can be calculated using a method described in e.g. Jap. J. Appl. Phys. 42, (2003) p. 3463.

The "optical retardation" at a given wavelength R(λ) (in nm) of a layer of liquid crystalline or birefringent material is defined as the product of birefringence at that wavelength Δn(λ) and layer thickness d (in nm) according to the following equation:

$$R(\lambda) = \Delta n(\lambda) \cdot d$$

The optical retardation R represents the difference in the optical path lengths in nanometres travelled by S-polarised and P-polarised light whilst passing through the birefringent material. "On-axis" retardation means the retardation at normal incidence to the sample surface.

The retardation (R(λ)) of a material can be measured using a spectroscopic ellipsometer, for example the M2000 spectroscopic ellipsometer manufactured by J. A. Woollam Co. This instrument can measure the optical retardance in nanometres of a birefringent sample e.g., Quartz over a range of wavelengths typically, 370nm to 2000nm. From this data it is possible to calculate the dispersion (R(450)/R(550) or Δn(450)/Δn(550)) of a material.

A method for carrying out these measurements was presented at the National Physics Laboratory (London, UK) by N. Singh in October 2006 and entitled "Spectroscopic Ellipsometry, Part1-Theory and Fundamentals, Part 2 - Practical Examples and Part 3 - measurements". In accordance with the measurement procedures described Retardation Measurement (RetMeas) Manual (2002) and Guide to WVASE (2002) (Woollam Variable Angle Spectroscopic Ellipsometer) published by J. A. Woollam Co. Inc (Lincoln, NE, USA). Unless stated otherwise, this method is used to determine the retardation of the materials, films and devices described in this invention.

The term "director" is known in prior art and means the preferred orientation direction of the long molecular axes (in case of calamitic compounds) or short molecular axes (in case of discotic compounds) of the liquid-crystalline or RM molecules. In case of uniaxial ordering of such anisotropic molecules, the director is the axis of anisotropy.

The term "alignment" or "orientation" relates to alignment (orientational ordering) of anisotropic units of material such as small molecules or fragments of big molecules in a common direction named "alignment direction". In an aligned layer of liquid-crystalline or RM material the liquid-crystalline director coincides with the alignment direction so that the alignment direction corresponds to the direction of the anisotropy axis of the material.

The terms "uniform orientation" or "uniform alignment" of an liquid-crystalline or RM material, for example in a layer of the material, mean that the long molecular axes (in case of calamitic compounds) or the short molecular axes (in case of discotic compounds) of the liquid-crystalline or RM molecules are oriented substantially in the same direction. In other words, the lines of liquid-crystalline director are parallel.

The terms "homeotropic structure / alignment / orientation" refer to a film wherein the optical axis is substantially perpendicular to the film plane.

The terms "planar structure /alignment / orientation" refer to a film wherein the optical axis is substantially parallel to the film plane.

The terms "helical twist " refers to a CLC or chiral RM layer/film wherein the optical axis and the LC director are helically twisted along a helix axis in a thickness direction, that is a direction perpendicular to the layer/film plane, which also includes an orientation where the helix axis is tilted at a tilt angle relative to the direction perpendicular to the layer/film

plane. Unless stated otherwise, values of the twist angle as given above and below refer to the helical twist in the thickness direction or tilted thereto.

All temperatures, such as, for example, the melting point T(C,N) or T(C,S), the transition from the smectic (S) to the nematic (N) phase T(S,N) and the clearing point T(N,I) of the liquid crystals, are quoted in degrees Celsius. All temperature differences are quoted in differential degrees.

In case of doubt the definitions as given in C. Tschierske, G. Pelzl and S. Diele, Angew. Chem. 2004, 116, 6340-6368 shall apply.

If in the formulae shown above and below a group R, including any variations thereof such as $R^1$, $R^0$, $R^{00}$, $R^{0*}$, $R^{11}$, $R^*$, $R^{**}$, $R^C$, $R^3$, $R^4$ etc., or L denotes an alkyl radical and/or an alkoxy radical, this may be straight-chain or branched. It is preferably straight-chain, has 2, 3, 4, 5, 6 or 7 C atoms and accordingly preferably denotes ethyl, propyl, butyl, pentyl, hexyl, heptyl, ethoxy, propoxy, butoxy, pentoxy, hexyloxy or heptyloxy, furthermore methyl, octyl, nonyl, decyl, undecyl, dodecyl, tridecyl, tetradecyl, pentadecyl, methoxy, octyloxy, nonyloxy, decyloxy, undecyloxy, dodecyloxy, tridecyloxy or tetradecyloxy.

If in the formulae shown above and below a group R including any variations thereof such as $R^1$, $R^0$, $R^{00}$, $R^{*0}$, $R^{11}$, $R^{22}$, $R^C$, $R^3$, $R^4$ etc., or L denotes an alkyl radical and/or an alkoxy radical, this may be straight-chain or branched. It is preferably straight-chain, has 2, 3, 4, 5, 6 or 7 C atoms and accordingly preferably denotes ethyl, propyl, butyl, pentyl, hexyl, heptyl, ethoxy, propoxy, butoxy, pentoxy, hexyloxy or heptyloxy, furthermore methyl, octyl, nonyl, decyl, undecyl, dodecyl, tridecyl, tetradecyl, pentadecyl, methoxy, octyloxy, nonyloxy, decyloxy, undecyloxy, dodecyloxy, tridecyloxy or tetradecyloxy.

If in the formulae shown above and below a group R including any variations thereof such as $R^1$, $R^0$, $R^{00}$, $R^{0*}$, $R^{11}$, $R^{22}$, $R^C$, $R^3$, $R^4$etc., or L denotes an alkyl radical wherein one or more $CH_2$ groups are replaced by S, this may be straight-chain or branched. It is preferably straight-chain, has 1, 2, 3, 4, 5, 6 or 7 C atoms and accordingly preferably denotes thiomethyl, thioethyl, thiopropyl, thiobutyl, thiopentyl, thiohexyl or thioheptyl.

Oxaalkyl preferably denotes straight-chain 2-oxapropyl (= methoxymethyl), 2-oxabutyl (= ethoxymethyl) or 3-oxabutyl (= 2-methoxyethyl), 2-, 3- or 4-oxapentyl, 2-, 3-, 4- or 5-oxahexyl, 2-, 3-, 4-, 5- or 6-oxaheptyl, 2-, 3-, 4-, 5-, 6- or 7-oxaoctyl, 2-, 3-, 4-, 5-, 6-, 7- or 8-oxanonyl, 2-, 3-, 4-, 5-, 6-, 7-, 8- or 9-oxadecyl.

If in the formulae shown above and below a group R including any variations thereof such as $R^1$, $R^0$, $R^{00}$, $R^{*0}$, $R^{11}$, $R^{22}$, $R^C$, $R^3$, $R^4$ etc., or L denotes an alkoxy or oxaalkyl group it may also contain one or more additional oxygen atoms, provided that oxygen atoms are not linked directly to one another.

In another preferred embodiment, one or more of R including any variations thereof such as $R^1$, $R^0$, $R^{00}$, $R^{*0}$, $R^{11}$, $R^{22}$, $R^C$, $R^3$, $R^4$ etc., or L are selected from the group consisting of

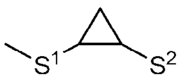 , 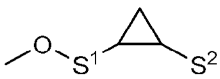 , 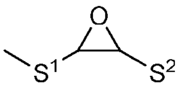 , 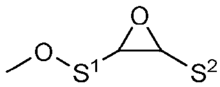 ,

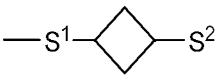 , 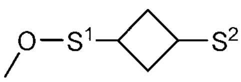 , 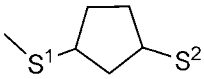 , 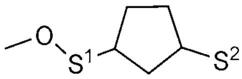 ,

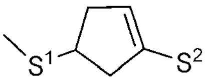 , 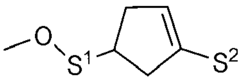 , 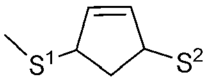 , 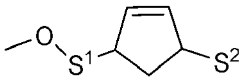 ,

$-S^1-F$, $-O-S^1-F$, $-O-S_1-O-S_2$, wherein $S^1$ is $C_{1-12}$-alkylene or $C_{2-12}$-alkenylene and $S^2$ is H, $C_{1-12}$-alkyl or $C_{2-12}$-alkenyl, and very preferably are selected from the group consisting of

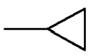 , 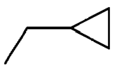 , 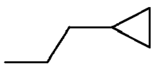 , 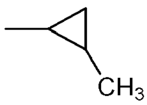 ,

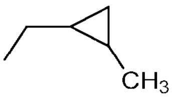 , 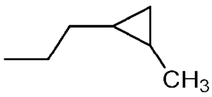 , 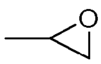 , 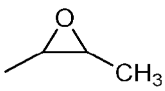 ,

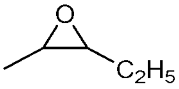, 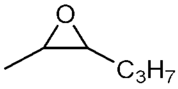, 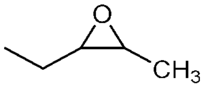, 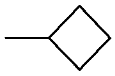,

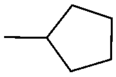, 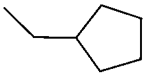, 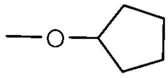, 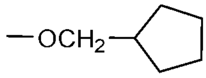,

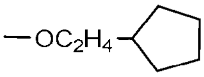, 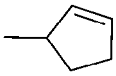, 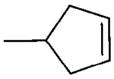, 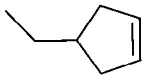,

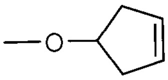, 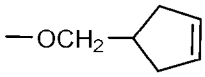, 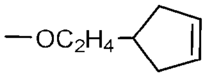.

$-OCH_2OCH_3$, $-O(CH_2)_2OCH_3$, $-O(CH_2)_3OCH_3$, $-O(CH_2)_4OCH_3$, $-O(CH_2)_2F$, $-O(CH_2)_3F$ and $-O(CH_2)_4F$.

If in the formulae shown above and below a group R including any variations thereof such as $R^1$, $R^0$, $R^{00}$, $R^{*0}$, $R^{11}$, $R^{22}$, $R^C$, $R^3$, $R^4$ etc., or L denotes an alkyl radical in which one $CH_2$ group has been replaced by -CH=CH-, this may be straight-chain or branched. It is preferably straight-chain and has 2 to 10 C atoms. Accordingly, it denotes, in particular, vinyl, prop-1- or -2-enyl, but-1-, -2- or -3-enyl,
pent-1-, -2-, -3- or -4-enyl, hex-1-, -2-, -3-, -4- or -5-enyl, hept-1-, -2-, -3-, -4-, -5- or -6-enyl, oct-1-, -2-, -3-, -4-, -5-, -6- or -7-enyl, non-1-, -2-, -3-, -4-, -5-, -6-, -7- or -8-enyl, dec-1-, -2-, -3-, -4-, -5-, -6-, -7-, -8- or -9-enyl.

If in the formulae shown above and below a group R including any variations thereof such as $R^1$, $R^0$, $R^{00}$, $R^{*0}$, $R^{11}$, $R^{22}$, $R^C$, $R^3$, $R^4$ etc., or L denotes an alkyl or alkenyl radical which is at least monosubstituted by halogen, this radical is preferably straight-chain, and halogen is preferably F or Cl. In the case of polysubstitution, halogen is preferably F. The resultant radicals also include perfluorinated radicals. In the case of monosubstitution, the fluorine or chlorine substituent may be in any desired position, but is preferably in the ω-position.

Above and below,

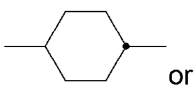 or 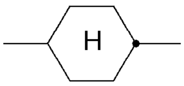

denotes a trans-1,4-cyclohexylene ring, and

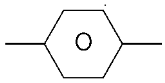

denotes a 1,4-phenylene ring.

Halogen is preferably F or Cl, very preferably F.

The group $-CR^0=CR^{00}-$ is preferably -CH=CH-.
-OC-, -CO-, -C(=O)- and -C(O)- denote a carbonyl group, i.e.

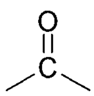.

Preferred substituents L, are, for example, F, Cl, Br, I, -CN, $-NO_2$, -NCO, -NCS, -OCN, -SCN, $-C(=O)N(R^x)_2$, $-C(=O)Y^1$, $-C(=O)R^x$, $-N(R^x)_2$, straight-chain or branched alkyl, alkoxy, alkylcarbonyl, alkoxycarbonyl, alkylcarbonyloxy or alkoxycarbonyloxy each having 1 to 25 C atoms, in which one or more H atoms may optionally be replaced by F or Cl, optionally substituted silyl having 1 to 20 Si atoms, or optionally substituted aryl having 6 to 25, preferably 6 to 15, C atoms, wherein $R^x$ denotes H, F, Cl, CN, or straight chain, branched or cyclic alkyl having 1 to 25 C atoms, wherein one or more non-adjacent $CH_2$-groups are optionally replaced by -O-, -S-, -CO-, -CO-O-, -O-CO-, -O-CO-O- in such a manner that O- and/or S-atoms are not directly connected with each other, and wherein one or more H atoms are each optionally replaced by F, Cl, P- or P-Sp-, and $Y^1$ denotes halogen.

Particularly preferred substituents L are, for example, F, Cl, CN, $NO_2$, $CH_3$, $C_2H_5$, $OCH_3$, $SCH_3$, $OC_2H_5$, $SC_2H_5$, $COCH_3$, $COC_2H_5$, $COOCH_3$, $COOC_2H_5$, $CF_3$, $OCF_3$, $OCHF_2$, $OC_2F_5$, furthermore phenyl.

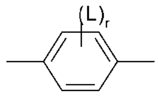

is preferably

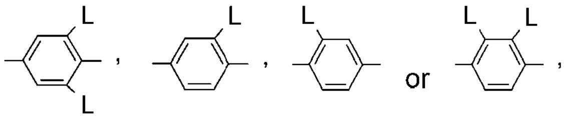

in which L has one of the meanings indicated above.

Throughout the application, the term "aryl and heteroaryl groups" encompass groups, which can be monocyclic or polycyclic, i.e. they can have one ring (such as, for example, phenyl) or two or more rings, which may also be fused (such as, for example, naphthyl) or covalently linked (such as, for example, biphenyl), or contain a combination of fused and linked rings. Heteroaryl groups contain one or more heteroatoms, preferably selected from O, N, S and Se. Particular preference is given to mono-, bi- or tricyclic aryl groups having 6 to 25 C atoms and mono-, bi- or tricyclic heteroaryl groups having 2 to 25 C atoms, which optionally contain fused rings, and which are optionally substituted. Preference is furthermore given to 5 , 6 or 7-membered aryl and heteroaryl groups, in which, in addition, one or more CH groups may be replaced by N, S or O in such a way that O atoms and/or S atoms are not linked directly to one another. Preferred aryl groups are, for example, phenyl, biphenyl, terphenyl, [1,1':3',1"]¬¬terphenyl-2'-yl, naphthyl, anthracene, binaphthyl, phenanthrene, pyrene, dihydropyrene, chrysene, perylene, tetracene, pentacene, benzopyrene, fluorene, indene, indenofluorene, spirobifluorene, more preferably 1,4-phenylene, 4,4'-biphenylene, 1, 4-tephenylene.

Preferred heteroaryl groups are, for example, 5 membered rings, such as pyrrole, pyrazole, imidazole, 1,2,3-triazole, 1,2,4-triazole, tetrazole, furan, thiophene, selenophene, oxazole, isoxazole, 1,2 thiazole, 1,3-thiazole, 1,2,3-oxadiazole, 1,2,4 oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 6 membered rings, such as pyridine, pyridazine, pyrimidine, pyrazine, 1,3,5-triazine, 1,2,4-triazine, 1,2,3-triazine, 1,2,4,5-tetrazine, 1,2,3,4-tetrazine, 1,2,3,5-tetrazine, or condensed groups, such as indole, iso-indole, indolizine, indazole, benzimidazole, benzotriazole, purine, naphthimidazole, phenanthrimidazole, pyridimidazole, pyrazinimidazole, quinoxalinimidazole, benzoxazole, naphthoxazole, anthroxazole, phen-anthroxazole, isoxazole, benzothiazole, benzofuran, isobenzofuran, dibenzofuran, quinoline, isoquinoline, pteridine, benzo-5,6-quinoline, benzo-6,7-quinoline, benzo-7,8-quinoline, benzoisoquinoline, acridine, phenothiazine, phenoxazine, benzopyridazine, benzopyrimidine, quinoxaline, phenazine, naphthyridine, azacarbazole, benzocarboline, phenanthridine, phenanthroline, thieno [2,3b]thiophene, thieno[3,2b]-thiophene, dithienothiophene, isobenzothiophene, dibenzothiophene, benzothiadiazothiophene, or combinations of these groups. The heteroaryl groups may also be substituted by alkyl, alkoxy, thioalkyl, fluorine, fluoroalkyl or further aryl or heteroaryl groups.

In a group

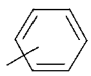

the single bond shown between the two ring atoms can be attached to any free position of the benzene ring.

-OC-, -CO-, -C(=O)- and -C(O)- denote a carbonyl group, i.e.

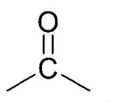

The polymerizable group P, including any variations thereof such as $P^0$, $P^1$, $P^2$, $P^{*0}$, is a group which is suitable for a polymerization reaction, such as, for example, free-radical or ionic chain polymerization, polyaddition or polycondensation, or for a polymer-analogous reaction, for example addition or condensation onto a main polymer chain. Particular preference is given to groups for chain polymerization, in particular those containing a C=C double bond or -C≡C- triple bond, and groups which are suitable for polymerization with ring opening, such as, for example, oxetane or epoxide groups.

Preferred groups P, including any variations thereof such as $P^0$, $P^1$, $P^2$, $P^{*0}$, are selected from the group consisting of $CH_2=CW^1-CO-O-$, $CH_2=CW^1-CO-$,

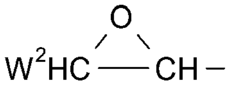, 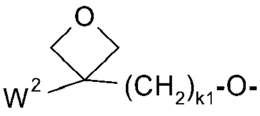,

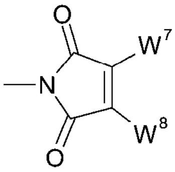, 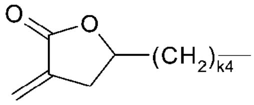, 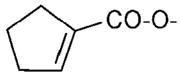,

$CH_2=CW^2-(O)_{k3}-$, $CW^1=CH-CO-(O)_{k3}-$, $CW^1=CH-CO-NH-$, $CH_2=CW^1-CO-NH-$, $CH_3-CH=CH-O-$, $(CH_2=CH)_2CH-OCO-$, $(CH_2=CH-CH_2)_2CH-OCO-$, $(CH_2=CH)_2CH-O-$, $(CH_2=CH-CH_2)_2N-$, $(CH_2=CH-CH_2)_2N-CO-$, $HO-CW^2W^3-$, $HS-CW^2W^3-$, $HW^2N-$, $HO-CW^2W^3-NH-$, $CH^2=CW^1-CO-NH-$, $CH_2=CH-(COO)_{k1}-Phe-(O)_{k2}-$, $CH_2=CH-(CO)_{k1}-Phe-(O)_{k2}-$, Phe-CH=CH-, HOOC-, OCN- and $W^4W^5W^6Si-$, in which $W^1$ denotes H, F, Cl, CN, $CF_3$, phenyl or alkyl having 1 to 5 C atoms, in particular H, F, Cl or $CH_3$, $W^2$ and $W^3$ each, independently of one another, denote H or alkyl having 1 to 5 C atoms, in particular H, methyl, ethyl or n-propyl, $W^4$, $W^5$ and $W^6$ each, independently of one another, denote Cl, oxaalkyl or oxacarbonylalkyl having 1 to 5 C atoms, $W^7$ and $W^8$ each, independently of one another, denote H, Cl or alkyl having 1 to 5 C atoms, Phe denotes 1,4-phenylene, which is optionally substituted by one or more radicals L as defined above which are other than P-Sp-, $k_1$, $k_2$ and $k_3$ each, independently of one another, denote 0 or 1, $k_3$ preferably denotes 1, and $k_4$ denotes an integer from 1 to 10.

Very preferred groups P, including any variations thereof such as $P^0$, $P^1$, $P^2$, $P^{*0}$, are selected from the group consisting of $CH_2=CW^1-CO-O-$, $CH_2=CW^1-CO-$,

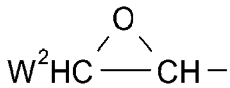, 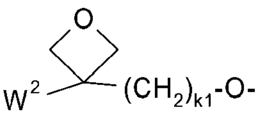,

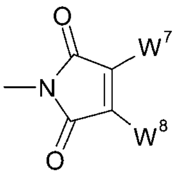, 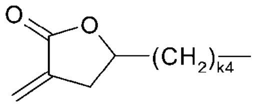, 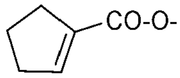,

$CH_2=CW^2-O-$, $CH_2=CW^2-$, $CW^1=CH-CO-(O)_{k3}-$, $CW^1=CH-CO-NH-$, $CH_2=CW^1-CO-NH-$, $(CH_2=CH)_2CH-OCO-$, $(CH_2=CH-CH_2)_2CH-OCO-$, $(CH_2=CH)_2CH-O-$, $(CH_2=CH-CH_2)_2N-$, $(CH_2=CH-CH_2)_2N-CO-$, $CH_2=CW^1-CO-NH-$, $CH_2=CH-(COO)_{k1}-Phe-(O)_{k2}-$, $CH_2=CH-(CO)_{k1}-Phe-(O)_{k2}-$, Phe-CH=CH- and $W^4W^5W^6Si-$ , in which $W^1$ denotes H, F, Cl, CN, $CF_3$, phenyl or alkyl having 1 to 5 C atoms, in particular H, F, Cl or $CH_3$, $W^2$ and $W^3$ each, independently of one another, denote H or alkyl having 1 to 5 C atoms, in particular H, methyl, ethyl or n-propyl, $W^4$, $W^5$ and $W^6$ each, independently of one another, denote Cl, oxaalkyl or oxacarbonylalkyl having 1 to 5 C atoms, $W^7$ and $W^8$ each, independently of one another, denote H, Cl or alkyl having 1 to 5 C atoms, Phe denotes 1,4-phenylene, $k_1$, $k_2$ and $k_3$ each, independently of one another, denote 0 or 1, $k_3$ preferably denotes 1, and $k_4$ denotes an integer from 1 to 10.

Very particularly preferred groups P, including any variations thereof such as $P^0$, $P^1$, $P^2$, $P^{*0}$, are selected from the group consisting of $CH_2=CW^1-CO-O-$, in particular $CH_2=CH-CO-O-$, $CH_2=C(CH_3)-CO-O-$ and $CH_2=CF-CO-O-$, furthermore $CH_2=CH-O-$, $(CH_2=CH)_2CH-O-CO-$,

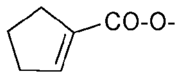,

$(CH_2=CH)_2CH-O-$,

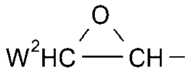

and

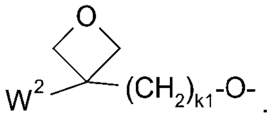

Further preferred polymerizable groups P, including any variations thereof such as $P^0$, $P^1$, $P^2$, $P^{*0}$, are selected from the group consisting of vinyloxy, acrylate, methacrylate, fluoroacrylate, chloroacrylate, oxetane and epoxide, most preferably from acrylate and methacrylate.

In another preferred embodiment of the invention, in a polymerizable compound as disclosed above and below, including compounds of formula I and its subformulae, all polymerizable groups have the same meaning, and preferably denote acrylate or methacrylate, very preferably acrylate.

The spacer group, including any variations thereof such as $Sp^0$, $Sp^1$, $Sp^2$, $Sp^{*0}$, when being different from a single bond, is preferably of the formula Sp"-X", so that the respective radical P-Sp- etc. conforms to the formula P-Sp"-X"-, wherein

Sp" denotes linear or branched alkylene having 1 to 20, preferably 1 to 12, C atoms, which is optionally mono- or polysubstituted by F, Cl, Br, I or CN and in which, in addition, one or more non-adjacent $CH_2$ groups may each be replaced, independently of one another, by -O-, -S-, -NH-, -N($R^0$)-, -Si($R^0R^{00}$)-, -CO-, -COO-, -O-CO-, -O-CO-O-, -S-CO-, -CO-S-, -N($R^{00}$)-CO-O-, -O-CO-N($R^0$)-, -N($R^0$)-CO-N($R^{00}$)-, -CH=CH- or -C≡C- in such a way that O and/or S atoms are not linked directly to one another,

X" denotes -O-, -S-, -CO-, -CO-O-, -O-CO-, -O-CO-O-, -CO-N($R^0$)-, -N($R^0$)-CO-, - N($R^0$)-CO-N($R^{00}$)-, $-OCH_2-$, $-CH_2O-$, $-SCH_2-$, $-CH_2S-$, $-CF_2O-$, $-OCF_2-$, $-CF_2S-$, - $SCF_2-$, $-CF_2CH_2-$, $-CH_2CF_2-$, $-CF_2CF_2-$, -CH=N-, -N=CH-, -N=N-, -CH=$CR^0$-, - $CY^2$=$CY^3$-, -C≡C-, -CH=CH-CO-O-, -O-CO-CH=CH- or a single bond,

$R^0$ and $R^{00}$ each, independently of one another, denote H or alkyl having 1 to 20 C atoms, and

$Y^2$ and $Y^3$ each, independently of one another, denote H, F, Cl or CN.

X" is preferably -O-, -S-, -CO-, -COO-, -OCO-, -O-COO-, -CO-$NR^0$-, -$NR^0$-CO-, -$NR^0$-CO-$NR^{00}$- or a single bond.

Typical spacer groups Sp, including any variations thereof such as $Sp^0$, $Sp^1$, $Sp^2$, $Sp^{*0}$, and -Sp"-X"- are, for example, $-(CH_2)_{p1}-$, $-(CH_2)_{p1}$-O-, $-(CH_2)_{p1}$-O-CO-, $-(CH_2)_{p1}$-CO-O-, - $(CH_2)_{p1}$-O-CO-O-, $-(CH_2CH_2O)_{q1}-CH_2CH_2-$, $-CH_2CH_2-S-CH_2CH_2-$, $-CH_2CH_2-NH-CH_2CH_2-$ or $-(SiR^0R^{00}-O)_{p1}-$, in which p1 is an integer from 1 to 12, q1 is an integer from 1 to 3, and $R^0$ and $R^{00}$ have the meanings indicated above.

Particularly preferred groups Sp, including any variations thereof such as $Sp^0$, $Sp^1$, $Sp^2$, $Sp^{*0}$, and -Sp"-X"- are $-(CH_2)_{p1}-$, $-(CH_2)_{p1}$-O-, $-(CH_2)_{p1}$-O-CO-, $-(CH_2)_{p1}$-CO-O-, $-(CH_2)_{p1}$-O-CO-O-, in which p1 and q1 have the meanings indicated above.

Particularly preferred groups Sp" are, in each case straight-chain, ethylene, propylene, butylene, pentylene, hexylene, heptylene, octylene, nonylene, decylene, undecylene, dodecylene, octadecylene, ethyleneoxyethylene, methyleneoxybutylene, ethylenethioethylene, ethylene-N-methyliminoethylene, 1-methylalkylene, ethenylene, propenylene and butenylene.

In another preferred embodiment of the invention, the polymerizable compounds as disclosed above and below, including compounds of formula D, M, T, A, C1-C3 and their subformulae, contain a spacer group Sp, including any variations thereof such as $Sp^0$, $Sp^1$, $Sp^2$, $Sp^{*0}$, that is substituted by one or more polymerizable groups P, so that the group Sp-P etc. corresponds to $Sp(P)_s$, with s being ≥2 (branched polymerizable groups).

Preferred polymerizable compounds according to this preferred embodiment are those wherein s is 2, i.e., compounds which contain a group $Sp(P)_2$. Very preferred polymerizable compounds according to this preferred embodiment contain a group selected from the following formulae:

-X-alkyl-CHPP    S1

$-X-alkyl-CH((CH_2)_{aa}P)((CH_2)_{bb}P)$    S2

$-X-N((CH_2)_{aa}P)((CH_2)_{bb}P)$ S3

-X-alkyl-CHP-$CH_2$-$CH_2$P S4

-X-alkyl-C($CH_2$P)($CH_2$P)-$C_{aa}H_{2aa+1}$ S5

-X-alkyl-CHP-$CH_2$P S6

-X-alkyl-CPP-$C_{aa}H_{2aa+1}$ S7

-X-alkyl-CHPCHP-$C_{aa}H_{2aa+1}$ S8

in which P is as defined in formula I,

alkyl denotes a single bond or straight-chain or branched alkylene having 1 to 12 C atoms which is unsubstituted or mono- or polysubstituted by F, Cl or CN and in which one or more non-adjacent $CH_2$ groups may each, independently of one another, be replaced by -C($R^0$)=C($R^0$)-, -C≡C-, -N($R^0$)-, -O-, -S-, -CO-, -CO-O-, -O-CO-, -O-CO-O- in such a way that O and/or S atoms are not linked directly to one another, where $R^0$ has the meaning indicated above,

aa and bb each, independently of one another, denote 0, 1, 2, 3, 4, 5 or 6,

X has one of the meanings indicated for X", and is preferably O, CO, $SO_2$, O-CO-, CO-O or a single bond.

Preferred spacer groups $Sp(P)_2$ are selected from formulae S1, S2 and S3.

Very preferred spacer groups $Sp(P)_2$ are selected from the following subformulae:

-CHPP S1a

-O-CHPP S1b

-$CH_2$-CHPP S1c

-$OCH_2$-CHPP S1d

-CH($CH_2$-P)($CH_2$-P) S2a

-OCH($CH_2$-P)($CH_2$-P) S2b

-$CH_2$-CH($CH_2$-P)($CH_2$-P) S2c

-$OCH_2$-CH($CH_2$-P)($CH_2$-P) S2d

-CO-NH($(CH_2)_2$P)($(CH_2)_2$P) S3a

Detailed Description of the Invention

In a DOE according to the present invention, at least one of the HWPs, preferably at least one achromatic HWP, more preferably an achromatic HWP and a chromatic HWP, contain a substrate containing a periodic surface grating or surface pattern.

The surface grating or surface pattern can be prepared by known methods, for example by providing on the substrate a photoalignment layer (PAL) which is patterned by laser interferometry to create a grating pattern with a defined pitch.

Preferably, the surface grating or surface pattern has a defined periodicity which induces a a rotation of the LC director along an in-plane direction of the CLC layer provided thereon, and is preferably a PB deflector or a PB lens grating. These HWPs are hereinafter also shortly referred to as PB-HWPs.

**Fig. 1a and b** exemplarily and schematically illustrate the LC director orientation in a PB-HWP according to the

present invention, the grating pitch being indicated by the bold black lines, with (a) the pitch being constant across the area, corresponding to a PB grating or PB deflector, and (b) the pitch increasing radially symmetric for the centre, corresponding to a PB lens.

The grating pitch can vary depending on the desired function of the PB-HWP. In a preferred embodiment, the patterned alignment layer of the first PB-HWP has a grating pitch from 1 to 5 $\mu$m, very preferably from 1 to 3 $\mu$m, and the patterned alignment layer of the second PB-HWP has a grating pitch from 6 to 15 $\mu$m, very preferably from 8 to 12 $\mu$m.

In another preferred embodiment, the DOE comprises one or more, very preferably two or more, HWPs, preferably chromatic HWP's, which contain a substrate containing an unpatterned, planar alignment layer.

In another preferred embodiment, the DOE according to the present invention additionally comprises one or more quarter-wave plates (QWP) which can be located in front of the first HWP or PB-HWP and/or behind the last HWP or PB-HWP when viewed from the direction of incident light. The QWPs can be made of a CLC multilayer comprising multiple polymerized chiral RM layers as described above and below, or can be selected from standard QWPs which are commercially available.

The individual waveplates, like the HWPs, PB-HWPs, QWPs and other optical element sin a DOE according to the present invention can be stacked together by conventional means and methods known to the skilled person. For example, they can be laminated onto each other or bonded together by adhesive layers, for example being optically bonded by optical clear adhesive (OCA) which is commercially available.

A preferred DOE according to the present invention comprises

- an achromatic HWP comprising, preferably consisting of, a substrate containing a periodic surace grating, and provided on the substrate two or more CLC layers, the first CLC layer deposited directly on the substrate and the second and further CLC layers deposited directly onto the respective previous CLC layer,

- at least one, preferably two or more, chromatic HWP(s), each comprising, preferably consisting of, a substrate containing a planar alignment layer, and provided on the substrate two or more CLC layers, the first CLC layer deposited directly on the substrate and the second and further CLC layers deposited directly onto the respective previous CLC layer,

- optionally a chromatic HWP comprising, preferably consisting of, a substrate containing a periodic surface grating, and provided on the substrate two or more CLC layers, the first CLC layer deposited directly on the substrate and the second and further CLC layers deposited directly onto the respective previous CLC layer,

    wherein each CLC layer consists of a polymerized chiral RM mixture having a helical twist along a helix axis in a thickness direction of the CLC layer, said chiral RM mixture comprising one or more RMs selected from mono-, di- and multireactive RMs, preferably one or more direactive RMs and one or more monoreactive RMs, and further comprising one or more chiral compounds selected from chiral RMs, and a photoinitiator,

    wherein preferably in at least one, very preferably in each, of the chromatic and achromatic HWPs at least two, preferably all, CLC layers have a different twist angle,

    and wherein the periodic surface grating induces a rotation of the LC director in an in-plane direction of the first CLC layer, and is preferably a PB deflector grating or a PB lens grating.

Preferably the chromatic PB-HWP is a half-wave plate for one or more, preferably two, of red, green and blue light, very preferably for red and blue light.

A first preferred embodiment of the present invention relates to a DOE comprising, in the following sequence viewed from the direction of incident light:

- a first, achromatic HWP being effective for all of red (R), green (G) and blue (B) light,

- a second, chromatic HWP being effective only for one of R, G and B light, preferably for B light, but not for the others of RGB light, prefrably not for R or G light,

- a third, chromatic HWP, being effective for R and B light but not for G light,

- a fourth, chromatic HWP being effective only for one of RGB light, preferably for R light, but not for the others of RGB light, preferably not for G or B light,

wherein each of the first, second, third and fourth HWP comprise two or more CLC layers, the first CLC layer deposited directly on a substrate, and the second and further CLC layers deposited directly onto the respective previous CLC layer,

and wherein each CLC layer consists of a polymerized chiral RM mixture having a helical twist along a helix axis in a thickness direction of the CLC layer, said chiral RM mixture comprising one or more direactive RMs, one or more monoreactive RMs, one or more chiral compounds selected from chiral RMs, and a photoinitiator,

and wherein the substrate of the first and third HWP contains a PB deflector grating, and the substrate of the second and fourth HWPs has a planar alignment layer.

**Fig. 2** exemplarily and schematically illustrates a DOE according to this first preferred embodiment, which functions as achromatic PBD, comprising a broadband PB-HWP (201), a blue (B) HWP (202), a red & blue (RB) PB-HWP (203), and a red (R) HWP (204), as described above and below, wherein the broadband PB-HWP and the RB PB-HWP contain a substrate containing a PB deflector grating. The arrows indicate incident circularly polarized red (R, solid line), green (G, dashed line), and blue (B, dotted line) light, respectively. The angle $\alpha_{R,G,B}$ indicates the deflection angle of the red, green and blue light, respectively, relative to the normal direction of incidence. The polarization states of the individual colours are given as RCP (right handed circularly polarized) or LCP (left-handed circularly polarized) light.

The broadband PB-HWP (201) is designed such that it will change the handedness of all of incident circularly polarized RGB light from RCP to LCP or vice versa. As a result, e.g., incident RCP light will be turned into LCP light. At the same time, the broadband PB-HWP (201) will cause different deflection angles $\alpha_R$, $\alpha_G$ and $\alpha_B$ for R, G and B light in the x-z-plane, respectively, with $\alpha_R > \alpha_G > \alpha_B$.

The B HWP (202) is a chromatic HWP which is designed such that it will change the handedness only of blue incident light from RCP to LCP or vice versa. As a result, e.g., incident LCP B light will be turned into RCP B light, while the handedness of incident LCP R and G light will remain unchanged. The deflection angles $\alpha_R$, $\alpha_G$ and $\alpha_B$ of the RGB light caused by the broadband PB-HWP (201) will remain substantially unchanged by the B HWP (202).

The RB HWP (203) is designed such that it will change the handedness only of incident circularly polarized R and B light from LCP to RCP or vice versa. As a result, e.g., incident LCP R light will be turned into RCP R light and incident RCP B light will be turned into LCP B light, while the handedness of incident LCP G light will remain unchanged. At the same time, the RB PB-HWP (203) is designed such that it will change the deflection angles $\alpha_R$ and $\alpha_B$ of the R and B light caused by the broadband PB-HWP (201) to the value of the deflection angle $\alpha_G$ of the G light. As a result, all of R G and B light will have substantially the same deflection angle after leaving the second PB-HWP (203).

The R HWP (204) is a chromatic HWP which is designed such that it changes the handedness only of red incident light from RCP to LCP or vice versa. As a result, e.g., incident RCP R light will be turned into LCP B light, while the handedness of incident LCP B and G light will remain unchanged. The deflection angles $\alpha_R$, $\alpha_G$ and $\alpha_B$ of the RGB light caused by the broadband and RP PB-HWPs (201, 203) will also remain substantially unchanged by the R HWP (204).

As a result, e.g., RGB light incident on the broadband PB-HWP (201) will leave the R HWP (204) with opposite handedness, i.e., LCP RGB light, and with substantially identical deflection angles $\alpha_R = \alpha_G = \alpha_B$. The DOE comprising the complete stack of broadband PB-HWP (201), RP PB-HWP (203), B HWP (202) and R HWP (204) thus functions as an achromatic PB lens for circularly polarized light.

Further preferably, the DOE according to this preferred embodiment additionally comprises a first QWP in front of the broadband HWP (201), and a second QWP behind the R HWP (204), when viewed from the direction of incident light (not shown in **Fig. 2).** As a result, incident linearly polarized RGB light, which has a polarization plane parallel to the x direction (LxP) will leave the DOE being deflected ideally at the same angle $\alpha_R = \alpha_G = \alpha_B$ and with its initial polarization state.

The DOE according to this first preferred embodiment thus functions and can be used as an achromatic PB deflector which deflects all colours of RGB light that is linearly polarized (if QWPs are included) or circularly polarized (without QWPs) at the same deflection angle.

A second preferred embodiment of the present invention relates to a DOE comprising, in the following sequence viewed from the direction of incident light:

- a first, achromatic HWP being effective for all of red (R), green (G) and blue (B) light,

- a second, chromatic HWP being effective only for one of R, G and B light, preferably for B light, but not for the others of RGB light, prefrably not for R or G light,

- a third, chromatic HWP, being effective for R and B light but not for G light,

- optionally a fourth, chromatic HWP being effective only for one of RGB light, preferably for R light, but not for the others of RGB light, preferably not for G or B light,

wherein each of the first, second, third and fourth HWP comprise two or more CLC layers, the first CLC layer deposited directly on a substrate, and the second and further CLC layers deposited directly onto the respective previous CLC layer,

and wherein each CLC layer consists of a polymerized chiral RM mixture having a helical twist along a helix axis in a thickness direction of the CLC layer, said chiral RM mixture comprising one or more direactive RMs, one or more monoreactive RMs, one or more chiral compounds selected from chiral RMs, and a photoinitiator,

and wherein the substrate of the first and third HWP contains a PB lens grating, and the substrate of the second and fourth HWP has a planar alignment layer.

**Fig. 3a-e** exemplarily and schematically illustrate the individual components of a preferred DOE (305) according to this second preferred embodiment, which functions as an achromatic PBL, and comprises a broadband PB-HWP (301), a blue HWP (302), and a red & blue (RB) PB-HWP (303) and a red HWP (304), all as described above and below, wherein the broadband PB-HWP and the RB PB-HWP each contain a substrate containing a PB lens grating. The arrows indicate incident circularly polarized red (R, dotted line), green (G, dashed line), and blue (B, solid line) light, respectively, incidence. The polarization state of the respective coloured light is given as RCP (right handed circularly polarized) or LCP (left-handed circularly polarized).

The broadband PB-HWP (301) as schematically illustrated in **Fig. 3a** is designed such that it will change the handedness of all of incident circularly polarized RGB light from LCP to RCP or vice versa. As a result, e.g., incident LCP light will be turned into RCP light. At the same time, the broadband PB-HWP (301) will converge R, G and B light at different angles, with R having the strongest and B the weakest convergence.

The B HWP (302) as schematically illustrated in **Fig. 3b** is a chromatic HWP which is designed such that it will change the handedness only of blue incident light from RCP to LCP or vice versa. As a result, e.g., incident LCP B light will be turned into RCP B light, while the handedness of incident LCP R and G light will remain unchanged. The angles of the RGB light caused by the broadband PB-HWP (301) will remain substantially unchanged by the B HWP (302).

The RB HWP (303) as schematically illustrated in **Fig. 3c** is designed such that it will change the handedness only of incident circularly polarized R and B light from LCP to RCP or vice versa. As a result, e.g., incident LCP R light will be turned into RCP R light and incident RCP B light will be turned into LCP B light, while the handedness of incident LCP G light will remain unchanged. At the same time, the RB PB-HWP (303) is designed such that it will diverge R light and further converge B light, while the angle of G light will remain substantially unchanged.

The R HWP (304) as schematically illustrated in **Fig. 3d** is a chromatic HWP which is designed such that it will change the handedness only of red incident light from RCP to LCP or vice versa. As a result, e.g., incident LCP R light will be turned into RCP R light, while the handedness of incident LCP B and G light will remain unchanged. The angles of the RGB light caused by the RB PB-HWP (303) will remain substantially unchanged by the R HWP (304).

As a result, as schematically illustrated in **Fig. 3e** RGB light incident on the DOE (305) will have substantially the same convergence angle after leaving it. The DOE comprising the complete stack of broadband PB-HWP (301), B HWP (302), RB PB-HWP (303) and R HWP (304) thus functions as an achromatic PB lens.

Further preferably, the DOE according to this preferred embodiment additionally comprises a first QWP in front of the broadband PB-HWP (301), and a second QWP behind the R HWP (304), when viewed from the direction of incident light (not shown in **Fig. 3).** As a result, incident linearly polarized RGB light will leave the DOE being converged ideally at the same angle and with its initial polarization state.

The DOE according to this preferred embodiment thus functions and can be used as an achromatic PB lens which converges all colours of RGB light that is linearly polarized (if QWPs are included) or circularly polarized (without QWPs) to substantially the same focal point.

Further DOEs with two or more chromatic and/or achromatic HWPs comprising a CLC multilayer, and being stacked in a sequence other than those described in the preferred embodiments above, can be prepared easily by using the materials and methods of the present invention.

Preferably the PB-HWPs and HWPs in a DOE according to the present invention comprise two to twelve, more preferably two to ten, very preferably two to eight, most preferably two to six, individual CLC layers as described above and below. Such a component comprising two or more individual CLC layers is above and below also referred to as "CLC multilayer" or "multi-twist retarder/waveplate".

The individual CLC layers preferably have planar alignment, and by adding a small amount of a chiral dopant with high twisting power a helical twist is induced in a direction throughout the film thickness. The dopant concentration can be varied for the individual CLC layers such that in at least one, very preferably in each, of the chromatic and achromatic

HWPs at least two CLC layers have a different twist angle.

In a PB-HWP and HWP as described above and below, each CLC layer comprises a polymerized chiral RM mixture comprising one or more RMs selected from mono-, di- and multireactive RMs, preferably comprising one or more direactive RMs and one or more monoreactive RMs, and further comprising at least one chiral compound, preferably selected from chiral RMs, and a photoinitiator,

The optical properties like the deflection angle, focal point, (a)chromaticity and retardation (e.g., half-wave or full-wave retardation) of the individual components, like the HWPs and PB-HWPs, of a DOE as described above and below can be controlled and adjusted by selecting the corresponding layer thickness, twist sense and twisting power for each individual CLC layer forming the multilayer stack, and also the PB grating or PB lens pitch. Thereby it is possible to prepare from these chiral RM mixtures multi-twist retarders, wherein the individual CLC layers have different twist angle, which can act as achromatic or chromatic waveplate with the desired retardation, e.g. as half-wave or full-wave plate, for linearly or circulary polarized light.

By using chiral RM mixtures and CLC multilayers and their production process according to the present invention in the concept of multi-twist retarders, it is possible to design waveplates and PB-HWPs which can range from completely achromatic across the visible wavelength range, to very chromatic for single wavelengths.

The individual optical components, like the PB-HWPs and HWPs, of a DOE according to the present invention are preferably prepared by depositing a first layer of a chiral RM mixture as described above and below onto a substrate, optionally annealing the chiral RM material and then curing the RM material by polymerization, preferably by UV photopolmerization. The second and optionally further layers of chiral RM material are then individually and subsequently deposited, optionally annealed, and cured on the respective previously cured chiral RM layer.

Preferably, the process of preparing a individual optical component, like a PB-HWP, according to the present invention comprises, preferably consists of, the following steps:

A1) forming a surface grating, preferably a PB deflector or PB lens grating, on the surface of a substrate,
A2) depositing a first layer of a chiral RM mixture as described above and below, or an RM formulation comprising a chiral RM mixture as described above and below and a solvent or solvent blend, onto the surface grating,
A3) removing any solvents present,
A4) optionally annealing the first layer of the chiral RM mixture, preferably at a temperature where it is in the cholesteric phase,
A5) polymerizing the chiral RM mixture of the first layer at a temperature where it is in the cholesteric phase, preferably by irradiation with actinic radiation, preferably with UV radiation,
B1) depositing a second layer of a chiral RM mixture as described above and below, or an RM formulation comprising a chiral RM mixture as described above and below and a solvent or solvent blend, onto the polymerized first chiral RM layer,
B2) removing any solvents present,
B3) optionally annealing the chiral RM mixture of the second layer, preferably at a temperature where it is in the cholesteric phase,
B4) polymerizing the chiral RM mixture of the second layer at a temperature where it is in the cholesteric phase, preferably by irradiation with actinic radiation, preferably with UV radiation,

optionally repeating steps B1 to B4 one or more times with a subsequent third, fourth etc. layer of a chiral RM mixture which is provided and polymerized on the respective previously polymerized chiral RM layer.

A HWP as used in a DOE according to the present invention which is not a PB-HWP can be prepared in analogy to this preferred process, but wherein in step A1) the substrate does not contain a surface grating and preferably contains a planar alignment layer instead.

As mentioned above, the values of the birefringence, thickness, helical pitch and twist angle of a single CLC layer in the waveplate according to the present invention can vary, depending on the desired function of the multi-twist waveplate. By using a chiral RM mixture as described above and below, especially a blend of chiral and achiral RM mixtures, and the process of preparing a multilayer as described above and below, these values can be adjusted easily and in a reproducible manner.

Preferably the thickness of a multilayer waveplate, like a PB-HWP or HWP according to the present invention is from 2 to 20 $\mu$m, very preferably from 2 to 15 $\mu$m.

Preferably the thickness of an individual CLC layer in the multilayer waveplate according to the present invention is from 1 to 10 $\mu$m, very preferably from 1 to 3 $\mu$m.

The twist angle in a single CLC layer of the multilayer preferably varies in a range from 0.1 to 150°.

In a preferred embodiment, the CLC layers have planar alignment with helical twist, i.e., the LC molecules are oriented parallel to the film plane and the helical axis is oriented substantially perpendicular to the film plane.

In another preferred embodiment one or more CLC layers have a tilted alignment with helical twist, i.e., the LC

molecules are oriented at an angle to the film plane and/or the helical axis is oriented at an angle to the direction perpendicular to the layer plane, also referred as tilt angle. Preferably, the tilt angle between the helix axis and the direction perpendicular to the film plane is from 5° to 45°, very preferably from 15° to 45°. In another preferred embodiment, the tilt angle between the helix axis and the direaction perpendicular to the layer plane is from >0 to 15°, very preferably from >0 to 5°.

Planar alignment can be induced for example by providing an alignment layer on the substrate, for example a polyimide alignment layer, as described below. Tilted alignment can be achieved for example by adding an alignment additive to the chiral RM mixture, or by using a substrate containing a surface grating or pattern, e.g. a PB grating.

The birefringence (Δn) of a single CLC layer is preferably in the range from 0.15 to 0.4, more preferably from 0.16 to 0.35, very preferably from 0.18 to 0.3.

The optical retardation of a half-wave plate according to the present invention is preferably from 200 to 400 nm.

The optical retardation of a full-wave plate according to the present invention is preferably from 400 to 800 nm.

The individual CLC layers in the waveplate according to the present invention can be prepared from the same or different chiral RM mixtures. The chiral RM mixtures can be easily and reproducibly prepared from achiral and chiral RM base mixtures, e.g. an achiral RM mixture without a chiral component, a first chiral RM mixture containing a defined amount of a chiral compound having a certain handedness, i.e. either right-handed or left-handed, and a second RM mixture containing a defined amount of a chiral compound having opposite handedness. These base mixtures can be blended at defined ratios to prepare multiple chiral RM mixtures with the desired handedness and degree of helical twist.

Moreover, the chiral RM mixtures and the CLC layer production process according to the present invention provide the following advantages:

- the chiral RM mixture of the first CLC layer can easily be aligned into the desired orientation, for example on a planar alignment layer or on a surface grating like for example a PB grating,
- by adding only a small amount of a chiral compound with high HTP a helical twist is induced in a direction throughout the film thickness,
- the chiral RM mixtured of the second and further CLC layers can be deposited on the respective previous CLC layer which induce the desired alignment in the subsequent layer, and be polymerized in situ to fix the twisted orientation,
- by blending chiral and achiral RM mixtures the desired helical pitch and twist angles in the individual final CLC layers can be easily adjusted,
- dewetting and chiral migration between the RM materials of adjacent CLC layers can be reduced,
- unwanted spontaneous crystallization of RMs can be suppressed,
- the easy adjustment of the twist angle using RM mixture blends and the reduced chiral migration enable the manufacture of multi-twist CLC layer stacks in a simple and reproducible manner which is is also suitable for production at arge scale.

In a chiral RM mixture used for preparing the CLC layer, preferably the proportion of the direactive RMs mixture is from 40 to 90%, preferably from 45 to 80%. Further preferably, the chiral compound is selected from chiral RMs. Further preferably, the photoinitiator is selected from oxime esters, very preferably from carbazole oxime esters.

It has been found that the use of a chiral RM mixture comprising a high amount of direactive RMs of formula D helps to suppress unwanted chiral migration. On the other hand, the amount of direactive RMs should not be too high to prevent unwanted crystallization and bad alignment. In view of these trade-offs, the proportion of monoreactive RMs of formula M and direactive RMs of formula M in the chiral RM mixture should be carefully controlled to achieve optimum balance between advantages and drawbacks.

Moreover, it has been found that by using a polymerizable chiral compound, preferably selected from formulae C1 to C3, undesired chiral migration between the CLC layers can be reduced.

Also, it has been found that by using photoinitiators based on oxime esters, preferably selected from formula P, it is possible to ensure on the one hand quick and complete polymerization of the CLC layers and on the other hand chiral migration can be suppressed.

In a preferred embodiment the chiral RM mixture comprises one or more di- or multireactive RMs. These di-or multireactive RMs are preferably selected of formula D

$$P^1\text{-}Sp^1\text{-}MG\text{-}Sp^2\text{-}P^2 \qquad D$$

wherein the individual radicals, independently of each other and on each occurrence identically or differently, have the following meanings

$P^1$, $P^2$ a polymerizable group,

$Sp^1$, $Sp^2$ a spacer group or a single bond, and

MG a rod-shaped mesogenic group, which is preferably selected of formula MG $-(A^1-Z^1)_n-A^2-$ MG

$A^1$ and $A^2$ an aromatic or alicyclic group, which optionally contains one or more heteroatoms selected from N, O and S, and is optionally mono- or polysubstituted by L,

L P-Sp-, F, Cl, Br, I, -CN, $-NO_2$ , -NCO, -NCS, -OCN, -SCN, $-C(=O)NR^xR^y$, $-C(=O)OR^x$, $-C(=O)R^x$, $-NR^xR^y$, -OH, $-SF_5$, optionally substituted silyl, aryl or heteroaryl with 1 to 12, preferably 1 to 6 C atoms, and straight chain or branched alkyl, alkoxy, alkylcarbonyl, alkoxycarbonyl, alkylcarbonyloxy or alkoxycarbonyloxy with 1 to 12, preferably 1 to 6 C atoms, wherein one or more H atoms are optionally replaced by F or Cl,

$R^x$ and $R^y$ H or alkyl with 1 to 12 C-atoms,

$Z^1$ -O-, -S-, -CO-, -COO-, -OCO-, -S-CO-, -CO-S-, -O-COO-, $-CO-NR^{00}-$, - $NR^{00}-CO-$, $-NR^{00}-CO-NR^{000}$, $-NR^{00}-CO-O-$, $-O-CO-NR^{00}-$, $-OCH_2-$, - $CH_2O-$, $-SCH_2-$, $-CH_2S-$, $-CF_2O-$, $-OCF_2-$, $-CF_2S-$, $-SCF_2-$, $-CH_2CH_2-$, - $(CH_2)_{n1}$, $-CF_2CH_2-$, $-CH_2CF_2-$, $-CF_2CF_2-$, -CH=N-, -N=CH-, -N=N-, - $CH=CR^{00}-$, $-CY^1=CY^2-$, -C≡C-, -CH=CH-COO-, -OCO-CH=CH- or a single bond, preferably -COO-, -OCO- or a single bond,

$R^{00}$ and $R^{000}$ H or alkyl having 1 to 12 C atoms,

$Y^1$ and $Y^2$ H, F, Cl or CN,

n 1, 2, 3 or 4, preferably 1 or 2, most preferably 2,

n1 an integer from 1 to 10, preferably 1, 2, 3 or 4.

Preferred groups $A^1$ and $A^2$ include, without limitation, furan, pyrrol, thiophene, oxazole, thiazole, thiadiazole, imidazole, phenylene, cyclohexylene, bicyclooctylene, cyclohexenylene, pyridine, pyrimidine, pyrazine, azulene, indane, fluorene, naphthalene, tetrahydronaphthalene, anthracene, phenanthrene and dithienothiophene, all of which are unsubstituted or substituted by 1, 2, 3 or 4 groups L as defined above.

Particular preferred groups $A^1$ and $A^2$ are selected from 1,4-phenylene, pyridine-2,5-diyl, pyrimidine-2,5-diyl, thiophene-2,5-diyl, naphthalene-2,6-diyl, 1,2,3,4-tetrahydronaphthalene-2,6-diyl, indane-2,5-diyl, bicyclooctylene or 1,4-cyclohexylene wherein one or two non-adjacent $CH_2$ groups are optionally replaced by O and/or S, wherein these groups are unsubstituted or substituted by 1, 2, 3 or 4 groups L as defined above.

Preferred RMs of formula D are selected of formula Da

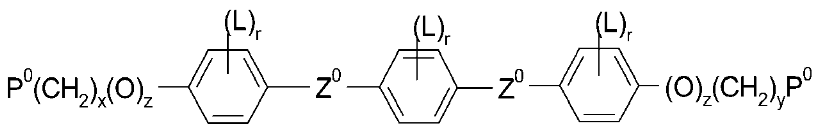

Da

wherein the individual radicals, independently of each other and on each occurrence identically or differently, have the following meanings

$P^0$ a polymerizable group, preferably an acryl, methacryl, oxetane, epoxy, vinyl, heptadiene, vinyloxy, propenyl ether or styrene group,

$Z^0$ -COO-, -OCO-, $-CH_2CH_2-$, $-CF_2O-$, $-OCF_2-$, -C≡C-, -CH=CH-,-OCO-CH=CH-, -CH=CH-COO-, or a single bond,

L has one of the meanings given in formula D, and is preferably selected from F, Cl, CN or optionally halogenated alkyl, alkoxy, alkylcarbonyl, alkoxycarbonyl, alkylcarbonyloxy or alkoxycarbonyloxy with 1 to 5 C atoms,

r 0, 1, 2, 3 or 4,

x and y 0 or identical or different integers from 1 to 12,

z 0 or 1, with z being 0 if the adjacent x or y is 0.

Very preferred RMs of formula D are selected from the following formulae:

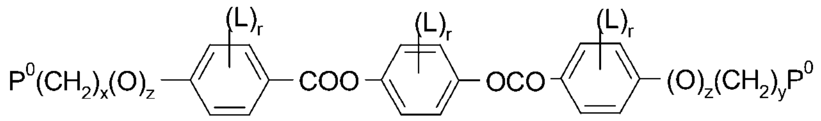
Da1

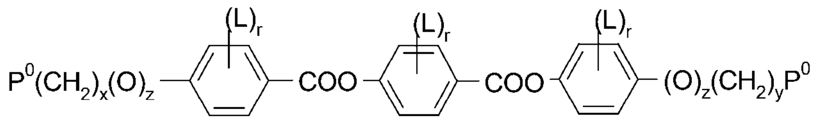
Da2

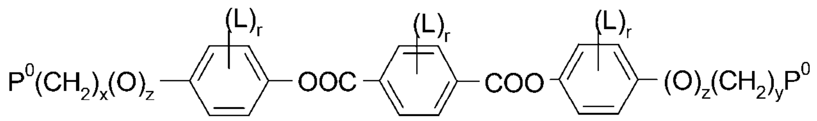
Da3

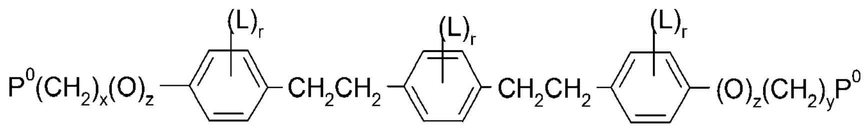
Da4

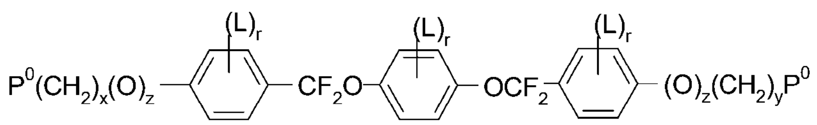
Da5

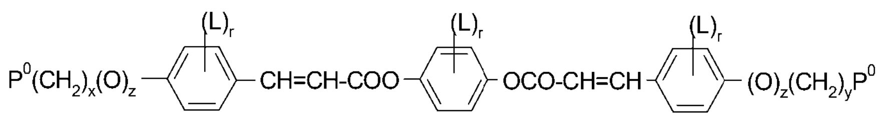
Da6

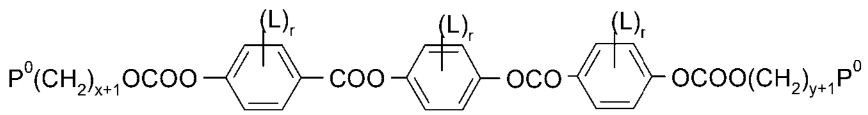
Da7

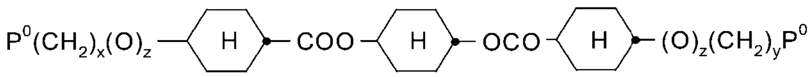
Db

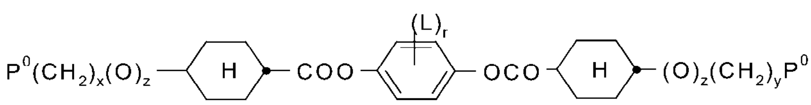
Dc

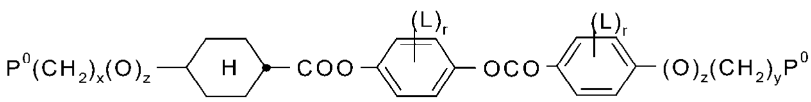
Dd

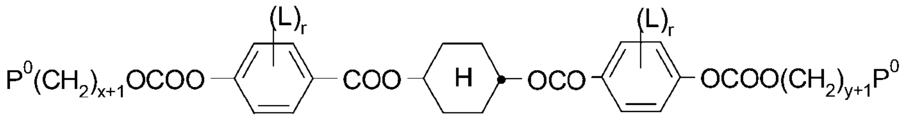 De

wherein $P^0$, L, r, x, y and z are as defined in formula Da, s is 0, 1, 2 or 3 and t is 0, 1 or 2.

Especially preferred are compounds of formula Da1, Da2 and Da3, in particular those of formula Da1.

In another preferred embodiment the chiral RM mixture contains one or more direactive RMs of formula D wherein at least one group $Z^1$ denotes -C≡C, very preferably selected from formulae Df, Dg, Dh, Di, Dk and Dm.

In formula D and its preferred subformulae, L is preferably selected from F, Cl, CN, $NO_2$ or straight chain or branched alkyl, alkoxy, alkylcarbonyl, alkoxycarbonyl, alkylcarbonyloxy or alkoxycarbonyloxy with 1 to 12 C atoms, wherein the alkyl groups are optionally perfluorinated, or P-Sp-.

Very preferably L is selected from F, Cl, CN, $NO_2$, $CH_3$, $C_2H_5$, $C(CH_3)_3$, $CH(CH_3)_2$, $CH_2CH(CH_3)C_2H_5$, $OCH_3$, $OC_2H_5$, $COCH_3$, $COC_2H_5$, $COOCH_3$, $COOC_2H_5$, $CF_3$, $OCF_3$, $OCHF_2$, $OC_2F_5$, in particular F, Cl, CN, $CH_3$, $C_2H_5$, $C(CH_3)_3$, $CH(CH_3)_2$, $OCH_3$, $COCH_3$ or $OCF_3$, most preferably F, Cl, $CH_3$, $C(CH_3)_3$, $OCH_3$ or $COCH_3$, or P-Sp-.

In another preferred embodiment the chiral RM mixture comprises one or more monoreactive RMs. These monoreactive RMs are preferably selected from formula M:

$P^1$-$Sp^1$-$MG^M$-$R^{22}$ M

wherein the individual radicals, independently of each other and on each occurrence identically or differently, have the following meanings

| | |
|---|---|
| $P^1$ | a polymerizable group, |
| $Sp^1$, $Sp^2$ | a spacer group or a single bond, and |
| $MG^M$ | a rod-shaped mesogenic group, which is preferably selected of formula MGM -($A^{1M}$-$Z^1$)$_n$-$A^{2M}$- MGM |
| $A^{1M}$ and $A^{2M}$ | an aromatic or alicyclic group, which optionally contains one or more heteroatoms selected from N, O and S, and is optionally mono- or polysubstituted by $L^M$, |
| $L^M$ | F, Cl, Br, I, -CN, -$NO_2$ , -NCO, -NCS, -OCN, -SCN, -C(=O)$NR^xR^y$, - C(=O)$OR^x$, -C(=O)$R^x$, -$NR^xR^y$, -OH, -$SF_5$, optionally substituted silyl, aryl or heteroaryl with 1 to 12, preferably 1 to 6 C atoms, and straight chain or branched alkyl, alkoxy, alkylcarbonyl, alkoxycarbonyl, alkylcarbonyloxy or alkoxycarbonyloxy with 1 to 12, preferably 1 to 6 C atoms, wherein one or more H atoms are optionally replaced by F or Cl, |
| $R^x$ and $R^y$ | H or alkyl with 1 to 12 C-atoms, |
| $Z^1$ | -O-, -S-, -CO-, -COO-, -OCO-, -S-CO-, -CO-S-, -O-COO-, -CO-$NR^{00}$-, - $NR^{00}$-CO-, -$NR^{00}$-CO-$NR^{000}$, -$NR^{00}$-CO-O-, -O-CO-$NR^{00}$-, -$OCH_2$-, - $CH_2O$-, -$SCH_2$-, -$CH_2S$-, -$CF_2O$-, -$OCF_2$-, -$CF_2S$-, -$SCF_2$-, -$CH_2CH_2$-, - $(CH_2)_{n1}$, -$CF_2CH_2$-, -$CH_2CF_2$-, -$CF_2CF_2$-, -CH=N-, -N=CH-, -N=N-, - CH=$CR^{00}$-, -$CY^1$=$CY^2$-, -C≡C-, -CH=CH-COO-, -OCO-CH=CH- or a single bond, preferably -COO-, -OCO- or a single bond, |
| $R^{00}$ and $R^{000}$ | H or alkyl having 1 to 12 C atoms, |
| $Y^1$ and $Y^2$ | H, F, Cl or CN, |
| n | 1, 2, 3 or 4, preferably 1 or 2, most preferably 2, |
| n1 | an integer from 1 to 10, preferably 1, 2, 3 or 4. |
| $R^{22}$ | denotes P-Sp-, F, Cl, Br, I, -CN, -$NO_2$ , -NCO, -NCS, -OCN, -SCN, - C(=O)$NR^xR^y$, -C(=O)X, -C(=O)$OR^x$, -C(=O)$R^y$, -$NR^xR^y$, -OH, -$SF_5$, optionally substituted silyl, straight chain or branched alkyl, alkoxy, alkylcarbonyl, alkoxycarbonyl, alkylcarbonyloxy or alkoxycarbonyloxy with 1 to 12, preferably 1 to 6 C atoms, wherein one or more H atoms are optionally replaced by F or Cl, |

X is halogen, preferably F or Cl, and

$R^x$ and $R^y$ are independently of each other H or alkyl with 1 to 12 C-atoms.

Preferred groups $A^{1M}$ and $A^{2M}$ include, without limitation, furan, pyrrol, thiophene, oxazole, thiazole, thiadiazole, imidazole, phenylene, cyclohexylene, bicyclooctylene, cyclohexenylene, pyridine, pyrimidine, pyrazine, azulene, indane, fluorene, naphthalene, tetrahydronaphthalene, anthracene, phenanthrene and dithienothiophene, all of which are unsubstituted or substituted by 1, 2, 3 or 4 groups L as defined above.

Particular preferred groups $A^{1M}$ and $A^{2M}$ are selected from 1,4-phenylene, pyridine-2,5-diyl, pyrimidine-2,5-diyl, thiophene-2,5-diyl, naphthalene-2,6-diyl, 1,2,3,4-tetrahydronaphthalene-2,6-diyl, indane-2,5-diyl, bicyclooctylene or 1,4-cyclohexylene wherein one or two non-adjacent $CH_2$ groups are optionally replaced by O and/or S, wherein these groups are unsubstituted or substituted by 1, 2, 3 or 4 groups L as defined above.

Preferably the RMs of formula M are selected from the following formulae.

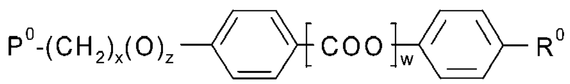
M1

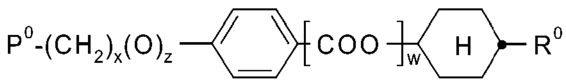
M2

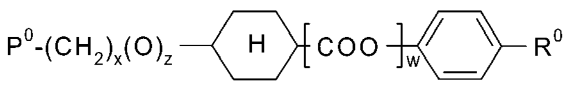
M3

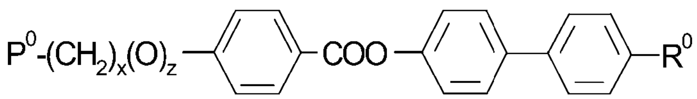
M4

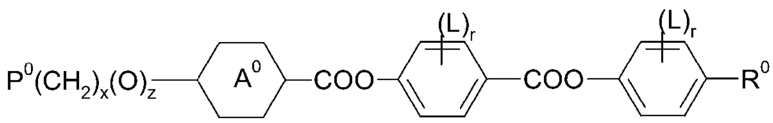
M5

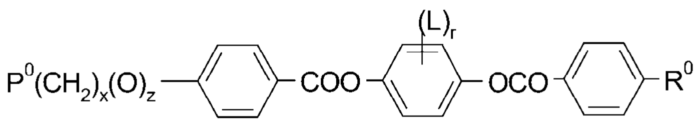
M6

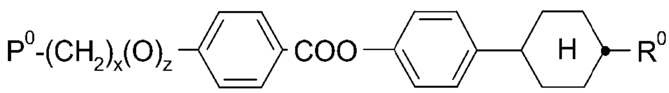
M7

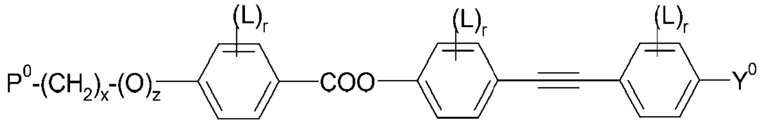
M8

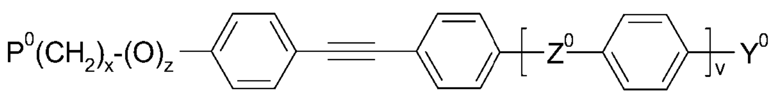
M9

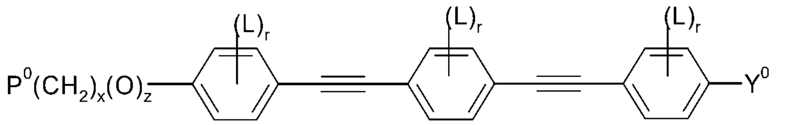

M10

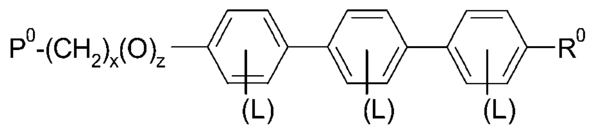

M11

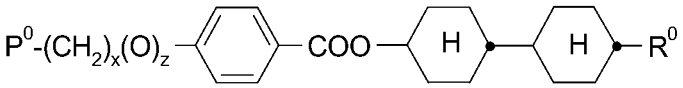

M12

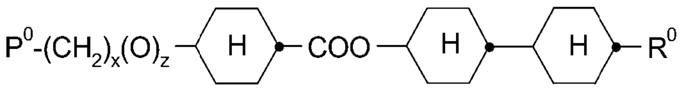

M13

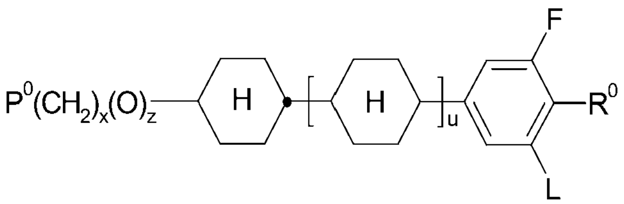

M14

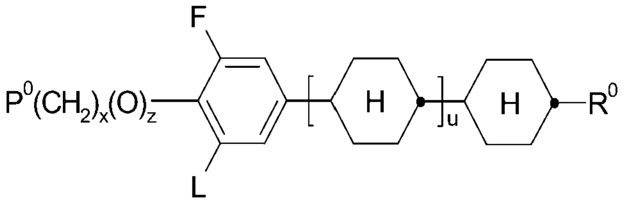

M15

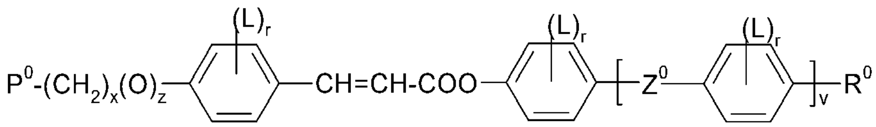

M16

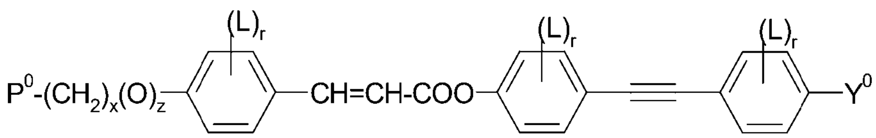

M17

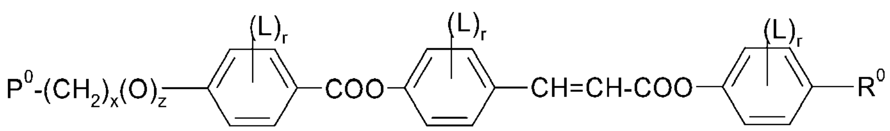

M18

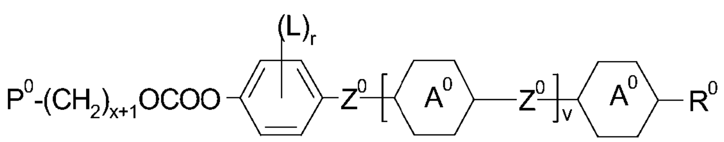

M19

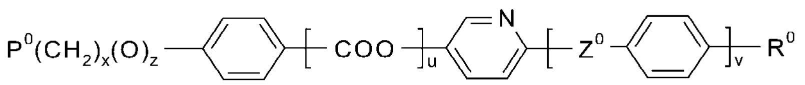

M20

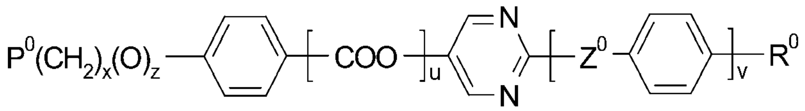

M21

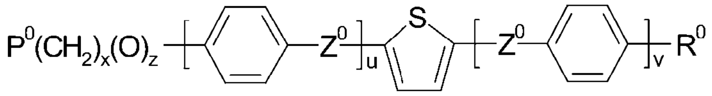

M22

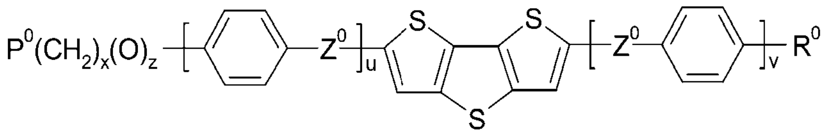

M23

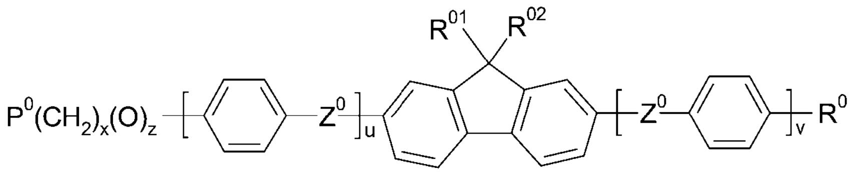

M24

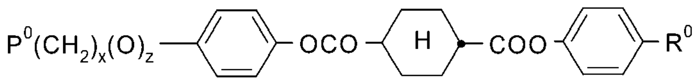

M25

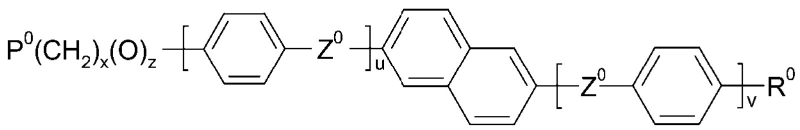

M26

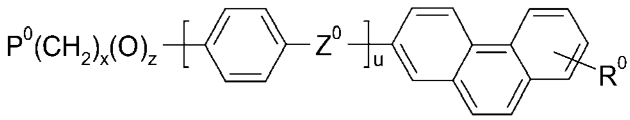

M27

wherein $P^0$, r, x, y, z, s and t are as defined in formula Da and Dk, and

L has one of the meanings given for $L^M$ in formula M above, and is preferably selected from F, Cl, CN or optionally halogenated alkyl, alkoxy, alkylcarbonyl, alkoxycarbonyl, alkylcarbonyloxy or alkoxycarbonyloxy with 1 to 5 C atoms,

$R^0$ is alkyl, alkoxy, thioalkyl, alkylcarbonyl, alkoxycarbonyl, alkylcarbonyloxy or alkoxycarbonyloxy with 1 or more, preferably 1 to 15 C atoms or denote $Y^0$ or P-$(CH_2)_y$-$(O)_z$-,

$X^0$ is -O-, -S-, -CO-, -COO-, -OCO-, -O-COO-, -CO-NR$^{01}$-, -NR$^{01}$-CO-, -NR$^{01}$-CO-NR$^{01}$-, -OCH$_2$-, -CH$_2$O-, -SCH$_2$-, -CH$_2$S-, -CF$_2$O-, -OCF$_2$-, -CF$_2$S-, -SCF$_2$-, -CF$_2$CH$_2$-, -CH$_2$CF$_2$-, -CF$_2$CF$_2$-, -CH=N-, -N=CH-, -N=N-, -CH=CR$^{01}$-, -CF=CF-, -C≡C-, -CH=CH-COO-, -OCO-CH=CH- or a single bond

$Y^0$ is F, Cl, CN, $NO_2$, $OCH_3$, OCN, SCN, $SF_5$, or mono- oligo- or polyfluorinated alkyl or alkoxy with 1 to 4 C atoms,

$Z^0$ is -COO-, -OCO-, -CH$_2$CH$_2$-, -CF$_2$O-, -OCF$_2$-, -CH=CH-,-OCO-CH=CH-, - CH=CH-COO-, or a single bond,

$A^0$ is, in case of multiple occurrence independently of one another, 1,4-phenylene that is unsubstituted or substituted with 1, 2, 3 or 4 groups L, or trans-1,4-cyclohexylene,

$R^{01,02}$ are independently of each other H, $R^0$ or $Y^0$,

u and v are independently of each other 0, 1 or 2,

w is 0 or 1,

and wherein the benzene and naphthalene rings can additionally be substituted with one or more identical or different groups $L^M$.

Especially preferred are compounds of formula M1, M4, M7, M8, M9, M10, M11, in particular those of formula M1, M4 and M7, further more those of formula M8, M9 and M10.

In another preferred embodiment the chiral RM mixture contains one or more monoreactive RMs of formula M wherein the group $MG^M$ contains at least one group $Z^1$ that denotes -C≡C, very preferably selected from formulae M8 to M10.

In formula M and its preferred subformulae, $L^M$ is preferably selected from F, Cl, CN, $NO_2$ or straight chain or branched alkyl, alkoxy, alkylcarbonyl, alkoxycarbonyl, alkylcarbonyloxy or alkoxycarbonyloxy with 1 to 12 C atoms, wherein the alkyl groups are optionally perfluorinated.

Very preferably $L^M$ is selected from F, Cl, CN, $NO_2$, $CH_3$, $C_2H_5$, $C(CH_3)_3$, $CH(CH_3)_2$, $CH_2CH(CH_3)C_2H_5$, $OCH_3$, $OC_2H_5$, $COCH_3$, $COC_2H_5$, $COOCH_3$, $COOC_2H_5$, $CF_3$, $OCF_3$, $OCHF_2$, $OC_2F_5$, in particular F, Cl, CN, $CH_3$, $C_2H_5$, $C(CH_3)_3$, $CH(CH_3)_2$, $OCH_3$, $COCH_3$ or $OCF_3$, most preferably F, Cl, $CH_3$, $C(CH_3)_3$, $OCH_3$ or $COCH_3$.

In another preferred embodiment the present invention, the chiral RM mixture contains one or more RMs of formula T

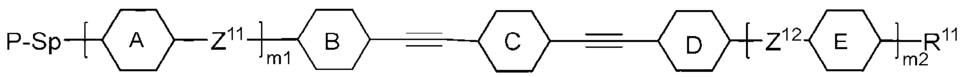 T

wherein the individual radicals, independently of each other and on each occurrence identically or differently, have the following meanings

P a polymerizable group,

Sp a spacer group or a single bond,

$R^{11}$ H, F, Cl, CN, alkyl, alkoxy, thioalkyl, alkylcarbonyl, alkoxycarbonyl, alkylcarbonyloxy or alkoxycarbonyloxy with 1 to 15, preferably with 1 to 5, C atoms which is optionally optionally fluorinated, or P-Sp,

A, B, D, and E are selected from the group consisting of 1,4-phenylene, naphthalene-1,4-diyl, naphthalene-2,6-diyl, phenanthrene-2,7-diyl, anthracene-9,10-diyl, fluorene-2,7-diyl, dibenzothiophene-2,7-diyl, dibenzofuran-2,7-diyl, benzo[1,2-b:4,5-b']dithiophene-2,5-diyl, indole-4,7-diyl, benzothiophene-4,7-diyl, 9,10-dihydro-phenanthrene-2,7-diyl, 1,2,3,4-tetrahydronaphthalene-5,8-diyl or indane-2,5-diyl, where, in addition, one or more CH groups in these groups may be replaced by N, all of which are optionally substituted by one or more groups L or P-Sp-.

C is selected from the group consisting of benzene-1,4-diyl, naphthalene-1,4-diyl, anthracene-9,10-diyl, fluorene-2,7-diyl, dibenzofuran-2,7-diyl, dibenzothiophene-2,7-diyl, benzo[1,2-b:4,5-b']dithiophene-2,5-diyl, indole-4,7-diyl, benzothiophene-4,7-diyl, all of which are optionally substituted by one or more groups L or P-Sp. and one of rings C and D may also denote a single bond,

L F, Cl, -CN, -SCN, P-Sp-, or straight chain, branched or cyclic alkyl having 1 to 25 C atoms, wherein one or more non-adjacent $CH_2$-groups are optionally replaced by -O-, -S-, -CO-, -CO-O-, -O-CO-, -O-CO-O-, $CR^0$=$CR^{00}$-, -C≡C-,

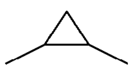, 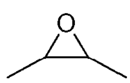, 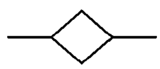, 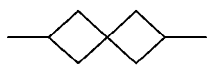,

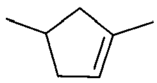, or 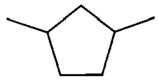,

in such a manner that O- and/or S-atoms are not directly connected with each other, and wherein one or more H atoms are each optionally replaced by P-Sp- , F or Cl, or two substituents L that are connected to directly adjacent C atoms may also form a cycloalkyl or cycloalkenyl group with 5, 6, 7 or 8 C atoms,

$Z^{11}$, $Z^{12}$ -O-, -S-, -CO-, -COO-, -OCO-, -S-CO-, -CO-S-, -O-COO-, -CO-NR$^0$-, -NR$^0$-CO-, -NR$^0$-CO-NR$^{00}$, -NR$^0$-CO-O-, -O-CO-NR$^0$-, -OCH$_2$-, -CH$_2$O-, -SCH$_2$-, -CH$_2$S-, -CF$_2$O-, -OCF$_2$-, -CF$_2$S-, -SCF$_2$-, -CH$_2$CH$_2$-, -(CH$_2$)$_{n1}$, -CF$_2$CH$_2$-, -CH$_2$CF$_2$-, -CF$_2$CF$_2$-, -CH=N-, -N=CH-, -N=N-, -CH=CR$^0$-, -CY$^1$=CY$^2$-, -C≡C-, -CH=CH-COO-, -OCO-CH=CH- or a single bond, preferably -COO-, -OCO-, -C≡C-, or a single bond, most preferably a single bond,

$R^0$, $R^{00}$ H or alkyl having 1 to 12 C atoms,

$Y^1$, $Y^2$ H, F, Cl, NCS, or CN,

m1, m2 0, 1, 2, 3 or 4, preferably 0, 1 or 2, very preferably 0 or 1, most preferably 0,

n1 1, 2, 3 or 4.

The RMs of formula T show a high extraordinary refractive index $n_e$ and a high birefringence.
Preferably A, B, D and E in formula T are selected from the group consisting of

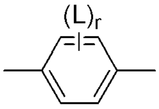, 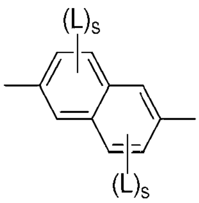, 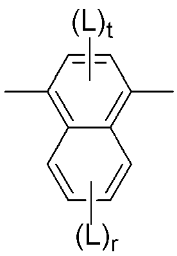, 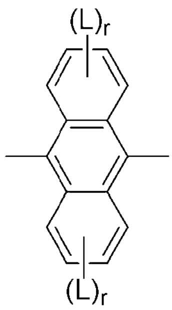, 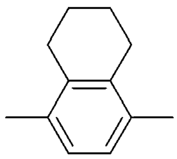,

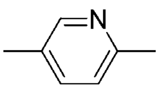, 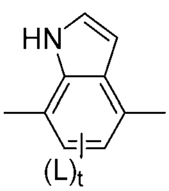, 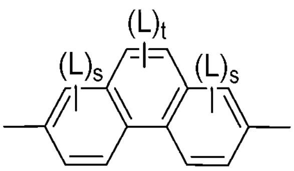, 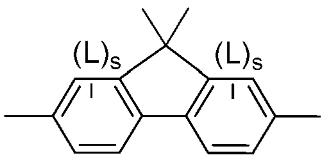,

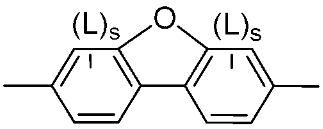, 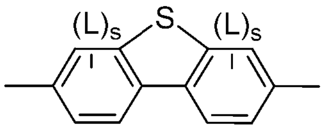, 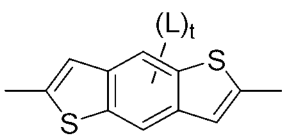

wherein the individual radicals, independently of each other and on each occurrence identically or differently, have the following meanings

L P-Sp-, -CN, F, Cl, or alkyl, alkoxy or thioalkyl which is optionally fluorinated and has 1 to 6, preferably 1 to 3, more preferably 1 or 2 C atoms, preferably P-Sp-, - CN, F, Cl, $OCH_3$, $SCH_3$, $C_2H_5$, $OC_2H_5$, $SC_2H_5$,

r 0, 1, 2, 3 or 4, preferably 0, 1 or 2,

s 0, 1, 2 or 3, preferably 0 or 1,

t 0, 1 or 2, preferably 0 or 1.

More preferably rings A, B, D and/or E in formula T are selected from the group consisting of benzene-1,4-diyl, naphthalene-1,4-diyl, naphthalene 2,6-diyl, phenanthrene-2,7-diyl, anthracene-9,10-diyl, fluorene-2,7-diyl, dibenzofuran-2,7-diyl, dibenzothiophene-2,7-diyl, benzo[1,2-b:4,5-b']dithiophene-2,5-diyl, indole-4,7-diyl, benzothiophene-4,7-diyl, all of which are optionally substituted by one or more groups L and/or P-Sp-.

Very preferably one, two, three, four or more of rings A, B, D and/or E in formula T are selected from the group consisting of

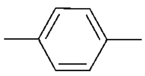 , 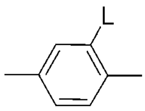 , 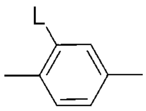 , 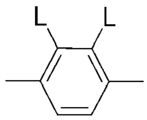 , 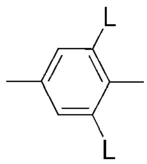 , 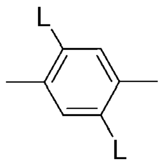 ,

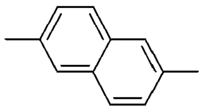 , 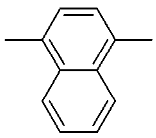 ,

wherein L, on each occurrence identically or differently, denotes P-Sp-, -CN, F, Cl, or alkyl, alkoxy or thioalkyl which is optionally fluorinated and has 1 to 6, preferably 1 to 3, more preferably 1 or 2 C atoms, preferably P-Sp-, -CN, F, Cl, $OCH_3$, $SCH_3$, $C_2H_5$, $OC_2H_5$, $SC_2H_5$.

Especially preferred are compounds of formula T, in particular wherein n=m=0, wherein the rings B and D are selected from the group consisting of benzene-1,4-diyl, naphthalene-1,4-diyl, naphthalene-2,6-diyl or anthracene-9,10-diyl, all of which are optionally mono- or disubstituted by L and/or P-Sp-.

Preferably ring C in formula T is selected from the group consisting of

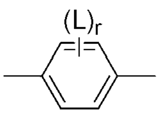 , 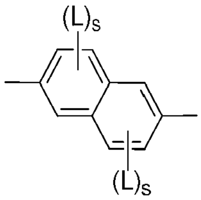 , 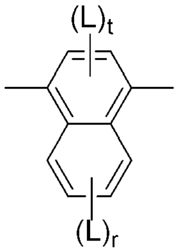 and 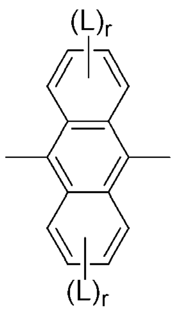

wherein the individual radicals, independently of each other and on each occurrence identically or differently, have the following meanings

L P-Sp-, -CN, F, Cl, or alkyl, alkoxy or thioalkyl which is optionally fluorinated and has 1 to 6, preferably 1 to 3, more preferably 1 or 2 C atoms, preferably P-Sp-, - CN, F, Cl, $OCH_3$, $SCH_3$, $C_2H_5$, $OC_2H_5$, $SC_2H_5$,

r 0, 1, 2, 3 or 4, preferably 0, 1 or 2,

s 0, 1, 2 or 3, preferably 0 or 1,

t 0, 1 or 2, preferably 0 or 1.

More preferably C in formula T is selected from the group consisting of

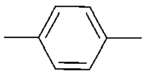, 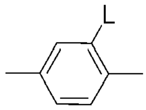, 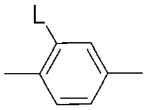, 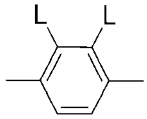, 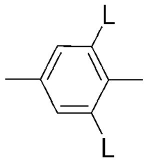, 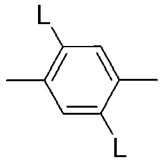,

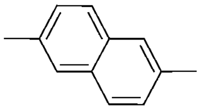, 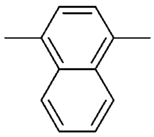, 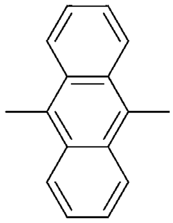, 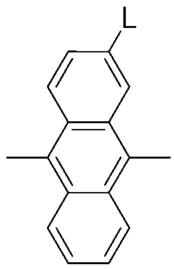

wherein L, on each occurrence identically or differently, denotes P-Sp-, -CN, F, Cl, or alkyl, alkoxy or thioalkyl which is optionally fluorinated and has 1 to 6, preferably 1 to 3, more preferably 1 or 2 C atoms, preferably P-Sp-, -CN, F, Cl, $OCH_3$, $SCH_3$, $C_2H_5$, $OC_2H_5$, $SC_2H_5$.

Very preferably ring C in formula T is selected from the group consisting of benzene-1,4-diyl, naphthalene-1,4-diyl or anthracene-9,10-diyl, all of which are optionally mono- or disubstituted by L and/or P-Sp-.

Further preferred are compounds of formula T, preferably those wherein n=m=0, wherein the rings B, C and D form a mesogenic group selected from the following formulae or their mirror images:

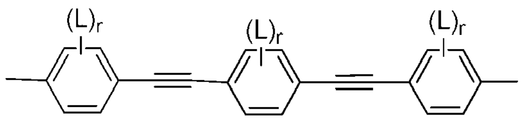
T1

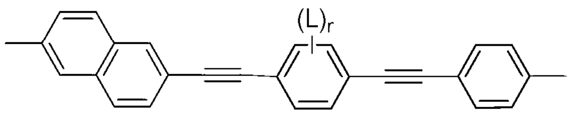
T2

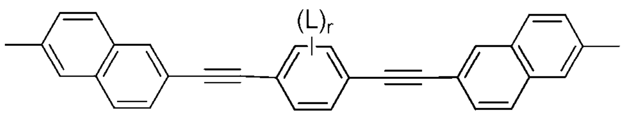
T3

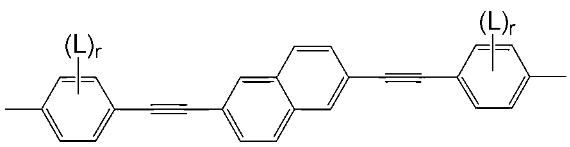
T4

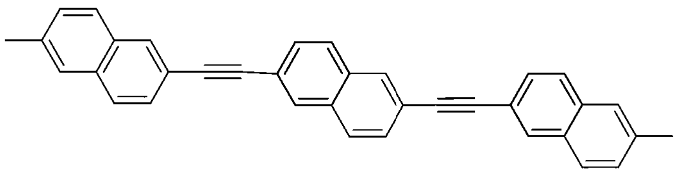
T5

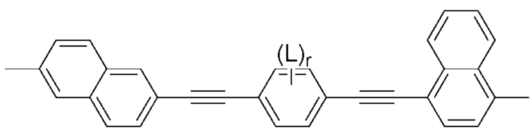
T6

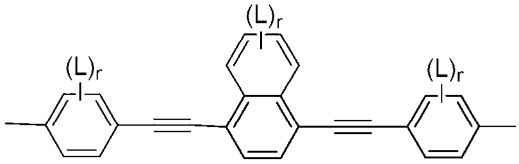

T7

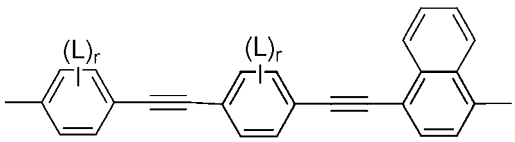

T8

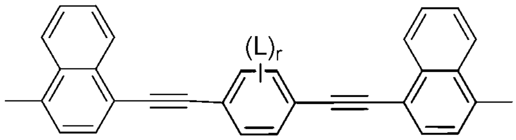

T9

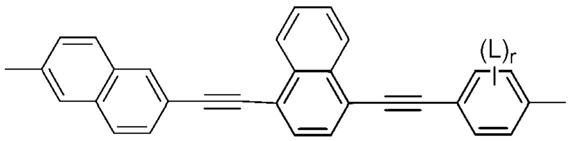

T10

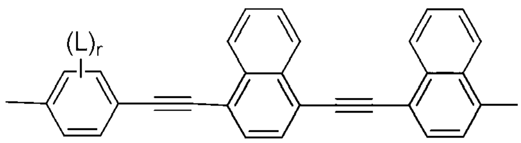

T11

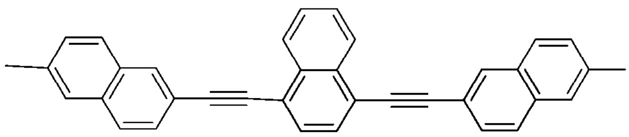

T12

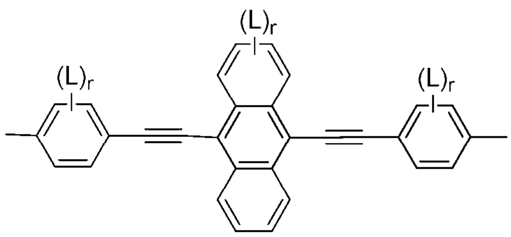

T13

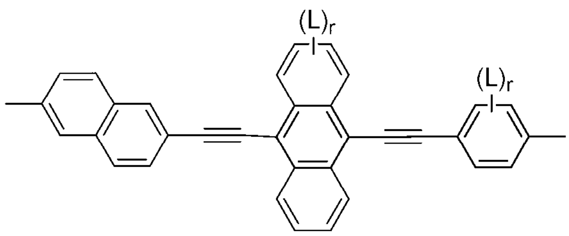

T14

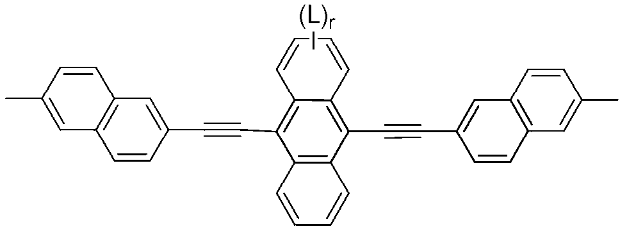

T15

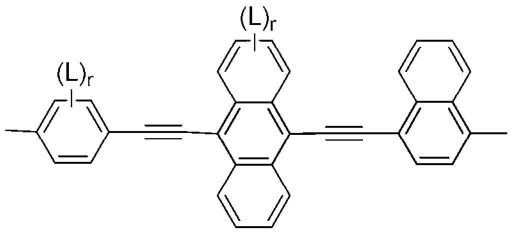

T16

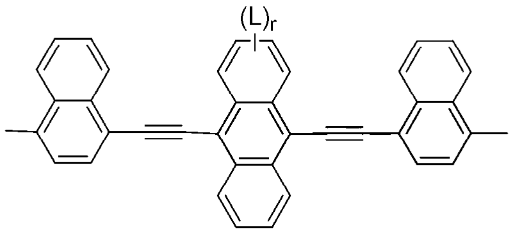

T17

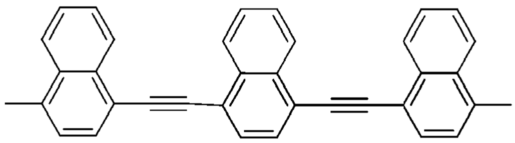

T18

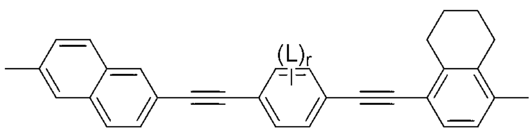

T19

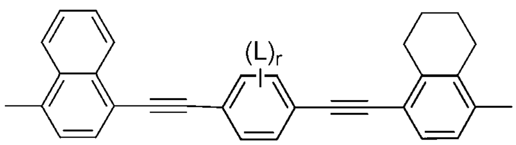

T20

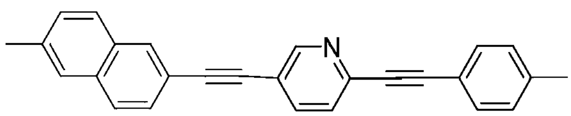

T21

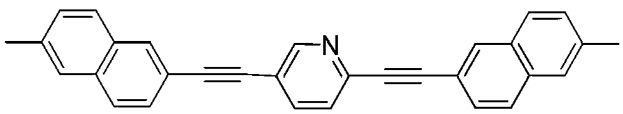

T22

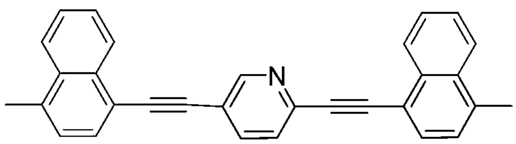

T23

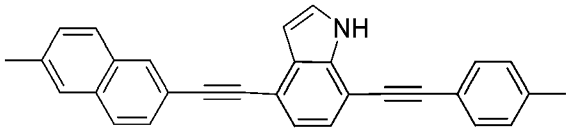

T24

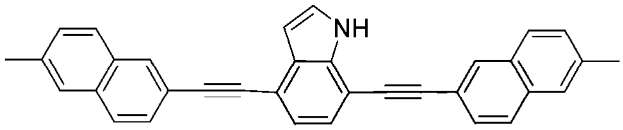

T25

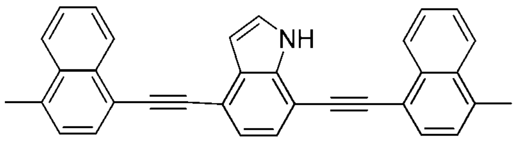

T26

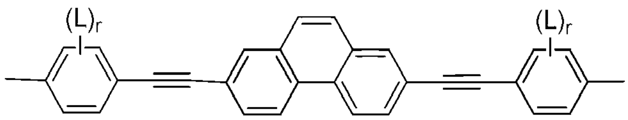

T27

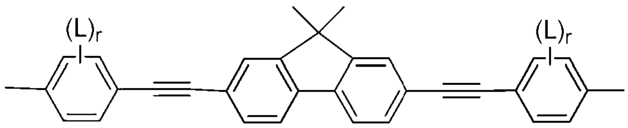

T28

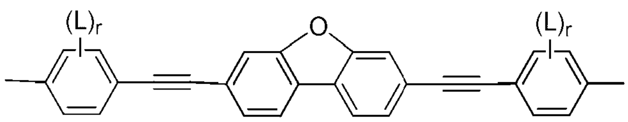

T29

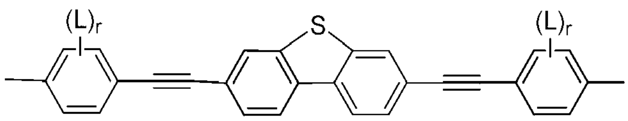

T30

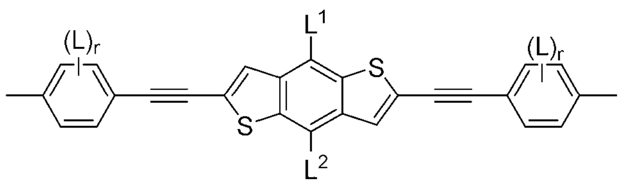

T31

wherein the naphthalene and phenanthrene groups are optionally substituted with one or two groups L, and L and r are as defined in formula T.

In formulae TM1 to TM28, preferably L on each occurrence identically or differently denotes P-Sp-, -CN, F, Cl, or alkyl, alkoxy or thioalkyl which is optionally fluorinated and has 1 to 6, preferably 1 to 3, more preferably 1 or 2 C atoms, very preferably P-Sp-, methyl, ethyl, methoxy, ethoxy, thiomethyl or thioethyl, most preferably methyl or ethyl, and r is preferably 0, 1, 2 or 3, very preferably 0, 1 or 2.

Very preferred are the groups of formulae TM01 to TM10, especially the groups of formula TM01 to TM07.

Very preferred compounds of formula T are selected from the following subformulae:

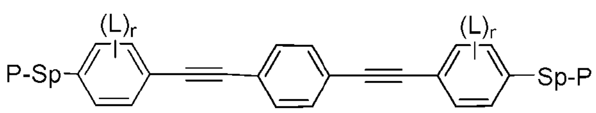

T-1

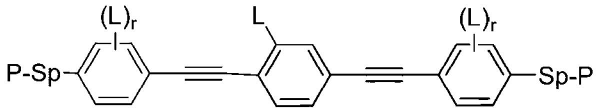

T-2

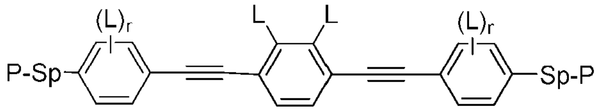

T-3

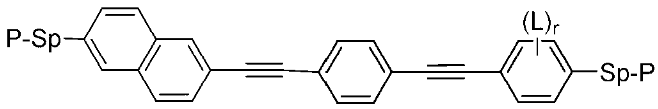

T-4

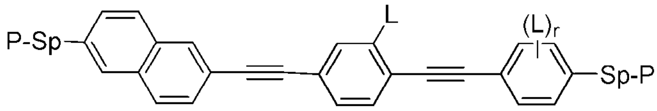

T-5

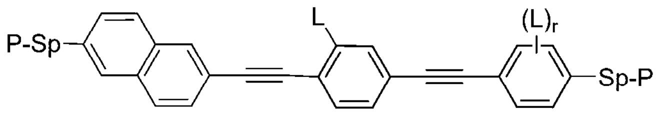

T-6

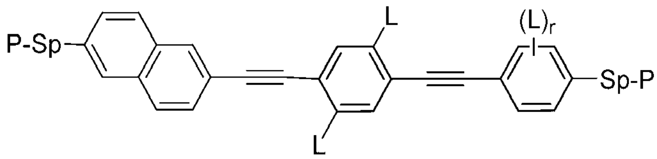

T-7

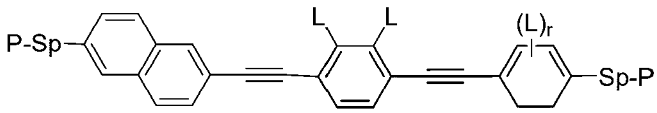

T-8

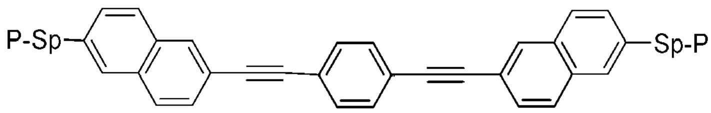

T-9

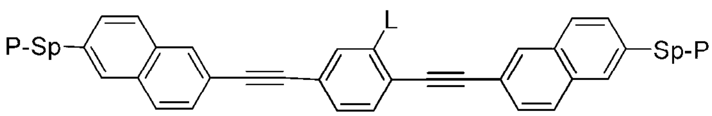

T-10

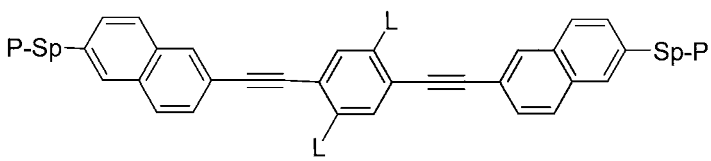

T-11

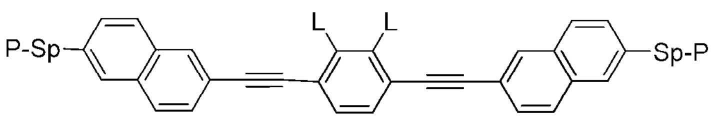

T-12

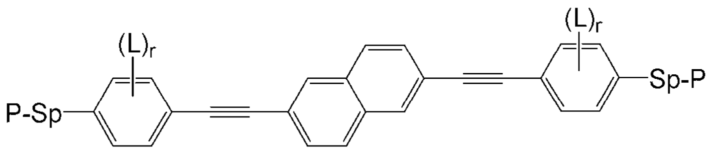

T-13

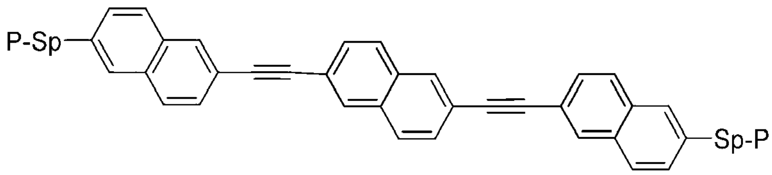

T-14

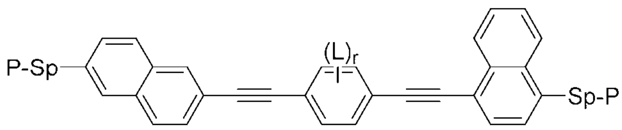

T-15

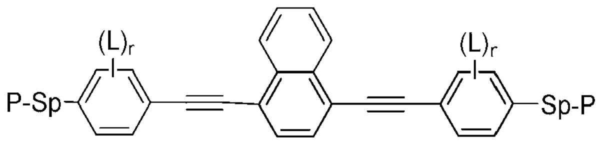

T-16

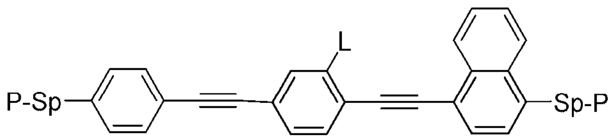

T-17

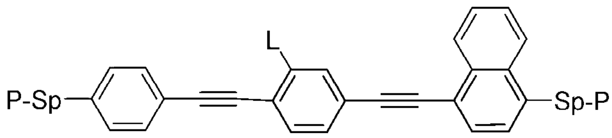

T-18

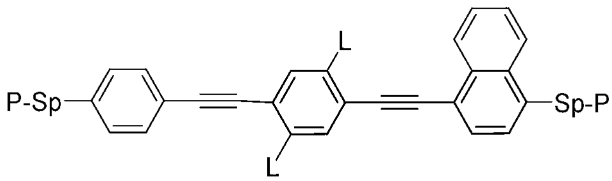

T-19

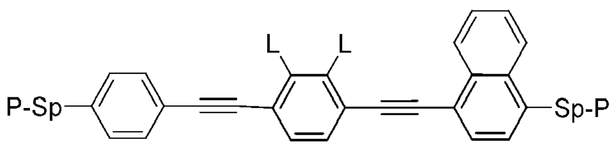

T-20

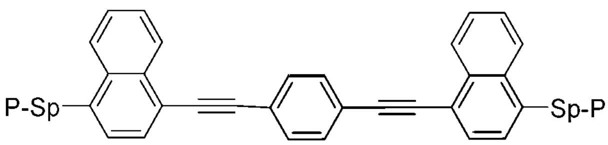

T-21

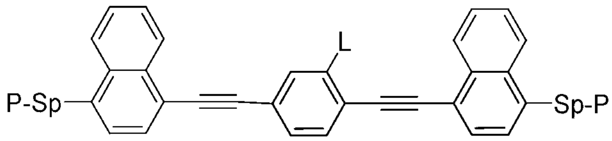

T-22

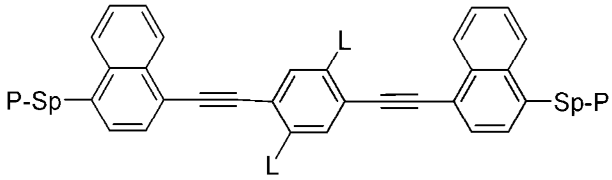

T-23

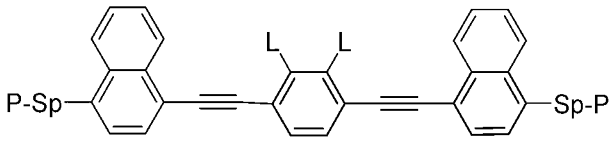

T-24

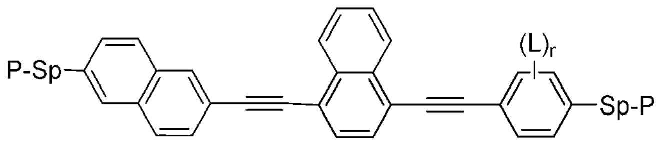

T-25

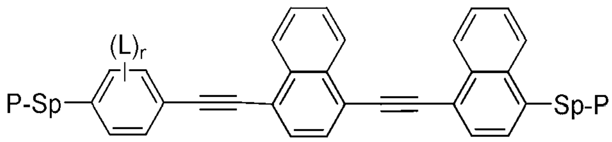

T-26

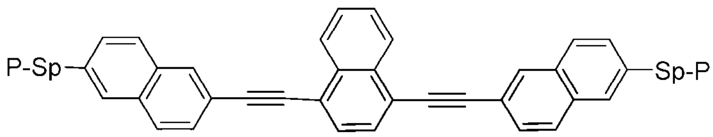

T-27

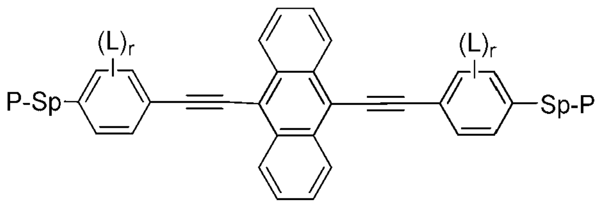

T-28

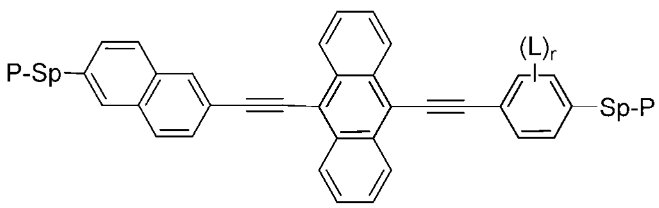

T-29

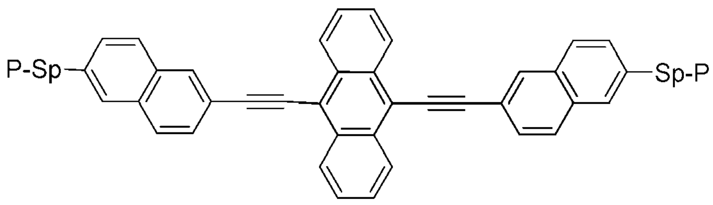

T-30

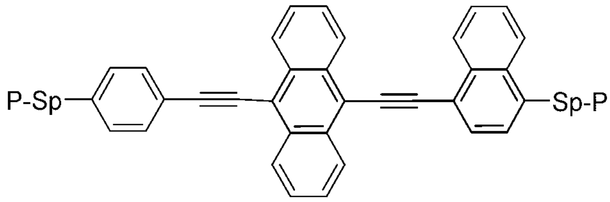

T-31

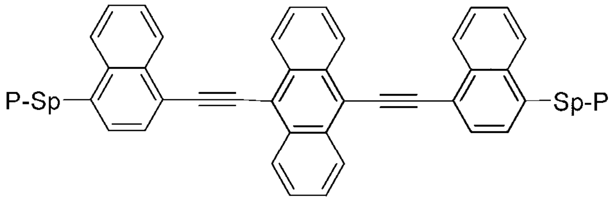

T-32

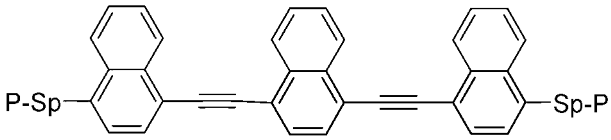

T-33

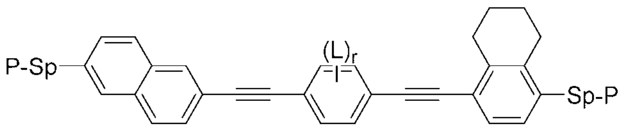

T-34

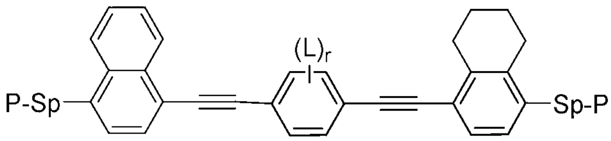

T-35

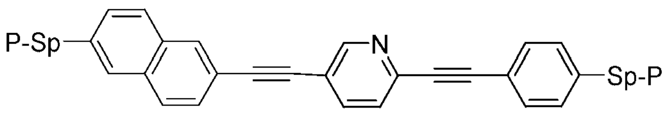

T-36

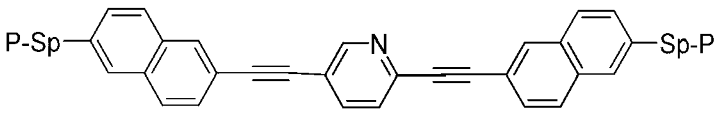

T-37

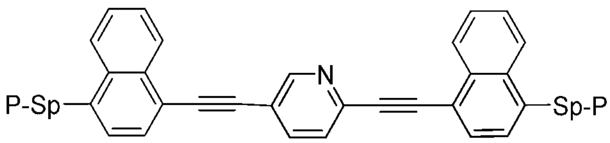

T-38

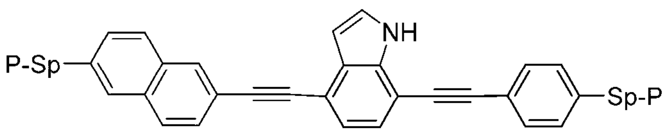

T-39

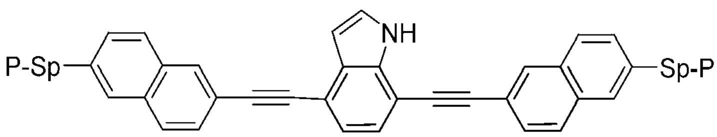

T-40

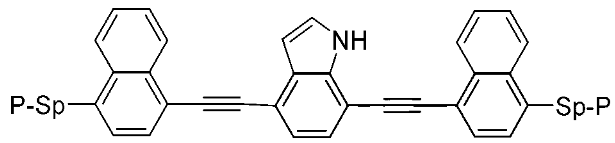

T-41

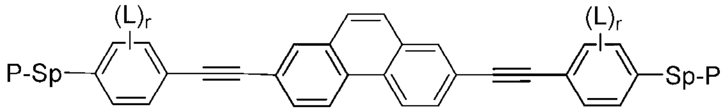

T-42

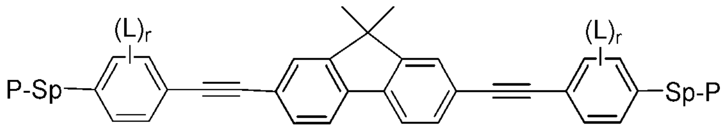

T-43

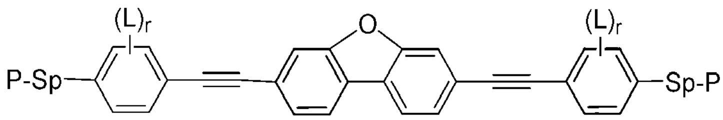

T-44

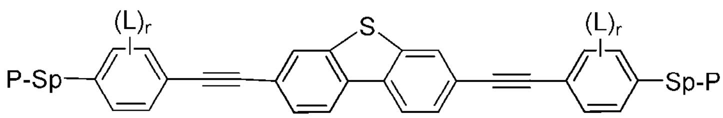

T-45

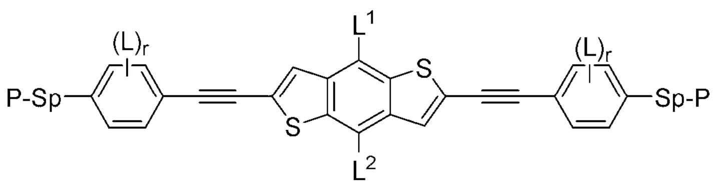

T-46

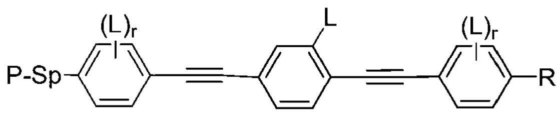

T-47

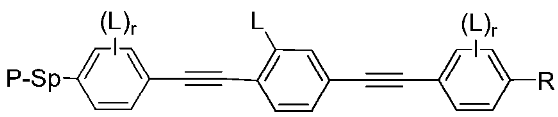

T-48

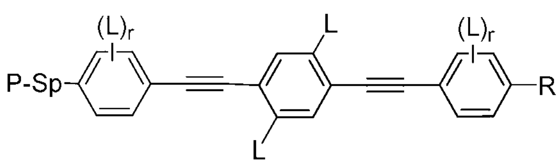

T-49

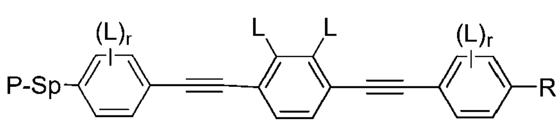

T-50

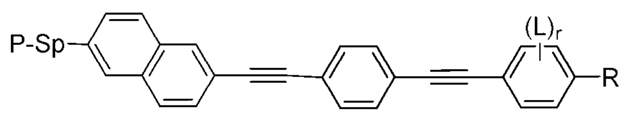

T-51

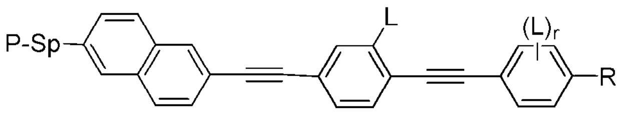

T-52

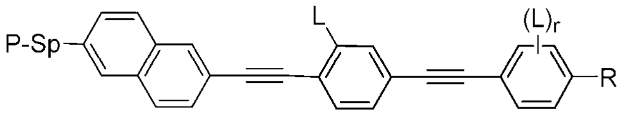

T-53

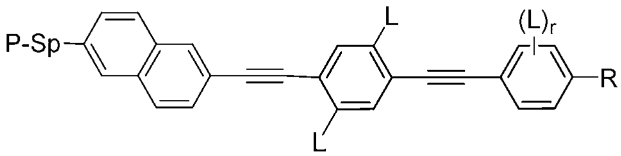

T-54

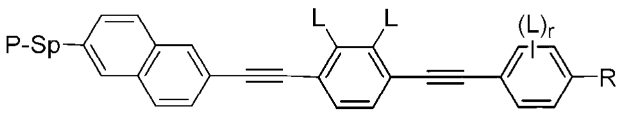

T-55

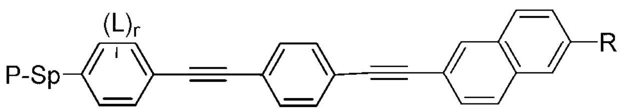

T-56

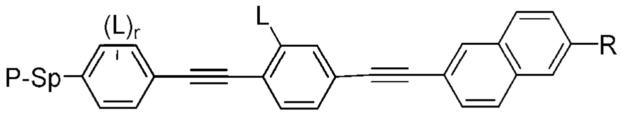

T-57

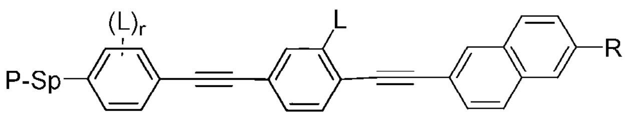

T-58

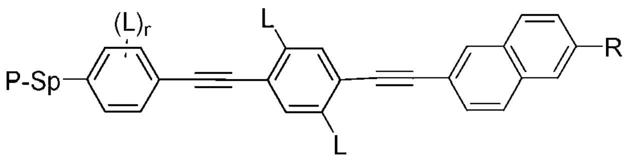

T-59

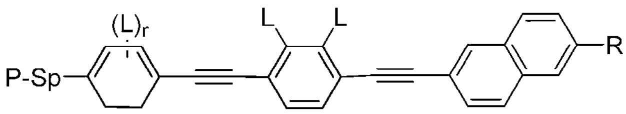

T-60

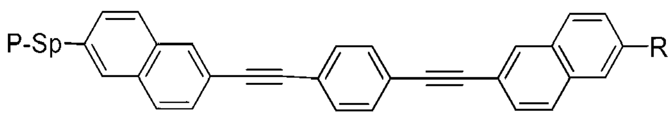

T-61

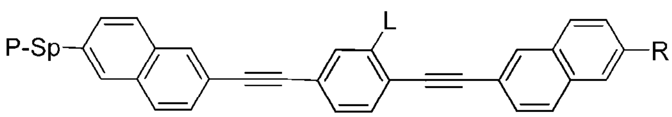

T-62

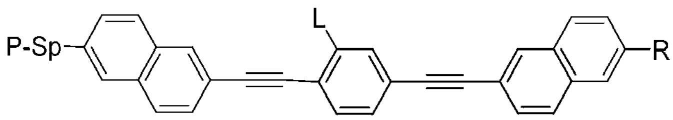

T-63

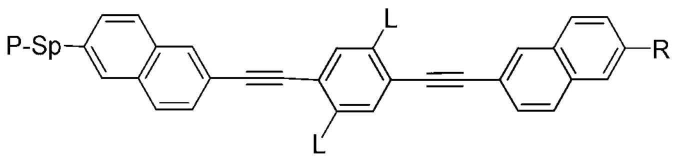

T-64

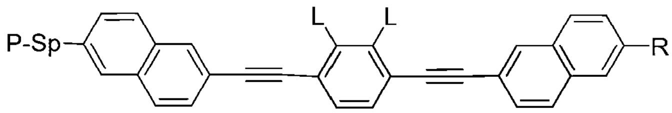

T-65

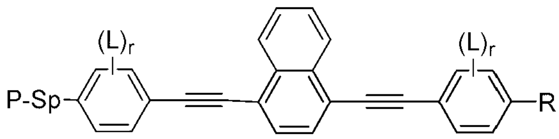

T-66

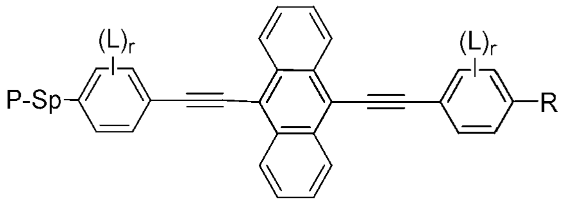

T-67

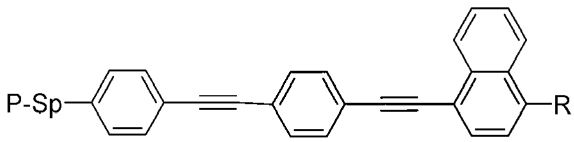

T-68

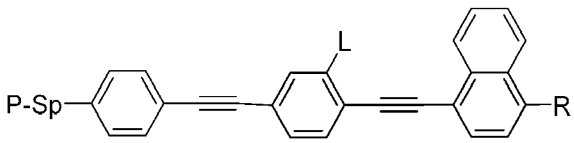

T-69

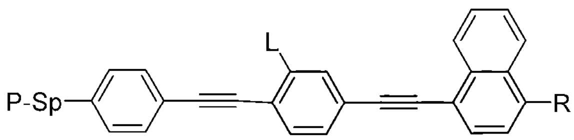

T-70

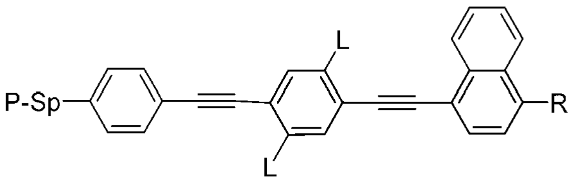

T-71

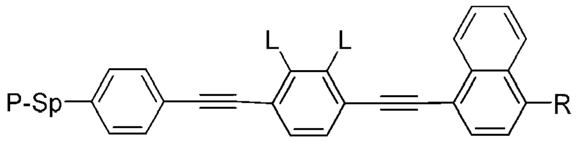

T-72

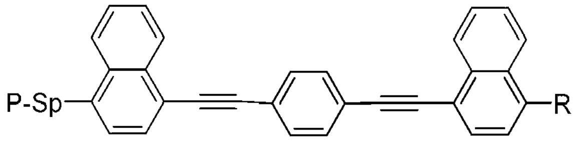

T-73

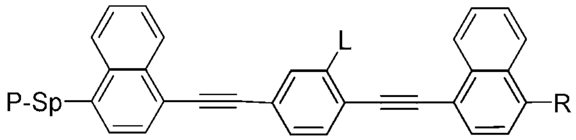

T-74

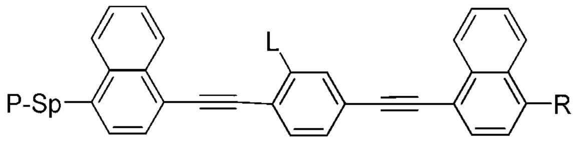

T-75

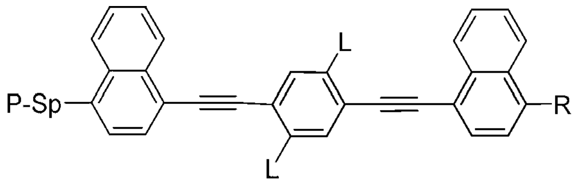

T-76

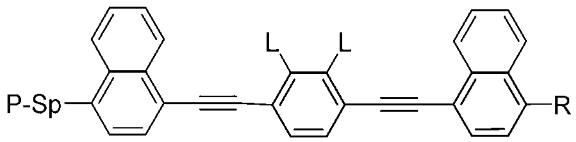

T-77

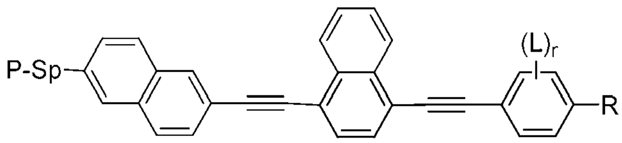

T-78

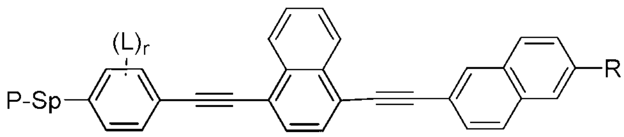

T-79

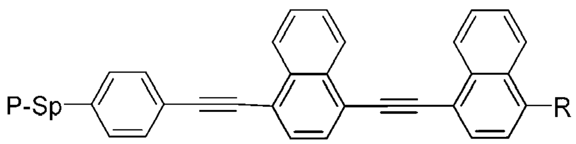

T-80

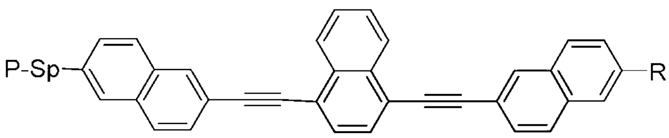

T-81

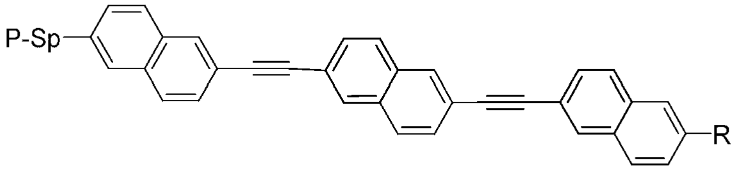
T-82

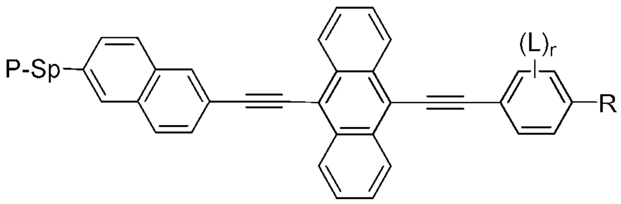
T-83

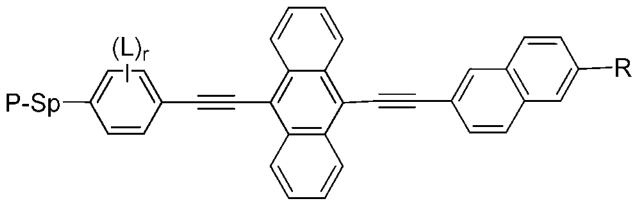
T-84

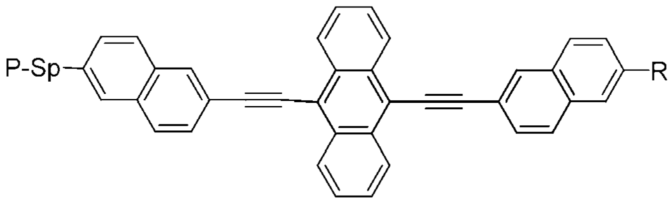
T-85

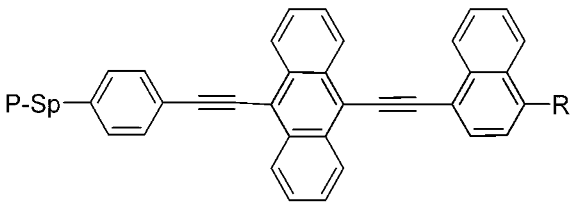
T-86

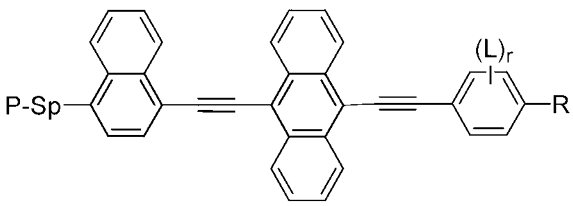
T-87

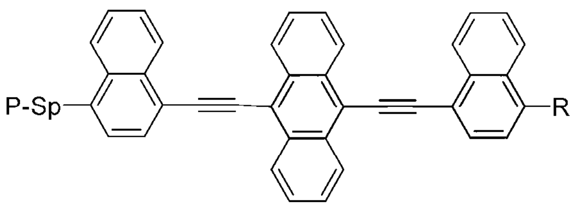
T-88

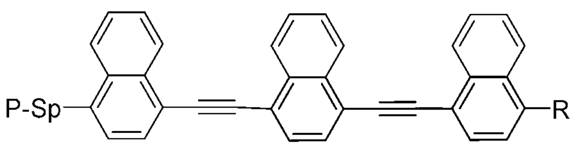
T-89

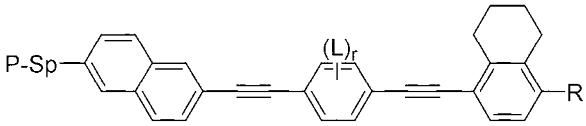

T-90

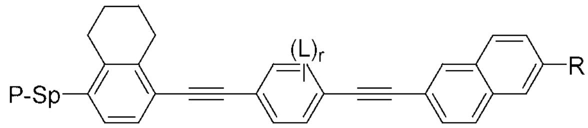

T-91

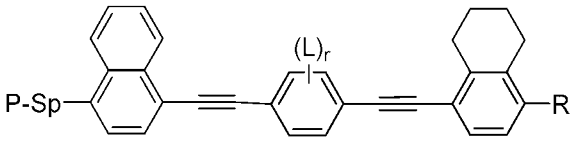

T-92

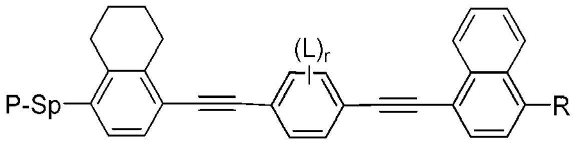

T-93

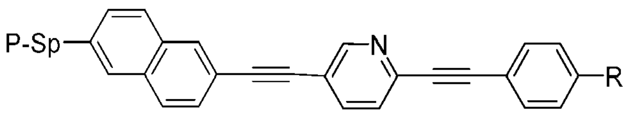

T-94

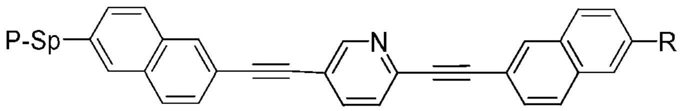

T-95

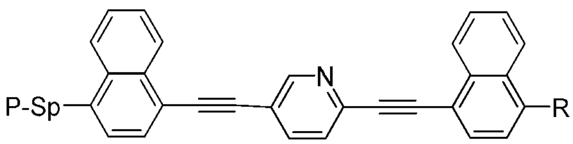

T-96

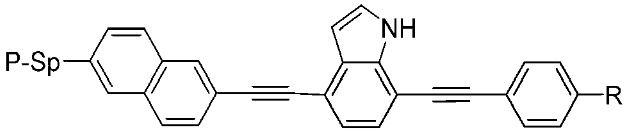

T-97

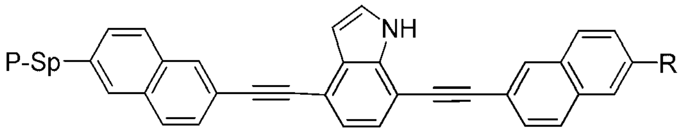

T-98

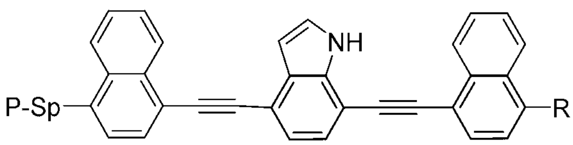

T-99

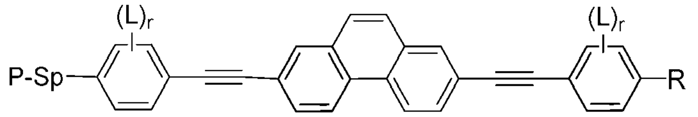

T-100

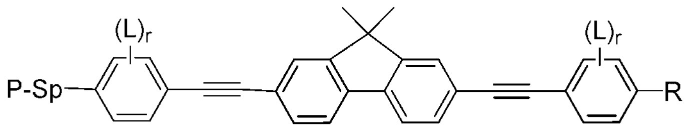

T-101

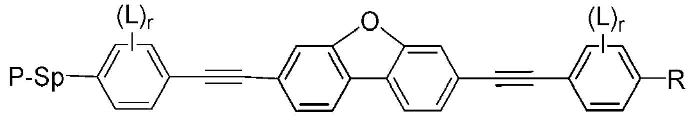

T-102

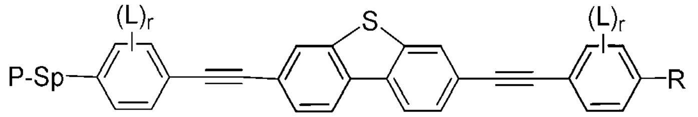

T-103

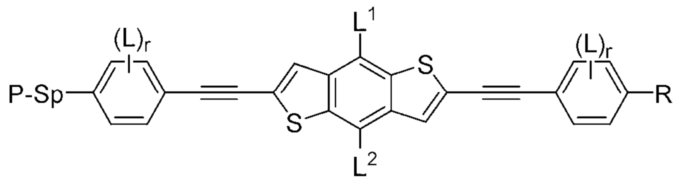

T-104

wherein the naphthalene and phenanthrene groups are optionally substituted with one or two groups L, and P, Sp, L and r, independently of each other and on each occurrence identically or differently, have the meanings given in formula T or one of the preferred meanings given above and below, and R has one of the meanings given for $R^{11}$ in formula T, and preferably denotes $OCH_3$ or $SCH_3$, very preferably $OCH_3$. L is preferably selected from alkyl, alkoxy or thioalkyl having 1 to 6, more preferably 1, 2 or 3 C atoms, very preferably from methyl or ethyl. P is preferably acrylate.

Very preferred are the compounds of formulae T-1 to T-20, especially the compounds of formulae T-1 to T-16.

In another preferred embodiment of the present invention, the chiral RM mixture contains one or more RMs of formula T which contain a -C≡C- group (acetylene group) in the spacer, preferably a -C≡C- group that is directly attached to an outer benzene or naphthalene group of the mesogenic core. These RMs are preferably selected from formula A:

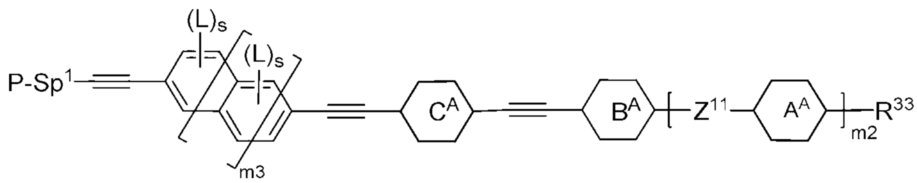

A

wherein the individual radicals, independently of each other and on each occurrence identically or differently, have the following meanings

| | |
|---|---|
| P | a polymerizable group, |
| Sp | a spacer group or a single bond, |
| $Sp^1$ | a spacer group or a single bond, preferably alkylene with 1 to 12, more preferably with 3 to 6, C atoms, |
| $R^{33}$ | H, F, Cl, CN, $CH=CH_2$, alkyl, alkoxy, thioalkyl, alkylcarbonyl, alkoxycarbonyl, alkylcarbonyloxy or alkoxycarbonyloxy with 1 to 6, preferably with 1 to 3, C atoms which is optionally fluorinated or chlorinated, or P-Sp, |
| $A^A$, $B^A$ | phenylene-1,4-diyl, naphthalene-1,4-diyl, naphthalene-2,6-diyl, fluorene-2,7-diyl, dibenzothiophene-2,7-diyl, dibenzofuran-2,7-diyl, benzo[1,2-b:4,5-b']dithiophene-2,5-diyl, indole-4,7-diyl, benzothiophene-4,7-diyl, |

9,10-dihydro-phenanthrene-2,7-diyl or 1,2,3,4-tetrahydronaphthalene-5,8-diyl where, in addition, one or more CH groups in these groups may be replaced by N, all of which are optionally substituted by one or more groups L or P-Sp-.

$C^A$ phenylene-1,4-diyl, naphthalene-1,4-diyl, or naphthalene-2,6-diyl, preferably phenylene-1,4-diyl or naphthalene-2,6-diyl, in which, in addition, one or more CH groups in these groups may be replaced by N, and which are optionally substituted by one or more groups L or P-Sp-, wherein preferably not more than one of $A^A$, $B^A$ and $C^A$ denote naphthalene-1,4-diyl,

L F, Cl, -CN, -SCN, P-Sp-, or straight chain, branched or cyclic alkyl having 1 to 25 C atoms, wherein one or more non-adjacent $CH_2$-groups are optionally replaced by -O-, -S-, -CO-, -CO-O-, -O-CO-, -O-CO-O-, $CR^0$=$CR^{00}$-, -C≡C-,

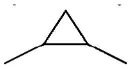 , 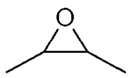 , 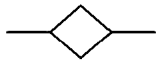 , 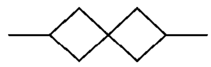 ,

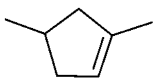 , or 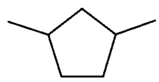 ,

in such a manner that O- and/or S-atoms are not directly connected with each other, and wherein one or more H atoms are each optionally replaced by P-Sp-, F or Cl, or two substituents L that are connected to directly adjacent C atoms may also form a cycloalkyl or cycloalkenyl group with 5, 6, 7 or 8 C atoms,

$Z^{11}$ -O-, -S-, -CO-, -COO-, -OCO-, -S-CO-, -CO-S-, -O-COO-, -CO-$NR^0$-, -$NR^0$-CO-, -$NR^0$-CO-$NR^{00}$, -$NR^0$-CO-O-, -O-CO-$NR^0$-, -$OCH_2$-, -$CH_2O$-, -$SCH_2$-, -$CH_2S$-, - $CF_2O$-, -$OCF_2$-, -$CF_2S$-, -$SCF_2$-, -$CH_2CH_2$-, -$(CH_2)_{n1}$, -$CF_2CH_2$-, -$CH_2CF_2$-, - $CF_2CF_2$-, -CH=N-, -N=CH-, -N=N-, -CH=$CR^0$-, -$CY^1$=$CY^2$-, -C≡C-, -CH=CH-COO-, -OCO-CH=CH- or a single bond, preferably -COO-, -OCO-, -C≡C-, or a single bond, most preferably a single bond,

$R^0$, $R^{00}$ H or alkyl having 1 to 12 C atoms,

$Y^1$, $Y^2$ H, F, Cl, NCS, or CN,

m2 0, 1, 2, 3 or 4, preferably 0, 1 or 2, more preferably 0 or 1, most preferably 0,

m3 0 or 1,

n1 1, 2, 3 or 4,

s 0, 1, 2 or 3, preferably 0, 1 or 2.

The RMs of formula A show a very high extraordinary refractive index $n_e$ and a very high birefringence. Moreover, their maximum absorbance peak is shifted towards lower wavelengths, with a steepened pitch of the UV absorbance curve, which results in less coloring of the RMs and polymer films made thereof.

In the compounds of formula A, preferably $A^A$ and $B^A$ are selected from the group consisting of

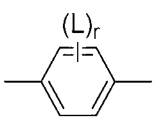 , 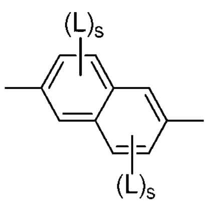 , 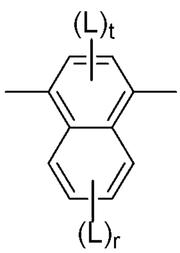 , 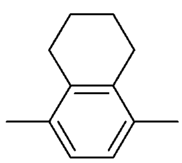 , 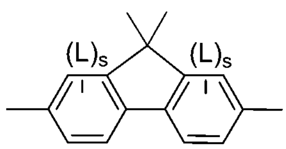 ,

wherein at least one of $A^A$ and $B^A$ is selected from phenylene-1,4-diyl and napththalene-2,6-diyl, and wherein the individual radicals, independently of each other and on each occurrence identically or differently, have the following meanings

L P-Sp-, -CN, F, Cl, or alkyl, alkoxy or thioalkyl which is optionally fluorinated and has 1 to 6, preferably 1 to 3, more preferably 1 or 2 C atoms, preferably P-Sp-, - CN, F, Cl, $OCH_3$, $SCH_3$, $C_2H_5$, $OC_2H_5$, $SC_2H_5$, CHO, $COCH_3$, $COOCH_3$ or COOH,

r 0, 1, 2, 3 or 4, preferably 0, 1 or 2,

s 0, 1, 2 or 3, preferably 0 or 1,

t 0, 1 or 2, preferably 0 or 1.

More preferably rings $A^A$ and $B^A$ in formula A are selected from the group consisting of phenylene-1,4-diyl, naphthalene-1,4-diyl and naphthalene 2,6-diyl, all of which are optionally substituted by one or more groups L and/or P-Sp-, wherein not more than one of A and B may denote naphthalene-1,4-diyl.

Very preferably one, two, three, four or more of rings $A^A$ and $B^A$ in formula A are selected from the group consisting of

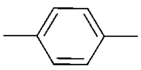 , 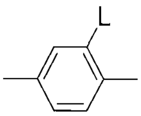 , 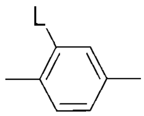 , 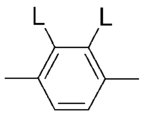 , 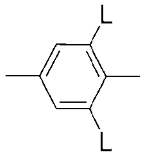 , 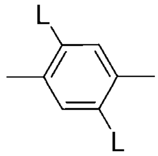 ,

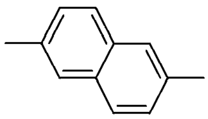 and 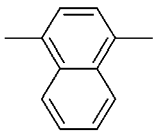 ,

wherein not more than one of $A^A$ and $B^A$ may denote naphthalene-1,4-diyl and wherein L, on each occurrence identically or differently, denotes P-Sp-, -CN, F, Cl, or alkyl, alkoxy or thioalkyl which is optionally fluorinated and has 1 to 6, preferably 1 to 3, more preferably 1 or 2 C atoms, preferably P-Sp-, F, Cl, CN, $CH_3$, $OCH_3$, $SCH_3$, $C_2H_5$, $OC_2H_5$ or $SC_2H_5$.

Especially preferred are compounds of formula A, in particular wherein n=m=0, wherein the ring $B^A$ is selected from the group consisting of phenylene-1,4-diyl, naphthalene-1,4-diyl and naphthalene-2,6-diyl, preferably phenylene-1,4-diyl, naphthalene-1,4-diyl and naphthalene-2,6-diyl, all of which are optionally mono- or disubstituted by L and/or P-Sp-.

Preferably ring $C^A$ in formula A is selected from the group consisting of

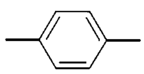 , 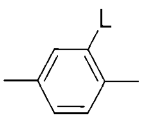 , 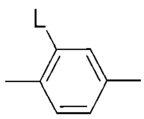 , 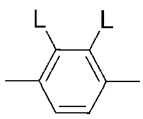 , 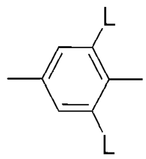 , 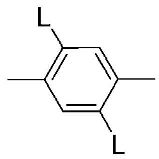

and

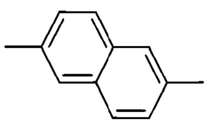 ,

wherein L, on each occurrence identically or differently, denotes P-Sp-, -CN, F, Cl, or alkyl, alkoxy or thioalkyl which is optionally fluorinated and has 1 to 6, preferably 1 to 3, more preferably 1 or 2 C atoms, preferably P-Sp-, F, Cl, CN, $CH_3$, $OCH_3$, $SCH_3$, $C_2H_5$, $OC_2H_5$ or $SC_2H_5$.

Further preferred are compounds of formula A wherein m=1 and/or at least one of rings $B^A$ and $C^A$ denotes naphthalene-2,6-diyl.

Further preferred are compounds of formula A wherein m=0, preferably those wherein n=0, wherein rings $B^A$ and $C^A$ together with the phenylene-1,4-diyl group form a group selected from the following formulae or their mirror images, wherein * denotes the linkage to the acetylene group in formula A:

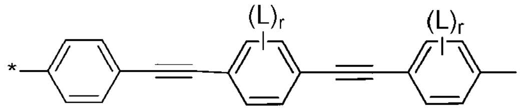

AM01

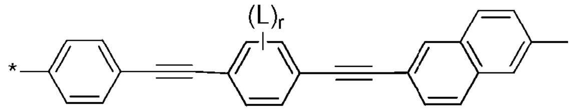

AM02

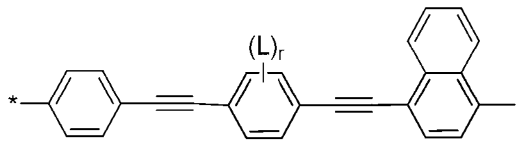

AM03

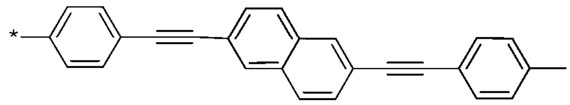

AM04

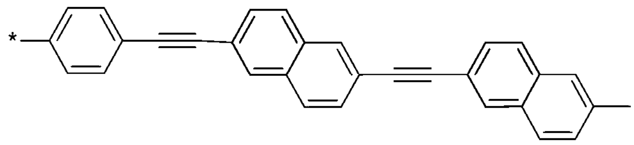

AM05

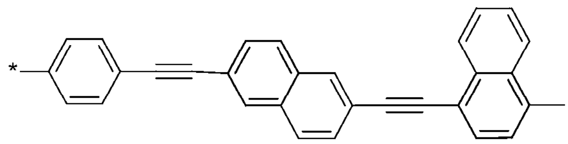

AM06

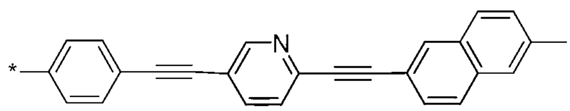

AM07

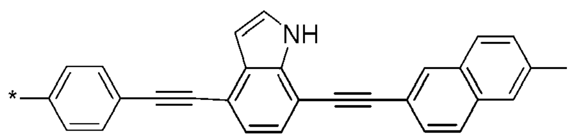

AM08

wherein the naphthalene groups are optionally substituted with one or two groups L, r is 0, 1, 2, 3 or 4, preferably 0, 1 or 2, and L is as defined in formula A.

Further preferred are compounds of formula A wherein m=1, preferably those wherein n=0, wherein rings $B^A$ and $C^A$ together with the naphthalene-2,6-diyl group form a group selected from the following formulae or their mirror images, wherein * denotes the linkage to the acetylene group in formula A:

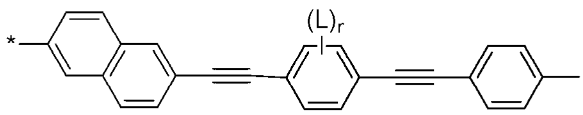

AM1

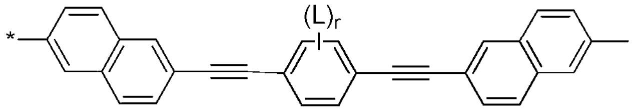

AM2

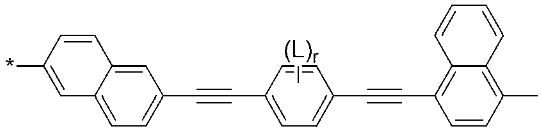

AM3

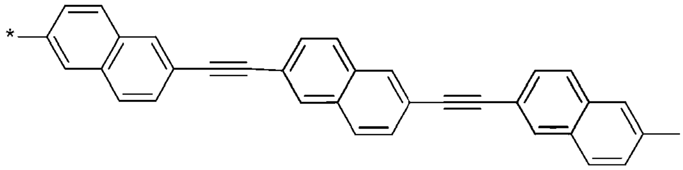

AM4

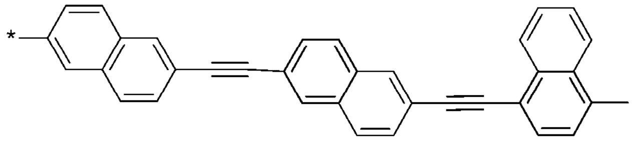

AM5

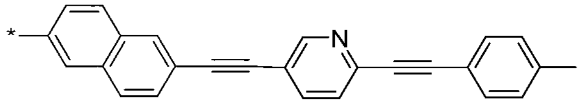

AM6

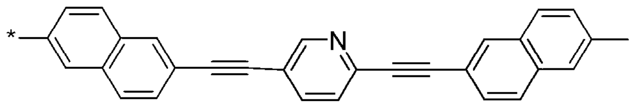

AM7

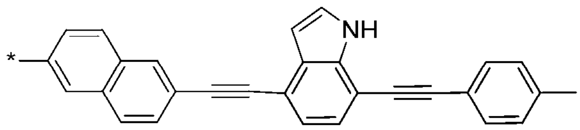

AM8

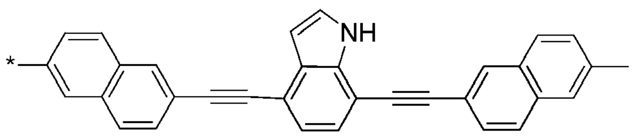

AM9

wherein the naphthalene groups are optionally substituted with one or two groups L, r is 0, 1, 2, 3 or 4, preferably 0, 1 or 2, and L is as defined in formula A.

In formulae AM01 to AM08 and AM1 to AM9, preferably L on each occurrence identically or differently denotes P-Sp-, -CN, F, Cl, or alkyl, alkoxy or thioalkyl which is optionally fluorinated and has 1 to 6, preferably 1 to 3, more preferably 1 or 2 C atoms, very preferably P-Sp-, F, Cl, CN, $CH_3$, $OCH_3$, $SCH_3$, $C_2H_5$, $OC_2H_5$ or $SC_2H_5$, most preferably $CH_3$ or $C_2H_5$, and r is preferably 0, 1, 2 or 3, very preferably 0, 1 or 2.

Especially preferred are the groups of formulae AM01, AM02, AM03, AM04, AM1, AM2 and AM3.

Very preferred compounds of formula A are selected from the following subformulae:

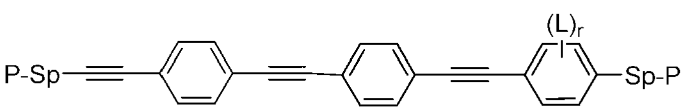

A-1

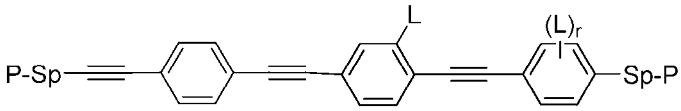

A-2

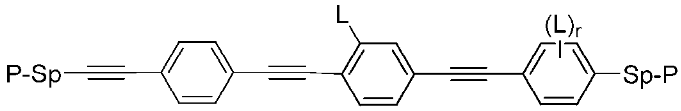

A-3

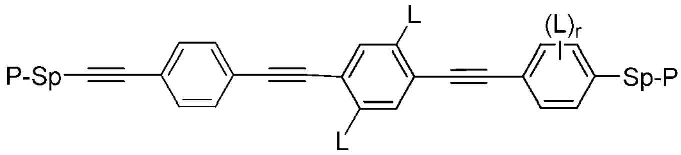

A-4

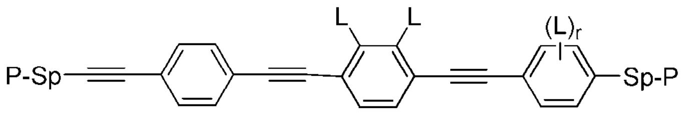

A-5

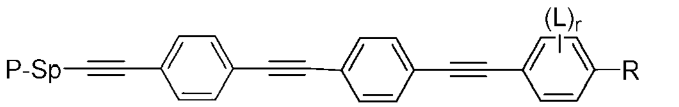

A-6

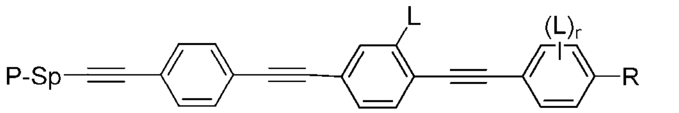

A-7

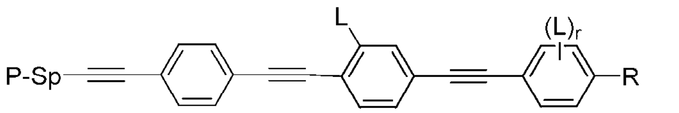

A-8

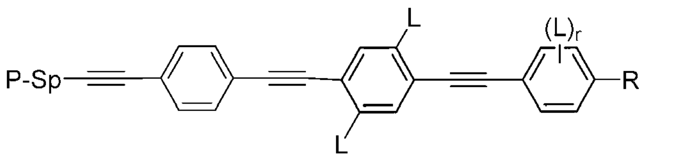

A-9

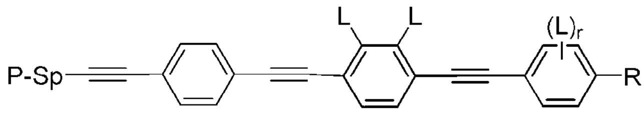

A-10

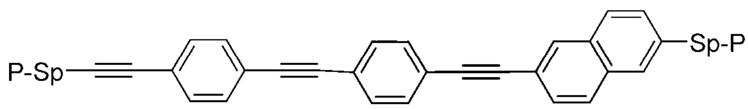

A-11

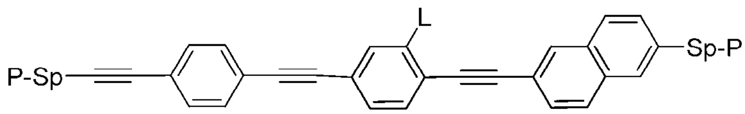

A-12

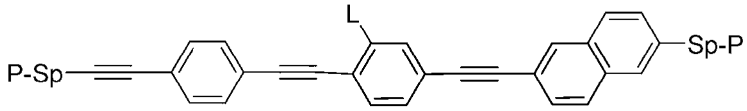

A-13

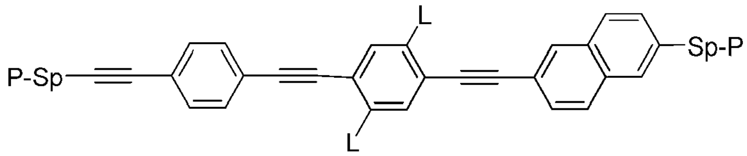

A-14

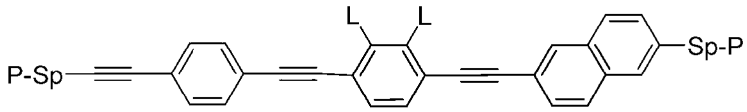

A-15

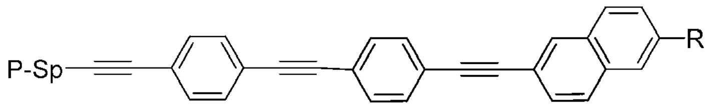

A-16

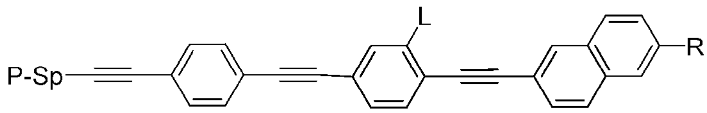

A-17

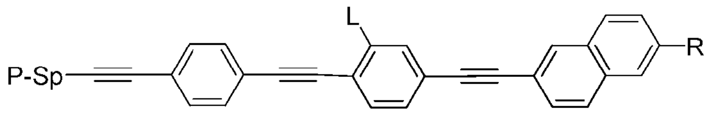

A-18

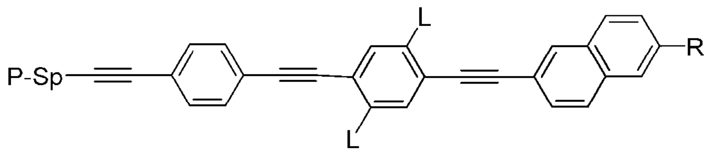

A-19

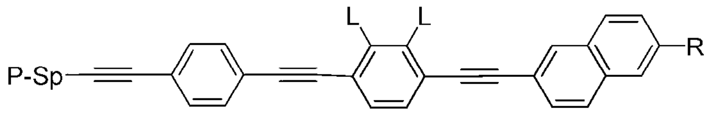

A-20

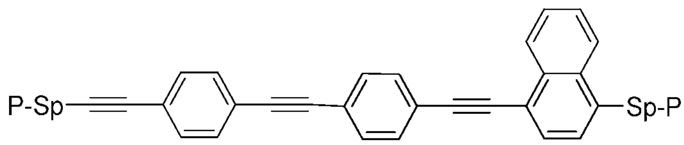

A-21

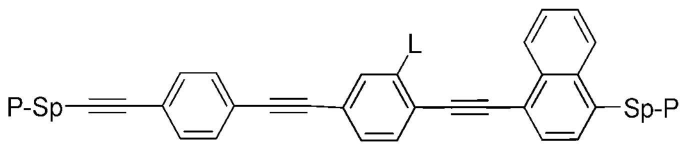

A-22

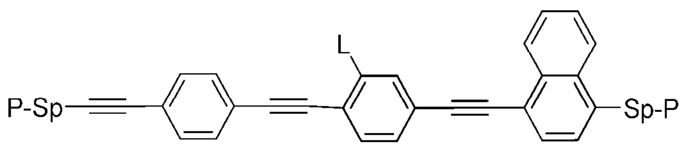

A-23

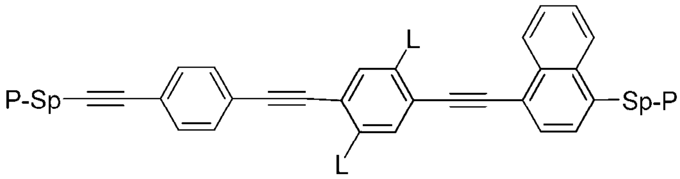

A-24

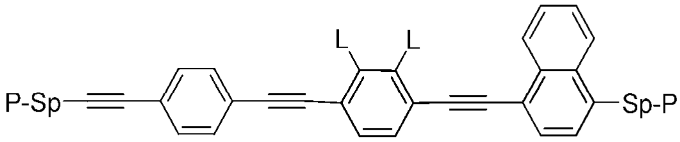

A-25

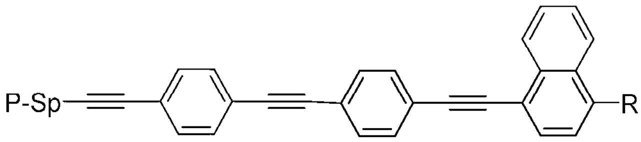

A-26

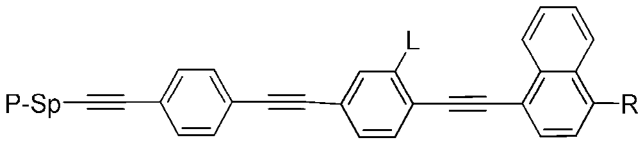

A-27

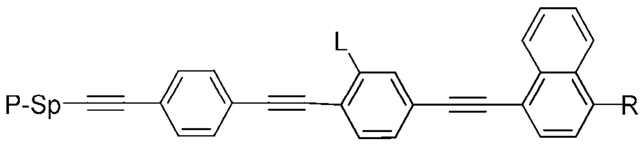

A-28

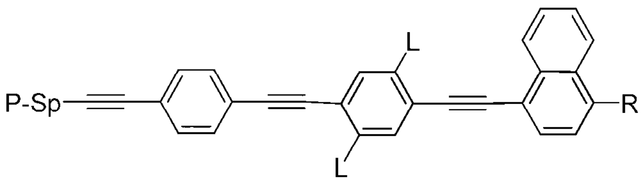

A-29

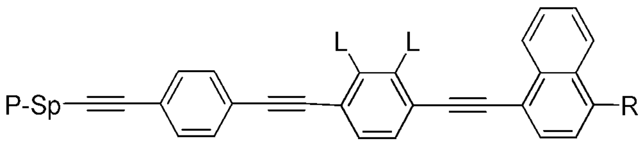

A-30

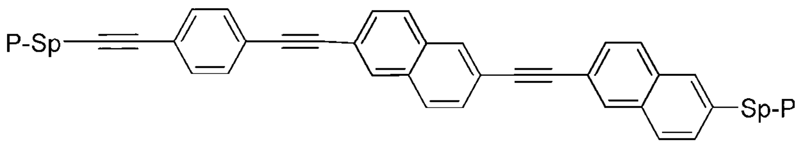

A-31

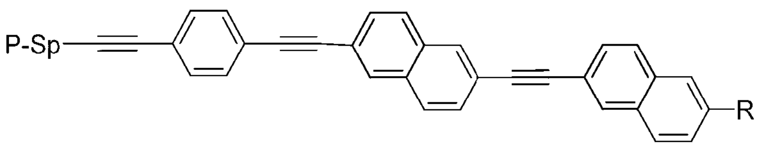

A-32

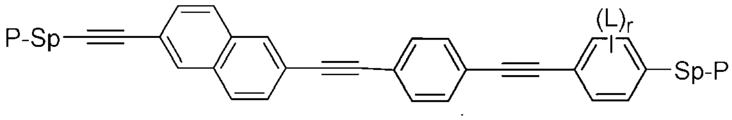

A-33

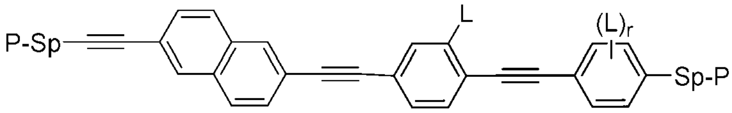

A-34

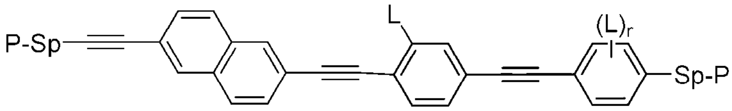

A-35

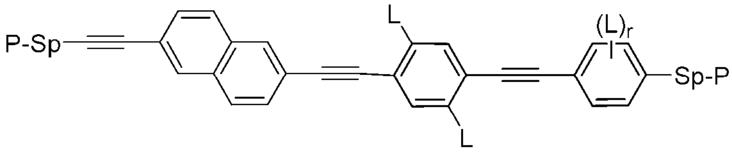

A-36

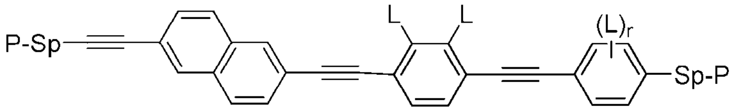

A-37

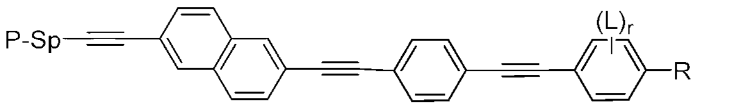

A-38

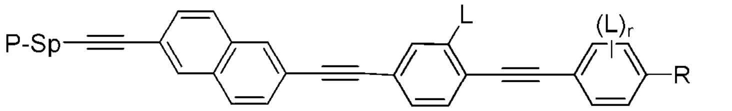

A-39

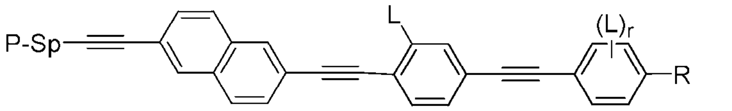

A-40

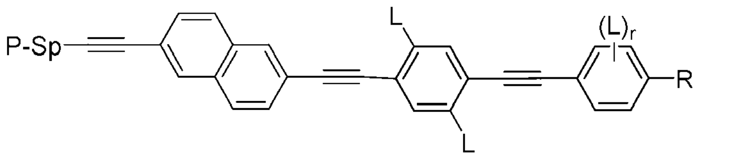

A-41

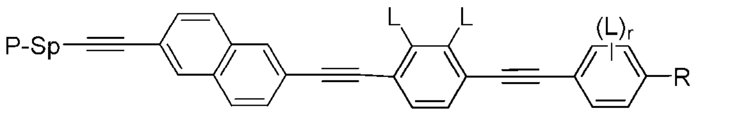

A-42

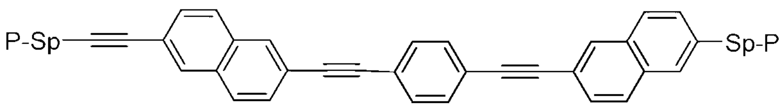

A-43

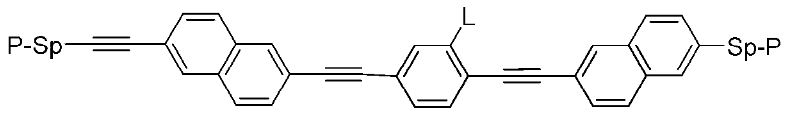

A-44

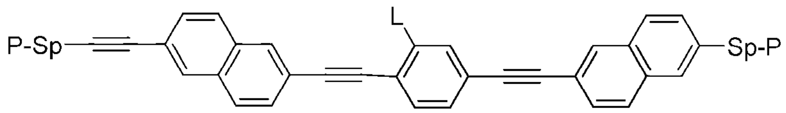

A-45

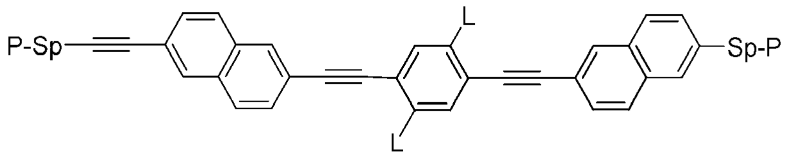

A-46

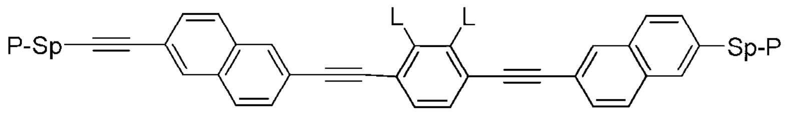

A-47

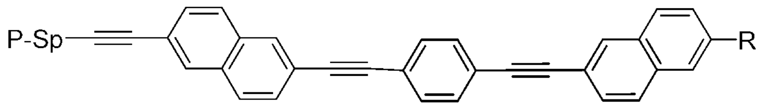

A-48

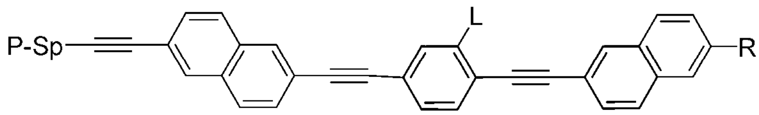

A-49

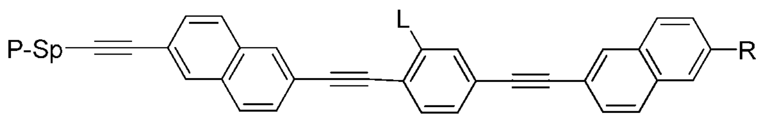

A-50

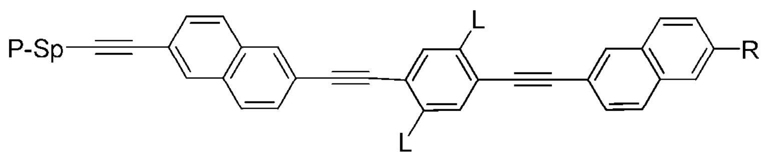

A-51

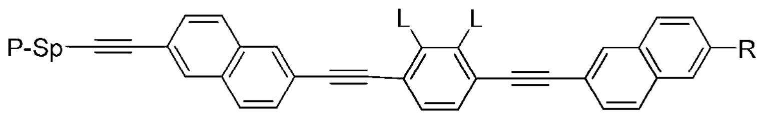

A-52

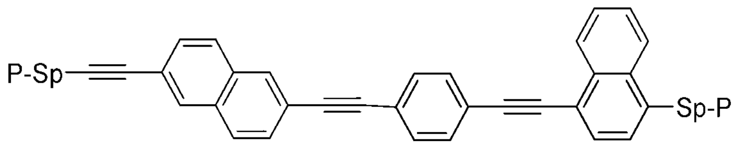

A-53

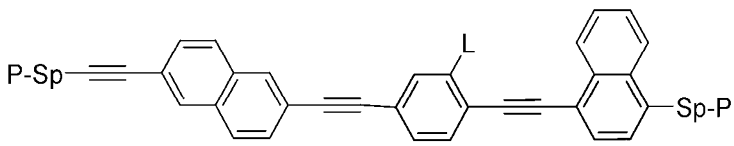

A-54

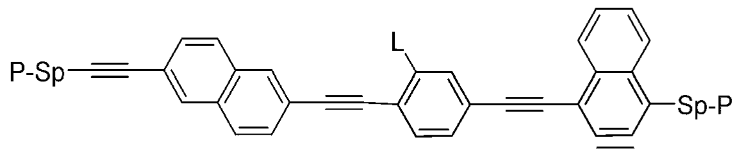

A-55

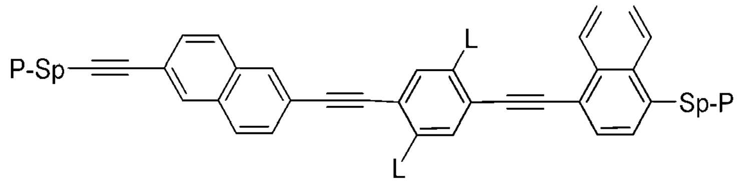

A-56

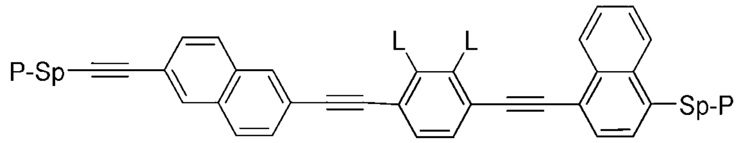

A-57

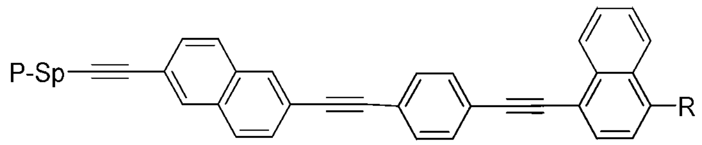

A-58

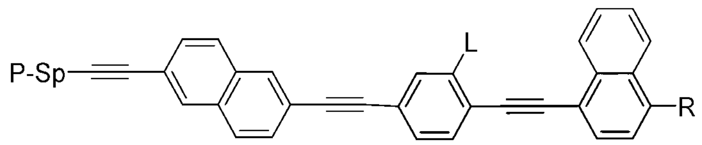

A-59

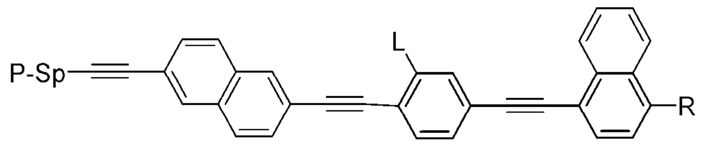

A-60

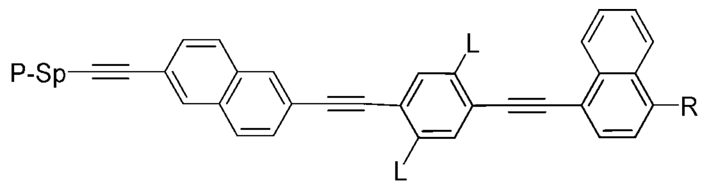

A-61

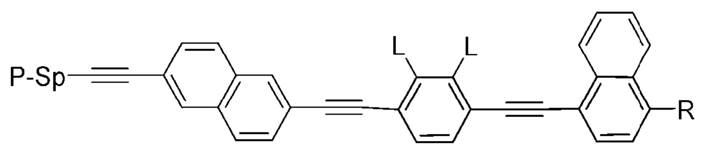

A-62

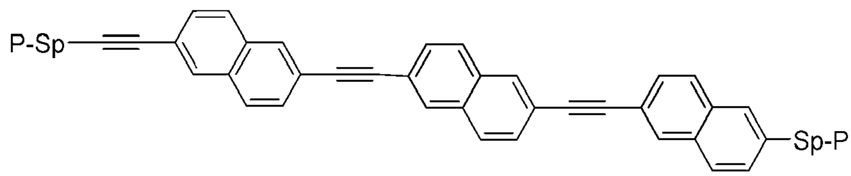

A-63

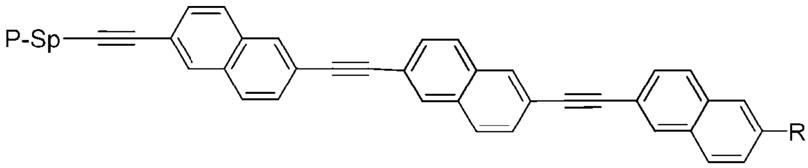

A-64

wherein the naphthalene groups are optionally substituted with one or two groups L, and P, Sp, L and r, independently of each other and on each occurrence identically or differently, have the meanings given above, and R has one of the meanings given for $R^{11}$ in formula A, and preferably denotes $OCH_3$ or $SCH_3$, very preferably $OCH_3$. L is preferably selected from F, Cl, CN, $CH_3$, $OCH_3$, $SCH_3$, $C_2H_5$, $OC_2H_5$ or $SC_2H_5$. P is preferably acrylate.

Further preferred are the direactive compounds of the formulae A and A-1 to A-64 wherein one of the two groups Sp is a single bond and the other group Sp is different from a single bond.

In the compounds of formula D, M, T, A and their subformulae as described above and below, P is preferably selected from the group consisting of vinyloxy, acrylate, methacrylate, fluoroacrylate, chloroacrylate, oxetane and epoxide, very preferably from acrylate and methacrylate, most preferably acrylate.

Further preferred are compounds of formula D, M, T, A and their subformulae as described above and below, wherein all polymerizable groups P that are present in the compound have the same meaning, and very preferably denote acrylate or methacrylate, most preferably acrylate.

Further preferred are compounds of formula D, M, T, A and their subformulae as described above and below, which contain one, two, three or four groups P-Sp, very preferably two or three groups P-Sp.

Further preferred are compounds of formula T, A and their subformulae as described above and below, wherein $R^{11}$ is P-Sp-.

Further preferred are compounds of formula M, T, A and their subformulae as described above and below, wherein $R^{22}$ or $R^{11}$, respectively, is selected from F, Cl, CN, $CF_3$, $CCl_3$, $CH{=}CH_2$, or alkoxy, thioalkyl, alkylcarbonyl, alkoxycarbonyl, alkylcarbonyloxy or alkoxycarbonyloxy with 1 to 3 C atoms which is optionally fluorinated, more preferably from F, Cl, CN, $OCH_3$, $SCH_3$, $OCF_3$, $CF_3$, $CH{=}CH_2$, CHO, $COCH_3$, $COOCH_3$, $COOC_2H_5$ and $CCl_3$, very preferably from $OCH_3$, $OCF_3$ or CHO, most preferably from $OCH_3$ or $OCF_3$.

Further preferred are compounds of formula D, M, T, A and their subformulae as described above and below, wherein $Sp^1$, and/or $Sp^2$ if present, denotes $-(CH_2)_{s1}-$, wherein s1 is an integer from 1 to 12, more preferably 3, 4, 5 or 6.

Further preferred are compounds of formula D, M, T, A and their subformulae as described above and below, wherein $Sp^1$, and/or $Sp^2$ if present, denotes a single bond or $-(CH_2)_{p1}-$, $-O-(CH_2)_{p1}-$, $-O-CO-(CH_2)_{p1}$, or $-CO-O-(CH_2)_{p1}$, wherein p1 is 2, 3, 4, 5 or 6, and, if Sp is $-O-(CH_2)_{p1}-$, $-O-CO-(CH_2)_{p1}$ or $-CO-O-(CH_2)_{p1}$ the O-atom or CO-group, respectively, is linked to the benzene ring.

Further preferred are compounds of formula D, M, T, A and their subformulae as described above and below, wherein $Sp^1$, and/or $Sp^2$ if present, is a single bond.

Further preferred are compounds of formula D, M, T, A and their subformulae as described above and below, wherein $Sp^1$, and/or $Sp^2$ if present, is different from a single bond.

Further preferred are compounds of formula D, M, T, A and their subformulae as described above and below, wherein m is 1.

Further preferred are compounds of formula T, A and their subformulae as described above and below, wherein at least one of B and C denotes naphthalene-2,6-diyl or naphthalene-1,4-diyl, very preferably naphthalene-2,6-diyl, which is optionally substituted by one or more groups L or P-Sp-.

Further preferred are compounds of formula T, A and their subformulae as described above and below, wherein L is P-Sp-, F, Cl, -CN, or straight chain, branched or cyclic alkyl having 1 to 25 C atoms, wherein one or more non-adjacent $CH_2$-groups are optionally replaced by -O-, -S-, -CO-, -CO-O-, -O-CO-, -O-CO-O-, $CR^0{=}CR^{00}$-, -C≡C-,

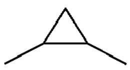 , 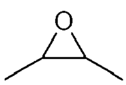 , 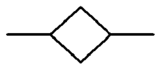 , 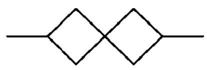 ,

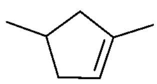 , or 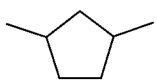 ,

in such a manner that O- and/or S-atoms are not directly connected with each other, and wherein one or more H atoms are each optionally replaced by P-Sp-, F or Cl, or two substituents L that are connected to directly adjacent C atoms may also form a cycloalkyl or cycloalkenyl group with 5, 6, 7 or 8 C atoms, and wherein $R^0$ and $R^{00}$ independently of each other denote H or alkyl with 1 to 12 C atoms.

Very preferred are compounds of formula T, A and their subformulae as described above and below, wherein L is F, Cl, CN or straight chain alkyl, alkoxy or thioalkyl having 1 to 6 C atoms or branched or cyclic alkyl, alkoxy or thioalkyl having 3 to 8 C atoms, most preferably F, Cl, CN, $CH_3$, $OCH_3$, $SCH_3$, $C_2H_5$, $OC_2H_5$ or $SC_2H_5$.

Further preferred are compounds of formula T, A and their subformulae as described above and below, wherein $Z^{11}$ and $Z^{12}$ denote -COO-, -OCO-, -C≡C- or a single bond, more preferably -C≡C- or a single bond, most preferably a single bond.

Further preferred compounds of the formulae T and A and their subformulae are selected from the following preferred embodiments, including any combination thereof:

- n = 0, and/or
- ring C or $C^A$, respectively, denotes phenylene-1,4-diyl which is substituted by alkyl, alkoxy or thioalkyl with 1 to 3, preferably 1 or 2 C atoms, more preferably methyl or ethyl, most preferably ethyl, or
- ring C or $C^A$, respectively, denotes naphthalene-2,6-diyl, which is optionally substituted by one or more groups L or P-Sp-, and/or
- ring B or $B^A$, respectively, denotes naphthalene-2,6-diyl, which is optionally substituted by one or more groups L or P-Sp-, and/or
- m=1 and/or at least one of B and C, or at least one of $B^A$ and $C^A$, respectively, denotes naphthalene-2,6-diyl, which is optionally substituted by one or more groups L or P-Sp-,
- m=0 and at least one of B and C, or at least one of $B^A$ and $C^A$, respectively, denotes naphthalene-2,6-diyl, which is optionally substituted by one or more groups L or P-Sp-,
- P denotes acrylate or methacrylate and/or
- $Sp^1$ denotes $-(CH_2)_{s1}-$, wherein s1 is an integer from 1 to 1, preferably 3, 4, 5 or 6, and/or
- Sp denotes Sp"-X", preferably, -Sp"-X"- denotes $-(CH_2)_{p1}-$, $-(CH_2)_{p1}-O-$, $-(CH_2)_{p1}-O-CO-$, $-(CH_2)_{p1}-CO-O-$, $-(CH_2)_{p1}-O-CO-O-$, $-(CH_2CH_2O)_{q1}-CH_2CH_2-$, $-CH_2CH_2-S-CH_2CH_2-$, or $-CH_2CH_2-NH-CH_2CH_2-$, in which p1 is an integer from 1 to 12, q1 is an integer from 1 to 3, and/or
- L is selected from P-Sp-, F, Cl, CN, $CH_3$, $OCH_3$, $SCH_3$, $C_2H_5$, $OC_2H_5$ or $SC_2H_5$, very preferably $CH_3$ or $C_2H_5$, and r denotes 1, and/or
- ring C is substituted by one L which denotes P-Sp-, preferably acrylate, and/or
- $R^{11}$ is P-Sp-, or
- $R^{11}$ is F, Cl, CN, $OCH_3$ or $SCH_3$, preferably $OCH_3$ or $SCH_3$, very preferably $OCH_3$.

Very preferred compounds of formula T are listed below:

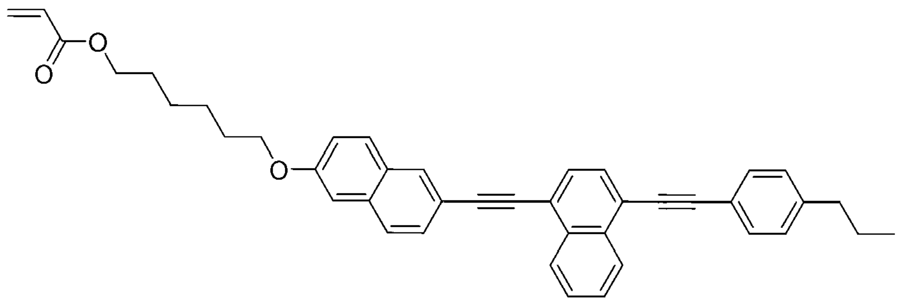

T1

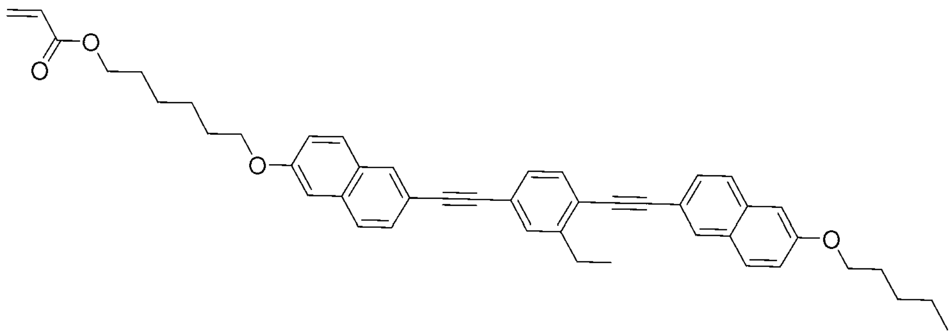

T2

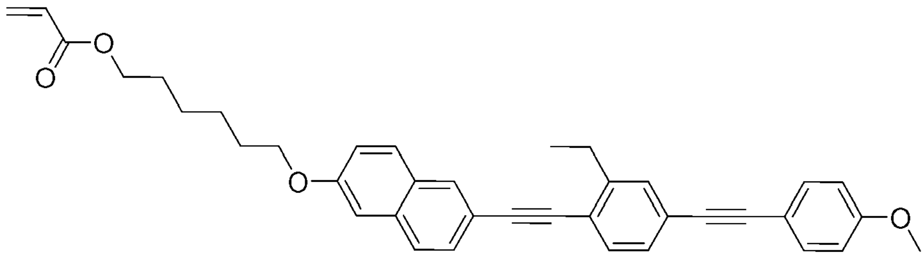

T3

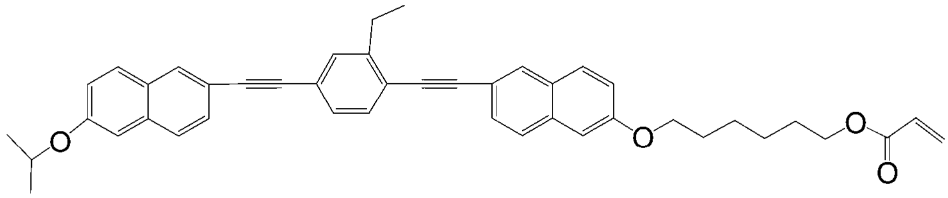

T4

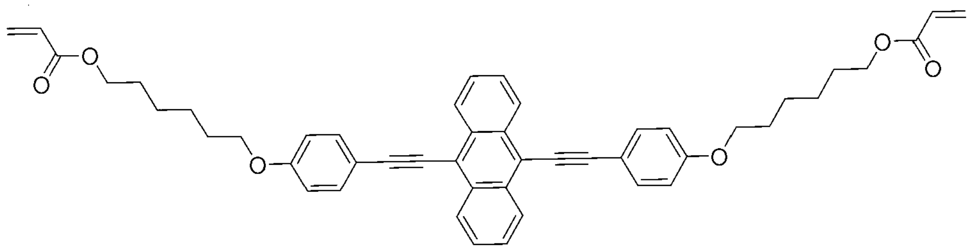

T5

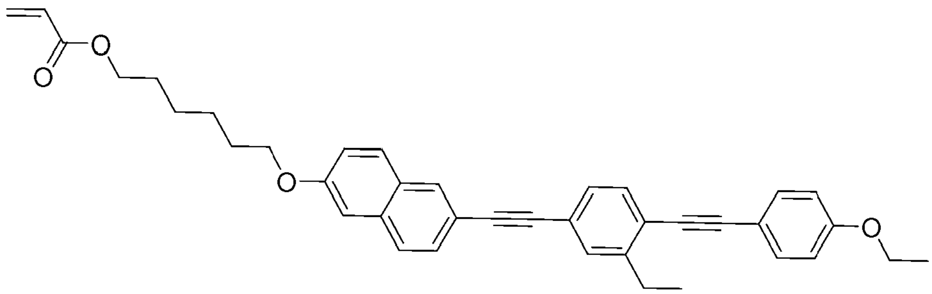

T6

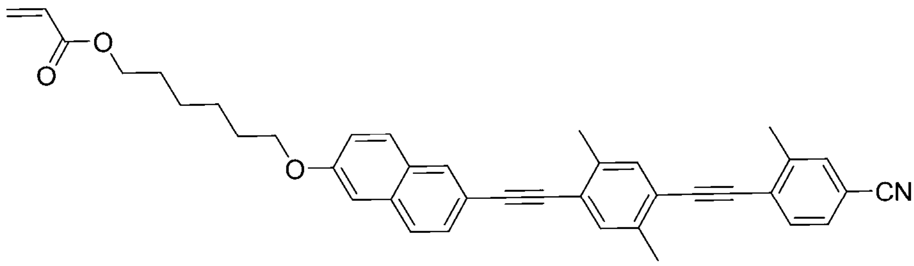

T7

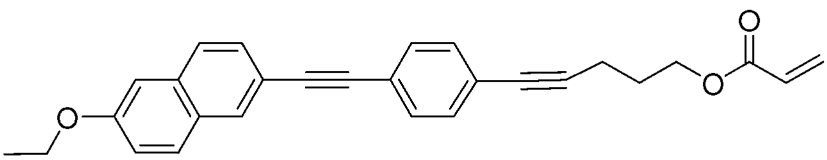

T8

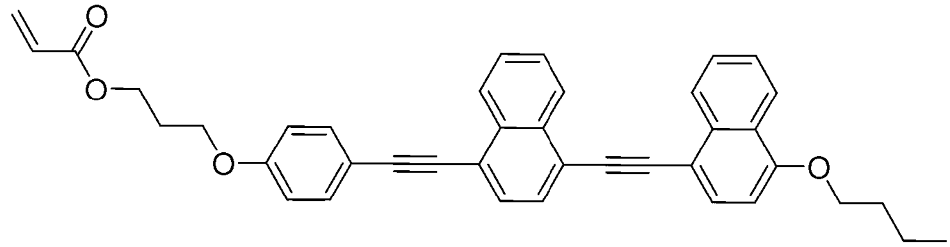

T9

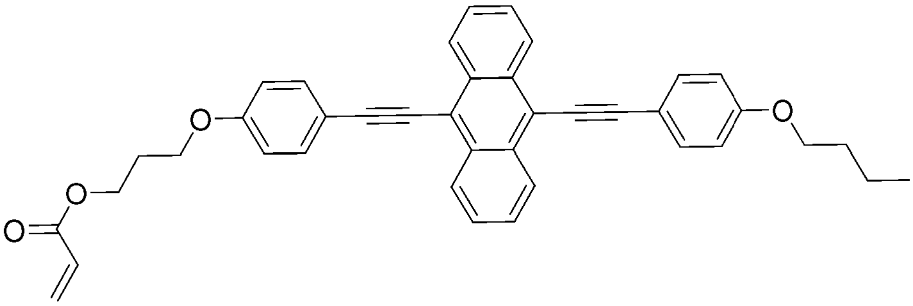

T10

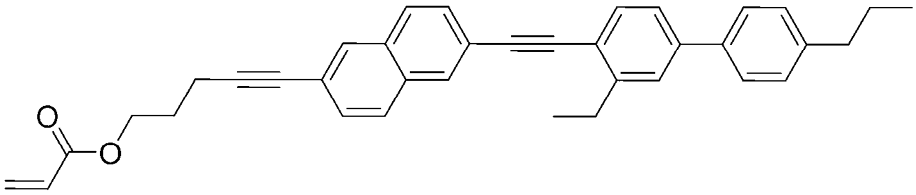

T11

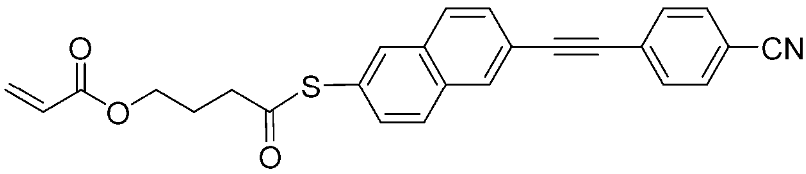

T12

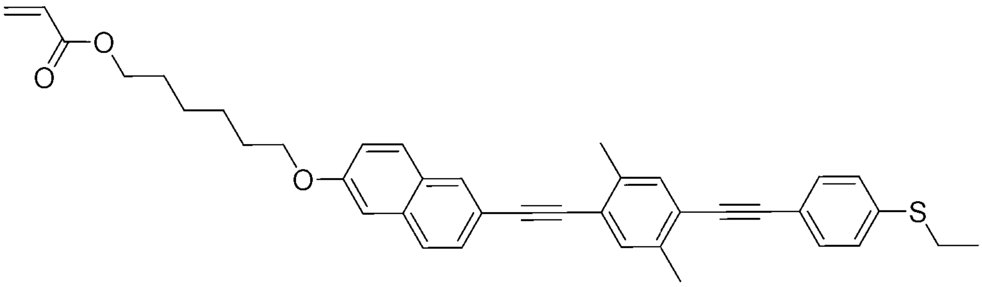

T13

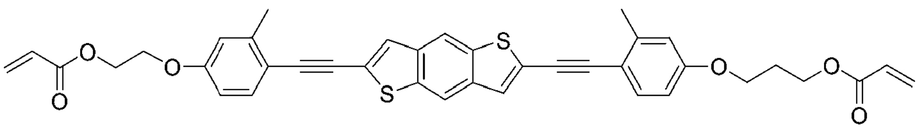

T14

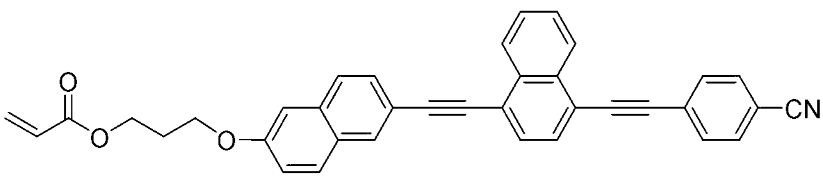

T15

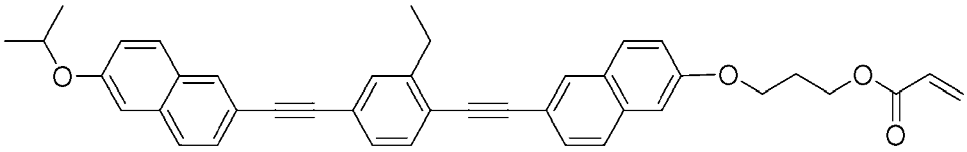

T16

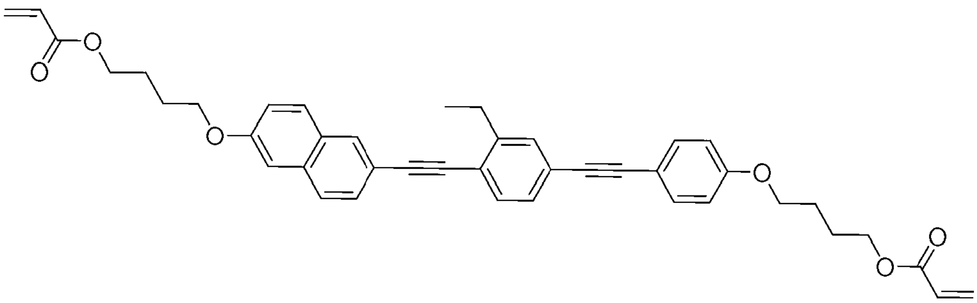

T17

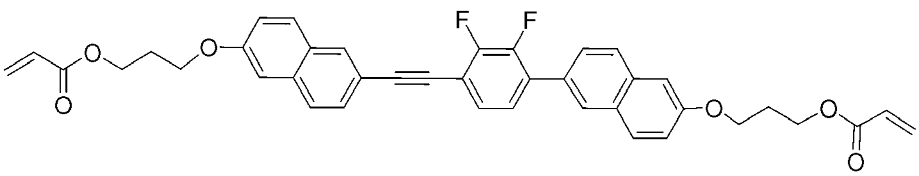

T18

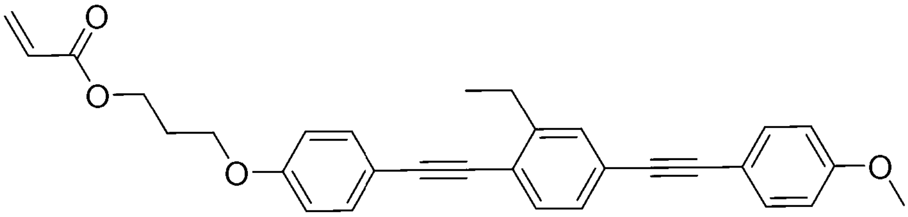

T19

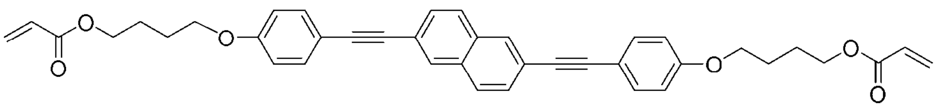

T20

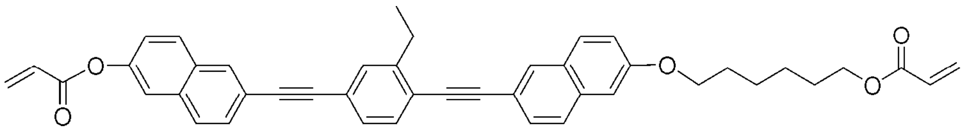

T21

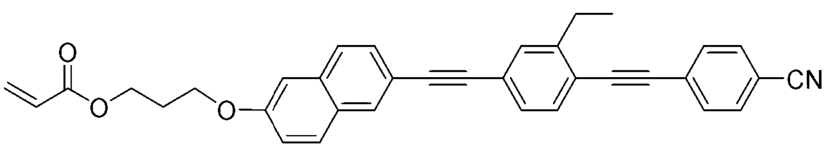

T22

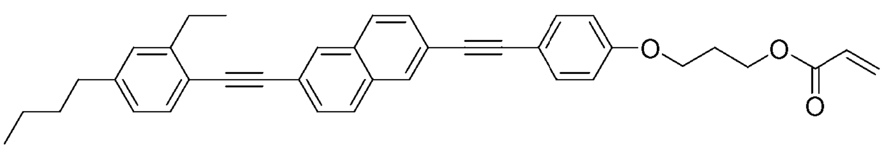

T23

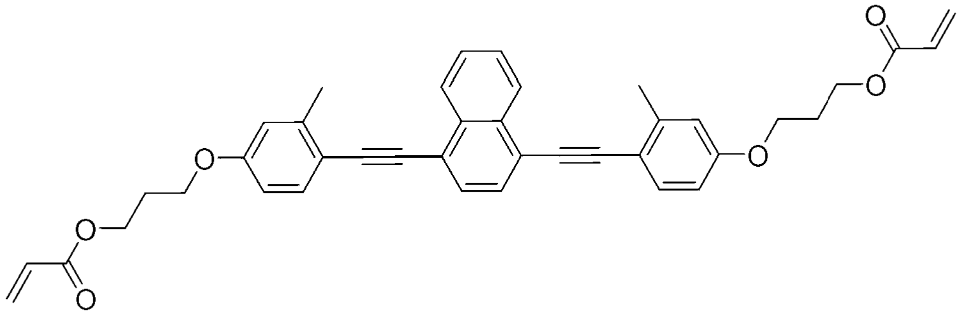

T24

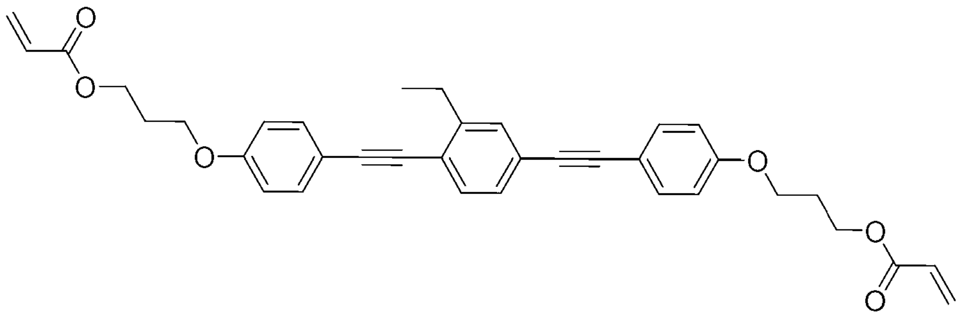

T25

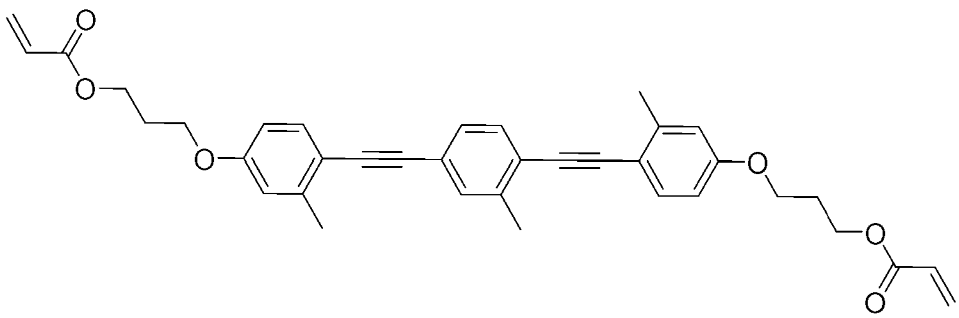

T26

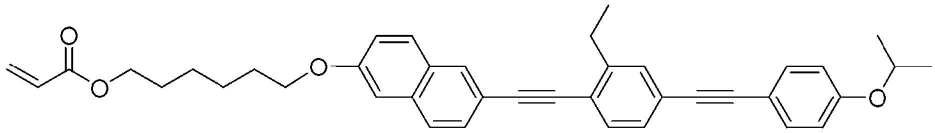

T27

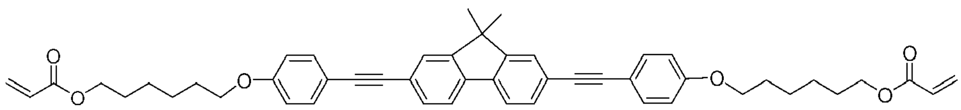

T28

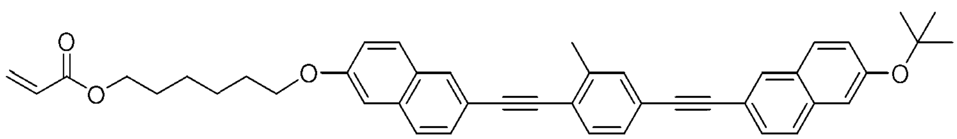

T29

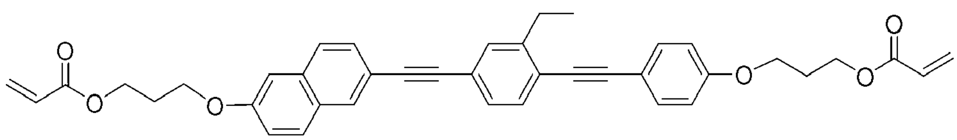

T30

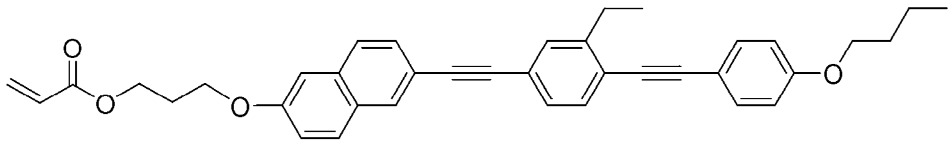

T31

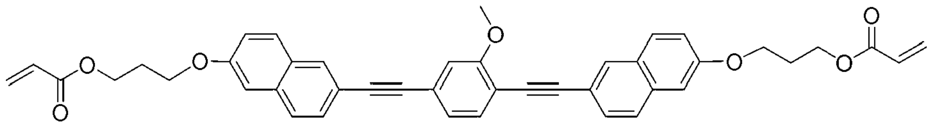

T32

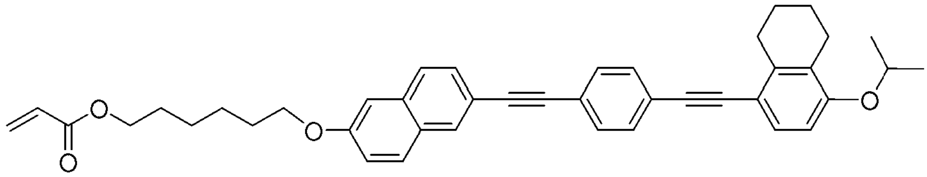

T33

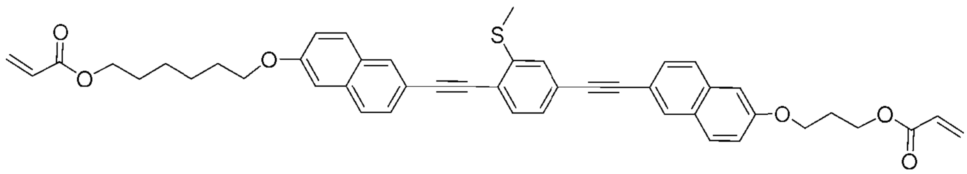

T34

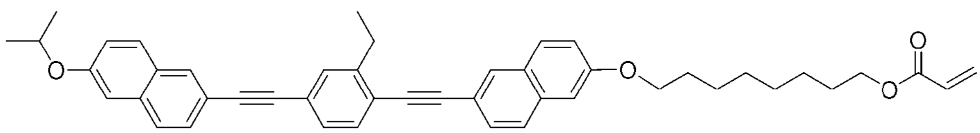

T35

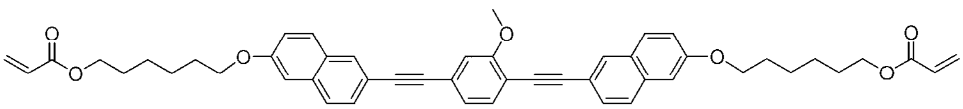

T36

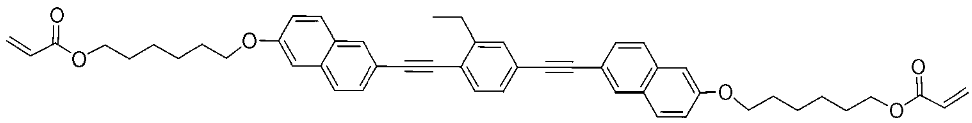

T37

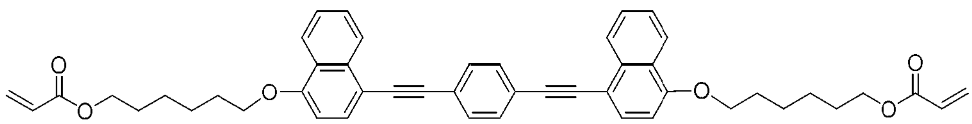

T38

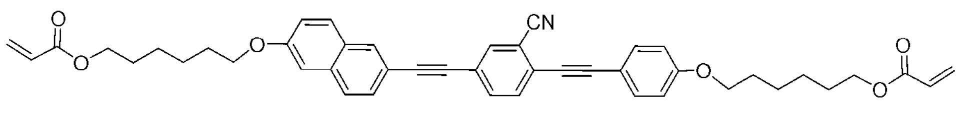

T39

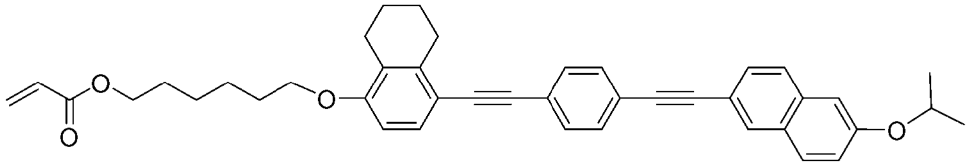

T40

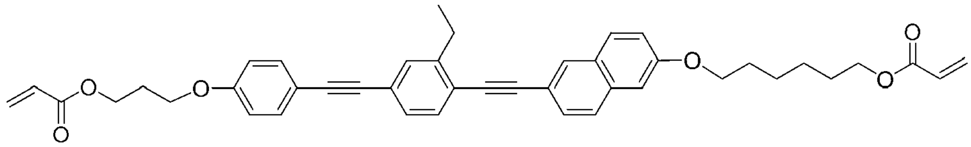

T41

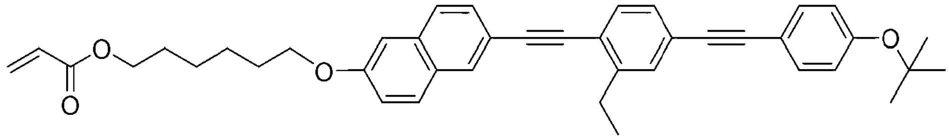

T42

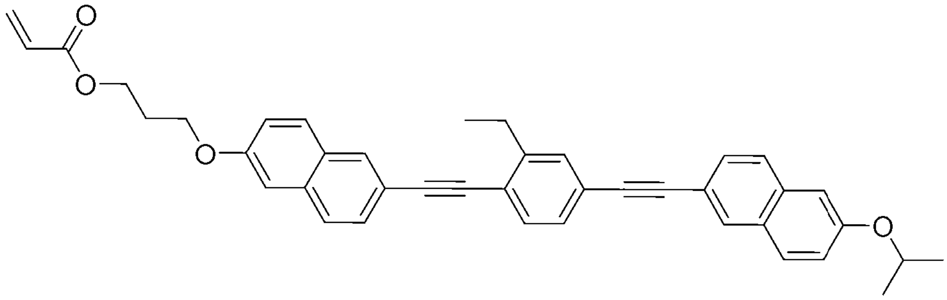

T43

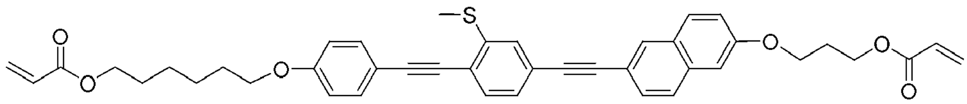

T44

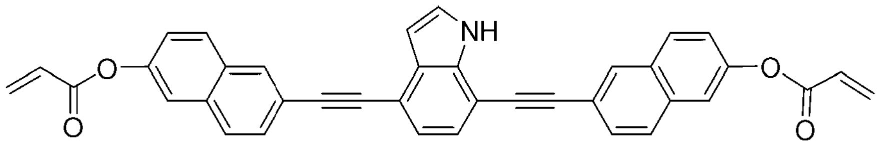

T45

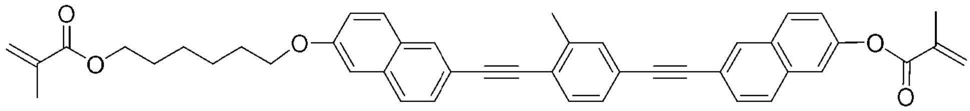

T46

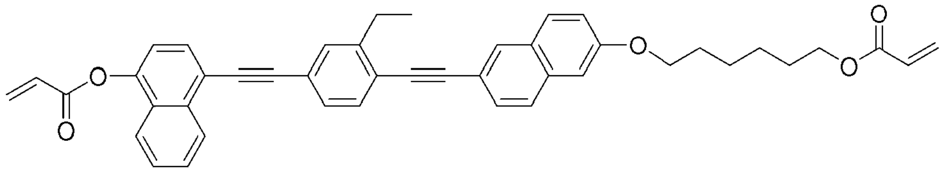

T47

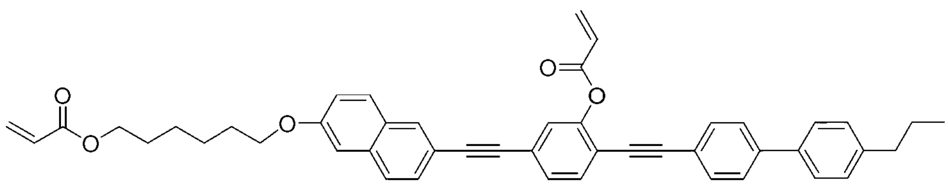

T48

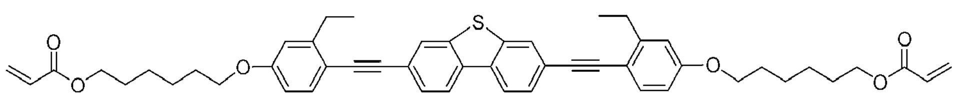

T49

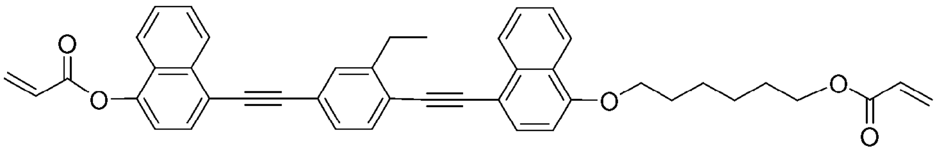

T50

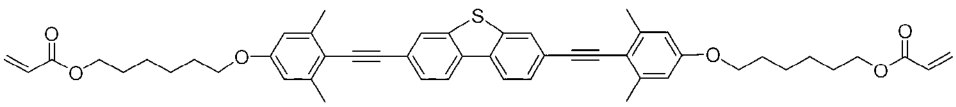

T51

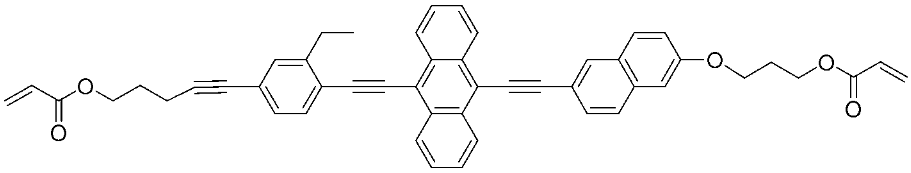

T52

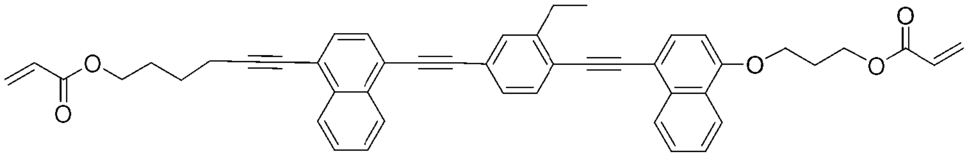

T53

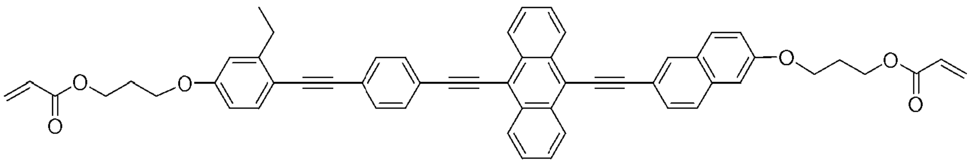

T54

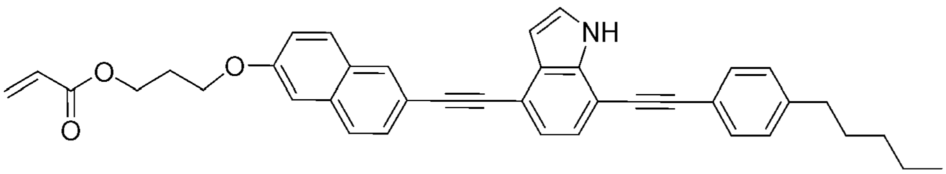

T55

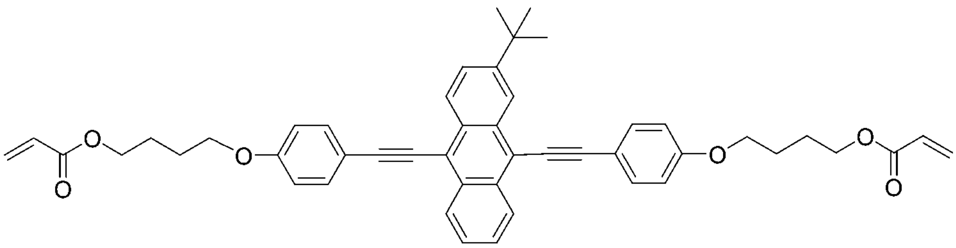

T56

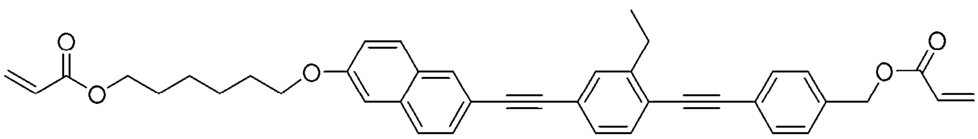

T57

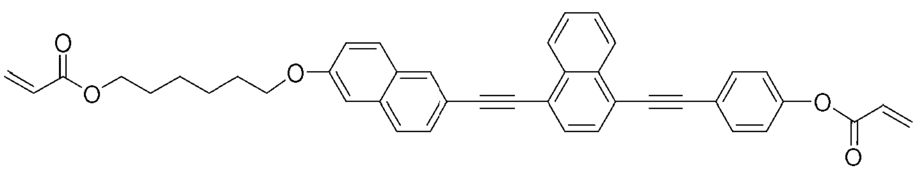

T58

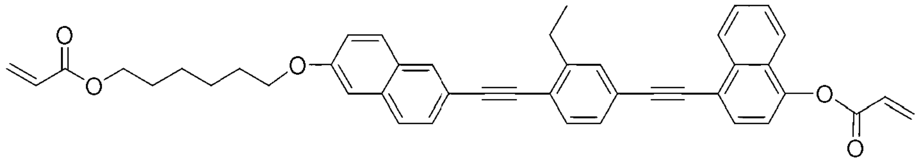

T59

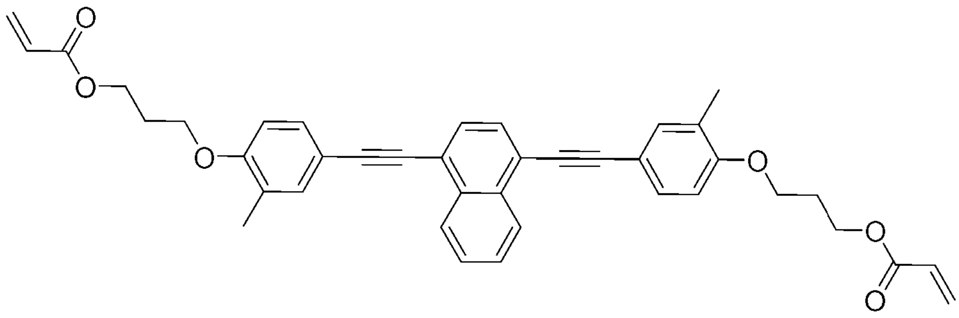

T60

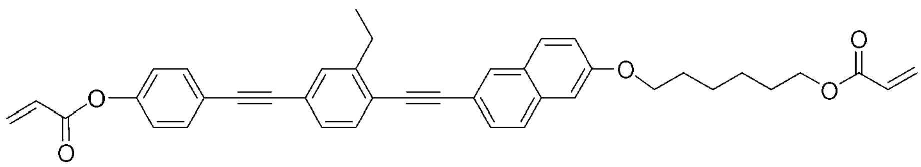

T61

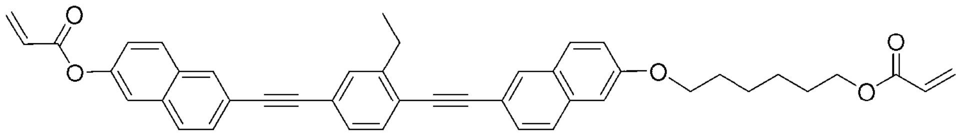

T62

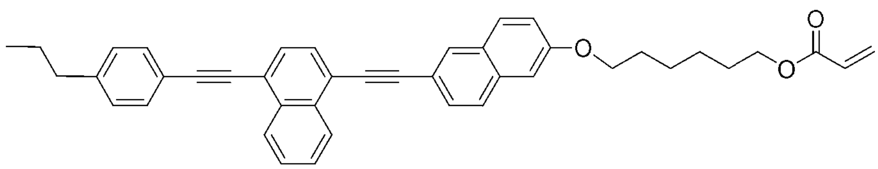

T63

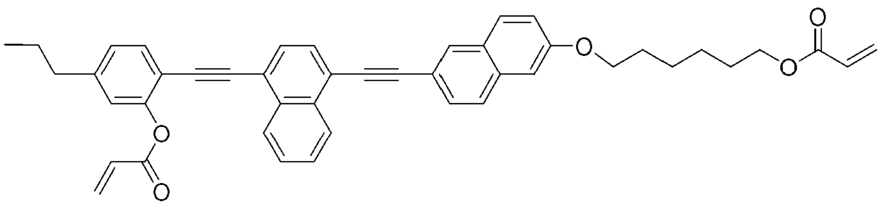

T64

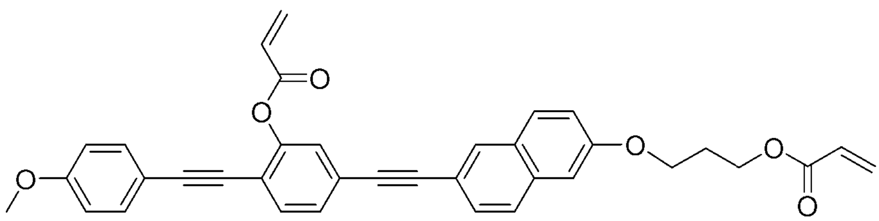

T65

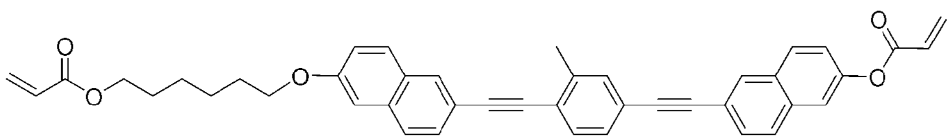

T66

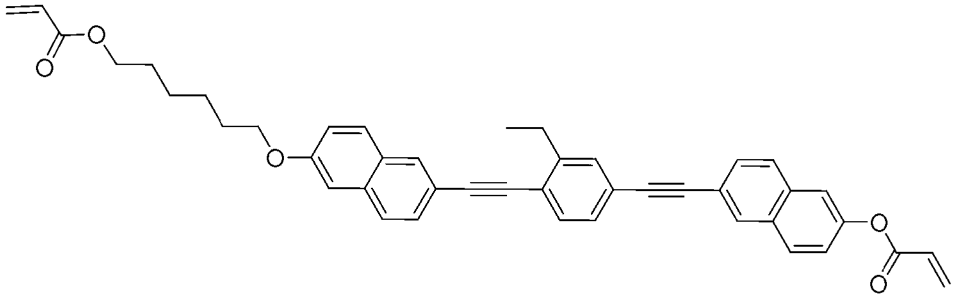
T67

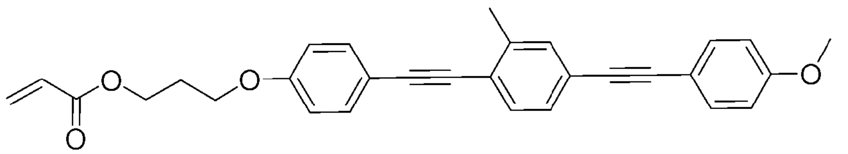
T68

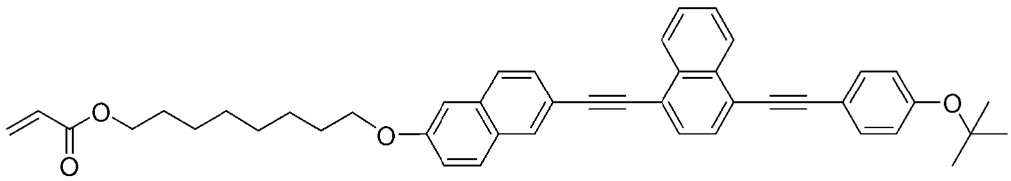
T69

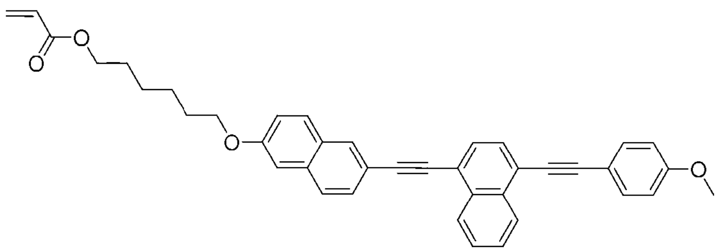
T70

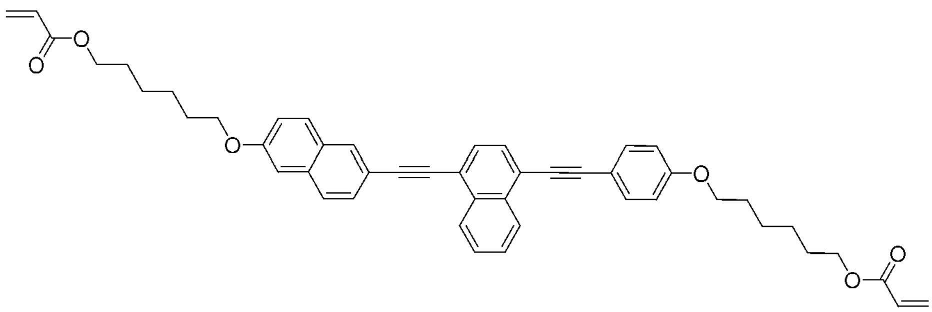
T71

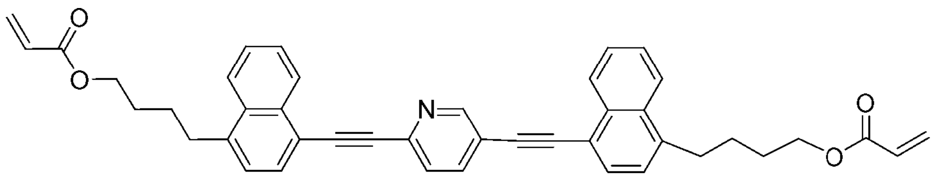
T72

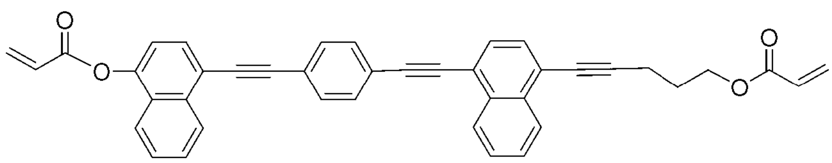
T73

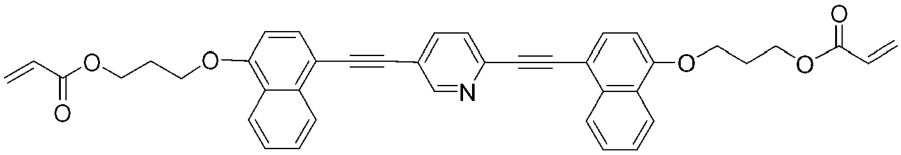

T74

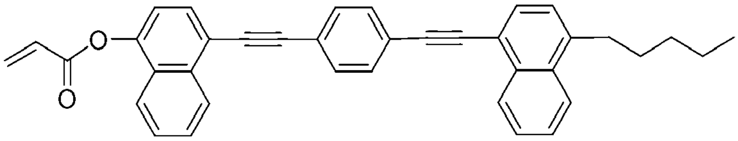

T75

Especially preferred are the compounds of formula T-3, T-19, T-21, T-24, T-25, T-30, T-47, T-50, T-53, T-59, T-60, T-68, T-70, T-71, T-73 and T-75.

Very preferred compounds of formula A are listed below:

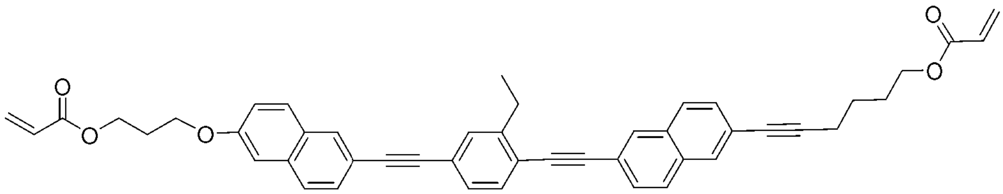

A1

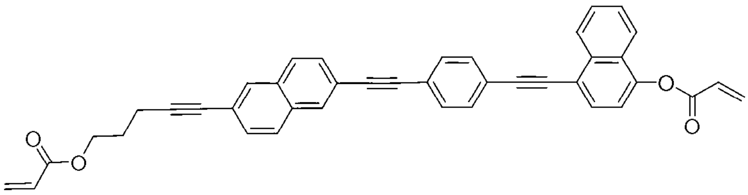

A2

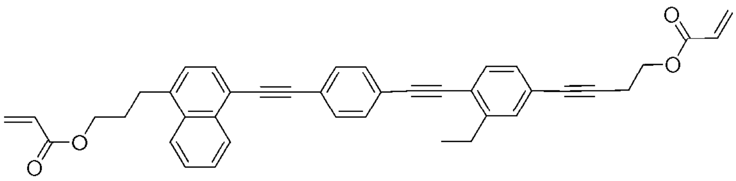

A3

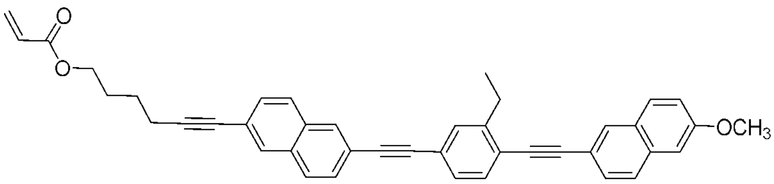

A4

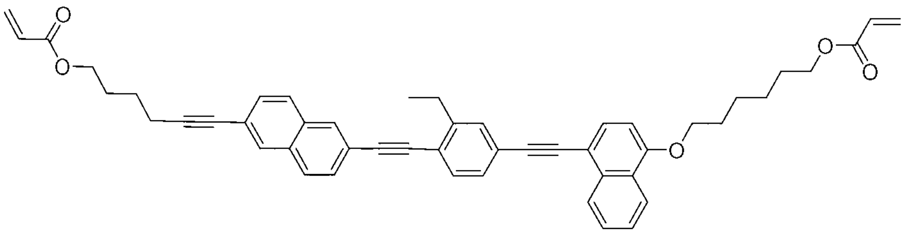

A5

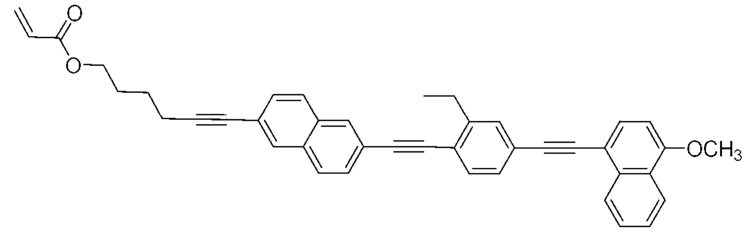

A6

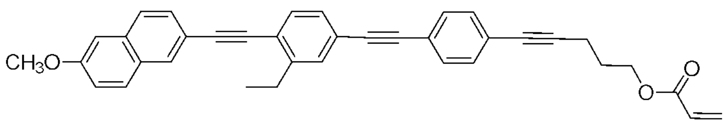

A7

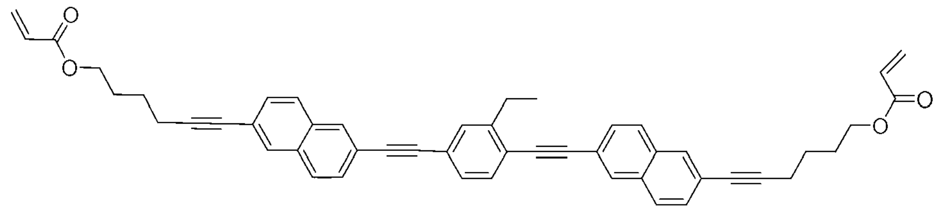

A8

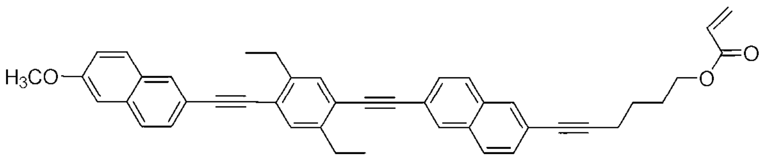

A9

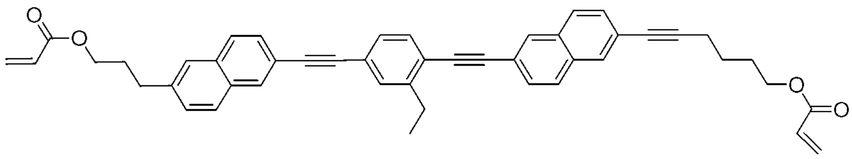

A10

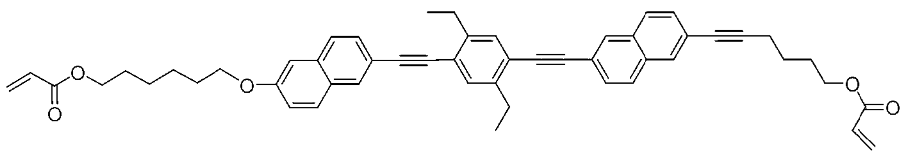

A11

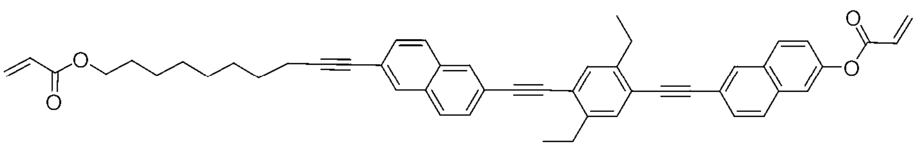

A12

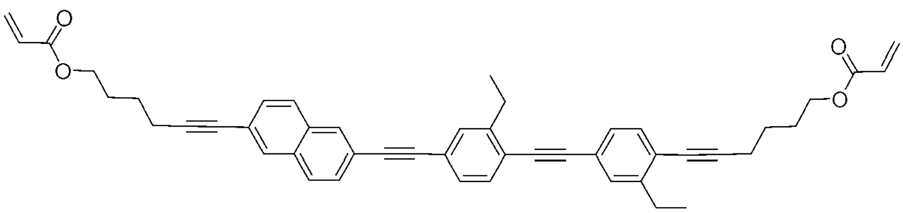

A13

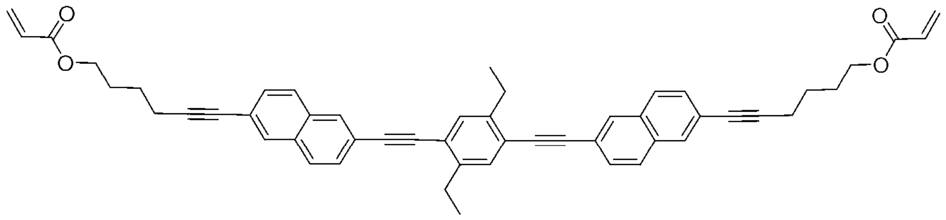

A14

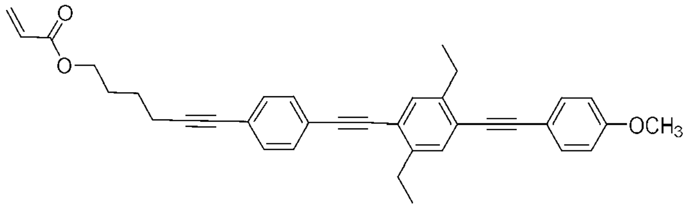

A15

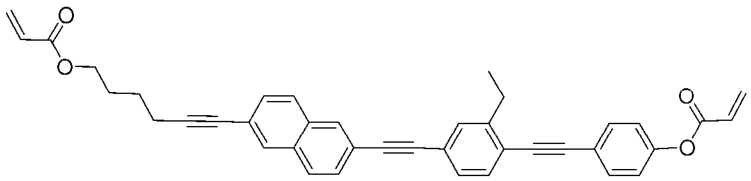

A16

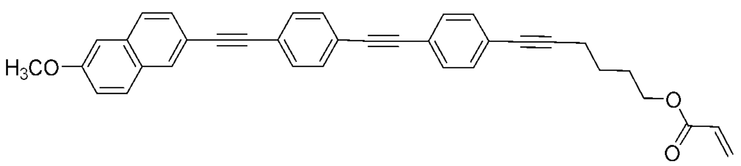

A17

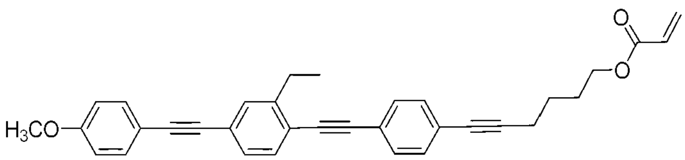

A18

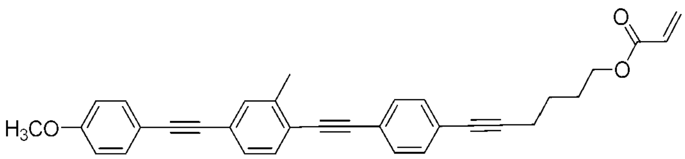

A19

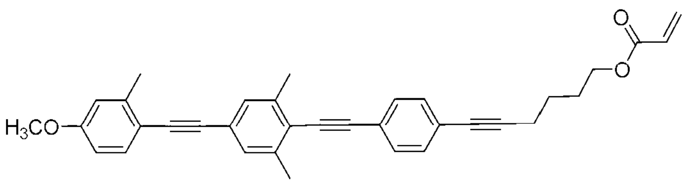

A20

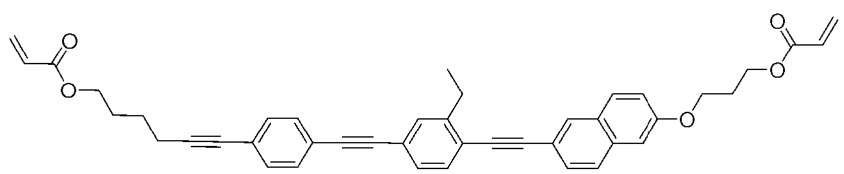

A21

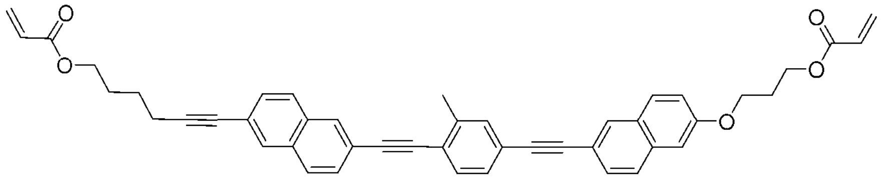

A22

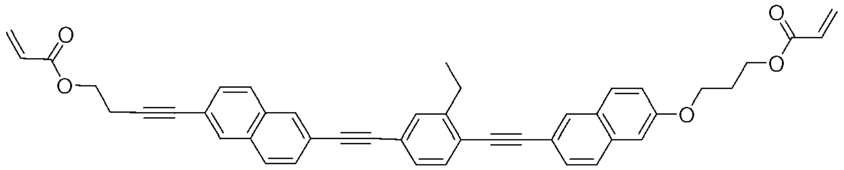

A23

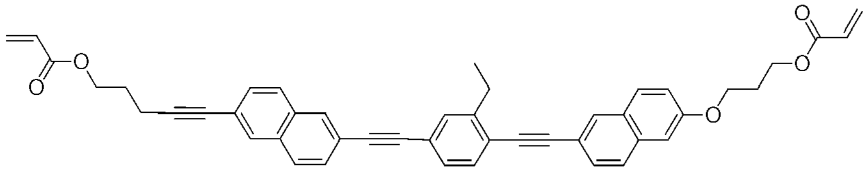

A24

The synthesis of the compounds of formula D, M, T, A and their subformulae can be carried by methods known per se to the person skilled in the art from the literature or in analogy thereto, as described for example in WO 2022/33908 A1.

The compounds of formula D, M, T, A and their subformulae either taken alone or in combination with other RMs in an chiral RM mixture, exhibit in particular and preferably at the same time, a high birefringence, exhibit a good solubility in commonly known organic solvents used in mass production, show an improved alignment, have favorable transition temperatures, and show high resistance against yellowing after being exposed to UV light.

Preferably the chiral RM mixture contains one or more compounds selected from formulae D, M, T, A and their subformulae.

Very preferably the chiral RM mixture contains, preferably 1 to 6, very preferably 1 to 4, RMs, preferably selected from D, M, T, A and their subformulae.

The concentration of the di- or multireactive RMs, preferably those of formula D or its subformulae, in the chiral RM mixture is preferably from 20 to 75%, very preferably from 25 to 65% of total solids.

The concentration of the monoreactive RMs, preferably those of formula M or its subformulae, in the chiral RM mixture is preferably from 10 to 70%, very preferably from 15 to 55% of total solids.

The amount of the chiral compounds in the chiral RM mixture is preferably from 0.1 to 10 %, more preferably from 0.5 to 8 % by weight of all solids.

The compounds of formula A and T and their subformulae show a very high birefringence, a good solubility in commonly known organic solvents, an improved alignment in the RM mixture, favorable transition temperatures, and high resistance against yellowing after being exposed to UV light. Their synthesis can be carried by methods known per se to the person skilled in the art from the literature or in analogy thereto, as described for example in WO 2022/33908A1 or WO 2.

Preferably the RM mixture contains one or more, preferably 1, 2 or 3, compounds selected from formulae D or its subformulae, and one or more, preferably 1 to 5, very preferably 2, 3 or 4 compounds selected from formulae M or its subformulae, and optionally one or more, preferably 1 to 5, very preferably 2, 3 or 4 compounds selected from formulae A and/or T or their subformulae.

If the chiral RM mixture contains one or more RMs of formula T or its subformulae, their concentration is preferably from 10 to 70%, very preferably from 10 to 50% of total solids.

If the chiral RM mixture contains one or more RMs of formula A or its subformulae, their concentration is preferably from 10 to 70%, very preferably from 10 to 50% of total solids.

In another preferred embodiment the chiral RM mixture contains one or more, preferably exactly one, chiral compounds, preferably selected from polymerizable chiral compounds, very preferably selected from mono- or direactive chiral polymerizable compounds.

Suitable polymerizable chiral compounds preferably comprise one or more ring elements, linked together by a direct bond or via a linking group and, where two of these ring elements optionally may be linked to each other, either directly or via a linking group, which may be identical to or different from the linking group mentioned. The ring elements are preferably selected from the group of four-, five-, six- or seven-, preferably of five- or six-, membered rings.

Preferred polymerizable chiral compounds are selected from the formulae C1, C2 and C3:

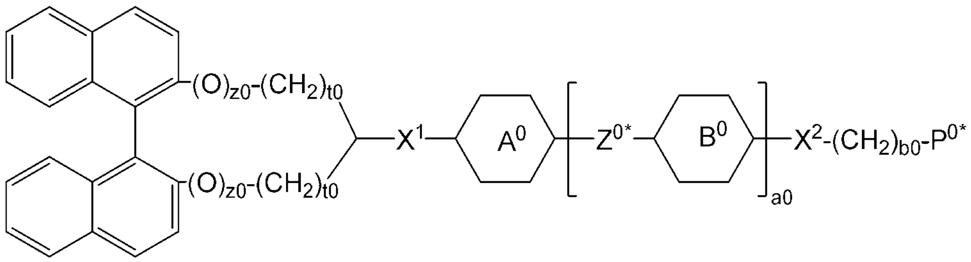

C1

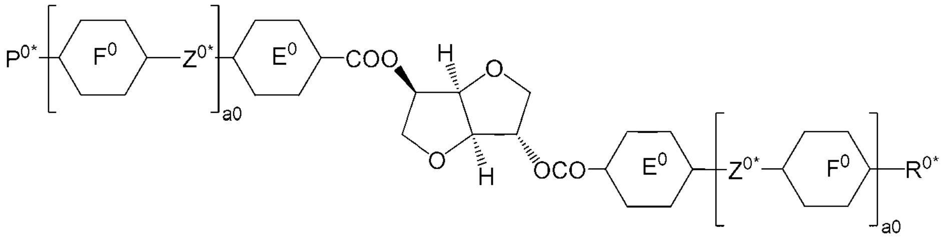

C2

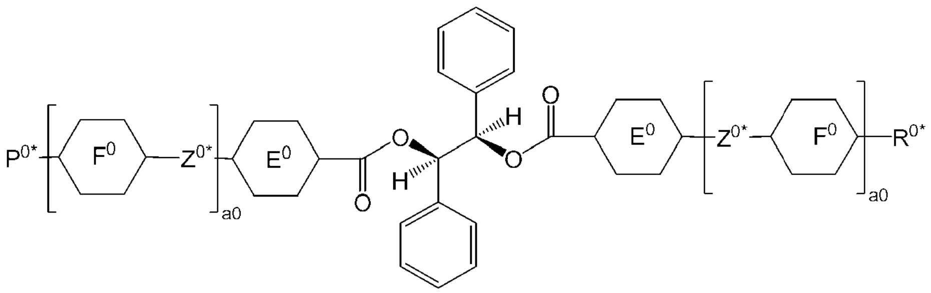

C3

wherein the individual radicals, independently of each other and on each occurrence identically or differently, have the following meanings

| | |
|---|---|
| $P^{0*}$ | a polymerizable group, |
| $Sp^{0*}$ | a spacer group or a single bond |
| $R^{0*}$ | F, Cl, CN, alkyl, alkoxy, thioalkyl, alkylcarbonyl, alkoxycarbonyl, alkylcarbonyloxy or alkoxycarbonyloxy with 1 to 15, preferably 1 to 6 C atoms, $P^{0*}$- or $P^{0*}$-Sp*-, |
| $A^0$, $B^0$, $E^0$, $F^0$ | 1,4-phenylene that is unsubstituted or substituted with 1, 2, 3 or 4 groups L, or trans-1,4-cyclohexylene, |
| L | F, Cl, CN, P-Sp-, or alkyl, alkoxy, thioalkyl, alkylcarbonyl, alkoxycarbonyl, alkylcarbonyloxy or alkoxycarbonyloxy with 1 to 5 C atoms that is optionally fluorinated, |
| $X^1$, $X^2$ | -O-, -COO-, -OCO-, -O-CO-O- or a single bond, |
| $Z^{0*}$ | -COO-, -OCO-, -O-CO-O-, $-OCH_2-$, $-CH_2O-$, $-CF_2O-$, $-OCF_2-$, $-CH_2CH_2-$, $-(CH_2)_4-$, $-CF_2CH_2-$, $-CH_2CF_2-$, $-CF_2CF_2-$, -C≡C-, -CH=CH-, -CH=CH-COO-, -OCO-CH=CH- or a single bond, preferably -COO-, -OCO- or a single bond, |
| a0 | 0, 1 or 2, preferably 0 or 1, |
| b0 | 0 or an integer from 1 to 12, preferably 1 to 6, |
| t0 | 0, 1, 2 or 3, |
| z0 | 0 or 1, preferably 1, |

and wherein the naphthalene rings can additionally be substituted with one or more identical or different groups L.

Further preferred are the stereoisomers of formula C2 wherein the central isosorbide unit is replaced by an isomannide or isoidide unit.

The compounds of formula C1 are preferably selected from the following formula:

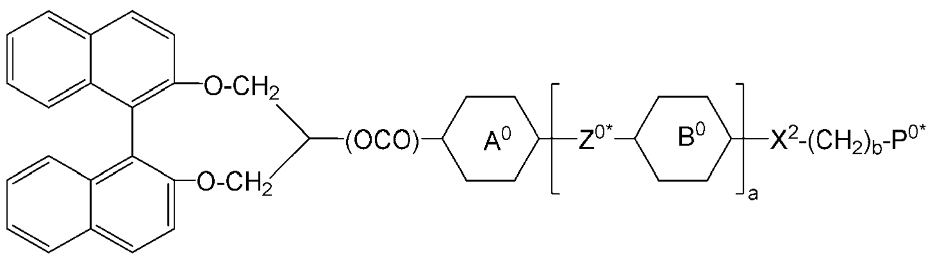

C1-1

wherein $A^0$, $B^0$, $Z^{0*}$, $X^2$, $P^{0*}$, a and b have the meanings given in formula Ca or one of the preferred meanings given above and below, and (OCO) denotes -O-CO- or a single bond.

Especially preferred compounds of formula C are selected from the group consisting of the following sub-formulae:

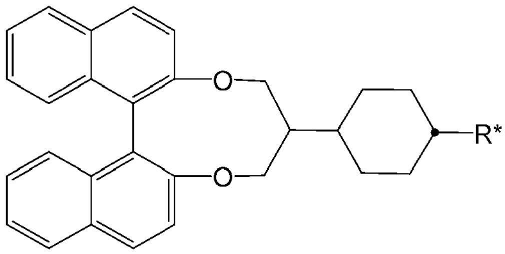

C1-1-1

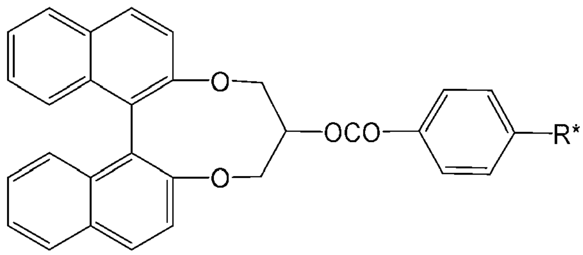

C1-1-2

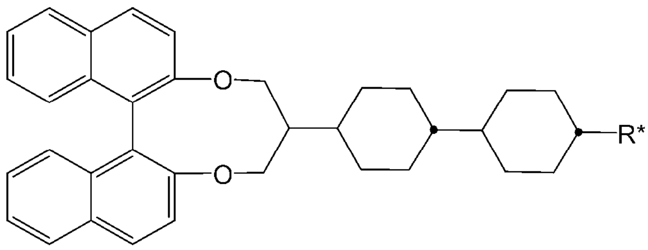

C1-1-3

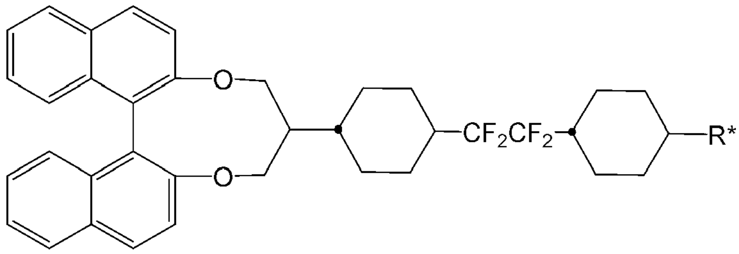

C1-1-4

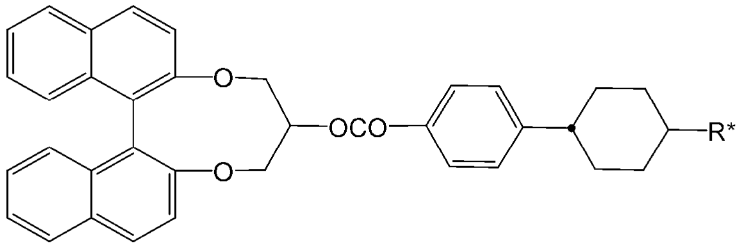

C1-1-5

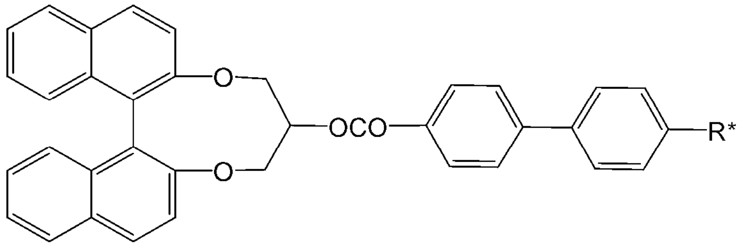

C1-1-6

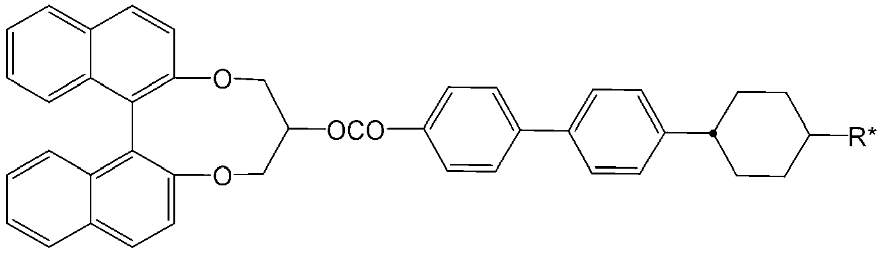

C1-1-7

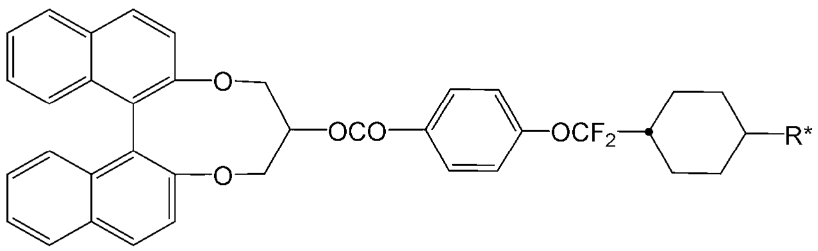

C1-1-8

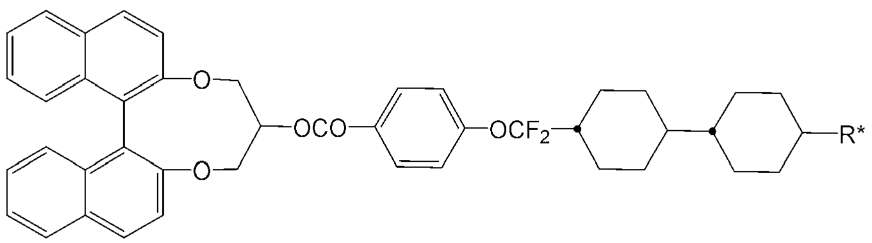

C1-1-9

wherein R* is $-X^2-(CH_2)_t-P^{0*}$ as defined in formula C1-1, and the benzene and naphthalene rings are unsubstituted or substituted with 1, 2, 3 or 4 groups L as defined above and below.

In case one or more polymerizable chiral compounds are present, their concentration in the chiral RM mixture is preferably from 0.1 to 10 %, more preferably from 0.5 to 8 % by weight of total solids.

Preferably the polymerizable chiral compounds have alone or in combination with each other an absolute value of the helical twisting power ($|HTP_{total}|$) of 20 $\mu m^{-1}$ or more, preferably of 40 $\mu m^{-1}$ or more, more preferably in the range of 60 $\mu m^{-1}$ or more, most preferably in the range of 80 $\mu m^{-1}$ or more to 260 $\mu m^{-1}$ .

In another preferred embodiment, the chiral RM mixture contains a photoinitiator selected from oxime esters, preferably selected from carbazole oxime esters and fluorene oxime esters.

Preferably the photoinitiator is selected from formulae PI and PII:

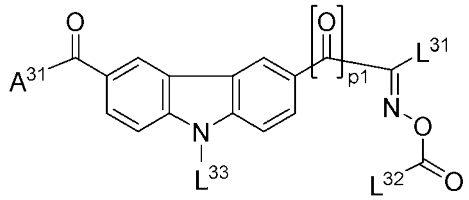

PI

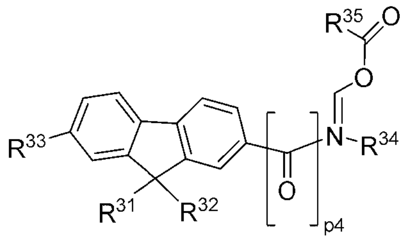

PII

wherein the individual radicals, independently of each other and on each occurrence identically or differently, have the following meanings:

$L^{31}$ $-(CH_2)_{p2}-A^{32}$,

$L^{32}$ H, alkyl, alkoxy, thioalkyl, alkylcarbonyl, alkoxycarbonyl, alkylcarbonyloxy or alkoxycarbonyloxy with 1 to 5 C atoms more; F, Cl, CN, $NO_2$, OCN, SCN, or mono- oligo- or polyfluorinated alkyl or alkoxy with 1 to 4 C atoms, or $-(CH_2)_{p3}-A^{33}$, preferably methyl or benzene,

$L^{33}$ H or alkyl having 1 to 12 C atoms, preferably ethyl,

$L^{34,35}$ H or alkyl having 1 to 12 C atoms, preferably methyl,

$A^{31}$ $A^{34}$ or or $C(L^{36})=N-O-C(=O)-L^{32}$,

$A^{32}$ an aryl, heteroaryl, (non-aromatic) alicyclic or heterocyclic group, optionally having one or more substituents selected from the group comprising silyl, sulfo, sulfonyl, formyl, amine, imine, nitrile, mercapto, nitro, halogen, $C_{1-12}$ alkyl, $C_{6-12}$ aryl, $C_{1-12}$ alkoxy, hydroxyl, or combinations of these groups, preferably $A^{32}$ denotes a $C_4$-$C_8$ alicyclic or heterocyclic group, very preferably cyclopentane or cyclohexane,

$A^{33}$ an aryl, heteroaryl, (non-aromatic) alicyclic or heterocyclic group, optionally having one or more substituents selected from the group comprising silyl, sulfo, sulfonyl, formyl, amine, imine, nitrile, mercapto, nitro, halogen, $C_{1-12}$ alkyl, $C_{6-12}$ aryl, $C_{1-12}$ alkoxy, hydroxyl, or combinations of these groups, preferably benzene,

$A^{34}$ an aryl, heteroaryl, (non-aromatic) alicyclic or heterocyclic group, optionally having one or more substituents selected from the group comprising silyl, sulfo, sulfonyl, formyl, amine, imine, nitrile, mercapto, nitro, halogen, $C_{1-12}$ alkyl, $C_{6-12}$ aryl, $C_{1-12}$ alkoxy, hydroxyl, or combinations of these groups, preferably benzene that is substituted with $C_1$-$_6$ alkyl, preferably in 2-position, or thiophene, very preferably 2-methyl benzene or thiophene-2-yl,

$L^{36}$ H, alkyl, alkoxy, thioalkyl, alkylcarbonyl, alkoxycarbonyl, alkylcarbonyloxy or alkoxycarbonyloxy with 1 to 5 C atoms more; F, Cl, CN, $NO_2$, OCN, SCN, or mono- oligo- or polyfluorinated alkyl or alkoxy with 1 to 4 C atoms, preferably $C_1$-$C_6$ alkyl,

$R^{31,32}$ H, alkyl, alkoxy or mono- oligo- or polyfluorinated alkyl or alkoxy, preferably H or alkyl having 1 to 12 C atoms,

$R^{33}$ H, alkyl, alkoxy, thioalkyl, alkylcarbonyl, alkoxycarbonyl, alkylcarbonyloxy or alkoxycarbonyloxy; halogen, CN, $NO_2$, OCN, SCN, or mono- oligo- or polyfluorinated alkyl or alkoxy atoms; or $-(Sp^{31}-A^{31})$, preferably H, halogen, CN, or $NO_2$,

$R^{34,35}$ H, alkyl, mono- oligo- or polyfluorinated alkyl, or $-(CH_2)_{p5}-A^{35}$, preferably H, alkyl, or $-(CH_2)_{p5}-A^{35}$,

$A^{35}$ denotes an aryl, heteroaryl, (non-aromatic) alicyclic and heterocyclic group, optionally having one or more substituents, which are selected from the group comprising silyl, sulfo, sulfonyl, formyl, amine, imine, nitrile, mercapto, nitro, halogen, $C_{1-12}$ alkyl, $C_{6-12}$ aryl, $C_{1-12}$ alkoxy, hydroxyl, or combinations of these groups, preferably phenyl, cyclohexyl, or cyclopentyl,

p1 0 or 1,

p2 0, 1, 2, 3, 4, 5 or 6, preferably 1 or 2,

p3 0, 1 or 2, preferably 0,

p4 0 or 1, preferably 1,

p5 0, 1, 2, 3, 4, 5 or 6, preferably 1 or 2.

Preferred compounds of formula PI and PII are selected from the following preferred embodiments, including any possible combination thereof:

- $A^{31}$ is $C(L^{34})=N-O-C(=O)-L^{32}$,
- $A^{31}$ is 2-methyl benzene or thiophene-2-yl,
- $A^{32}$ is cyclopentane or cyclohexane,
- $A^{33}$ is benzene,
- $A^{34}$ is 2-methyl benzene or thiophene-2-yl,
- $L^{32}$ is $C_1$-C5 alkyl, preferably methyl,
- $L^{32}$ is benzene,
- $L^{33}$ is $C_1$-$C_4$ alkyl, preferably ethyl,
- $L^{34}$ and $L^{35}$ are methyl,
- $L^{36}$ is $C_{1-6}$ alkyl, preferably hexyl,
- $R^{31}$, $R^{32}$ is methyl, ethyl, n-propyl or n-butyl, preferably methyl or ethyl,
- $R^{33}$ is H,
- $R^{34}$ is methyl,
- $R^{35}$ is methyl, ethyl or phenyl,
- p1 is 0,
- p1 is 1,
- p2 is 1 or 2,
- p3 is 0,
- p4 is 1,
- p5 is 1 or 2.

Preferred compounds of formula PI are selected from the following subformulae:

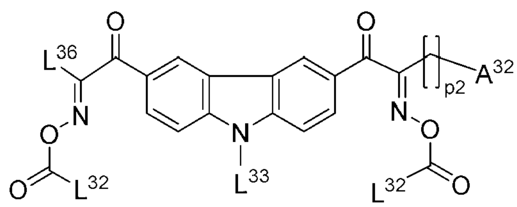

P-Ia

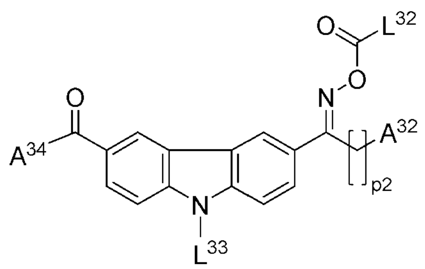

P-Ib

wherein $L^{32}$, $L^{33}$, $L^{34}$, $L^{35}$, $L^{36}$, $A^{32}$ and $A^{34}$ and p2, independently of each other and on each occurrence identically or differently, have one of the meanings given in formula PI or one of the preferred meanings given above and below.

Further preferred compounds of formula P are selected from the group consisting of the following subformulae:

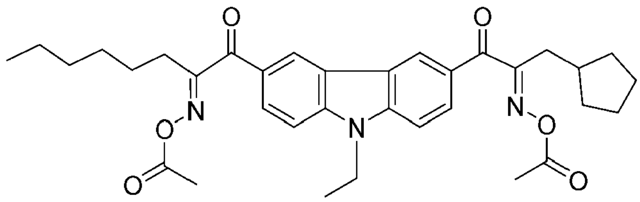

P1

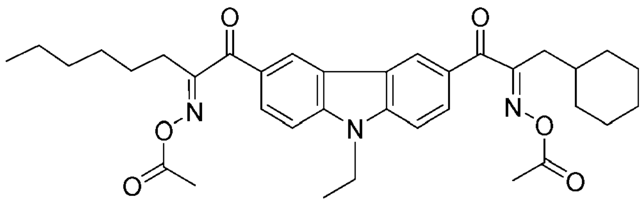

P2

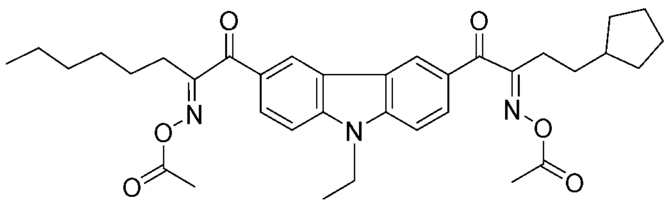

P3

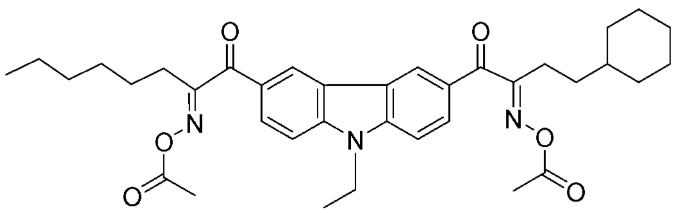

P4

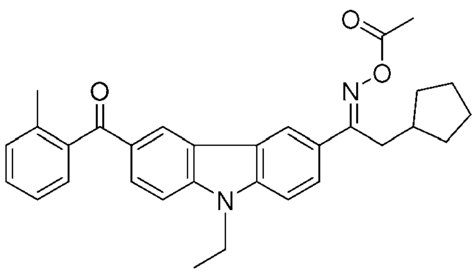

P5

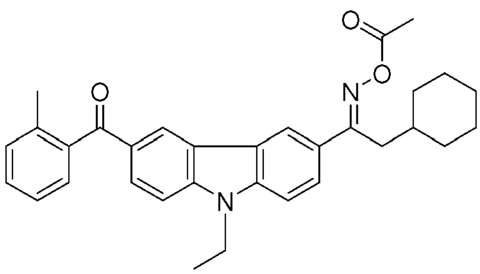

P6

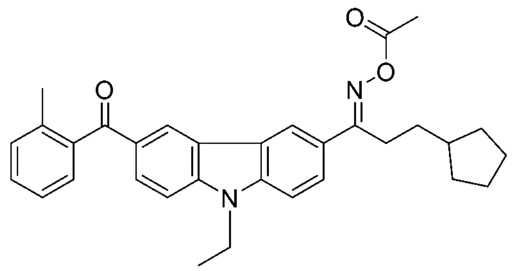

P7

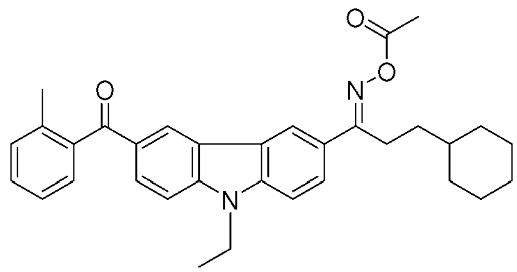

P8

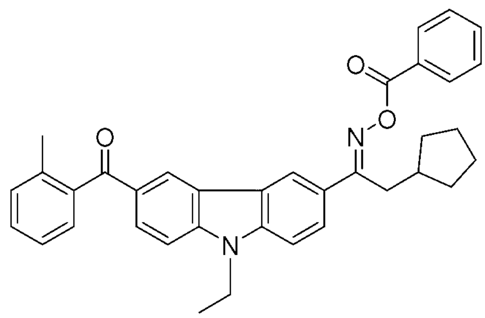

P9

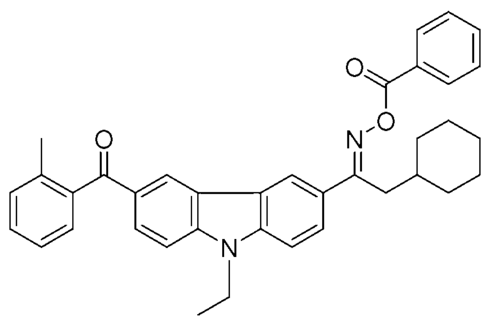

P10

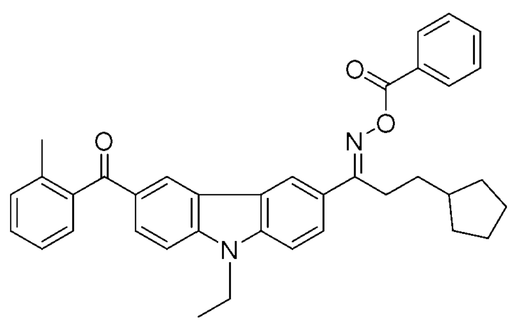

P11

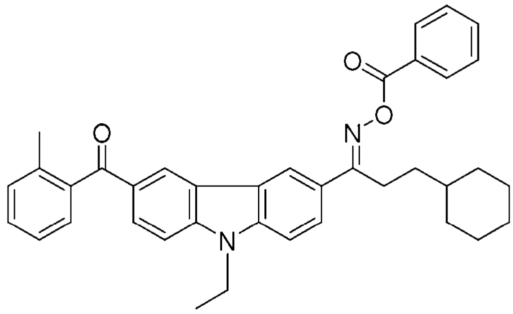

P12

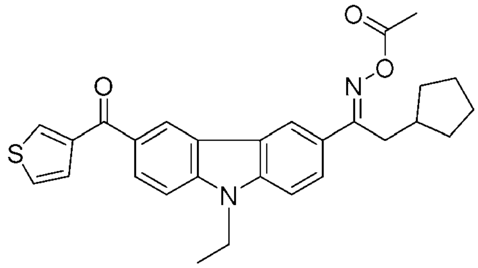

P13

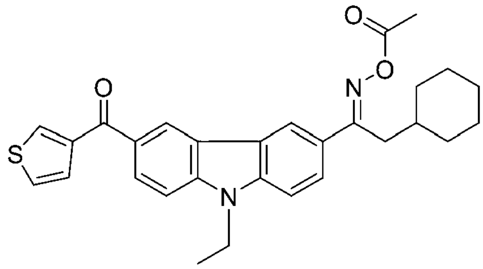

P14

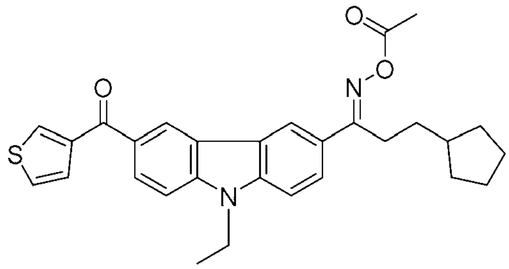

P15

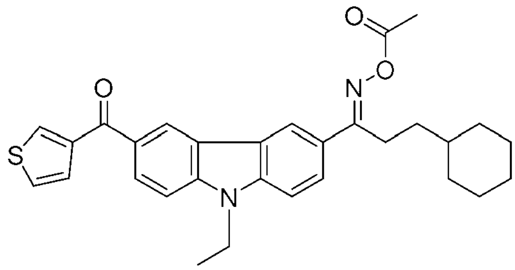

P16

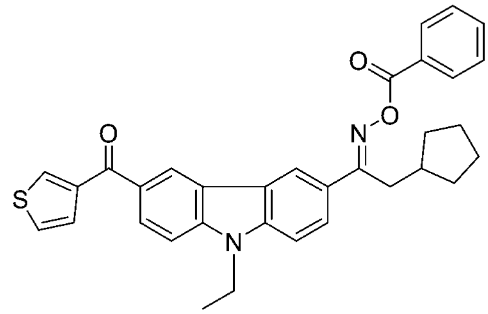

P17

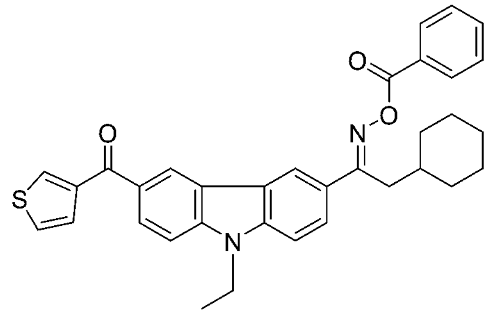

P18

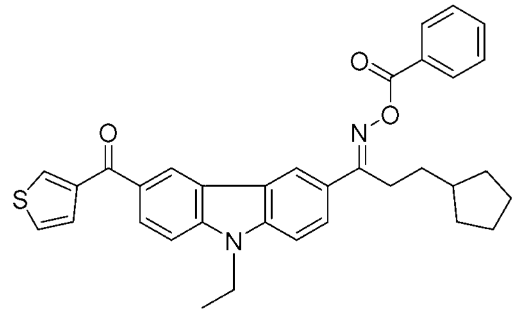

P19

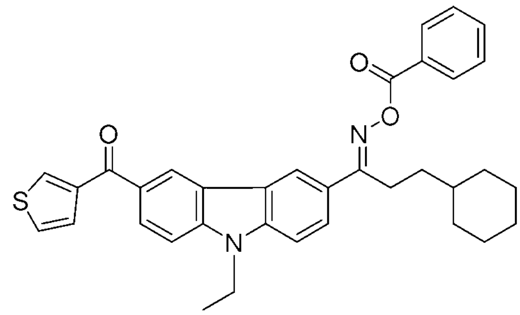

P20

Especially preferred are the compounds of formula P2 and P7.

Preferred compounds of formula PII are selected from the following subformulae:

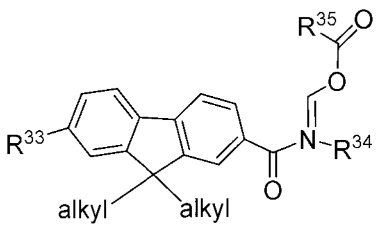

PIIa

wherein alkyl is methyl, ethyl, n-propyl or n-butyl, $R^{33}$ is H, Br, CN or $NO_2$, preferably H, and $R^{34}$ and $R^{35}$, independently of

each other and on each occurrence identically or differently, have one of the meanings given in formula PII or one of the preferred meanings given above and below, and preferably $R^{34}$ and $R^{35}$ is methyl or ethyl.

Very preferred compounds of formula PII and PIIa are selected from the following subformulae:

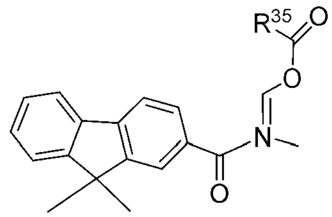

PIIa1

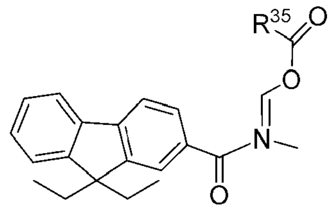

PIIa2

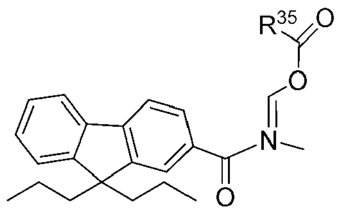

PIIa3

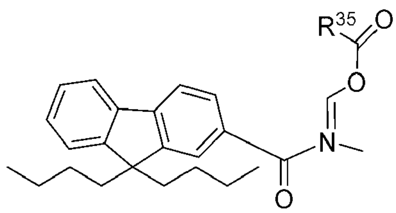

PIIa4

wherein $R^{35}$ has one of the meanings given in formula PII or one of the preferred meanings given above and below, and is preferably methyl or ethyl.

Further preferred compounds of formula PII and PIIa are selected from the group consisting of the following subformulae:

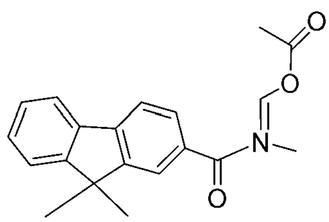

P21

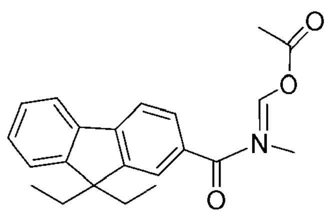

P22

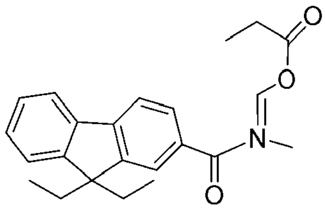

P23

Especially preferred are the compounds of formula P22.

Especially preferred compounds of formula P are the photoinitiators of the TR-PBG series commercially available from Changzhou Tronly New Electronic Materials (China), such as TR-PBG-304, TR-PBG-314 and TR-PBG-345. Further preferred are the photoinitiators of the SPI series commercially available from Samyang (Korea), such as SPI-02, SPI-03 and SPI-04. Further preferred are the photoinitiators of the Irgacue OXE series commercially available from BASF (Germany), such as OXE-02, OXE-03 and OXE-05.

In another preferred embodiment the chiral RM mixture additionally contains one or more, preferably exactly one, chiral dopants which are not polymerizable.

Preferred chiral dopants are selected from the group consisting of compounds of formulae C-I to C-III,

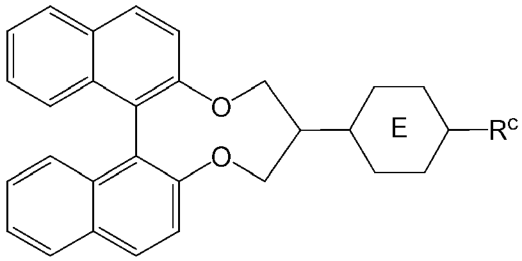

C-I

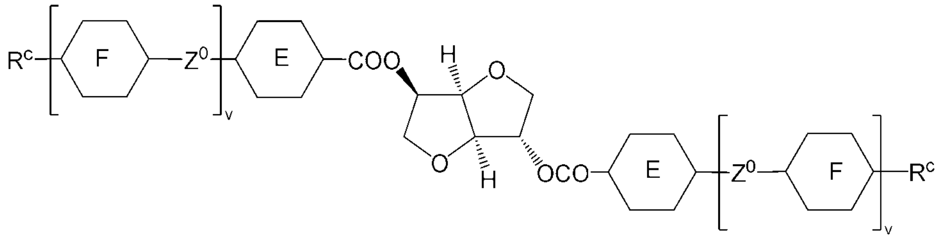

C-II

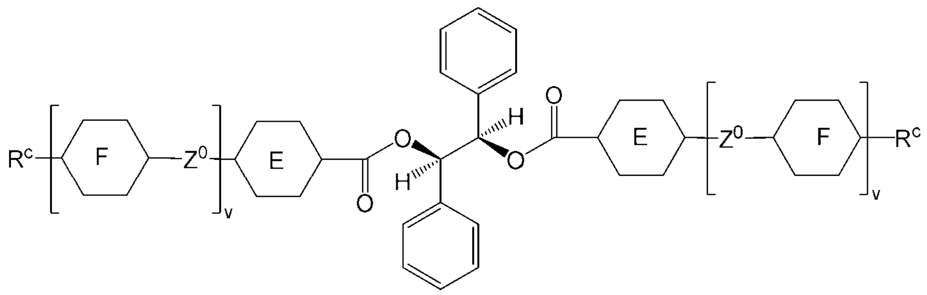

C-III

wherein formula C-II and C-III include the respective (S,S) enantiomers, and wherein E and F are each independently 1,4-phenylene or trans-1,4-cyclohexylene, v is 0 or 1, $Z^0$ is -COO-, -OCO-, $-CH_2CH_2-$ or a single bond, and $R^c$ is alkyl, alkoxy or alkanoyl with 1 to 12 C atoms.

Further preferred are the stereoisomers of formula C-II wherein the central isosorbide unit is replaced by an isomannide or isoidide unit.

The compounds of formula C-I and their synthesis are described in EP1389199 A1. The compounds of formula C-II and their synthesis are described in WO98/00428 A1. The compounds of formula C-III and their synthesis are described in GB2328207 A.

Further preferred chiral dopants are e.g. the commercially available R/S-6011, R/S-5011, R/S-4011, R/S-3011, R/S-2011, R/S-1011, R/S-811 and CB-15 (from Merck KGaA, Darmstadt, Germany).

The amount of the non-polymerizable chiral dopants in the chiral RM mixture is preferably from 0.1 to 10 %, more

preferably from 0.5 to 8 % by weight of all solids.

In another preferred embodiment the chiral RM mixture contains, in addition or alternatively to the chiral compounds as described above and below, one or more chiral compounds which are isomerizable, preferably photoisomerizable, very preferably photoisomerizable and polymerizable. Very preferably these compounds are photoisomerizable by UV irradiation.

The isomerizable group(s) in the chiral compound can undergo a photo driven E/Z isomerization reaction, and thereby lead to a reduction in helical twisting power (HTP). This allows for rapid photo driven adjustment of the chiral pitch in an RM layer and by varying the formulation and processing conditions it is possible to produce alignment profiles with variable pitch and a non-linear twist profile, profile with an accelerating or decreasing twist in the layer thickness direction. When aligned on a grating alignment layer it is possible to increase the grating angular bandwidth.

In another preferred embodiment the chiral RM mixture comprises at least two, more preferably exactly two, chiral compounds with opposite handedness, one of which contains an isomerizable group, and the other of which does not contain an isomerizable group, and wherein one or both, preferably both, chiral compounds are polymerizable. Photoirradiation of the isomerizable chiral compound changes its twisting power, while the twisting power of the non-isomerizable chiral compound remains unchanged. Thereby it is possible to control and adjust the twist profile in the final RM layer accordingly.

Preferred chiral isomerizable compounds are selected of formula I*:

$$R^3\text{-}(A^3\text{-}Z^3)_m\text{-}G(\text{-}(Z^4\text{-}A^4)_l\text{-}R^4)_k \qquad I^*$$

wherein the individual radicals, independently of each other and on each occurrence identically or differently, have the following meanings

$R^3$, $R^4$ H, F, Cl, CN, P-Sp- or an alkyl radical with up to 25 C atoms which may be unsubstituted, mono- or polysubstituted by halogen or CN, it being also possible for one or more non-adjacent $CH_2$ groups to be replaced, in each case independently from one another, by -O-, -S-, -NH-, -N($CH_3$)-, -CO-, - COO- -OCO-, -OCO-O-, -S-CO-, -CO-S- or -C≡C- in such a manner that oxygen atoms are not linked directly to one another,

P a polymerizable group,

Sp a spacer group or a single bond,

$Z^3$, $Z^4$ -CO-O-, -O-CO-, -$CH_2CH_2$-, -$OCH_2$-, -$CH_2O$-, -CH=CH-, -CH=CH-CO-O-, -O-CO-CH=CH-, -CH=C(CN)-CO-O-, -O-CO-C(CN)=CH-, -N=N-, -CH=N-, - N=CH-, -C≡C-, or a single bond,

$A^3$, $A^4$ an alicyclic, heterocyclic, aromatic or heteroaromatic group with 4 to 20 ring atoms, which is monocyclic or polycyclic and which is optionally substituted by one or more groups L or P-Sp-,

G a chiral group,

L F, Cl, -CN, -SCN, P-Sp-, or straight chain, branched or cyclic alkyl having 1 to 25 C atoms, wherein one or more non-adjacent $CH_2$-groups are optionally replaced by -O-, -S-, -CO-, -CO-O-, -O-CO-, -O-CO-O-, $CR^0$=$CR^{00}$-, -C≡C-,

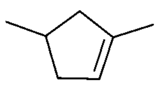, or 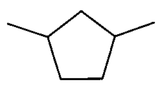,

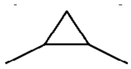, 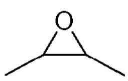, 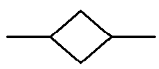, 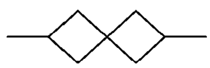,

in such a manner that O- and/or S-atoms are not directly connected with each other, and wherein one or more H atoms are each optionally replaced by P-Sp-, F or Cl, or two substituents L that are connected to directly adjacent C atoms may also form a cycloalkyl or cycloalkenyl group with 5, 6, 7 or 8 C atoms,

m, l independently of each other 0, 1, 2 or 3,

k 0, 1 or 2,

wherein the compound contains at least one isomerizable group, which is preferably a photoisomerizable group, and preferably at least one of $R^3$ and $R^4$ denotes P-Sp-.

Preferred compounds of formula I* and its subformulae are those wherein at least one of $R^3$ and $R^4$, preferably both $R^3$ and $R^4$, denote P-Sp-.

Further preferred compounds of formula I* and its subformulae are those wherein at least one of $R^3$ and $R^4$, preferably both $R^3$ and $R^4$, is different from P-Sp-, and preferably denotes alkyl or alkoxy with 1 to 12, more preferably 1 to C atoms, and one of $R^3$ and $R^4$ may also denote F, Cl or CN.

Preferred compounds of formula I* and its subformulae are those wherein $A^3$ and $A^4$ are selected from the group consisting of 1,4-phenylene, naphthalene-1,4-diyl, naphthalene 2,6-diyl, 1,4-cyclohexylene in which, in addition, one or two non-adjacent $CH_2$ groups may be replaced by O and/or S, 1,4-cyclohexenylene, 1,4-bicyclo(2,2,2)octylene, piperidine-1,4-diyl, naphthalene-2,6-diyl, decahydronaphthalene-2,6-diyl, or 1,2,3,4-tetrahydro-naphthalene-2,6-diyl, very preferably 1,4-phenylene or 1,4-cyclohexylene, all of which are optionally substituted by one or more groups L or P-Sp.

Further preferred compounds of formula I* and its subformulae are those wherein $Z^3$ and $Z^4$ independently of each other denote -CO-O-, -O-CO- or a single bond.

Further preferred compounds of formula I* and its subformulae are those wherein L is selected from F, Cl, CN, $CH_3$, $C_2H_5$, $OCH_3$, $OC_2H_5$, $COCH_3$, $COC_2H_5$, $CF_3$, $OCF_3$, P-Sp-, in particular F, Cl, CN, $CH_3$, $C_2H_5$, $OCH_3$, $COCH_3$ or $OCF_3$ , most preferably F, $CH_3$, $OCH_3$ or $COCH_3$.

Further preferred compounds of formula I* and its subformulae are those wherein P is selected from the group consisting of vinyloxy, acrylate, methacrylate, fluoroacrylate, chloroacrylate, oxetane and epoxide, very preferably from acrylate and methacrylate, most preferably acrylate.

Further preferred compounds of formula I* and its subformulae are those wherein Sp denotes a single bond or $-(CH_2)_{p1}-$, $-O-(CH_2)_{p1}-$, $-O-CO-(CH_2)_{p1}$, or $-CO-O-(CH_2)_{p1}$, wherein p1 is an integer from 2 to 10, preferably 2, 3, 4, 5 or 6, and, if Sp is $-O-(CH_2)_{p1}-$, $-O-CO-(CH_2)_{p1}$ or $-CO-O-(CH_2)_{p1}$ the O-atom or CO-group, respectively, is linked to the benzene ring.

Further preferred compounds of formula I* and its subformulae are those wherein all polymerisable groups P that are present in the compound have the same meaning, and very preferably denote acrylate or methacrylate, most preferably acrylate.

Further preferred compounds of formula I* and its subformulae are those which contain one, two, three or four groups P-Sp, very preferably two or three groups P-Sp.

Further preferred compounds of formula I* and its subformulae are those wherein at least one group Sp is a single bond.

Further preferred compounds of formula I* and its subformulae are those wherein at least one group Sp is a single bond and at least one group Sp is different from a single bond.

Further preferred compounds of formula I* and its subformulae are those wherein at least one group Sp is different from a single bond, and is selected from $-(CH_2)_{p1}-$, $-O-(CH_2)_{p1}-$, $-O-CO-(CH_2)_{p1}$, or $-CO-O-(CH_2)_{p1}$, wherein p1 is an integer from 2 to 10, preferably 2, 3, 4, 5 or 6, and, if Sp is $-O-(CH_2)_{p1}-$, $-O-CO-(CH_2)_{p1}$ or $-CO-O-(CH_2)_{p1}$ the O-atom or CO-group, respectively, is linked to the benzene ring.

In the event that $R^3$ or $R^4$ is a group of formula P-Sp-, the spacer groups on each side of the mesogenic core may be identical or different.

In the compounds of formula I*, m and l are preferably 0 or 1.

Preferred compounds of formula I* and its subformulae are those wherein G denotes or contains a photoisomerizable group.

Further preferred compounds of formula I* and its subformulae are those wherein $Z^3$ and/or $Z^4$ independently of each other denote -CH=CH-CO-O-, -O-CO-CH=CH-, - CH=C(CN)-CO-O-, -O-CO-C(CN)=CH-, -CH=N-, -N=CH- or -N=N-.

Further preferred compounds of formula I* and its subformulae are those containing an isomerizable group selected from stilbene, (1,2-difluoro-2-phenyl-vinyl)-benzene, cinnamate, $\alpha$-cyanocinnamate, 4-phenylbut-3-en-2-one, Schiff base, 2-benzyliden-1-indanone, chalcone, coumarin, chromone, pentalenone or azobenzene.

Further preferred compounds of formula I* and its subformulae are those wherein the chiral group G is selected or derived from dianhydrohexitol, preferably isosorbide, isomannide or isoidide, 1,1'-bi-2-naphthol (binol), 1,2-diphenyl-1,2-ethanediol (hydrobenzoin), 2-benzylidene-p-menthan-3-one and menthyl cinnamate ((1R,2S,5R)-5-Methyl-2-(1-methylethyl)cyclohexyl (2E)-3-phenyl-2-propenoate).

Very preferred compounds of formula I* are those wherein the chiral group G is selected of formula A:

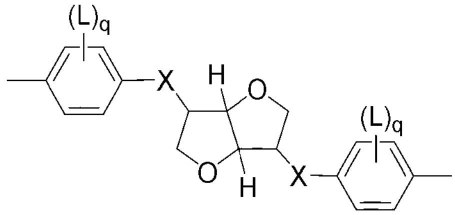

A

wherein X is -CO-O-, -CH=CH-CO-O-, -CH=C(CN)-CO-O-, in each of which the ester O-atom is linked to the furan ring, or -N=N-, q is 0, 1, 2, 3 or 4, and L has the meaning of formula I* or one of its preferred meanings as given above and below.

Formula A includes the following stereoisomers based on the corresponding dianhydrohexitols:

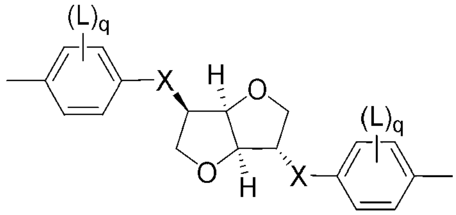

Ai

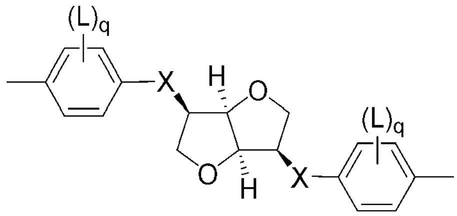

Aii

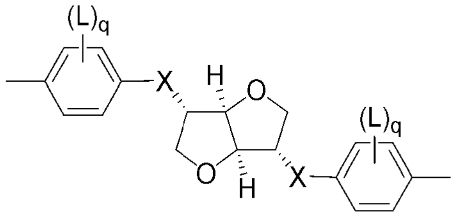

Aiii

wherein X, L and q have the meanings given in formula A, and wherein Ai is based on isosorbide, Aii is based on isomannide and Aiii is based on isoidide. Especially preferred is Ai.

Further preferred compounds of formula I* and its subformulae are those wherein one or both of $Z^3$ and $Z^4$ independently of each other denote -CH=CH-CO-O-, -O-CO-CH=CH-, -CH=C(CN)-CO-O-, -O-CO-C(CN)=CH-, -CH=N-, -N=CH- or -N=N-, and/or wherein G is of formula A, preferably Ai, and X denotes -CH=CH-CO-O-, -CH=C(CN)-CO-O- or -N=N-.

Further preferred compounds of formula I* and its subformulae are those wherein G is of formula A, preferably formula Ai, and X denotes -CH=CH-CO-O-, -CH=C(CN)-COO- or -N=N-, very preferably -CH=CH-CO-O-.

Further preferred compounds of formula I* and its subformulae are those wherein the chiral group G is selected from the following formulae

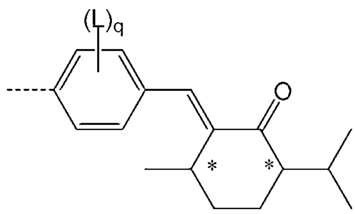

C

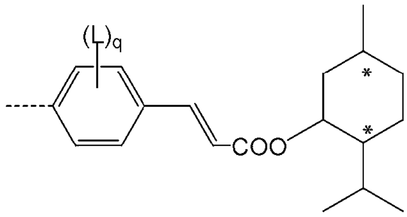

D

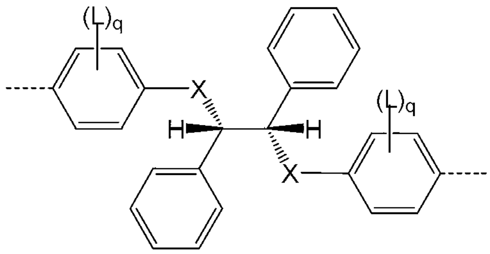

E

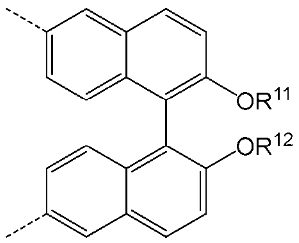

F

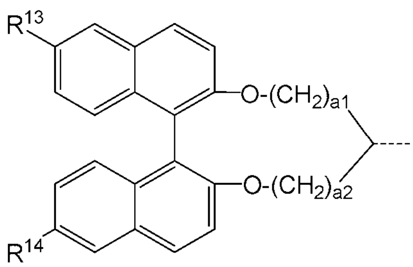

G

wherein

X, L and q have the meanings given in formula A or one of the preferred meanings as given above and below,
$R^{11}$ and $R^{12}$ independently of each other denote $-(Z^4-A^4)_l-R^4$ as defined in formula I*, or $R^{11}$ and $R^{12}$ together with the O atoms form a cyclic group or a spirocyclic group which is optionally substituted by a group $-(Z^4-A^4)_l-R^4$ as defined in formula I*,
$R^{13}$ and $R^{14}$ independently of each other denote $R^3-(A^3-Z^3)_m-$ as defined in formula I*, a1 and a2 independently of each other are 0, 1 or 2,
and the dashed lines represent a linkage to the adjacent group(s) in formula I*.

Preferred compounds of formula I* are selected from the following formulae:

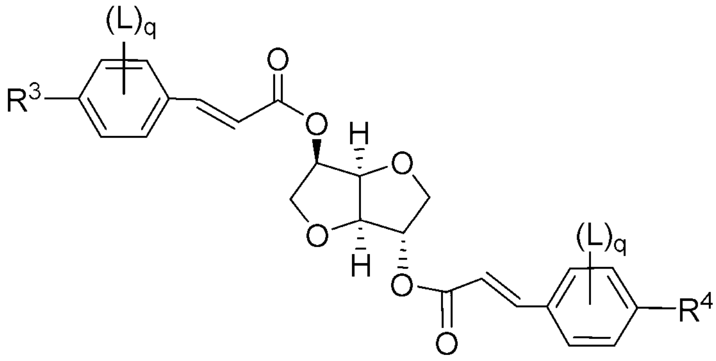

I*A

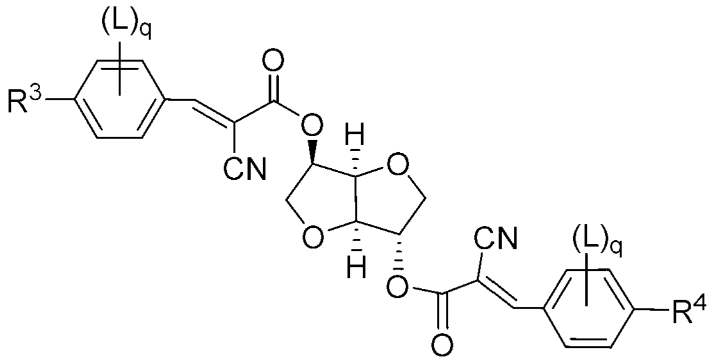

I*B

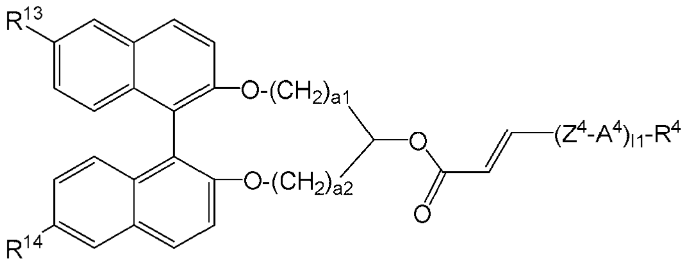

I*F1

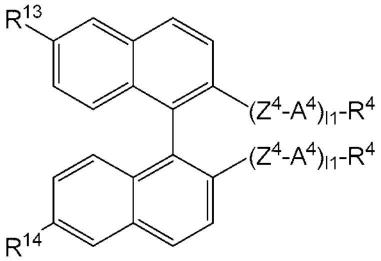

I*F2

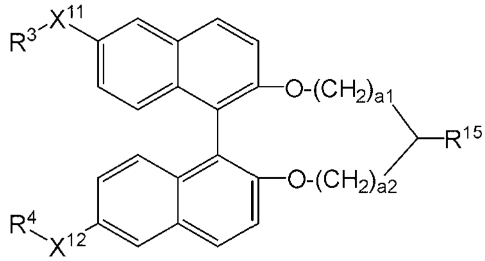

I*G

wherein $R^3$, $R^4$, $Z^4$, $A^4$, L and q have, independently of each other and on each occurrence identically or differently, the meanings given in formula I* or one of the preferred meanings as given above and below, l1 is 0, 1 or 2, $R^{13}$, $R^{14}$, a1 and a2 have the meanings given in formula G or one of the preferred meanings as given above and below, $R^{15}$ denotes

$-(Z^4-A^4)_l-R^4$ as defined in formula I* and $X^{11}$ and $X^{12}$ denote -O-CO-CH=CH-.

Very preferred compounds of formula I*A are selected from the following subformulae:

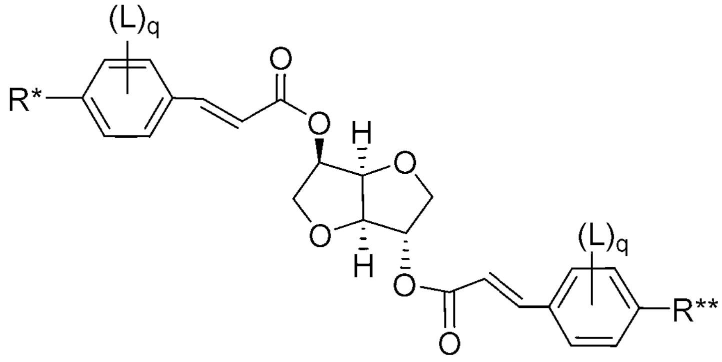

I*A1

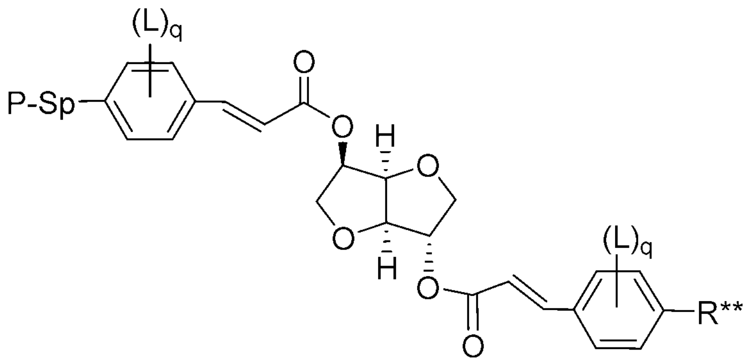

I*A2

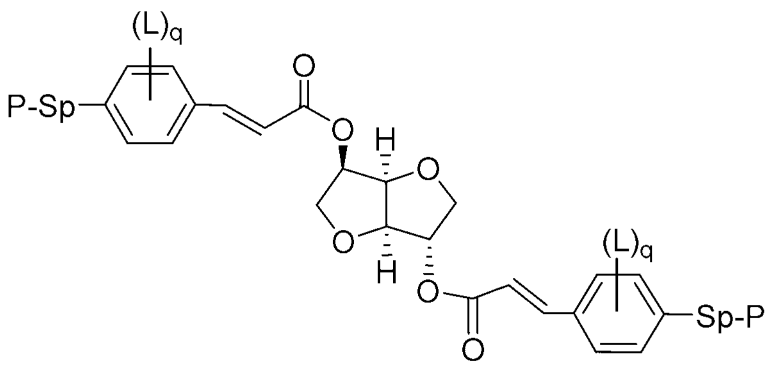

I*A3

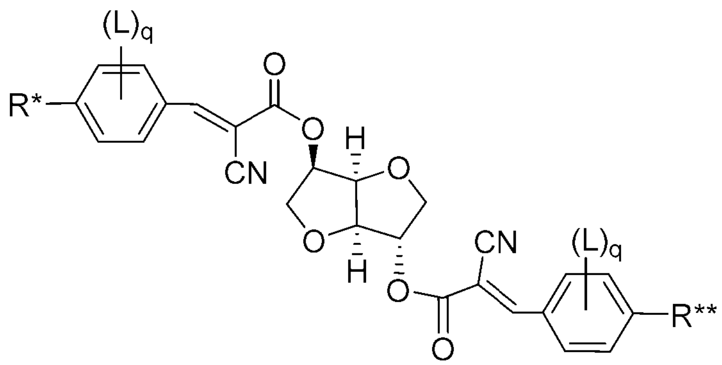

I*B1

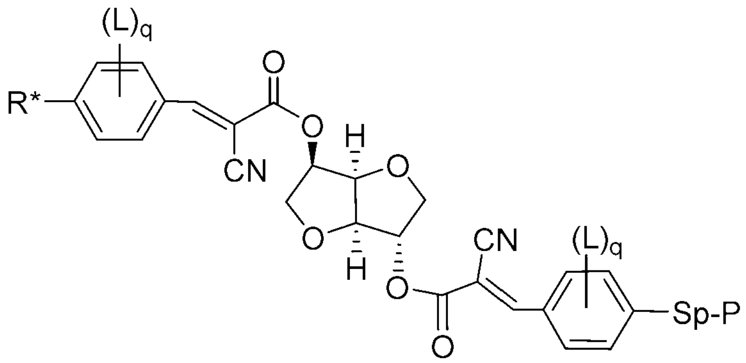

I*B2

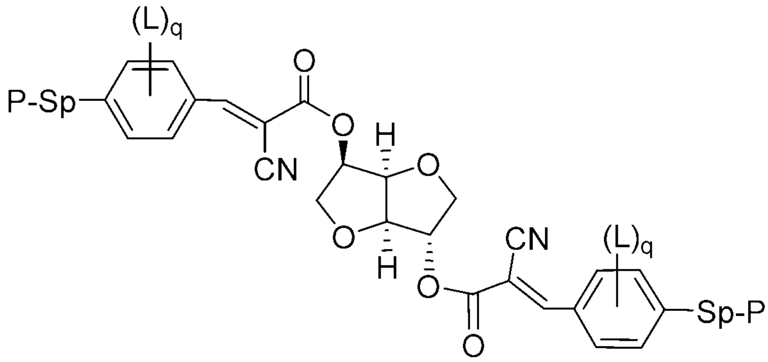

I*B3

wherein P, Sp, L and q have the meanings given in formula I* or one of the preferred meanings as given above and below, R* has one of the meanings of $R^3$ in formula I* which is different from P-Sp-, and R** has one of the meanings of $R^4$ in formula I* which is different from P-Sp-.

Especially preferred are the compounds of formula I*A3.

Further preferred are the stereoisomers of formula I*A, I*B, I*A1, I*A2 and I*A3 wherein the central isosorbide unit is replaced by an isomannide or isoidide unit.

In the compounds of formula I*A, I*B, I*A1, I*A2 and I*A3, P is preferably acrylate or methacrylate, very preferably acrylate, Sp is preferably $-O-(CH_2)_{p1}-$, $-O-CO-(CH_2)_{p1}-$ or $-CO-O-(CH_2)_{p1}-$,, very preferably $-O-(CH_2)_{p1}-$, wherein the O-atom or CO-group, respectively, is linked to the benzene ring, p1 is an integer from 1 to 6, more preferably 2, 3, 4, 5 or 6, and $R^4$ is preferably P-Sp-.

Further preferred compounds of formula I* and its subformulae are selected from the following formulae:

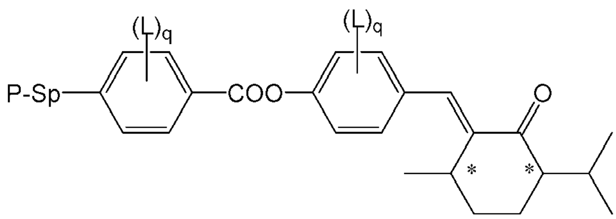

I*C1

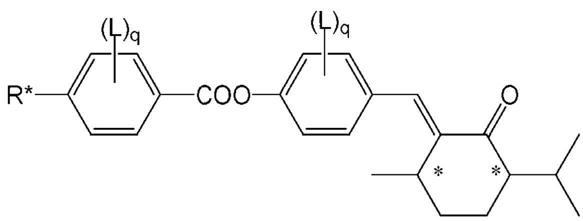

I*C2

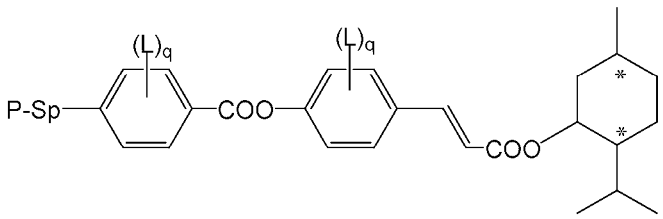

I*D1

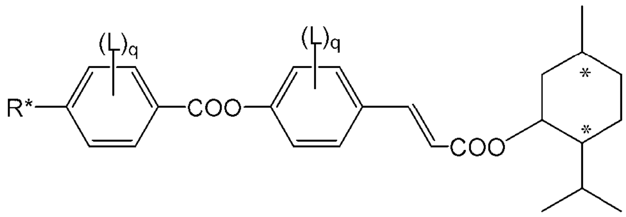

I*D2

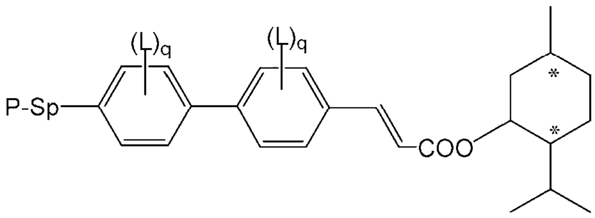

I*D3

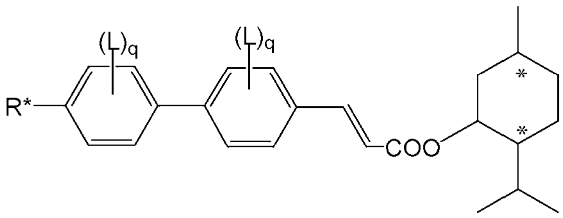

I*D4

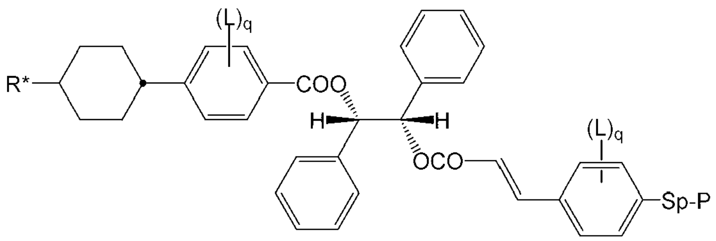

I*E1

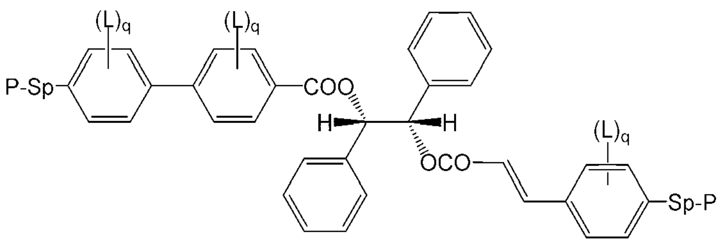

I*E2

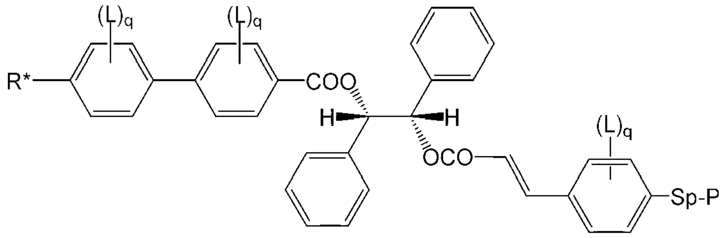

I*E3

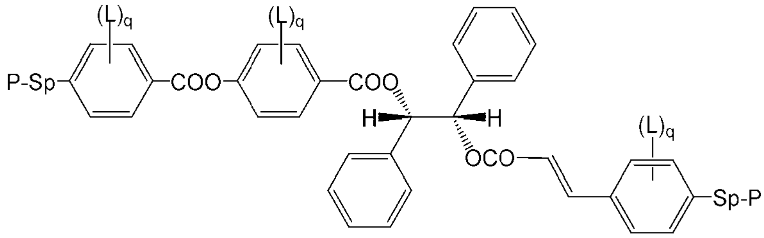

I*E4

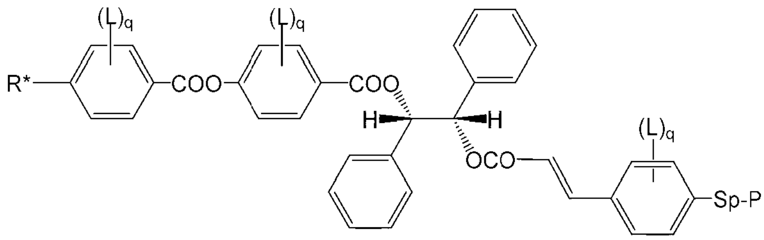

I*E5

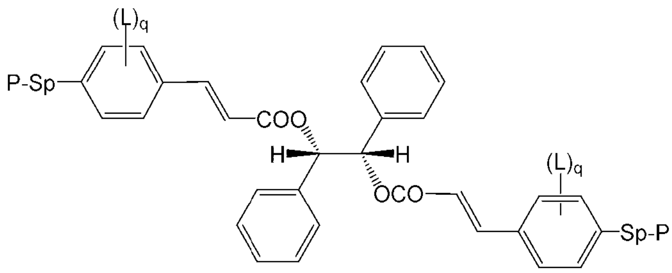

I*E6

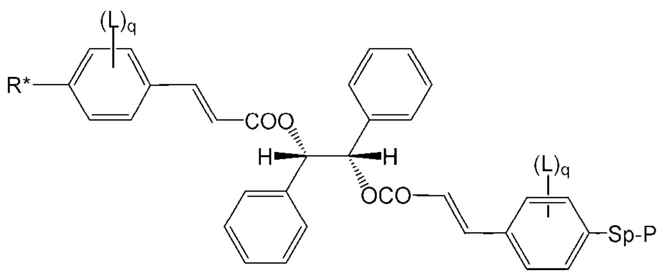

I*E7

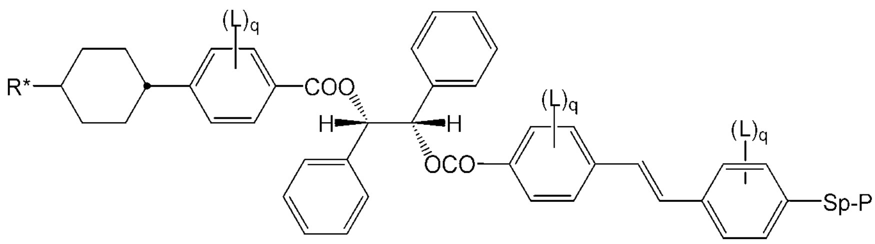

I*E8

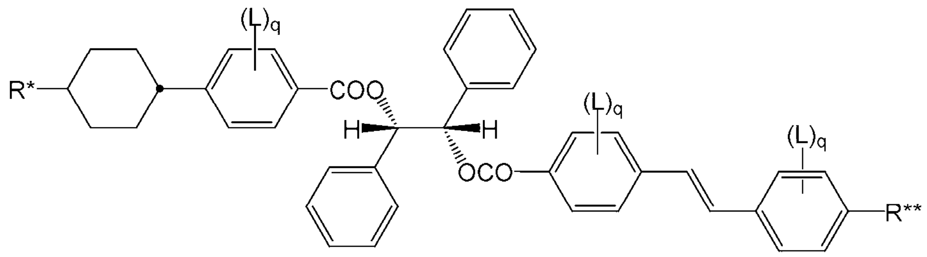

I*E9

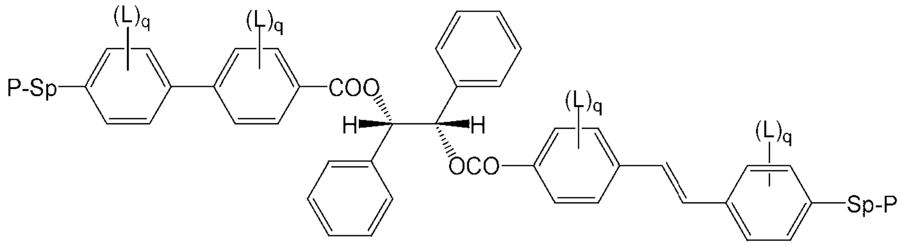

I*E10

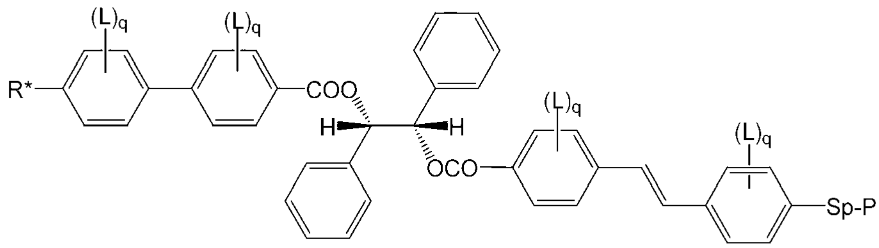

I*E11

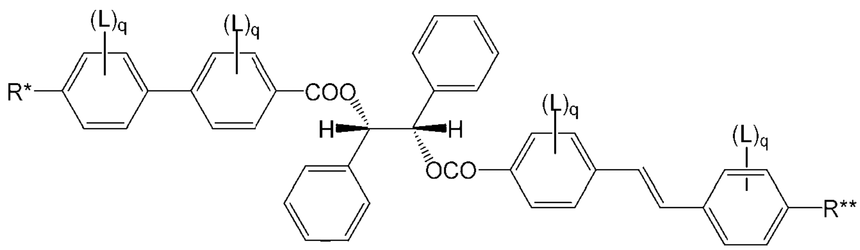

I*E12

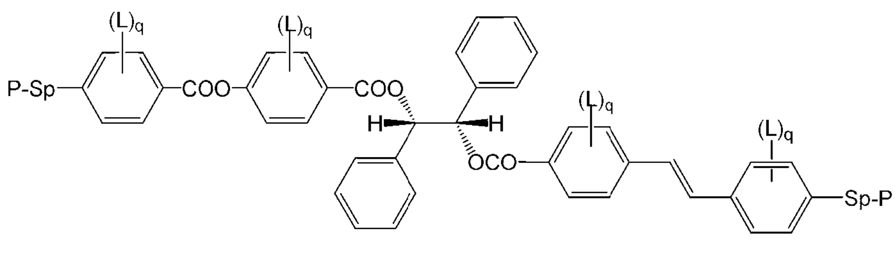

I*E13

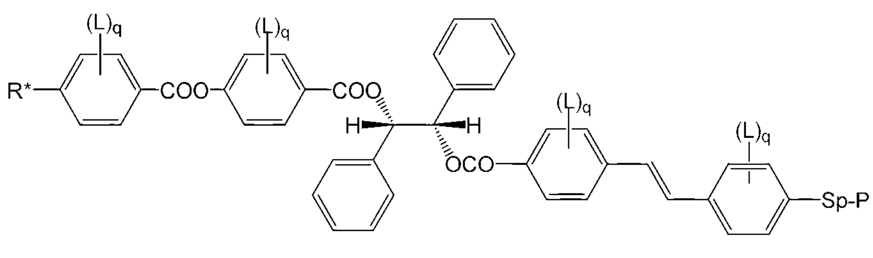

I*E14

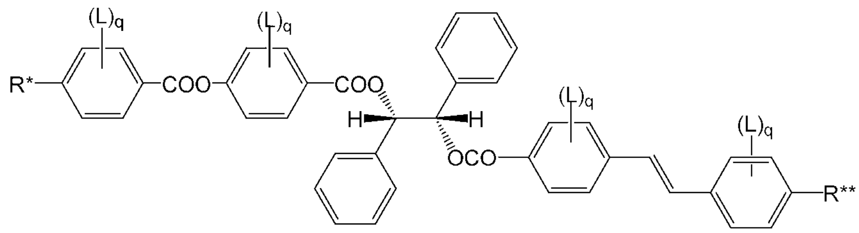

I*E15

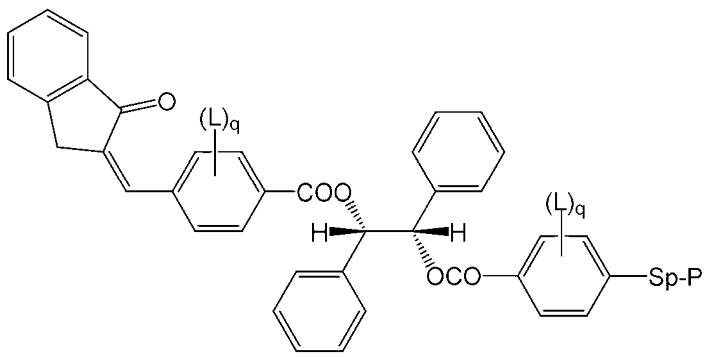

I*E16

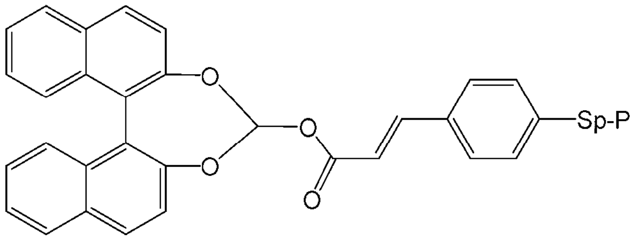

I*F1a

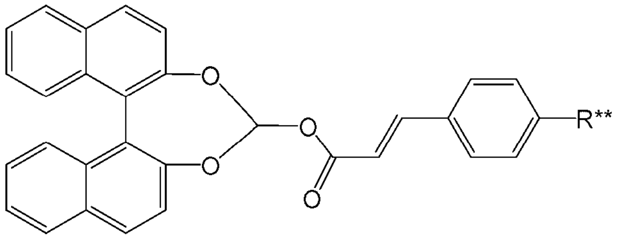

I*F1b

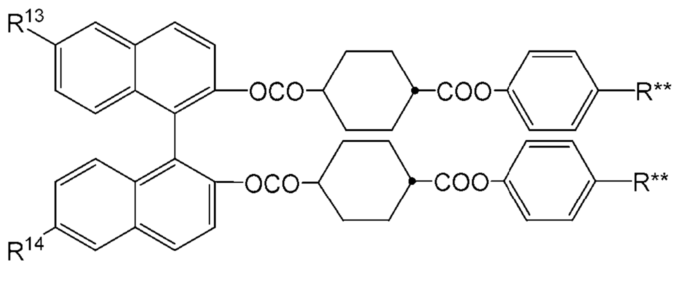

I*F2a

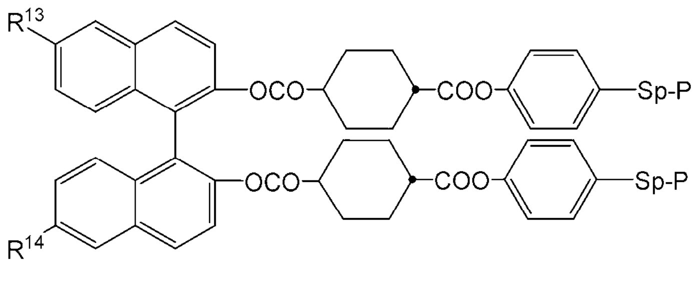

I*F2b

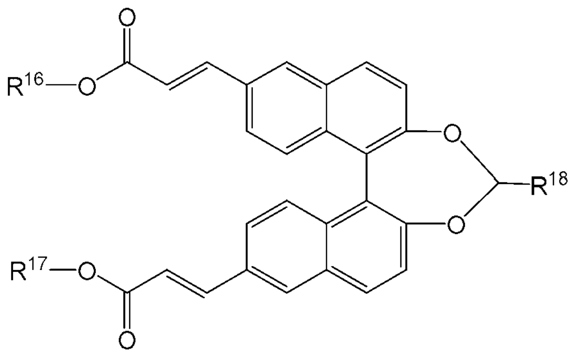

I*G1

wherein P, Sp, R*, R**, L and q have the meanings given in formula I* and I*A1 or one of the preferred meanings as given above and below, $R^{16}$ and $R^{17}$ independently of each other denote alkyl with 1 to 12, preferably 1 to 6 C atoms, very preferably methyl, ethyl or propyl, and $R^{18}$ denotes P-Sp-, H or alkyl with 1 to 12, preferably 1 to 6 C atoms, very preferably H.

In the compounds of formulae I*C1 to I*G1, P is preferably acrylate or methacrylate, very preferably acrylate, Sp is preferably $-O-(CH_2)_{p1}-$, $-O-CO-(CH_2)_{p1}-$ or $-CO-O-(CH_2)_{p1}-$, very preferably $-O-(CH_2)_{p1}-$, wherein the O-atom or CO-group, respectively, is linked to the benzene ring, p1 is an integer from 1 to 6, more preferably 2, 3, 4, 5 or 6, R* and R** are preferably, independently of each other, alkyl or alkoxy with 1 to 12, very preferably 1 to 6, C atoms.

The compounds of formula IA* can be prepared for example according to or in analogy to the method described in GB 2314839 A. The compounds of formulae I*E1 to I*E15 can be prepared for example according to or in analogy to the method described in WO 02/40614 A1.

Preferably the utilized chiral isomerizable compounds have each alone or in combination with each other an absolute value of the helical twisting power ($|HTP_{total}|$) of 20 $\mu m^{-1}$ or more, preferably of 40 $\mu m^{-1}$ or more, more preferably in the range of 60 $\mu m^{-1}$ or more, most preferably in the range of 80 $\mu m^{-1}$ or more to 260 $\mu m^{-1}$ .

Preferably the proportion of the chiral isomerizable compounds, especially those selected from formula I* or its subformulae, in the RM mixture according to the present invention as a whole is in the range from 0.1 to 4 % by weight, very preferably in the range from 0.2 to 3 % by weight, most preferably in the range from 0.3 to 2 % by weight.

The chiral RM mixture preferably exhibits a chiral nematic LC phase, or a chiral smectic LC phase and a chiral nematic LC phase, very preferably a chiral nematic LC phase at room temperature.

The chiral RM mixture preferably has a birefringence ($\Delta n$) in the range from 0.10 to 0.8, more preferably in the range from 0.12 to 0.7 and even more preferably in the range from 0.12 to 0.6.

The chiral RM mixture preferably exhibits a chiral nematic LC phase, or a chiral smectic LC phase and a chiral nematic LC phase, very preferably a chiral nematic LC phase at room temperature.

The chiral RM mixture preferably has a birefringence ($\Delta n$) in the range from 0.18 to 0.8, more preferably in the range from 0.20 to 0.7 and even more preferably in the range from 0.25 to 0.6.

Preferably the chiral RM mixture comprises an achiral host mixture and a chiral component. The achiral host mixture preferably comprises, very preferably consists of, one or more mono- and/or direactive achiral RMs, which are preferably selected from formulae D, M, T and A and their subformulae, but does not contain a chiral compound. The chiral component preferably comprises, very preferably consists of, one or more chiral compounds, which are preferably selected from formula C1, C2 and C3 and their subformulae.

The proportion of the achiral host mixture in the chiral RM mixture is preferably from 90 to 99.7%, very preferably from 94 to 99.5%. The proportion of the chiral component in the chiral RM mixure is preferably from 0.3 to 10%, very preferably from 0.5 to 6%.

In another preferred embodiment, the chiral RM mixture is prepared by blending an achiral host mixture which comprises, very preferably consists of, one or more mono- and/or direactive achiral RMs, preferably selected from formulae D, M, T and A and their subformulae, but does not contain a chiral compound, with another chiral RM mixture containing a chiral compound in a higher amount than the final chiral RM mixture after blending.

In another preferred embodiment of the present invention the achiral host mixture and the chiral RM mixture do not contain a compound of formula T or A. In another preferred embodiment the chiral RM mixture consists of compounds selected from formulae D, M, C1, C2, C3, P or their subformulae and optionally one or more additives as described below, and the achiral host mixture consists of compounds selected from formulae D, M and optionally one or more additives as described below.

Another object of the invention is an RM formulation comprising a chiral or achiral RM mixture as described above and below (hereinafter also simply referred to as "RM mixture"), and further comprising one or more solvents and/or additives.

The proportion of the RM mixture in the RM formulation is preferably from 85 to 100%, more preferably from 85 to

99%, very preferably from 90 to 99% of total solids and liquid additives, i.e., excluding the solvents.

In another preferred embodiment the RM mixture or RM formulation comprises optionally one or more additives selected from the group consisting of polymerization initiators, surfactants, stabilisers, catalysts, sensitizers, inhibitors, chain-transfer agents, co-reacting monomers, reactive thinners, surface-active compounds, lubricating agents, wetting agents, dispersing agents, hydrophobing agents, adhesive agents, flow improvers, degassing or defoaming agents, deaerators, diluents, reactive diluents, auxiliaries, colourants, dyes, pigments and nanoparticles.

In another preferred embodiment the present invention, the RM mixture and/or RM formulation do not contain a compound with at least one $CF_3$ or $CF_2$ group (PFAS), and very preferably the RM mixture and/or RM formulation do not contain a compound with a polyfluorinated alkyl or aryl group or a perfuorocarbon group. More preferably the RM mixture and/or RM formulation do not contain a compound with a fluorinated aliphatic C atom, most preferably the RM mixture and/or RM formulation do not contain a compound with a fluorinated C atom. The RM mixtures and RM formulations according to this preferred embodiment do thus enable a reduction of perfluorocarbons.

The RM mixture and/or RM formulation as described above and below, which do not contain a PFAS, more preferably do not contain a perfluorocarbon compound, very preferably do not contain compound with a polyfluorinated C atom, and most preferably do not contain a compound with a fluorinated C atom, are another object of the invention.

In another preferred embodiment the RM mixture or RM formulation comprises one or more specific antioxidant additives, preferably selected from the Irganox® series, e.g. the commercially available antioxidants Irganox®1076 and Irganox®1010, from Ciba, Switzerland.

In another preferred embodiment, the RM mixture or RM formulation comprises a photoinitiator or a combination of one or more, more preferably of two or more photoinitiators, for example, selected from the commercially available Omnirad® or Darocur® series (from IGM Resins), in particular, Omnirad 127, Omnirad 184, Omnirad 369, Omnirad 651, Omnirad 817, Omnirad 907, Omnirad 1300, Omnirad, Omnirad 2022, Omnirad 2100, Omnirad 2959, or Darocur TPO, further selected from the commercially available OXE-02, OXE-03, OXE-05 (BASF), NCI 930, N1919T (Adeka), SPI-03 or SPI-04 (Samyang), TR-PBG 304 or TR-PBG 345 (Tronly).

The concentration of the polymerization initiator(s) as a whole in the RM formulation is preferably from 0.1 to 6%, very preferably from 0.3 to 4%, more preferably from 0.7 to 2%.

In another preferred embodiment, in the RM mixture the ratio between the concentration of the photoinitiator and the concentration of the chiral compounds as a whole is in the range from 2:1 to 1:5, more preferably in the range from 2:1 to 1:4, even more preferably in the range from 2:1 to 1:3.

In another preferred embodiment the RM mixture or RM formulation optionally comprises one or more additives selected from polymerizable non-mesogenic compounds (reactive thinners). The amount of these additives in the RM formulation is preferably from 0 to 30 %, very preferably from 0 to 25 %.

The reactive thinners used are not only substances which are referred to in the actual sense as reactive thinners, but also auxiliary compounds already mentioned above which contain one or more complementary reactive units, for example hydroxyl, thiol-, or amino groups, via which a reaction with the polymerizable units of the liquid-crystalline compounds can take place.

The substances which are usually capable of photopolymerization include, for example, mono-, bi- and polyfunctional compounds containing at least one olefinic double bond. Examples thereof are vinyl esters of carboxylic acids, for example of lauric, myristic, palmitic and stearic acid, and of dicarboxylic acids, for example of succinic acid, adipic acid, allyl and vinyl ethers and methacrylic and acrylic esters of monofunctional alcohols, for example of lauryl, myristyl, palmityl and stearyl alcohol, and diallyl and divinyl ethers of bifunctional alcohols, for example ethylene glycol and 1,4-butanediol.

Also suitable are, for example, methacrylic and acrylic esters of polyfunctional alcohols, in particular those which contain no further functional groups, or at most ether groups, besides the hydroxyl groups. Examples of such alcohols are bifunctional alcohols, such as ethylene glycol, propylene glycol and their more highly condensed representatives, for example diethylene glycol, triethylene glycol, dipropylene glycol, tripropylene glycol etc., butanediol, pentanediol, hexanediol, neopentyl glycol, alkoxylated phenolic compounds, such as ethoxylated and propoxylated bisphenols, cyclohexanedimethanol, trifunctional and polyfunctional alcohols, such as glycerol, trimethylolpropane, butanetriol, trimethylolethane, pentaerythritol, ditrimethylolpropane, dipentaerythritol, sorbitol, mannitol, and the corresponding alkoxylated, in particular ethoxylated and propoxylated alcohols.

Other suitable reactive thinners are polyester (meth)acrylates, which are the (meth)acrylic ester of polyesterols.

Examples of suitable polyesterols are those which can be prepared by esterification of polycarboxylic acids, preferably dicarboxylic acids, using polyols, preferably diols. The starting materials for such hydroxyl-containing polyesters are known to the person skilled in the art. Dicarboxylic acids which can be employed are succinic, glutaric acid, adipic acid, sebacic acid, o-phthalic acid and isomers and hydrogenation products thereof, and esterifiable and transesterifiable derivatives of said acids, for example anhydrides and dialkyl esters. Suitable polyols are the abovementioned alcohols, preferably ethyleneglycol, 1,2- and 1,3-propylene glycol, 1,4-butanediol, 1,6-hexanediol, neopentyl glycol, cyclohexanedimethanol and polyglycols of the ethylene glycol and propylene glycol type.

Suitable reactive thinners are furthermore 1,4-divinylbenzene, triallyl cyanurate, acrylic esters of tricyclodecenyl alcohol of the following formula

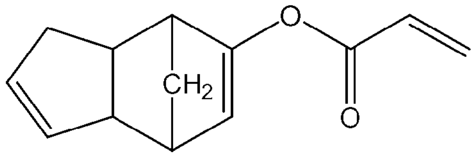

also known under the name dihydrodicyclopentadienyl acrylate, and the allyl esters of acrylic acid, methacrylic acid and cyanoacrylic acid.

Of the reactive thinners which are mentioned by way of example, those containing photopolymerizable groups are used in particular and in view of the abovementioned preferred compositions.

This group includes, for example, dihydric and polyhydric alcohols, for example ethylene glycol, propylene glycol and more highly condensed representatives thereof, for example diethylene glycol, triethylene glycol, dipropylene glycol, tripropylene glycol etc., butanediol, pentanediol, hexanediol, neopentyl glycol, cyclohexanedimethanol, glycerol, trimethylolpropane, butanetriol, trimethylolethane, pentaerythritol, ditrimethylolpropane, dipentaerythritol, sorbitol, mannitol and the corresponding alkoxylated, in particular ethoxylated and propoxylated alcohols.

The group furthermore also includes, for example, alkoxylated phenolic compounds, for example ethoxylated and propoxylated bisphenols.

These reactive thinners may furthermore be, for example, epoxide or urethane (meth)acrylates.

Epoxide (meth)acrylates are, for example, those as obtainable by the reaction, known to the person skilled in the art, of epoxidized olefins or poly- or diglycidyl ether, such as bisphenol A diglycidyl ether, with (meth)acrylic acid.

Urethane (meth)acrylates are, in particular, the products of a reaction, likewise known to the person skilled in the art, of hydroxylalkyl (meth)acrylates with poly- or diisocyanates.

Such epoxide and urethane (meth)acrylates are included amongst the compounds listed above as "mixed forms".

If reactive thinners are used, their amount and properties must be matched to the respective conditions in such a way that, on the one hand, a satisfactory desired effect, for example the desired colour of the composition according to the invention, is achieved, but, on the other hand, the phase behaviour of the liquid-crystalline composition is not excessively impaired. The low-crosslinking (high-crosslinking) liquid-crystalline compositions can be prepared, for example, using corresponding reactive thinners which have a relatively low (high) number of reactive units per molecule.

The group of diluents include, for example:

C1-C4-alcohols, for example methanol, ethanol, n-propanol, isopropanol, butanol, isobutanol, sec-butanol and, in particular, the C5-C12-alcohols n-pentanol, n-hexanol, n-heptanol, n-octanol, n-nonanol, n-decanol, n-undecanol and n-dodecanol, and isomers thereof, glycols, for example 1,2-ethylene glycol, 1,2- and 1,3-propylene glycol, 1,2-, 2,3- and 1,4-butylene glycol, di- and triethylene glycol and di- and tripropylene glycol, ethers, for example methyl tert-butyl ether, 1,2-ethylene glycol mono- and dimethyl ether, 1,2-ethylene glycol mono- and -diethylether, 3-methoxypropanol, 3-isopropoxypropanol, tetrahydrofuran and dioxane, ketones, for example acetone, methyl ethyl ketone, methyl isobutyl ketone and diacetone alcohol (4-hydroxy-4-methyl-2-pentanone), C1-C5-alkyl esters, for example methyl acetate, ethyl acetate, propyl acetate, butyl acetate and amyl acetate, aliphatic and aromatic hydrocarbons, for example pentane, hexane, heptane, octane, isooctane, petroleum ether, toluene, xylene, ethylbenzene, tetralin, decalin, dimethylnaphthalene, white spirit, Shellsol® and Solvesso® mineral oils, for example gasoline, kerosine, diesel oil and heating oil, but also natural oils, for example olive oil, soya oil, rapeseed oil, linseed oil and sunflower oil.

It is of course also possible to use mixtures of these diluents in the compositions according to the invention.

So long as there is at least partial miscibility, these diluents can also be mixed with water. Examples of suitable diluents here are C1-C4-alcohols, for example methanol, ethanol, n-propanol, isopropanol, butanol, isobutanol and sec-butanol, glycols, for example 1,2-ethylene glycol, 1,2- and 1,3-propylene glycol, 1,2-, 2,3- and 1,4-butylene glycol, di- and triethylene glycol, and di- and tripropylene glycol, ethers, for example tetrahydrofuran and dioxane, ketones, for example acetone, methyl ethyl ketone and diacetone alcohol (4-hydroxy-4-methyl-2-pentanone), and C1-C4-alkyl esters, for example methyl, ethyl, propyl and butyl acetate.

The diluents are optionally employed in a proportion of from about 0 to 10.0% by weight, preferably from about 0 to 5.0% by weight, based on the total weight of the RM formulation.

The antifoams and deaerators (c1)), lubricants and flow auxiliaries (c2)), thermally curing or radiation-curing auxiliaries (c3)), substrate wetting auxiliaries (c4)), wetting and dispersion auxiliaries (c5)), hydrophobicizing agents (c6)), adhesion promoters (c7)) and auxiliaries for promoting scratch resistance (c8)) cannot strictly be delimited from one another in their action.

For example, lubricants and flow auxiliaries often also act as antifoams and/or deaerators and/or as auxiliaries for

improving scratch resistance. Radiation-curing auxiliaries can also act as lubricants and flow auxiliaries and/or deaerators and/or as substrate wetting auxiliaries. In individual cases, some of these auxiliaries can also fulfil the function of an adhesion promoter (c8)).

Corresponding to the above-said, a certain additive can therefore be classified in a number of the groups c1) to c8) described below.

The antifoams in group c1) include silicon-free and silicon-containing polymers. The silicon-containing polymers are, for example, unmodified or modified polydialkylsiloxanes or branched copolymers, comb or block copolymers comprising polydialkylsiloxane and polyether units, the latter being obtainable from ethylene oxide or propylene oxide.

The deaerators in group c1) include, for example, organic polymers, for example polyethers and polyacrylates, dialkylpolysiloxanes, in particular dimethylpolysiloxanes, organically modified polysiloxanes, for example arylalkyl-modified polysiloxanes, and fluorosilicones.

The action of the antifoams is essentially based on preventing foam formation or destroying foam that has already formed. Antifoams essentially work by promoting coalescence of finely divided gas or air bubbles to give larger bubbles in the medium to be deaerated, for example the compositions according to the invention, and thus accelerate escape of the gas (of the air). Since antifoams can frequently also be employed as deaerators and vice versa, these additives have been included together under group c1).

Such auxiliaries are, for example, commercially available from Tego as TEGO® Foamex 800, TEGO® Foamex 805, TEGO® Foamex 810, TEGO® Foamex 815, TEGO® Foamex 825, TEGO® Foamex 835, TEGO® Foamex 840, TEGO® Foamex 842, TEGO® Foamex 1435, TEGO® Foamex 1488, TEGO® Foamex 1495, TEGO® Foamex 3062, TEGO® Foamex 7447, TEGO® Foamex 8020, Tego® Foamex N, TEGO® Foamex K 3, TEGO® Antifoam 2-18,TEGO® Antifoam 2-18, TEGO® Antifoam 2-57, TEGO® Antifoam 2-80, TEGO® Antifoam 2-82, TEGO® Antifoam 2-89, TEGO® Antifoam 2-92, TEGO® Antifoam 14, TEGO® Antifoam 28, TEGO® Antifoam 81, TEGO® Antifoam D 90, TEGO® Antifoam 93, TEGO® Antifoam 200, TEGO® Antifoam 201, TEGO® Antifoam 202, TEGO® Antifoam 793, TEGO® Antifoam 1488, TEGO® Antifoam 3062, TEGOPREN® 5803, TEGOPREN® 5852, TEGOPREN® 5863, TEGOPREN® 7008, TEGO® Antifoam 1-60, TEGO® Antifoam 1-62, TEGO® Antifoam 1-85, TEGO® Antifoam 2-67, TEGO® Antifoam WM 20, TEGO® Antifoam 50, TEGO® Antifoam 105, TEGO® Antifoam 730, TEGO® Antifoam MR 1015, TEGO® Antifoam MR 1016, TEGO® Antifoam 1435, TEGO® Antifoam N, TEGO® Antifoam KS 6, TEGO® Antifoam KS 10, TEGO® Antifoam KS 53, TEGO® Antifoam KS 95, TEGO® Antifoam KS 100, TEGO® Antifoam KE 600, TEGO® Antifoam KS 911, TEGO® Antifoam MR 1000, TEGO® Antifoam KS 1100, TEGO® Twin 4000, Tego® Airex 900, Tego® Airex 910, Tego® Airex 931, Tego® Airex 935, Tego® Airex 936, Tego® Airex 960, Tego® Airex 970, Tego® Airex 980 and Tego® Airex 985 and from BYK as BYK®-011, BYK®-019, BYK®-020, BYK®-021, BYK®-022, BYK®-023, BYK®-024, BYK®-025, BYK®-027, BYK®-031, BYK®-032, BYK®-033, BYK®-034, BYK®-035, BYK®-036, BYK®-037, BYK®-045, BYK®-051, BYK®-052, BYK®-053, BYK®-055, BYK®-057, BYK®-065, BYK®-066, BYK®-070, BYK®-080, BYK®-088, BYK®-141 and BYK®-A 530.

The auxiliaries in group c1) are optionally employed in a proportion of from about 0 to 3.0% by weight, preferably from about 0 to 2.0% by weight, based on the total weight of the RM formulation.

In group c2), the lubricants and flow auxiliaries typically include silicon-free, but also silicon-containing polymers, for example polyacrylates or modifiers, low-molecular-weight polydialkylsiloxanes. The modification consists in some of the alkyl groups having been replaced by a wide variety of organic radicals. These organic radicals are, for example, polyethers, polyesters or even long-chain alkyl radicals, the former being used the most frequently.

The polyether radicals in the correspondingly modified polysiloxanes are usually built up from ethylene oxide and/or propylene oxide units. Generally, the higher the proportion of these alkylene oxide units in the modified polysiloxane, the more hydrophilic is the resultant product.

Such auxiliaries are, for example, commercially available from Tego as TEGO® Glide 100, TEGO® Glide ZG 400, TEGO® Glide 406, TEGO® Glide 410, TEGO® Glide 411, TEGO® Glide 415, TEGO® Glide 420, TEGO® Glide 435, TEGO® Glide 440, TEGO® Glide 450, TEGO® Glide A 115, TEGO® Glide B 1484 (can also be used as antifoam and deaerator), TEGO® Flow ATF, TEGO® Flow 300, TEGO® Flow 460, TEGO® Flow 425 and TEGO® Flow ZFS 460. Suitable radiation-curable lubricants and flow auxiliaries, which can also be used to improve the scratch resistance, are the products TEGO® Rad 2100, TEGO® Rad 2200, TEGO® Rad 2500, TEGO® Rad 2600 and TEGO® Rad 2700, which are likewise obtainable from TEGO.

Such-auxiliaries are available, for example, from BYK as BYK®-300 BYK®-306, BYK®-307, BYK®-310, BYK®-320, BYK®-333, BYK®-341, Byk® 354, Byk®361, Byk®361N, BYK®388.

The auxiliaries in group c2) are optionally employed in a proportion of from about 0 to 3.0% by weight, preferably from about 0 to 2.0% by weight, based on the total weight of the RM formulation.

In group c3), the radiation-curing auxiliaries include, in particular, polysiloxanes having terminal double bonds which are, for example, a constituent of an acrylate group. Such auxiliaries can be crosslinked by actinic or, for example, electron radiation. These auxiliaries generally combine a number of properties together. In the uncrosslinked state, they can act as antifoams, deaerators, lubricants and flow auxiliaries and/or substrate wetting auxiliaries, while, in the crosslinked state, they increase, in particular, the scratch resistance, for example of coatings or films which can be

produced using the compositions according to the invention. The improvement in the gloss properties, for example of precisely those coatings or films, is regarded essentially as a consequence of the action of these auxiliaries as antifoams, deaerators and/or lubricants and flow auxiliaries (in the uncrosslinked state).

Examples of suitable radiation-curing auxiliaries are the products TEGO® Rad 2100, TEGO® Rad 2200, TEGO® Rad 2500, TEGO® Rad 2600 and TEGO® Rad 2700 available from TEGO and the product BYK®-371 available from BYK.

Thermally curing auxiliaries in group c3) contain, for example, primary OH groups which are able to react with isocyanate groups, for example of the binder.

Examples of thermally curing auxiliaries which can be used are the products BYK®-370, BYK®-373 and BYK®-375 available from BYK.

The auxiliaries in group c3) are optionally employed in a proportion of from about 0 to 5.0% by weight, preferably from about 0 to 3.0% by weight, based on the total weight of the RM formulation.

The substrate wetting auxiliaries in group c4) serve, in particular, to increase the wettability of the substrate to be printed or coated, for example, by printing inks or coating compositions, for example compositions according to the invention. The generally attendant improvement in the lubricant and flow behaviour of such printing inks or coating compositions has an effect on the appearance of the finished (for example crosslinked) print or coating.

A wide variety of such auxiliaries are commercially available, for example from Tego as TEGO® Wet KL 245, TEGO® Wet 250, TEGO® Wet 260 and TEGO® Wet ZFS 453 and from BYK as BYK®-306, BYK®-307, BYK®-310, BYK®-333, BYK®-344, BYK®-345, BYK®-346, Byk®-348 and Byk®-3550.

The auxiliaries in group c4) are optionally employed in a proportion of from about 0 to 3.0% by weight, preferably from about 0 to 1.5% by weight, based on the total weight of the liquid-crystalline composition.

The wetting and dispersion auxiliaries in group c5) serve, in particular, to prevent the flooding and floating and the sedimentation of pigments and are therefore, if necessary, suitable in particular in pigmented compositions according to the invention.

These auxiliaries stabilize pigment dispersions essentially through electrostatic repulsion and/or steric hindrance of the pigment particles containing these additives, where, in the latter case, the interaction of the auxiliary with the ambient medium (for example binder) plays a major role.

Since the use of such wetting and dispersion auxiliaries is common practice, for example in the technical area of printing inks and paints, the selection of a suitable auxiliary of this type generally does not present the person skilled in the art with any difficulties, if they are used.

Such wetting and dispersion auxiliaries are commercially available, for example from Tego, as TEGO® Dispers 610, TEGO® Dispers 610 S, TEGO® Dispers 630, TEGO® Dispers 700, TEGO® Dispers 705, TEGO® Dispers 710, TEGO® Dispers 720 W, TEGO® Dispers 725 W, TEGO® Dispers 730 W, TEGO® Dispers 735 W and TEGO® Dispers 740 W and from BYK as Disperbyk®, Disperbyk®-107, Disperbyk®-108, Disperbyk®-110, Disperbyk®-111, Disperbyk®-115, Disperbyk®-130, Disperbyk®-160, Disperbyk®-161, Disperbyk®-162, Disperbyk®-163, Disperbyk®-164, Disperbyk®-165, Disperbyk®-166, Disperbyk®-167, Disperbyk®-170, Disperbyk®-174, Disperbyk®-180, Disperbyk®-181, Disperbyk®-182, Disperbyk®-183, Disperbyk®-184, Disperbyk®-185, Disperbyk®-190, Anti-Terra®-U, Anti-Terra®-U 80, Anti-Terra®-P, Anti-Terra®-203, Anti-Terra®-204, Anti-Terra®-206, BYK®-151, BYK®-154, BYK®-155, BYK®-P 104 S, BYK®-P 105, Lactimon®, Lactimon®-WS and Bykumen®.

The amount of the auxiliaries in group c5) used on the mean molecular weight of the auxiliary. In any case, a preliminary experiment is therefore advisable, but this can be accomplished simply by the person skilled in the art.

Another preferred group of auxiliaries, which can be allocated to group c2), c4) or c5), includes wetting-, flow- and leveling agents, in particular based on non-ionic fluorosurfactants, which are commercially available from Synthomer under the Polyfox™ series, for example Polyfox™PF-656.

The hydrophobicizing agents in group c6) can be used to give water-repellent properties to prints or coatings produced, for example, using compositions according to the invention. This prevents or at least greatly suppresses swelling due to water absorption and thus a change in, for example, the optical properties of such prints or coatings. In addition, when the composition is used, for example, as a printing ink in offset printing, water absorption can thereby be prevented or at least greatly reduced.

Such hydrophobicizing agents are commercially available, for example, from Tego as Tego® Phobe WF, Tego® Phobe 1000, Tego® Phobe 1000 S, Tego® Phobe 1010, Tego® Phobe 1030, Tego® Phobe 1010, Tego® Phobe 1010, Tego® Phobe 1030, Tego® Phobe 1040, Tego® Phobe 1050, Tego® Phobe 1200, Tego® Phobe 1300, Tego® Phobe 1310 and Tego® Phobe 1400.

The auxiliaries in group c6) are optionally employed in a proportion of from about 0 to 5.0% by weight, preferably from about 0 to 3.0% by weight, based on the total weight of the RM formulation.

Adhesion promoters from group c7) serve to improve the adhesion of two interfaces in contact. It is directly evident from this that essentially the only fraction of the adhesion promoter that is effective is that located at one or the other or at both interfaces. If, for example, it is desired to apply liquid or pasty printing inks, coating compositions or paints to a solid substrate, this generally means that the adhesion promoter must be added directly to the latter or the substrate must

be pre-treated with the adhesion promoters (also known as priming), i.e. this substrate is given modified chemical and/or physical surface properties.

If the substrate has previously been primed with a primer, this means that the interfaces in contact are that of the primer on the one hand and of the printing ink or coating composition or paint on the other hand. In this case, not only the adhesion properties between the substrate and the primer, but also between the substrate and the printing ink or coating composition or paint play a part in adhesion of the overall multilayer structure on the substrate.

Adhesion promoters in the broader sense which may be mentioned are also the substrate wetting auxiliaries already listed under group c4), but these generally do not have the same adhesion promotion capacity.

In view of the widely varying physical and chemical natures of substrates and of printing inks, coating compositions and paints intended, for example, for their printing or coating, the multiplicity of adhesion promoter systems is not surprising.

Adhesion promoters based on silanes are, for example, 3-aminopropyltrimethoxysilane, 3-aminopropyltriethoxysilane, 3-aminopropylmethyldiethoxysilane, N-aminoethyl-3-aminopropyltrimethoxysilane, N-aminoethyl-3-aminopropylmethyldimethoxysilane, N-methyl-3-aminopropyltrimethoxysilane, 3-ureidopropyltriethoxysilane, 3-methacryloyloxypropyltrimethoxysilane, 3-glycidyloxypropyltrimethoxysilane, 3-mercaptopropyltrimethoxysilane, 3-chloropropyltrimethoxysilane and vinyltrimethoxysilane. These and other silanes are commercially available from Hüls, for example under the tradename DYNASILAN®.

Corresponding technical information from the manufacturers of such additives should generally be used or the person skilled in the art can obtain this information in a simple manner through corresponding preliminary experiments.

However, if these additives are to be added as auxiliaries from group c7) to the **RM** formulations according to the invention, their proportion optionally corresponds to from about 0 to 5.0% by weight, based on the total weight of the **RM** formulation. These concentration data serve merely as guidance, since the amount and identity of the additive are determined in each individual case by the nature of the substrate and of the printing/coating composition. Corresponding technical information is usually available from the manufacturers of such additives for this case or can be determined in a simple manner by the person skilled in the art through corresponding preliminary experiments.

The auxiliaries for improving the scratch resistance in group c8) include, for example, the abovementioned products TEGO® Rad 2100, TEGO® Rad 2200, TEGO® Rad 2500, TEGO® Rad 2600 and TEGO® Rad 2700, which are available from Tego.

For these auxiliaries, the amount data given for group c3) are likewise suitable, i.e. these additives are optionally employed in a proportion of from about 0 to 5.0% by weight, preferably from about 0 to 3.0% by weight, based on the total weight of the liquid-crystalline composition.

Examples which may be mentioned of light, heat and/or oxidation stabilizers are the following:

alkylated monophenols, such as 2,6-di-tert-butyl-4-methylphenol, 2-tert-butyl-4,6-dimethylphenol, 2,6-di-tert-butyl-4-ethylphenol, 2,6-di-tert-butyl-4-n-butylphenol, 2,6-di-tert-butyl-4-isobutylphenol, 2,6-dicyclopentyl-4-methylphenol, 2-($\alpha$-methylcyclohexyl)-4,6-dimethylphenol, 2,6-dioctadecyl-4-methylphenol, 2,4,6-tricyclohexylphenol, 2,6-di-tert-butyl-4-methoxymethylphenol, nonylphenols which have a linear or branched side chain, for example 2,6-dinonyl-4-methylphenol, 2,4-dimethyl-6-(1'-methylundec-1'-yl)phenol, 2,4-dimethyl-6-(1'-methylheptadec-1'-yl) phenol, 2,4-dimethyl-6-(1'-methyltridec-1'-yl)phenol and mixtures of these compounds, alkylthiomethylphenols, such as 2,4-dioctylthiomethyl-6-tert-butylphenol, 2,4-dioctylthiomethyl-6-methylphenol, 2,4-dioctylthiomethyl-6-ethylphenol and 2,6-didodecylthiomethyl-4-nonylphenol, Hydroquinones and alkylated hydroquinones, such as 2,6-di-tert-butyl-4-methoxyphenol, 2,5-di-tert-butylhydroquinone, 2,5-di-tert-amylhydrocrainone, 2,6-diphenyl-4-octadecyloxyphenol, 2,6-di-tert-butylhydroquinone, 2,5-di-tert-butyl-4-hydroxyanisole, 3,5-di-tert-butyl-4-hydroxyanisole, 3,5-di-tert-butyl-4-hydroxyphenyl stearate and bis(3,5-di-tert-butyl-4-hydroxyphenyl)adipate,

Tocopherols, such as $\alpha$-tocopherol, $\beta$-tocopherol, $\gamma$-tocopherol, $\delta$-tocopherol and mixtures of these compounds, and tocopherol derivatives, such as tocopheryl acetate, succinate, nicotinate and polyoxyethylenesuccinate ("tocofersolate"),

hydroxylated diphenyl thioethers, such as 2,2'-thiobis(6-tert-butyl-4-methylphenol), 2,2'-thiobis(4-octylphenol), 4,4'-thiobis(6-tert-butyl-3-methylphenol), 4,4'-thiobis(6-tert-butyl-2-methylphenol), 4,4'-thiobis(3,6-di-sec-amylphenol) and 4,4'-bis(2,6-dimethyl-4-hydroxyphenyl)disulfide,

Alkylidenebisphenols, such as 2,2'-methylenebis(6-tert-butyl-4-methylphenol), 2,2'-methylenebis(6-tert-butyl-4-ethylphenol), 2,2'-methylenebis[4-methyl-6-(a-methylcyclohexyl)phenol], 2,2'-methylenebis(4-methyl-6-cyclohexylphenol), 2,2'-methylenebis(6-nonyl-4-methylphenol), 2,2'-methylenebis(4,6-di-tert-butylphenol), 2,2-ethylidenebis(4,6-di-tert-butylphenol), 2,2'-ethylidenebis(6-tert-butyl-4-isobutylphenol), 2,2'-methylenebis[6-($\alpha$-methylbenzyl)-4-nonylphenol], 2,2'-methylenebis[6-($\alpha$,$\alpha$-dimethylbenzyl)-4-nonylphenol], 4,4'-methylenebis(2,6-di-tert-butylphenol), 4,4'-methylenebis(6-tert-butyl-2-methylphenol), 1,1-bis(5-tert-butyl-4-hydroxy-2-methylphenyl)butane, 2,6-bis(3-tert-butyl-5-methyl-2-hydroxybenzyl)-4-methylphenol, 1,1,3-tris(5-tert-butyl-4-hydroxy-2-methylphenyl) butane, 1,1-bis(5-tert-butyl-4-hydroxy-2-methylphenyl)-3-n-dodecyl-mercaptobutane, ethylene glycol bis[3,3-bis(3'-tert-butyl-4'-hydroxyphenyl)butyrate], bis(3-tert-butyl-4-hydroxy-5-methylphenyl)dicyclopentadiene, bis [2-(3'-tert-butyl-2'-hydroxy-5'-methylbenzyl)-6-tert-butyl-4-methylphenyl]terephthalate, 1,1-bis(3,5-dimethyl-2-hydroxyphenyl)butane, 2,2-bis(3,5-di-tert-butyl-4-hydroxyphenyl)propane, 2,2-bis(5-tert-butyl-4-hydroxy-2-methylphenyl)-4-n-dodecyl-mercaptobutane and 1,1,5,5-tetrakis(5-tert-butyl-4-hydroxy-2-methylphenyl)pentane,

O-, N- and S-benzyl compounds, such as 3,5,3',5'-tetra-tert-butyl-4,4'-dihydroxydibenzyl ether, octadecyl 4-hydroxy-3,5-dimethylbenzylmercaptoacetate, tridecyl 4-hydroxy-3,5-di-tert-butylbenzylmercaptoacetate, tris(3,5-di-tert-butyl-4-hydroxybenzyl)amine, bis(4-tert-butyl-3-hydroxy-2,6-dimethylbenzyl)dithioterephthalate, bis(3,5-di-tert-butyl-4-hydroxybenzyl)sulfide and isooctyl-3,5-di-tert-butyl-4-hydroxybenzylmercaptoacetate,

aromatic hydroxybenzyl compounds, such as 1,3,5-tris(3,5-di-tert-butyl-4-hydroxybenzyl)-2,4,6-trimethyl-benzene, 1,4-bis(3,5-di-tert-butyl-4-hydroxybenzyl)-2,3,5,6-tetramethyl-benzene and 2,4,6-tris(3,5-di-tert-butyl-4-hydroxybenzyl)phenol,

Triazine compounds, such as 2,4-bis(octylmercapto)-6-(3,5-di-tert-butyl-4-hydroxyanilino)-1,3,5-triazine, 2-octylmercapto-4,6-bis(3,5-di-tert-butyl-4-hydroxyanilino)-1,3,5-triazine, 2-octylmercapto-4,6-bis(3,5-di-tert-butyl-4-hydroxyphenoxy)-1,3,5-triazine, 2,4,6-tris(3,5-di-tert-butyl-4-hydroxyphenoxy)-1,2,3-triazine, 1,3,5-tris(3,5-di-tert-butyl-4-hydroxybenzyl)isocyanurate, 1,3,5-tris(4-tert-butyl-3-hydroxy-2,6-dimethylbenzyl)isocyanurate, 2,4,6-tris(3,5-di-tert-butyl-4-hydroxyphenylethyl)-1,3,5-triazine, 1,3,5-tris-(3,5-di-tert-butyl-4-hydroxyphenylpropionyl)hexahydro-1,3,5-triazine, 1,3,5-tris(3,5-dicyclohexyl-4-hydroxybenzyl)isocyanurate and 1,3,5-tris(2-hydroxyethyl)isocyanurate,

Benzylphosphonates, such as dimethyl 2,5-di-tert-butyl-4-hydroxybenzylphosphonate, diethyl 3,5-di-tert-butyl-4-hydroxybenzylphosphonate, dioctadecyl 3,5-di-tert-butyl-4-hydroxybenzylphosphonate and dioctadecyl 5-tert-butyl-4-hydroxy-3-methylbenzylphosphonate,

Acylaminophenols, such as 4-hydroxylauroylanilide, 4-hydroxystearoylanilide and octyl N-(3,5-di-tert-butyl-4-hydroxyphenyl)carbamate,

Propionic and acetic esters, for example of monohydric or polyhydric alcohols, such as methanol, ethanol, n-octanol, i-octanol, octadecanol, 1,6-hexanediol, 1,9-nonanediol, ethylene glycol, 1,2-propanediol, neopentyl glycol, thiodiethylene glycol, diethylene glycol, triethylene glycol, pentaerythritol, tris(hydroxyethyl)isocyanurate, N,N'-bis(hydroxyethyl)oxalamide, 3-thiaundecanol, 3-thiapentadecanol, trimethylhexanediol, trimethylolpropane and 4-hydroxymethyl-1-phospha-2,6,7-trioxabicyclo[2.2.2]-octane,

Propionamides based on amine derivatives, such as N,N'-bis(3,5-di-tert-butyl-4-hydroxyphenylpropionyl)hexamethylenediamine, N,N'-bis(3,5-di-tert-butyl-4-hydroxyphenylpropionyl)trimethylenediamine and N,N'-bis(3,5-di-tert-butyl-4-hydroxyphenylpropionyl)hydrazine,

Ascorbic acid (Vitamin C) and ascorbic acid derivatives, such as ascorbyl palmitate, laurate and stearate, and ascorbyl sulfate and phosphate,

Antioxidants based on amine compounds, such as N,N'-diisopropyl-p-phenylenediamine, N,N'-di-sec-butyl-p-phenylenediamine, N,N'-bis(1,4-dimethylpentyl)-p-phenylenediamine, N,N'-bis(1-ethyl-3-methylpentyl)-p-phenylenediamine, N,N'-bis(1-methylheptyl)-p-phenylenediamine, N,N'-dicyclohexyl-p-phenylenediamine, N,N'-diphenyl-p-phenylenediamine, N,N'-bis(2-naphthyl)-p-phenylenediamine, N-isopropyl-N'-phenyl-p-phenylenediamine, N-(1,3-dimethylbutyl)-N'-phenyl-p-phenylenediamine, N-(1-methylheptyl)-N'-phenyl-p-phenylenediamine, N-cyclohexyl-N'-phenyl-p-phenylenediamine, 4-(p-toluenesulfamoyl)diphenylamine, N,N'-dimethyl-N,N'-di-sec-butyl-p-phenylenediamine, diphenylamine, N-allyldiphenylamine, 4-isopropoxydiphenylamine, N-phenyl-1-naphthylamine, N-(4-tert-octylphenyl)-1-naphthylamine, N-phenyl-2-naphthylamine, octyl-substituted diphenylamine, such as p,p'-di-tert-octyldiphenylamine, 4-n-butylaminophenol, 4-butyrylaminophenol, 4-nonanoylaminophenol, 4-dodecanoylaminophenol, 4-octadecanoylaminophenol, bis[4-methoxyphenyl)amine, 2,6-di-tert-butyl-4-dimethylaminomethylphenol, 2,4-diaminodiphenylmethane, 4,4'-diaminodiphenylmethane, N,N,N',N'-tetramethyl-4,4'-diaminodiphenylmethane, 1,2-bis[(2-methylphenyl)amino]ethane, 1,2-bis(phenylamino)propane, (o-tolyl)biguanide, bis[4-(1',3'-dimethylbutyl)phenyl]amine, tert-octyl-substituted N-phenyl-1-naphthylamine, a mixture of mono- and dialkylated tert-butyl/tert-octyldiphenylamine, a mixture of mono- and dialkylated nonyldiphenylamine, a mixture of mono- and dialkylated dodecyldiphenylamine, a mixture of mono- and dialkylated isopropyl/isohexyldiphenylamine, a mixture of mono- and dialkylated tert-butyldiphenylamine, 2,3-dihydro-3,3-dimethyl-4H-1,4-benzothiazine, phenothiazine, a mixture of mono- and dialkylated tert-butyl/tert-octylphenothiazine, a mixture of mono- and dialkylated tert-octylphenothiazine, N-allylphenothiazine, N,N,N',N'-tetraphenyl-1,4-diaminobut-2-ene, N,N-bis(2,2,6,6-tetramethylpiperidin-4-yl)hexamethylenediamine, bis(2,2,6,6-tetramethylpiperidin-4-yl)sebacate, 2,2,6,6-tetramethylpiperidin-4-one and 2,2,6,6-tetramethylpiperidin-4-ol,

Phosphines, phosphites and phosphonites, such as triphenylphosnine triphenylphosphite, diphenyl alkyl phosphite, phenyl dialkyl phosphite, tris(nonylphenyl)phosphite, trilauryl phosphite, trioctadecyl phosphite, distearyl pentaerythritol diphosphite, tris(2,4-di-tert-butylphenyl)phosphite, diisodecyl pentaerythritol diphosphite, bis(2,4-di-tert-butylphenyl)pentaerythritol diphosphite, bis(2,6-di-tert-butyl-4-methylphenyl)pentaerythritol diphosphite, diisodecyloxy pentaerythritol diphosphite, bis(2,4-di-tert-butyl-6-methylphenyl)pentaerythritol diphosphite, bis(2,4,6-tris(tert-butylphenyl))pentaerythritol diphosphite, tristearyl sorbitol triphosphite, tetrakis(2,4-di-tert-butylphenyl)4,4'-biphenylenediphosphonite, 6-isooctyloxy-2,4,8,10-tetra-tert-butyl-12H-dibenz[d,g]-1,3,2-dioxaphosphocine, 6-fluoro-2,4,8,10-tetra-tert-butyl-12-methyl-dibenz[d,g]-1,3,2-dioxaphosphocine, bis(2,4-di-tert-butyl-6-methylphenyl)methyl phosphite and bis(2,4-di-tert-butyl-6-methylphenyl)ethyl phosphite,

2-(2'-Hydroxyphenyl)benzotriazoles, such as 2-(2'-hydroxy-5'-methylphenyl)benzotriazole, 2-(3',5'-di-tert-butyl-2'-hydroxyphenyl)benzotriazole, 2-(5'-tert-butyl-2'-hydroxyphenyl)benzotriazole, 2-(2'-hydroxy-5'-(1,1,3,3-tetramethylbutyl)phenyl)benzotriazole, 2-(3',5'-di-tert-butyl-2'-hydroxyphenyl)-5-chlorobenzotriazole, 2-(3'-tert-butyl-2'-hydroxy-5'-methylphenyl)-5-chlorobenzotriazole, 2-(3'-sec-butyl-5'-tert-butyl-2'-hydroxyphenyl)benzotriazole, 2-(2'-hydroxy-4'-octyloxyphenyl)benzotriazole, 2-(3',5'-di-tert-amyl-2'-hydroxyphenyl)benzotriazole, 2-(3,5'-bis-($\alpha$,$\alpha$-dimethylbenzyl)-2'-hydroxyphenyl)benzotriazole, a mixture of 2-(3'-tert-butyl-2'-hydroxy-5'-(2-octyloxycarbonylethyl)phenyl)-5-chlorobenzotriazole, 2-(3'-tert-butyl-5'-[2-(2-ethylhexyloxy)carbonylethyl]-2'-hydroxy phenyl)-5-chlorobenzotriazole, 2-(3'-tert-butyl-2'-hydroxy-5'-(2-methoxycarbonylethyl)phenyl)-5-chlorobenzotriazole, 2-(3'-tert-butyl-2'-hydroxy-5'-(2-methoxycarbonylethyl)phenyl)benzotriazole, 2-(3'-tert-butyl-2'-hydroxy-5'-(2-octyloxycarbonylethyl)phenyl)benzotriazole, 2-(3'-tert-butyl-5'-[2-(2-ethylhexyloxy)carbonylethyl]-2'-hydroxy phenyl)benzotriazole, 2-(3'-dodecyl-2'-hydroxy-5'-methylphenyl)benzotriazole and 2-(3'-tert-butyl-2'-hydroxy-5'-(2-isooctyloxycarbonylethyl)phenyl benzotriazole, 2,2'-methylenebis[4-(1,1,3,3-tetramethylbutyl)-6-benzotriazol-2-ylphenol]; the product of complete esterification of 2-[3'-tert-butyl-5'-(2-methoxycarbonylethyl)-2'-hydroxyphenyl]-2H-benzotriazole with polyethylene glycol 300;

sulfur-containing peroxide scavengers and sulfur-containing antioxidants, such as esters of 3,3'-thiodipropionic acid, for example the lauryl, stearyl, myristyl and tridecyl esters, mercaptobenzimidazole and the zinc salt of 2-mercaptobenzimidazole, dibutylzinc dithiocarbamates, dioctadecyl disulfide and pentaerythritol tetrakis($\beta$-dodecylmercapto) propionate,

2-hydroxybenzophenones, such as the 4-hydroxy, 4-methoxy, 4-octyloxy, 4-decycloxy, 4-dodecyloxy, 4-benzyloxy, 4,2',4'-trihydroxy and 2'-hydroxy-4,4'-dimethoxy derivatives,

Esters of unsubstituted and substituted benzoic acids, such as 4-tert-butylphenyl salicylate, phenyl salicylate, octylphenyl salicylate, dibenzoylresorcinol, bis(4-tert-butylbenzoyl)resorcinol, benzoylresorcinol, 2,4-di-tert-butylphenyl 3,5-di-tert-butyl-4-hydroxybenzoate, hexadecyl-3,5-di-tert-butyl-4-hydroxybenzoate, octadecyl-3,5-di-tert-butyl-4-hydroxybenzoate and 2-methyl-4,6-di-tert-butylphenyl-3,5-di-tert-butyl-4-hydroxybenzoate,

Acrylates, such as ethyl $\alpha$-cyano-$\beta$,$\beta$-diphenylacrylate, isooctyl $\alpha$-cyano-$\beta$,$\beta$-diphenylacrylate, methyl $\alpha$-methoxycarbonylcinnamate, methyl $\alpha$-cyano-$\beta$-methyl-p-methoxycinnamate, butyl-$\alpha$-cyano-$\beta$-methyl-p-methoxycinnamate and methyl-$\alpha$-methoxycarbonyl-p-methoxycinnamate, sterically hindered amines, such as bis(2,2,6,6-tetramethylpiperidin-4-yl)sebacate, bis(2,2,6,6-tetramethylpiperidin-4-yl)succinate, bis(1,2,2,6,6-pentamethylpiperidin-4-yl)sebacate, bis(1-octyloxy-2,2,6,6-tetramethylpiperidin-4-yl)sebacate, bis(1,2,2,6,6-pentamethylpiperidin-4-yl)-n-butyl-3,5-di-tert-butyl-4-hydroxybenzylmalonate, the condensation product of 1-(2-hydroxyethyl)-2,2,6,6-tetramethyl-4-hydroxypiperidine and succinic acid, the condensation product of N,N'-bis(2,2,6,6-tetramethylpiperidin-4-yl)hexamethylenediamine and 4-tert-octylamino-2,6-dichloro-1,3,5-triazine, tris(2,2,6,6-tetramethylpiperidin-4-yl)nitrilotriacetate, tetrakis(2,2,6,6-tetramethylpiperidin-4-yl)1,2,3,4-butanetetracarboxylate, 1,1'-(1,2-ethylene)bis(3,3,5,5-tetramethylpiperazinone), 4-benzoyl-2,2,6,6-tetramethylpiperidine, 4-stearyloxy-2,2,6,6-tetramethylpiperidine, bis(1,2,2,6,6-pentamethylpiperidin-4-yl)2-n-butyl-2-(2-hydroxy-3,5-di-tert-butylbenzyl)malonate, 3-n-octyl-7,7,9,9-tetramethyl-1,3,8-triazaspiro[4.5]decane-2,4-dione, bis(1-octyloxy-2,2,6,6-tetramethylpiperidin-4-yl)sebacate, bis(1-octyloxy-2,2,6,6-tetramethylpiperidin-4-yl)succinate, the condensation product of N,N'-bis(2,2,6,6-tetramethylpiperidin-4-yl)hexamethylenediamine and 4-morpholino-2,6-dichloro-1,3,5-triazine, the condensation product of 2-chloro-4,6-bis(4-n-butylamino-2,2,6,6-tetramethylpiperidin-4-yl)-1,3,5-triazine and 1,2-bis(3-aminopropylamino)ethane, the condensation product of 2-chloro-4,6-di(4-n-butylamino-1,2,2,6,6-pentamethylpiperidin-4-yl)-1,3,5-triazine and 1,2-bis(3-aminopropylamino)ethane, 8-acetyl-3-dodecyl-7,7,9,9-tetramethyl-1,3,8-triazaspiro[4.5]-decane-2,4-dione, 3-dodecyl-1-(2,2,6,6-tetramethylpiperidin-4-yl)pyrrolidine-2,5-dione, 3-dodecyl-1-(1,2,2,6,6-pentamethylpiperidin-4-yl)pyrrolidine-2,5-dione, a mixture of 4-hexadecyloxy- and 4-stearyloxy-2,2,6,6-tetramethylpiperidine, the condensation product of N,N'-bis(2,2,6,6-tetramethylpiperidin-4-yl)hexamethylenediamine and 4-cyclohexylamino-2,6-dichloro-1,3,5-triazine, the condensation product of 1,2-bis(3-aminopropylamino)ethane and 2,4,6-trichloro-1,3,5-triazine, 4-butylamino-2,2,6,6-tetramethylpiperidine, N-(2,2,6,6-tetramethylpiperidin-4-yl)-n-dodecylsuccinimide, N-(1,2,2,6,6-pentamethylpiperidin-4-yl)-n-dodecylsuccinimide, 2-undecyl-7,7,9,9-tetramethyl-1-oxa-3,8-diaza-4-oxo-spiro[4.5]-decane, the condensation product of 7,7,9,9-tetramethyl-2-cycloundecyl-1-oxa-3,8-diaza-4-oxospiro-[4.5]decane and epichlorohydrin, the condensation products of 4-amino-2,2,6,6-tetramethylpiperidine with tetramethylolacetylenediureas and poly(methoxypropyl-3-oxy)-[4(2,2,6,6-tetramethyl)piperidinyl]-siloxane,

Oxalamides, such as 4,4'-dioctyloxyoxanilide, 2,2'-diethoxyoxanilide, 2,2'-dioctyloxy-5,5'-di-tert-butoxanilide, 2,2'-didodecyloxy-5,5'-di-tert-butoxanilide, 2-ethoxy-2'-ethyloxanilide, N,N'-bis(3-dimethylaminopropyl)oxalamide, 2-ethoxy-5-tert-butyl-2'-ethoxanilide and its mixture with 2-ethoxy-2'-ethyl-5,4'-di-tert-butoxanilide, and mixtures of ortho-, para-methoxy-disubstituted oxanilides and mixtures of ortho- and para-ethoxy-disubstituted oxanilides, and

2-(2-hydroxyphenyl)-1,3,5-triazines, such as 2,4,6-tris-(2-hydroxy-4-octyloxyphenyl)-1,3,5-triazine, 2-(2-hydroxy-4-octyloxyphenyl)-4,6-bis(2,4-dimethylphenyl)-1,3,5-triazine, 2-(2,4-dihydroxyphenyl)-4,6-bis(2,4-dimethylphenyl)-1,3,5-triazine, 2,4-bis(2-hydroxy-4-propyloxyphenyl)-6-(2,4-dimethylphenyl)-1,3,5-triazine, 2-(2-hydroxy-4-octyloxyphenyl)-4,6-bis(4-methylphenyl)-1,3,5-triazine, 2-(2-hydroxy-4-dodecyloxyphenyl)-4,6-bis(2,4-dimethylphenyl)-1,3,5-triazine, 2-(2-hydroxy-4-tridecyloxyphenyl)-4,6-bis(2,4-dimethylphenyl)-1,3,5-triazine, 2-[2-hydroxy-4-(2-hydroxy-3-butyloxypropoxy)phenyl]-4,6-bis(2,4-dimethyl)-1,3,5-triazine, 2-[2-hydroxy-4-(2-hydroxy-3-octyloxypropoxy)phenyl]-4,6-bis(2,4-dimethyl)-1,3,5-triazine, 2-[4-(dodecyloxy/tridecyloxy-2-hydroxypropoxy)-2-hydroxyphenyl]-4,6-bis(2,4-dimethylphenyl)-1,3,5-triazine, 2-[2-hydroxy-4-(2-hydroxy-3-dodecyloxypropoxy)phenyl]-4,6-bis-(2,4-dimethylphenyl)-1,3,5-triazine, 2-(2-hydroxy-4-hexyloxyphenyl)-4,6-diphenyl-1,3,5-triazine, 2-(2-hydroxy-4-methoxyphenyl)-4,6-diphenyl-1,3,5-triazine, 2,4,6-tris[2-hydroxy-4-(3-butoxy-2-hydroxypropoxy)phenyl]-1,3,5-triazine and 2-(2-hydroxyphenyl)-4-(4-methoxyphenyl)-6-phenyl-1,3,5-triazine.

In another preferred embodiment the chiral RM mixture or RM formulation contains an additive selected from formula IA:

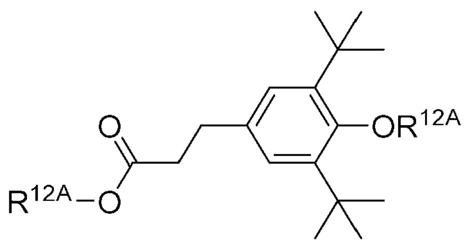

IA

wherein $R^{11A}$ denotes alkyl with 12 to 25, preferably 14 to 22, C atoms, which is preferably straight-chain, very preferably n-octadecyl, and $R^{12A}$ denotes alkyl with 1 to 6 Catoms, preferably methyl or ethyl, very preferably methyl.

Very compounds of formula IA are those of formula IA1:

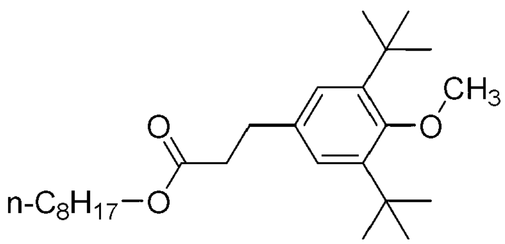

IA1

The compounds of formula IA and IA1 improve the alignment of RM layers, especially CLC RM layers, while not decreasing the surface tension too much. This allows coating multiple RM or chiral RM layers on top of one another without coating defects.

The concentration of the compounds of formula IA and IA1 in the chiral RM mixture is preferably from 0.05 to 2%, very preferably from 0.1 to 1%, most preferably from 0.2 to 0.7% of total solids.

In a preferred embodiment the RM formulation is obtained by dissolving the RM mixture in a suitable solvent, which are preferably selected from organic solvents.

The solvents are preferably selected from ketones such as acetone, methyl ethyl ketone, methyl propyl ketone, methyl isobutyl ketone or cyclohexanone; acetates such as methyl, ethyl or butyl acetate or methyl acetoacetate; alcohols such as methanol, ethanol or isopropyl alcohol; aromatic solvents such as toluene or xylene; alicyclic hydrocarbons such as cyclopentane or cyclohexane; halogenated hydrocarbons such as di- or trichloromethane; glycols or their esters such as PGMEA (propyl glycol monomethyl ether acetate), $\gamma$-butyrolactone. It is also possible to use binary, ternary or higher mixtures of the above solvents. In particular, for multilayer applications, methyl iso butyl ketone is the preferred utilized solvent

In case the RM formulation contains one or more solvents, the total concentration of all solids, including the RMs, in the solvent(s) is preferably from 5 to 60%, more preferably from 10 to 50%, in particular from 10 to 35%.

Preferably, the RM mixture or RM formulation comprises one or more components selected from the group consisting of the following components or any combination thereof:

a) one or more multi - or direactive polymerizable mesogenic compounds or RMs, preferably selected from compounds of formula D and its subformulae,
b) one or more monoreactive polymerizable mesogenic compounds or RMs, preferably selected from compounds of formula M and its subformulae,
c) one or more polymerizable chiral compounds, preferably selected from formula C1-C3 or their subformulae,
d) one or more photoinitiators,
e) optionally one or more polymerizable mesogenic compounds or RMs selected from compounds of formula T and A and their subformulae,
f) optionally one or more non-polymerizable chiral compounds, preferably selected from formulae C-I, C-II and C-III,
g) optionally one or more isomerizable, chiral compounds, preferably selected from photoisomerizable, chiral compounds which are polymerizable,
h) optionally one or more additives selected from adhesion promotors, surfactants, wetting agents, antifoam agents, lubricants, flow auxiliaries, diluents, antioxidants and UV stabilizers,
i) optionally one or more organic solvents.

More preferably, the RM mixture or RM formulation comprises:

1) one or more, preferably two or more, direactive polymerizable mesogenic compounds, preferably selected from formula Da-1,
2) one or more, preferably two or more, monoreactive polymerizable mesogenic compounds, preferably selected from formulae M-1, M-4, M-6 and M-8 to M10,
3) one or more polymerizable chiral compounds, preferably selected from formulae C1-C3 or their subformulae,
4) one or more photoinitiators,
5) optionally one or more compounds of formula T or A, or their preferred subformulae,
6) optionally one or more non-polymerizable chiral compounds, preferably selected from formulae C-I, C-II and C-III,
7) optionally one or more isomerizable, chiral compounds, preferably selected from photoisomerizable, chiral compounds which are polymerizable,
8) optionally one or more additives selected from adhesion promotors, surfactants, wetting agents, antifoam agents, lubricants, flow auxiliaries, diluents, antioxidants and UV stabilizers,
9) optionally one or more organic solvents,

or any combination of the aforementioned components 1) to 7), provided that at least components 1) to 4) are present.

The RM mixtures and RM formulations can be prepared in a manner conventional per se, for example by mixing one or more of the above-mentioned RMs as defined above, and optionally with further additives and dissolving these RMs and additives in a solvent or solvent blend.

The invention further relates to a process of preparing an individual RM layer comprising, preferably consisting of, the steps of

- depositing a layer of a chiral RM mixture or RM formulation as described above and below onto a substrate, which is

optionally provided with an alignment layer or a surface grating,

- removing any solvents present,
- optionally annealing the chiral RM mixture (i.e., without solvents), preferably at a temperature where the RM mixture exhibits a cholesteric phase,
- irradiating the chiral RM mixture with actinic radiation, preferably with UV radiation, causing polymerization of the RMs and formation of a polymer film,
- optionally removing the polymer film from the substrate.

A preferred embodiment of the present invention relates to a process of preparing a multilayer RM waveplate, comprising the steps of:

A1) depositing a first layer of a chiral RM mixture or RM formulation according to the invention onto a substrate, preferably a substrate which contains a surface grating or pattern,
A2) removing any solvents present,
A3) optionally annealing the chiral RM mixture of the first layer (i.e., without solvents), preferably at a temperature where it is in the cholesteric phase,
A4) polymerizing the chiral RM mixture of the first layer at a temperature where it is in the cholesteric phase, preferably by exposure to UV light, under an inert atmosphere,
B1) depositing a second layer of an RM formulation according to the invention on to the first, polymerized RM layer,
B2) removing any solvents present,
B3) optionally annealing the chiral RM mixture of the second layer (i.e., without solvents), preferably at a temperature where it is in the cholesteric phase,
B4) polymerizing the chiral RM mixture of the second layer at a temperature where it is in the cholesteric phase, preferably by exposure to UV light, under an inert atmosphere.

A third, fourth, fifth or further layers can be prepared by repeating process steps B1) to B4) using a different chiral RM mixture or RM formulation.
If the waveplate is not a PBOE, it can be prepared by a process as described above, but wherein in step A1) the substrate does not contain a surface grating and preferably contains a planar alignment layer instead.
If the chiral RM mixture additionally contains a photoisomerizable chiral compound, the process of preparing an optical element according to the present invention preferably comprises an additional UV irradiation step for photoisomerization, which is carried out before the (photo)polymerization step. In a preferred embodiment, one or more of steps A4) and B4) in the process of preparing such an optical element as described above and below consist of the following (sub)steps:

4.1) a first step of irradiating the chiral RM mixture with actinic radiation, preferably with UV radiation, in air (1$^{st}$ UV step), which causes photoisomerization of the isomerizable chiral compound,
4.2) optionally annealing the chiral RM mixture, preferably at a temperature where it is in its cholesteric phase, and
4.3) a second step of irradiating the chiral RM mixture with actinic radiation, preferably with UV radiation, in an inert gas atmosphere (2$^{nd}$ UV step), which causes photopolymerization of the polymerizable compounds.

The first irradiation or 1$^{st}$ UV step causes photoisomerization of the chiral compound comprising the photoisomerizable group and provides the chiral structure with the biased helical pitch. The second irradiation or 2$^{nd}$ UV step causes photopolymerisation of the polymerisable mesogenic compounds and thereby fixes the chiral structure.
The chiral RM mixtures for the individual RM layers are preferably different from each other. In a preferred embodiment the RM mixtures used for preparation of the first, second and further layers, respectively, contain different amounts of a chiral compound(s) and/or contain chiral compounds with different HTP and/or handedness. As a consequence the helical pitch and twist angle in the first, second and further RM layers can be adjusted to be different from each other.
In a preferred embodiment, an RM mixture containing a chiral dopant (chiral mixture) is blended with an RM mixture that does not contain a chiral compound (achiral mixture) in various ratios, which allows to easily vary the amount of the chiral dopant in the blends of the chiral and achiral mixture. Thereby the desired helical pitch and twist angles in the individual final RM layers can be easily adjusted. First, second and further chiral RM layers with the same or different twist angles can then be prepared from such RM mixtures or blended RM mixtures in a simple and reproducible manner which is is also suitable for production at arge scale.
The RM mixtures, formulations and methods of the present invention do thus allow a simple way of preparing a multilayer of two or more chiral LC polymer films, by using an achiral RM host mixture comprising, or consisting of, one or more compounds selected from formulae D, M, A and T. This achiral RM host mixture can be used for the preparation of

each individual layer. Chiral RM mixtures for use in the first, second or further layers, respectively, are prepared by adding different amounts of the same chiral compound to the RM host mixture, or by adding chiral compounds with differing HTP to the RM host mixture.

The RM mixture or RM formulation can be coated or printed onto the substrate, for example by spin-coating, printing, or other known techniques, and the solvent is evaporated off before polymerization. In most cases, it is suitable to heat the mixture in order to facilitate the evaporation of the solvent.

The RM mixture or RM formulation can be applied onto a substrate by conventional coating techniques like spin coating, bar coating or blade coating. It can also be applied to the substrate by conventional printing techniques which are known to the expert, like for example screen printing, offset printing, reel-to-reel printing, letter press printing, gravure printing, rotogravure printing, flexographic printing, intaglio printing, pad printing, heat-seal printing, ink-jet printing or printing by means of a stamp or printing plate.

Suitable substrate mediums and substrates are known to the expert and described in the literature, as for example conventional substrates used in the optical films industry, such as glass or plastic. Especially suitable and preferred substrates for polymerization are polyester such as polyethyleneterephthalate (PET) or polyethylenenaphthalate (PEN), polyvinylalcohol (PVA), polycarbonate (PC), triacetylcellulose (TAC), cyclo-olefin polymers (COP), or commonly known color filter materials, preferably triacetylcellulose (TAC), cyclo-olefin polymers (COP), or commonly known colour filter materials.

In another preferred embodiment the substrate contains a surface grating or surface pattern, preferably a PB grating, for example as shown in **Fig. 1a** or **1b**. A surface grating can be prepared from a photoalignment layer (PAL) which is patterned by laser interferometry to create a grating pattern with a defined pitch.

In another preferred embodiment the substrate is equipped with an alignment layer that induces or enhances planar alignment of the RM molecules, for example a polyimide alignment layer which can additionally be rubbed e.g. using a velvet cloth, or a photoalignment layer, or an aligned and cured RM layer.

The Friedel-Creagh-Kmetz rule can be used to predict whether a mixture will adopt planar or homeotropic alignment, by comparing the surface energies of the RM layer ($\gamma_{RM}$) and the substrate ($\gamma_s$):
If $\gamma_{RM} > \gamma_s$ the reactive mesogenic compounds will display homeotropic alignment, If $\gamma_{RM} < \gamma_s$ the reactive mesogenic compounds will display homogeneous alignment.

Without wishing to be bound to a specific theory, when the surface energy of a substrate is relatively low, the intermolecular forces between the reactive mesogens are stronger than the forces across the RM-substrate interface and consequently, reactive mesogens align perpendicular to the substrate (homeotropic alignment) in order to maximise the intermolecular forces. Accordingly, an additional alignment layer capable of inducing a planar alignment to the adjacent RM mixture is required.

When the surface tension of the substrate is greater than the surface tension of the RMs, the force across the interface dominates. The interface energy is minimised if the reactive mesogens align parallel with the substrate, so the long axis of the RM can interact with the substrate. One way planar alignment can be promoted is by coating the substrate containing a polyimide layer, and then rubbing the alignment layer with a velvet cloth.

Other suitable planar alignment layers are known in the art, like for example rubbed polyimide or alignment layers prepared by photoalignment as described in US 5,602,661, US 5,389,698 or US 6,717,644.

In general, reviews of alignment techniques are given for example by I. Sage in "Thermotropic Liquid Crystals", edited by G. W. Gray, John Wiley & Sons, 1987, pages 75-77; and by T. Uchida and H. Seki in "Liquid Crystals - Applications and Uses Vol. 3", edited by B. Bahadur, World Scientific Publishing, Singapore 1992, pages 1-63. A further review of alignment materials and techniques is given by J. Cognard, Mol. Cryst. Liq. Cryst. 78, Supplement 1 (1981), pages 1-77.

In a preferred embodiment, the process according to the invention contains a process step where the RM mixture is allowed to rest for a period of time in order to evenly redistribute the RM mixture on the substrate (herein referred to as "annealing").

In a preferred embodiment, after providing the RM mixture or RM formulation onto the substrate, the layer stack is annealed for a time between 10 seconds and 1 hour, preferably between 20 seconds and 10 minutes and most preferably between 30 seconds and 2 minutes. The annealing is preferably performed at room temperature.

The RM mixture preferably consists of compounds that align spontaneously when being deposited as a mixture onto the substrate. Therefore, preferably the LC medium is not subjected to heat treatment to align the mesogenic or liquid-crystalline compounds before the UV exposure.

If necessary, the layer stack can be cooled down to room temperature after annealing at an elevated temperature. The cooling can be performed actively with the help of cooling aids or passively just by letting the layer stack rest for a given time.

If the process contains an additional photoisomerization step or 1st UV step, a suitable UV radiation power in the photoisomerization step is preferably in the range from 5 to 300 $mWcm^{-2}$, more preferably in the range from 50 to 250 $mWcm^{-2}$ and most preferably in the range from 100 to 180 $mWcm^{-2}$.

In connection with the applied UV radiation and as a function of time, a suitable UV dose in the photoisomerization

step is preferably in the range from 20 to 1000 $mJcm^{-2}$, more preferably in the range from 30 to 800 $mJcm^{-2}$, very preferably in the range from 40 to 500 $mJcm^{-2}$, most preferably in the range from 40 to 200 $mJcm^{-2}$.

The first irradiation step or 1st UV step is preferably performed in air.

The first irradiation step or 1st UV step is preferably performed at room temperature.

Photopolymerization of the RM mixture is preferably achieved by exposing it to actinic radiation. Actinic radiation means irradiation with light, like UV light, IR light or visible light, irradiation with X-rays or gamma rays, or irradiation with high-energy particles, such as ions or electrons. Preferably, polymerization is carried out by photo irradiation, in particular with UV light. As a source for actinic radiation, for example a single UV lamp or a set of UV lamps can be used. When using a high lamp power the curing time can be reduced. Another possible source for photo radiation is a laser, like e.g. a UV laser, an IR laser, or a visible laser.

The curing time for the photopolymerization is dependent, inter alia, on the reactivity of the RM mixture, the thickness of the coated layer, the type of polymerization initiator and the power of the UV lamp. The curing time is preferably ≤ 5 minutes, very preferably ≤ 3 minutes, most preferably ≤ 1 minute. For mass production, short curing times of ≤ 30 seconds are preferred.

A suitable UV radiation power for the photopolymerization is preferably in the range from 100 to 1000 mWcm-2, more preferably in the range from 200 to 800 $mWcm^{-2}$ and most preferably in the range from 300 to 600 $mWcm^{-2}$.

In connection with the applied UV radiation and as a function of time, a suitable UV dose for the photopolymerization is preferably in the range from 25 to 16500 $mJcm^{-2}$, more preferably in the range from 50 to 7200 $mJcm^{-2}$, very preferably in the range from 100 to 3500 $mJcm^{-2}$ and most preferably in the range from 200 to 2000 $mJcm^{-2}$.

Photopolymerization is preferably performed under an inert gas atmosphere, preferably in a nitrogen atmosphere.

Photopolymerization is preferably performed at room temperature.

After photopolymerization, the resulting polymer film can be removed from the substrate and combined with other substrates or optical films by a laminating process known by the skilled person. Suitable substrates and optical films are given above and include especially polarisers, in particular linear polarisers, photoalignment layers, or diffraction gratings, for example PB gratings.

The polymer film according to the present invention has good adhesion to plastic substrates, in particular to TAC, COP, and colour filters. Accordingly, it can be used as adhesive or base coating for subsequent LC layers which otherwise would not well adhere to the substrates.

The polymer films of the present invention can also be used as alignment film or substrate for other liquid-crystalline or RM materials. The inventors have found that the polymer film obtainable from a RM formulation as described above and below, is in particular useful for multilayer applications due to its improved dewetting characteristics. In this way, stacks of optical films or preferably polymer films can be prepared.

The invention further relates to an optical, electrooptical or electronic device or a component comprising a waveplate as described above and below.

Said components include, without limitation, optical retardation films like quarter-wave plates (QWP) or half-wave plates (HWP), polarizers, optical compensators, reflective films, diffraction or surface gratings such as Bragg polarization gratings (Bragg PG), polarization volume gratings (PVG), polarization volume holograms (PVH), Pancharatnam Berry (PB) gratings, furthermore nonmechanical beam steering elements, optical waveguides, optical couplers, deflectors or combiners, polarization beam splitters, partial mirrors, reflective films, alignment layers, colour filters, antistatic protection sheets, electromagnetic interference protection sheets, lenses for light guides, focusing and optical effects, polarization controlled lenses, PB deflectors, PB lenses and IR reflection films; for example for use in LC displays (LCDs), organic light emitting diodes (OLEDs), autostereoscopic 3D displays, see-through near-eye displays, augmented reality( AR) or virtual reality (VR) systems, switchable windows, spatial light modulators, optical data storage, remote optical sensing, holography, spectroscopy, optical telecommunications, polarimetry or front/back-lighting.

Said devices include, without limitation, electro optical displays, especially LCDs, OLEDs, non-linear optic (NLO) devices, autostereoscopic 3D displays, see-through near-eye displays, head-up-displays, AR/VR systems, goggles for AR/VR applications, switchable windows, spatial light modulators, optical data storage devices, optical sensors, holographic devices, spectrometers, optical telecommunication systems, polarimeters or front-/backlights.

Preferably, the component is a diffraction grating, very preferably a PBG, PBL or Bragg PG, comprising one or more waveplates according to the present invention as described above and below, optionally together with further waveplates, polarizers and/or other components .

The waveplate according to the present invention is especially suitable for use in OLED displays or LC displays, head-up displays, e.g. for automotive use, NLO devices, autostereoscopic 3D displays, see-through near-eye displays, AR/VR systems, or goggles for AR/VR applications.

The present invention is described above and below with particular reference to the preferred embodiments. It should be understood that various changes and modifications might be made therein without departing from the spirit and scope of the invention.

Many of the compounds or mixtures thereof mentioned above and below are commercially available. All of these compounds are either known or can be prepared by methods which are known per se, as described in the literature (for example in the standard works such as Houben-Weyl, Methoden der Organischen Chemie [Methods of Organic Chemistry], Georg-Thieme-Verlag, Stuttgart), to be precise under reaction conditions which are known and suitable for said reactions. Use may also be made here of variants which are known per se, but are not mentioned here.

It will be appreciated that variations to the foregoing embodiments of the invention can be made while still falling within the scope of the invention. Alternative features serving the same, equivalent, or similar purpose may replace each feature disclosed in this specification, unless stated otherwise. Thus, unless stated otherwise, each feature disclosed is one example only of a generic series of equivalent or similar features.

All of the features disclosed in this specification may be combined in any combination, except combinations where at least some of such features and/or steps are mutually exclusive. In particular, the preferred features of the invention are applicable to all aspects of the invention and may be used in any combination. Likewise, features described in non-essential combinations may be used separately (not in combination).

It will be appreciated that many of the features described above, particularly of the preferred embodiments, are inventive in their own right and not just as part of an embodiment of the present invention. Independent protection may be sought for these features in addition to or alternative to any invention presently claimed.

Unless explicitly noted otherwise, all temperature values indicated in the present application, such as, for example, for the melting point T(K,N), the transition from the smectic (S) to the nematic (N) phase T(S,N) and the clearing point T(N,I), are quoted in degrees Celsius (°C). Furthermore, K denotes the crystalline state, N denotes the nematic phase, and I denotes the isotropic phase. The data between these symbols represent the transition temperatures.

All physical properties have been and are determined according to "Merck Liquid Crystals, Physical Properties of Liquid Crystals", Status Nov. 1997, Merck KGaA, Germany and are given for a temperature of 20 °C, unless explicitly stated otherwise.

Above and below, percentages are per cent by weight unless stated otherwise. All temperatures are given in degrees Celsius.

Above and below, m.p. denotes the melting point, cl.p. denotes the clearing point, $T_g$ denotes glass transition temperature. Furthermore, C denotes the crystalline state, N denotes the nematic phase, $S_A$, $S_B$ etc. denotes the smectic A phase, smectic B phase etc., $S_X$ denotes an unidentified smectic phase, X denotes an unidentified mesophase and I denotes the isotropic phase. The values between these symbols represent the transition temperature in °C. $\Delta n$ denotes the optical anisotropy or birefringence ($\Delta n = n_e - n_o$, where $n_o$ denotes the refractive index perpendicular to the longitudinal molecular axes and $n_e$ denotes the refractive index parallel thereto) at 589 nm and 20°C. The optical and electro optical data are measured at 20°C, unless expressly stated otherwise. "Clearing point" and "clearing temperature" mean the temperature of the transition from an LC phase into the isotropic phase.

Unless stated otherwise, the percentages of solid components in an RM mixture or RM formulation as described above and below refer to the total amount of solids in the mixture or formulation, i.e. without any solvents.

Unless stated otherwise, all optical, electro optical properties and physical parameters like birefringence, permittivity, electrical conductivity, electrical resistivity and sheet resistance, refer to a temperature of 20°C.

The invention will now be described in more detail by reference to the following working examples, which are illustrative only and do not limit the scope of the invention.

<u>Example 1 - Achromatic HWP on PB deflector grating, 4-layer design</u>

The following RM mixtures are prepared:

| **M1** | **Conc.** |
|---|---|
| Irganox®-1076 | 0.1% |
| BYK®-310 | 0.8% |
| TR-PBG-304 | 6.8% |
| 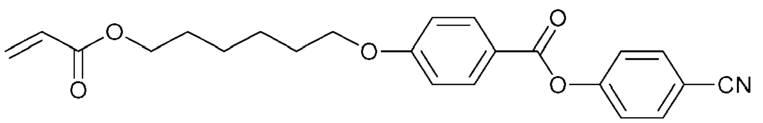 M1a | 8.5% |
| 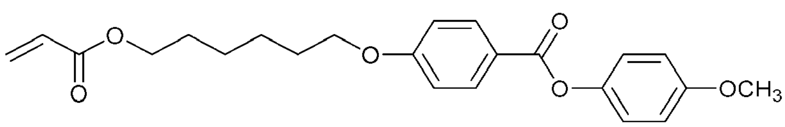 M1b | 8.5% |

(continued)

| **M1** | **Conc.** |
|---|---|
| 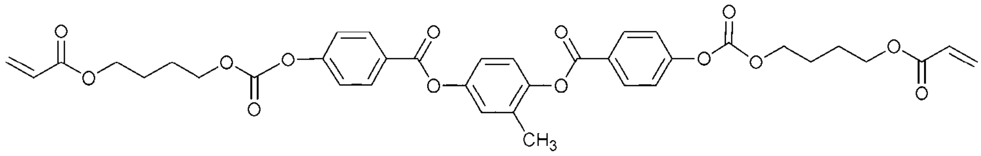 | 30.0% |
| Paliocolor® LC 242 | |
| 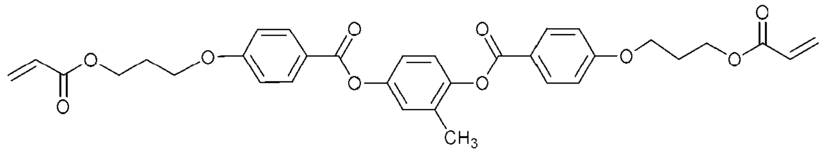 Da1a | 45.3% |

Irganox®1076 is a stabilizer being commercially available (Ciba AG, Basel, Switzerland). BYK®-310 is a surfactant being commercially available (BYK, Germany). TR-PBG-304 is a photoinitiator being commercially available (Tronly, China). Paliocolor® LC 242 is a direactive achiral RM being commercially available (BASF, Germany).

| **M2** | **Conc.** |
|---|---|
| Irganox®-1076 | 0.1% |
| BYK®-310 | 0.8% |
| TR-PBG-304 | 6.8% |
| 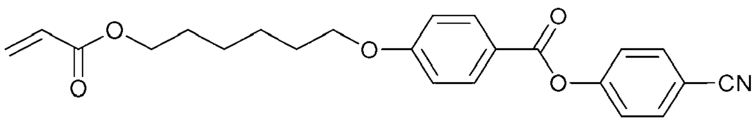 M1a | 8.5% |
| 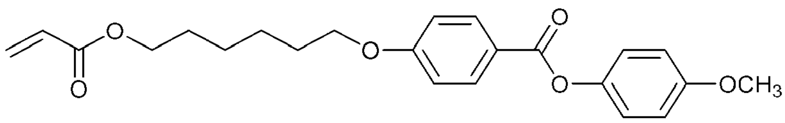 M1b | 8.5% |
| 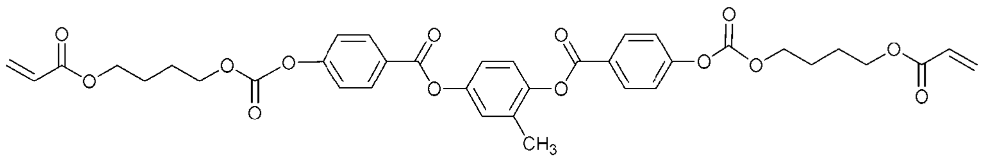 | 30.0% |
| Paliocolor® LC 242 | |
| 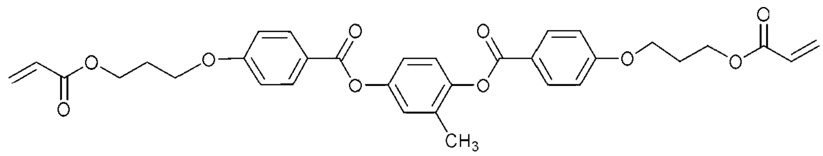 Da1a | 44.9% |
| 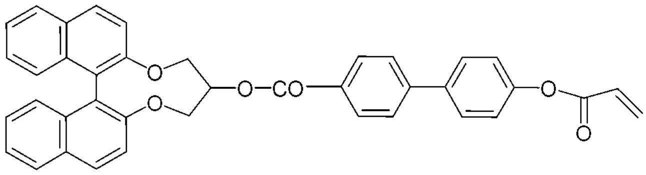 C1-1-6a$^R$ | 0.4% |
| (R)-Configuration | |

| **M3** | **Conc.** |
|---|---|
| Irganox®-1076 | 0.1% |
| BYK®-310 | 0.8% |
| TR-PBG-304 | 6.8% |

(continued)

| M3 | Conc. |
|---|---|
| 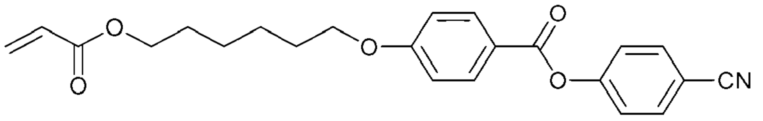 M1a | 8.5% |
| 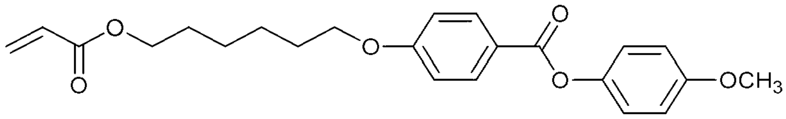 M1b | 8.5% |
| 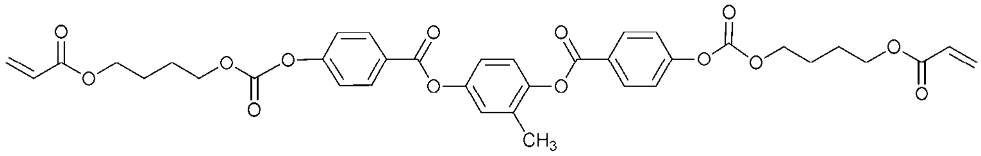 Paliocolor® LC 242 | 30.0% |
| 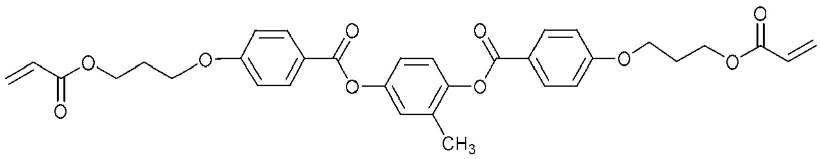 Da1a | 44.9% |
| 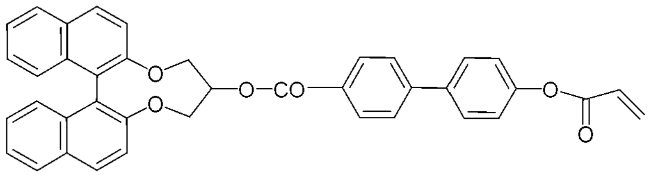 C1-1-6a$^S$ (S)-Configuration | 0.4% |

The achiral RM mixture M1 and the chiral RM mixtures M2 and M3 are each dissolved in diethyl carbonate at 30% solids. Blends 1 to 6 are made from these solutions to match the required chiral concentration for achieving the desired CLC pitch for each RM layer as shown in Table 1.1. By using the chiral RM of formula C1-1-6a with either S- or R-configuration, chiral RM layers with either left-handed or right-handed twist can be achieved.

Table 1.1 - Chiral RM Mixture Blends

| Name | Layer | Handedness / LH or RH | Chiral Added / g | Achiral Added / g | Chiral wt.% |
|---|---|---|---|---|---|
| Blend 1 | 1 | L | 0.1187 | 2.9841 | 0.02 |
| Blend 2 | 2 | L | 1.5022 | 1.5398 | 0.20 |
| Blend 3 | 3 | R | 1.5996 | 1.444 | 0.21 |
| Blend 4 | 4 | L | 0.0786 | 2.7477 | 0.01 |

Blends 1 to 4 are then used to prepare a twisted RM multilayer with the design as shown in Table 1.2, which acts as broadband HWP for circularly polarised light.

Table 1.2 - Multilayer film design

| Layer # | Thickness / µm | Twist Angle / ° | CLC Pitch / µm |
|---|---|---|---|
| 1 | 1.2252 | -6.2143 | -70,98 |
| 2 | 1.2252 | -80.3084 | -5,49 |
| 3 | 1.2252 | 83.5794 | 5,28 |

(continued)

| Layer # | Thickness / µm | Twist Angle / ° | CLC Pitch / µm |
|---|---|---|---|
| 4 | 1.2252 | -4.5171 | -97,64 |

The multilayer film is made by the following process: An SD1 photoalignment layer is spincoated onto a raw glass at 3000 rpm and annealed at 80°C for 60s.

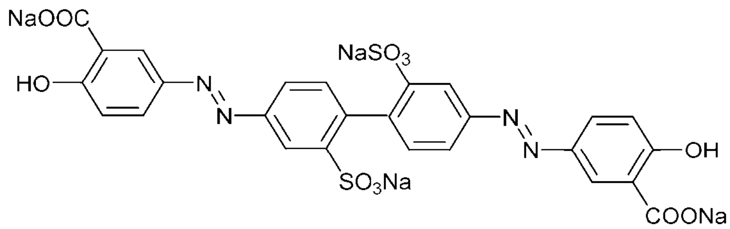

SD1

The annealed SD1 layer is then irradiated with polarized UV light using a laser interferometer using a Coherent Genesis 355nm laser with two overlapping opposite circular polarization states (as described also in Shin-Tson Wu et al., J. Opt. Soc. Am. B, 36(5), D52-D65 (2019)) to create a PB deflector grating as shown in **Fig. 1a** with a grating pitch length of 2 µm.

A layer of blend 1 is coated onto the PB grating at 2484 rpm for 30s, annealed at 60°C for 60s, and cured using broadband Omnicure lamp (100 mW/cm$^{-2}$) for 60s in a nitrogen atmosphere. A layer of blend 2 is then coated, annealed and cured on the cured layer of blend 1 under the same conditions except that annealing is done at 40°C for 30s. This process is then repeated for blends 3 and 4, each being coated onto the respective previous cured layer.

The resulting multilayer film is observed between crossed circular polarisers and a white film with high transmission is seen. This matches with the expected performance of a broadband HWP.

Example 2 - Blue HWP, 6-layer design

The RM mixtures M1 to M3 from Example 1 are each dissolved in diethyl carbonate at 40% solids. Blends 5 to 10 are made from these solutions as shown in Table 2.1.

Table 2.1 - Chiral RM Mixture Blends

| Name | Layer | Chiral wt.% |
|---|---|---|
| Blend 5 | 1 | 0.00536 |
| Blend 6 | 2 | 0.10014 |
| Blend 7 | 3 | 0.02105 |
| Blend 8 | 4 | 0.01044 |
| Blend 9 | 5 | 0.08784 |
| Blend 10 | 6 | 0.2466 |

Blends 5 to 10 are then used to prepare a twisted RM multilayer with the design as shown in Table 2.2, which acts as a blue HWP.

Table 2.2 - Multilayer film design

| Layer # | Thickness / µm | Twist Angle / ° | CLC Pitch / µm |
|---|---|---|---|
| 1 | 1.9103 | -3.3935 | -202,65 |
| 2 | 1.9103 | 62.0498 | 11,08 |
| 3 | 1.9103 | -13.3207 | -51,63 |
| 4 | 1.9103 | -6.6092 | -104,05 |
| 5 | 1.9103 | -55.5888 | -12,37 |

(continued)

| Layer # | Thickness / μm | Twist Angle / ° | CLC Pitch / μm |
|---|---|---|---|
| 6 | 1.9103 | 152.7947 | 4,5 |

A layer of blend 5 is coated onto a substrate of Corning Eagle XG with a planar rubbed polyimide alignment layer at 3188 rpm for 30s, annealed at 60°C for 60s, and cured using broadband Omnicure lamp (100 $mW/cm^{-2}$) for 60s in a nitrogen atmosphere. A layer of blend 6 is then coated, annealed and cured on the cured layer of blend 1 under the same conditions except that annealing is done at 40°C for 30s. This process is then repeated for blends 7 to 10, each being coated onto the respective previous cured layer.

The resulting multilayer film is observed between crossed circular polarisers and a bright blue film is seen. This matches with the expected performance of a blue HWP and red & green full-wave plate.

Example 3 - Red-Blue HWP with PB deflector grating, 6-layer design

The RM mixtures M1 to M3 from Example 1 are each dissolved in diethyl carbonate at 35% solids. Blends 11 to 16 are made from these solutions as shown in Table 3.1.

Table 3.1 - Chiral RM Mixture Blends

| Name | Layer | Chiral wt.% |
|---|---|---|
| Blend 11 | 1 | 0.02169 |
| Blend 12 | 2 | 0.03381 |
| Blend 13 | 3 | 0.06656 |
| Blend 14 | 4 | 0.23887 |
| Blend 15 | 5 | 0.10822 |
| Blend 16 | 6 | 0.01521 |

Blends 11 to 16 are then used to prepare a twisted RM multilayer with the design as shown in Table 3.2 which acts as HWP for red and blue light.

Table 3.2 - Multilayer film design

| Layer # | Thickness / μm | Twist / ° | CLC Pitch / μm |
|---|---|---|---|
| 1 | 1.483 | -10.6588 | -50,09 |
| 2 | 1.483 | -16.5734 | -32,21 |
| 3 | 1.483 | 32.032 | 16,67 |
| 4 | 1.483 | 114.979 | 4,64 |
| 5 | 1.483 | 51.9987 | 50,5157 |
| 6 | 1.483 | 7.316 | 5,833 |

The multilayer film is prepared on a PB deflector grating by the process as described in Example 1, except that the spin speed is 3105 rpm and the grating pitch length is 11 μm.

The resulting multilayer film is observed between crossed circular polarisers and a bright purple film is seen. This matches with the expected performance of a red & blue HWP and green full-wave plate.

Example 4 - Red HWP, 7-layer design

The RM mixtures M1 to M3 from Example 1 are each dissolved in diethyl carbonate at 40% solids. Blends 17 to 23 are made from these solutions as shown in Table 4.1.

Table 4.1 - Chiral RM Mixture Blends

| Name | Layer | Chiral wt.% |
|---|---|---|
| Blend 17 | 1 | 0.00918 |
| Blend 18 | 2 | 0.05498 |
| Blend 19 | 3 | 0.11239 |
| Blend 20 | 4 | 0.14664 |
| Blend 21 | 5 | 0.05441 |
| Blend 22 | 6 | 0.00833 |
| Blend 23 | 7 | 0.28273 |

Blends 17 to 23 are then used to prepare a twisted RM multilayer with the design as shown in Table 4.2, which acts as a HWP for red light.

Table 4.2 - Multilayer film design

| Layer # | Thickness / μm | Twist Angle / ° | CLC Pitch / μm |
|---|---|---|---|
| 1 | 1.784 | 5.3089 | 120,97 |
| 2 | 1.784 | -32.4931 | -19,77 |
| 3 | 1.784 | 65.243 | 9,84 |
| 4 | 1.784 | 84.8427 | 7,57 |
| 5 | 1.784 | -32.177 | -19,96 |
| 6 | 1.784 | 4.8294 | 132,99 |
| 7 | 1.784 | -167.1806 | -3,84 |

The multilayer film is prepared on a planar photoalignment layer by the process as described in Example 2, except that the spin speed is 3696 rpm.

The resulting multilayer film is observed between crossed circular polarisers and a bright red film is seen. This matches with the expected performance of a red HWP and green & blue full-wave plate.

Example 5 - Chromatic HWP for blue light

The following RM mixtures are prepared:

| **M4** | **Conc.** |
|---|---|
| Irganox®-1076 | 0.10% |
| 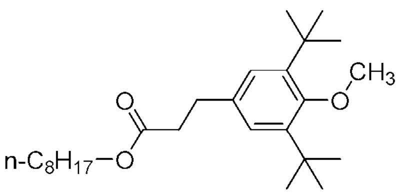 IA1 | 0.50% |
| OXE-05 | 6.75% |
| M1a | 8.45% |
| M1b | 8.45% |
| Paliocolor® LC 242 | 29.85% |
| Da1a | 45.90% |

OXE-05 is a photoinitiator being commercially available (BASF).

| M5 | Conc. |
|---|---|
| Irganox®-1076 | 0.10% |

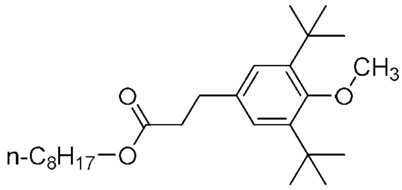

IA1 0.50%

| | |
|---|---|
| OXE-05 | 6.75% |
| M1a | 8.40% |
| M1b | 8.40% |
| Paliocolor® LC 242 | 29.75% |
| Da1a | 45.70% |
| C1-1-6a$^R$, (R)-Configuration | 0.40% |

| M6 | Conc. |
|---|---|
| Irganox®-1076 | 0.10% |
| IA1 | 0.50% |
| OXE-05 | 6.75% |
| M1a | 8.40% |
| M1b | 8.40% |
| Paliocolor® LC 242 | 29.75% |
| Da1a | 45.70% |
| C1-1-6a$^s$, (S)-Configuration | 0.40% |

The achiral RM mixture M4 and the chiral RM mixtures M5 and M6 are each dissolved in diethyl carbonate at 40% solids. Blends 24 to 29 are made from these solutions to match the required chiral concentration for achieving the desired CLC pitch for each RM layer as shown in Table 5.1. By using the chiral RM of formula C1-1-6a with either S- or R-configuration, chiral RM layers with either left-handed or right-handed twist can be achieved. In addition, the achiral mixture M4 is used in one of the layers.

Table 5.1 - Chiral RM Mixture Blends

| Name | Layer | Chiral wt.% |
|---|---|---|
| Blend 24 | 1 | 0.2164 |
| Blend 25 | 2 | 0.0707 |
| M4 | 3 | - |
| Blend 26 | 4 | 0.0417 |
| Blend 27 | 5 | 0.1307 |
| Blend 28 | 6 | 0.1974 |
| Blend 29 | 7 | 0.0089 |

Blends 24 to 29 and mixture M4 are then used to prepare a twisted RM multilayer with the design as shown in Table 5.2, for use as chromatic waveplate that selectively acts as HWP for blue circularly polarised light.

Table 5.2 - Multilayer film design

| Layer # | Thickness / μm | Twist Angle / ° | CLC Pitch / μm |
|---|---|---|---|
| 1 | 1.987 | -143.57 | -4.98 |

(continued)

| Layer # | Thickness / μm | Twist Angle / ° | CLC Pitch / μm |
|---|---|---|---|
| 2 | 2.012 | -47.45 | -15.26 |
| 3 | 1.974 | 0 | 0 |
| 4 | 1.963 | -27.40 | -25.79 |
| 5 | 1.940 | 85.11 | 8.21 |
| 6 | 1.952 | -128.90 | -5.45 |
| 7 | 1.949 | -5.79 | -121.15 |

The multilayer film is made on a rubbed polyimide alignment layer by the process as described in Example 2, except that the annealing is done at 40°C and the curing is done with 60 mW/cm$^2$ lamp intensity.

The resulting multilayer film is observed between crossed circular polarisers and a blue transmissive film is seen. This matches with the expected performance of a blue HWP.

Example 6 - Chromatic PB Deflector Grating for red and blue light

The RM mixtures M4 to M6 from Example 5 are each dissolved in diethyl carbonate at 40% solids. Blends 30 to 37 are made from these solutions as shown in Table 6.1.

Table 6.1 - Chiral RM Mixture Blends

| Name | Layer | Chiral wt.% |
|---|---|---|
| Blend 30 | 1 | 0.3177% |
| Blend 31 | 2 | 0.1193% |
| Blend 32 | 3 | 0.3166% |
| Blend 33 | 4 | 0.1527% |
| Blend 34 | 5 | 0.3172% |
| Blend 35 | 6 | 0.1192% |
| Blend 36 | 7 | 0.3026% |
| Blend 37 | 8 | 0.3124% |

Blends 30 to 37 are then used to prepare a twisted RM multilayer with the design as shown in Table 6.2, for use as chromatic grating that selectively diffracts red and blue light but does not diffract green light.

Table 6.2 - Multilayer film design

| Layer # | Thickness / μm | Twist Angle / ° | CLC Pitch / μm |
|---|---|---|---|
| 1 | 2.000 | -212.20 | -3.39 |
| 2 | 2.000 | 79.97 | 9.00 |
| 3 | 2.000 | 212.84 | 3.38 |
| 4 | 2.000 | 102.64 | 7.01 |
| 5 | 2.000 | 213.94 | 3.37 |
| 6 | 2.000 | 79.98 | 9.00 |
| 7 | 2.000 | -202.14 | -3.56 |
| 8 | 2.000 | 210.38 | 3.42 |

The multilayer film is made on a PB grating with a grating pitch of 11 μm by the process as described in Example 1, except that the annealing is done at 40°C and the curing is done with 60 mW/cm$^2$ lamp intensity.

The resulting multilayer film is inspected in transmission and is seen to be selectively diffracting red and blue light but not green light, and thus matches the expected performance of a chromatic diffraction grating that acts as PB deflector for red and blue light.

Example 7 - Achromatic PB Deflector Grating

The following RM mixtures are prepared:

| **M7** | **Conc.** |
|---|---|
| Irganox® 1076 | 0.10% |
| Dynol™ 800 | 0.75% |
| TR-PBG-304 | 6.80% |
| 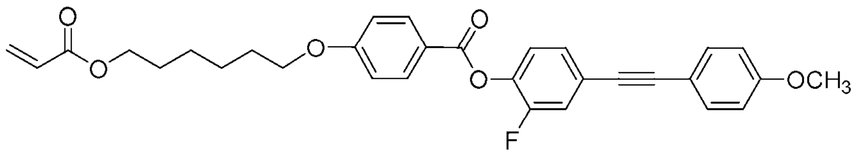 M8a | 46.29% |
| Da1a | 36.91% |
| Da1b | 9.15% |

| **M8** | **Conc.** |
|---|---|
| Irganox®-1076 | 0.10% |
| Dynol™ 800 | 0.75% |
| TR-PBG-304 | 6.80% |
| M8a | 46.29% |
| Da1a | 36.51% |
| Da1b | 9.15% |
| C1-1-6a$^R$, (R)-Configuration | 0.40% |

| **M9** | **Conc.** |
|---|---|
| Irganox®-1076 | 0.10% |
| Dynol™ 800 | 0.75% |
| TR-PBG-304 | 6.80% |
| M8a | 46.29% |
| Da1a | 36.51% |
| Da1b | 9.15% |
| C1-1-6a$^L$, (L)-Configuration | 0.40% |

The RM mixtures M7 to M9 are each dissolved in PGEMA at 25% solids. Blends 38 to 41 are made from these solutions as shown in Table 7.1.

Table 7.1 - Chiral RM Mixture Blends

| Name | Layer | Chiral wt.% |
|---|---|---|
| Blend 37 | 1 | 0.3102% |
| Blend 38 | 2 | 0.05596% |
| Blend 39 | 3 | 0.0394% |
| Blend 40 | 4 | 0.3148% |

Blends 37 to 40 are then used to prepare a twisted RM multilayer with the design as shown in Table 7.2, for use as achromatic diffraction grating.

Table 7.2 - Multilayer film design

| Layer # | Thickness / μm | Twist Angle / ° | CLC Pitch / μm |
|---|---|---|---|
| 1 | 0.809 | -83.14 | -3.50 |
| 2 | 0.585 | 10.61 | 19.84 |
| 3 | 0.744 | -9.70 | -27.61 |
| 4 | 0.798 | 81.43 | 3.53 |

The multilayer film is made on a PB grating with a grating pitch of 2 μm by the process as described in Example 1, except that annealing is done at 20°C and the curing is done in a conveyor belt fusion lamp with 60% power and 10 m/min belt speed in a nitrogen atmosphere

The resulting multilayer film is inspected in transmission and is seen to be diffracting the red, green and blue light, and thus matches the expected performance of an achromatic diffraction grating that acts as achromatic PB deflector.

Example 8 - Achromatic Diffractive Deflector

A stack of the multilayers of Examples 1, 2, 3 and 4 in the sequence as illustrated in **Fig 2** is formed by spacing the films in one after another with air gaps between. The resulting stack acts as an achromatic PB deflector with a deflection angle of 15° for circularly polarized RGB light.

A QWP is added both in front and behind the stack of multilayers as descriebd above. The resulting enlarged stack acts as an achromatic PB deflector with a deflection angle of 15° for linearly polarized RGB light.

## Claims

**1.** A diffractive optical element (DOE) comprising

- at least one achromatic half-wave plate (HWP), and
- at least one chromatic HWP,

wherein each HWP comprises a substrate and provided on the substrate two or more cholesteric liquid crystal (CLC) layers, the first CLC layer deposited directly on the substrate and the second and further CLC layers deposited directly onto the respective previous CLC layer,

wherein each CLC layer consists of a polymerized chiral reactive mesogen (RM) mixture wherein the LC director exhibits a helical twist with a defined twist angle along a helix axis in a thickness direction of the CLC layer, said chiral RM mixture comprising one or more RMs selected from mono-, di and multireactive RMs, and further comprising one or more chiral compounds selected from chiral RMs, and a photoinitiator,

wherein in at least one of the achromatic and chromatic HWP the substrate contains a periodic surface grating that induces a rotation of the LC director in an in-plane direction of the first CLC layer.

**2.** The DOE according to claim 1, **characterized in that** in at least one of the chromatic and achromatic HWPs at least two CLC layers have a different twist angle.

**3.** The DOE according to claim 1 or 2, **characterized in that** it comprises two or more chromatic HWPs.

**4.** The DOE according to one or more of claims 1 to 3, **characterized in that** it additionally comprises one or more quarter wave-plates (QWPs).

**5.** The DOE according to one or more of claims 1 to 4, **characterized in that** it comprises

- an achromatic HWP comprising, preferably consisting of, a substrate containing a periodic surface grating, and provided on the substrate two or more CLC layers, the first CLC layer deposited directly on the substrate and the second and further CLC layers deposited directly onto the respective previous CLC layer,
- at least one, preferably two or more, chromatic HWP(s), each comprising, preferably consisting of, a substrate, optionally with a planar alignment layer, and provided on the substrate two or more CLC layers, the first CLC layer deposited directly on the substrate and the second and further CLC layers deposited directly onto the respective

previous CLC layer,
- optionally a chromatic HWP comprising, preferably consisting of, a substrate containing a periodic surface grating, and provided on the substrate two or more CLC layers, the first CLC layer deposited directly on the substrate and the second and further CLC layers deposited directly onto the respective previous CLC layer,
wherein each CLC layer consists of a polymerized chiral RM mixture having a helical twist along a helix axis in a thickness direction of the CLC layer, said chiral RM mixture comprising one or more RMs selected from mono-, di and multireactive RMs, and further comprising one or more chiral compounds selected from chiral RMs, and a photoinitiator,
wherein in at least one, preferably in each, of the chromatic and achromatic HWPs at least two CLC layers have a different twist angle, and
wherein the periodic surface grating induces a rotation of the LC director in an in-plane direction of the first CLC layer, and is preferably a PB deflector grating or a PB lens grating.

6. The DOE according to one or more of claims 1 to 5, **characterized in that** it comprises, in the following sequence viewed from the direction of incident light:

- a first, achromatic HWP (201, 301) being effective for all of red (R), green (G) and blue (B) light,
- a second, chromatic HWP (202, 302) being effective only for one of RGB light, preferably for B light, but not for the others of RGB light, preferably not for R or G light,
- a third, chromatic HWP (203, 303) being effective for R and B light but not for G light,
- optionally a fourth, chromatic HWP (204, 304) being effective only for one of RGB light, preferably for R light, but not for the others of RGB light, preferably not for G or B light,

wherein each of the first, second, third and fourth HWP comprise two or more CLC layers, the first CLC layer deposited directly on a substrate, and the second and further CLC layers deposited directly onto the respective previous CLC layer,
and wherein each CLC layer consists of a polymerized chiral RM mixture having a helical twist along a helix axis in a thickness direction of the CLC layer, said chiral RM mixture comprising one or more direactive RMs, one or more monoreactive RMs, one or more chiral compounds selected from chiral RMs, and a photoinitiator,
and wherein the substrate of the first and third HWP contains a PB deflector or PB lens grating, and the substrate of the second and fourth HWPs has a planar alignment layer.

7. The DOE according to claim 6, **characterized in that** it additionally comprises a first QWP in front of the first HWP (201, 301) and a second QWP behind the fourth HWP (204, 304), when viewed from the direction of incident light.

8. The DOE according to one or more of claims 1 to 7, **characterized in that** the surface grating is a PB deflector grating and the DOE is an achromatic PB deflector.

9. The DOE according to one or more of claims 1 to 8, **characterized in that** the surface grating is a PB lens grating and the DOE is an achromatic PB lens.

10. The DOE according to one or more of claims 1 to 9, **characterized in that** the chiral RM mixture contains one or more compounds selected from formula D and/or one or more compounds selected from formula M:

$$P^1\text{-}Sp^1\text{-}MG\text{-}Sp^2\text{-}P^2 \qquad D$$

$$P^1\text{-}Sp^1\text{-}MG^M\text{-}R^{22} \qquad M$$

wherein

$P^1$, $P^2$ independently of each other denote a polymerizable group,
Sp', $Sp^2$ independently of each other are a spacer group or a single bond, and
MG is a rod-shaped mesogenic group, which is preferably selected of formula MG $-(A^1-Z^1)_n-A^2-$ MG
$A^1$ and $A^2$ denote, in case of multiple occurrence independently of one another, an aromatic or alicyclic group, which optionally contains one or more heteroatoms selected from N, O and S, and is optionally mono- or polysubstituted by L,
L is P-Sp-, F, Cl, Br, I, -CN, $-NO_2$, -NCO, -NCS, -OCN, -SCN, - $C(=O)NR^xR^y$, $-C(=O)OR^x$, $-C(=O)R^x$, $-NR^xR^y$, -OH,

$-SF_5$, optionally substituted silyl, aryl or heteroaryl with 1 to 12, preferably 1 to 6 C atoms, and straight chain or branched alkyl, alkoxy, alkylcarbonyl, alkoxycarbonyl, alkylcarbonyloxy or alkoxycarbonyloxy with 1 to 12, preferably 1 to 6 C atoms, wherein one or more H atoms are optionally replaced by F or Cl,

$MG^M$ is a rod-shaped mesogenic group, which is preferably selected of formula MGM $-(A^{1M}-Z^1)_n-A^{2M}$. MGM

$A^{1M}$ and $A^{2M}$ denote, in case of multiple occurrence independently of one another, an aromatic or alicyclic group, which optionally contains one or more heteroatoms selected from N, O and S, and is optionally mono- or polysubstituted by $L^M$,

$L^M$ is F, Cl, Br, I, -CN, $-NO_2$, -NCO, -NCS, -OCN, -SCN, $-C(=O)NR^xR^y$, $-C(=O)OR^x$, $-C(=O)R^x$, $-NR^xR^y$, -OH, $-SF_5$, optionally substituted silyl, aryl or heteroaryl with 1 to 12, preferably 1 to 6 C atoms, and straight chain or branched alkyl, alkoxy, alkylcarbonyl, alkoxycarbonyl, alkylcarbonyloxy or alkoxycarbonyloxy with 1 to 12, preferably 1 to 6 C atoms, wherein one or more H atoms are optionally replaced by F or Cl,

$R^x$ and $R^y$ independently of each other denote H or alkyl with 1 to 12 C-atoms,

$Z^1$ denotes, in case of multiple occurrence independently of one another, -O-, -S-, -CO-, -COO-, -OCO-, -S-CO-, -CO-S-, -O-COO-, $-CO-NR^{00}-$, $-NR^{00}-CO-$, $-NR^{00}-CO-NR^{000}$, $-NR^{00}-CO-O-$, $-O-CO-NR^{00}-$, $-OCH_2-$, $-CH_2O-$, $-SCH_2-$, $-CH_2S-$, $-CF_2O-$, $-OCF_2-$, $-CF_2S-$, $-SCF_2-$, $-CH_2CH_2-$, $-(CH_2)_{n1}$, $-CF_2CH_2-$, $-CH_2CF_2-$, $-CF_2CF_2-$, -CH=N-, -N=CH-, -N=N-, $-CH=CR^{00}-$, $-CY^1=CY^2-$, -C≡C-, -CH=CH-COO-, -OCO-CH=CH- or a single bond, preferably -COO-, -OCO- or a single bond,

$Y^1$ and $Y^2$ independently of each other denote H, F, Cl or CN,

$R^{00}$ and $R^{000}$ independently of each other denote H or alkyl with 1 to 12 C atoms,

$R^{22}$ denotes P-Sp-, F, Cl, Br, I, -CN, $-NO_2$, -NCO, -NCS, -OCN, -SCN, $-C(=O)NR^xR^y$, -C(=O)X, $-C(=O)OR^x$, $-C(=O)R^y$, $-NR^xR^y$, -OH, $-SF_5$, optionally substituted silyl, straight chain or branched alkyl, alkoxy, alkylcarbonyl, alkoxycarbonyl, alkylcarbonyloxy or alkoxycarbonyloxy with 1 to 12, preferably 1 to 6 C atoms, wherein one or more H atoms are optionally replaced by F or Cl,

X is halogen, preferably F or Cl,

n is 1, 2, 3 or 4, preferably 1 or 2, most preferably 2,

n1 is an integer from 1 to 10, preferably 1, 2, 3 or 4.

**11.** The DOE according to one or more of claims 1 to 10, **characterized in that** the chiral RM mixture contains a chiral compound selected from the formulae C1, C2 and C3:

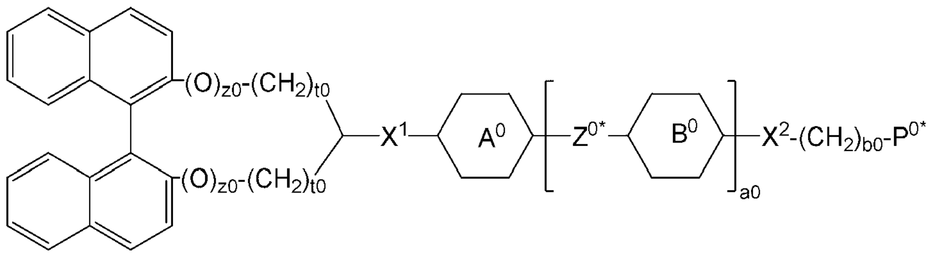

C1

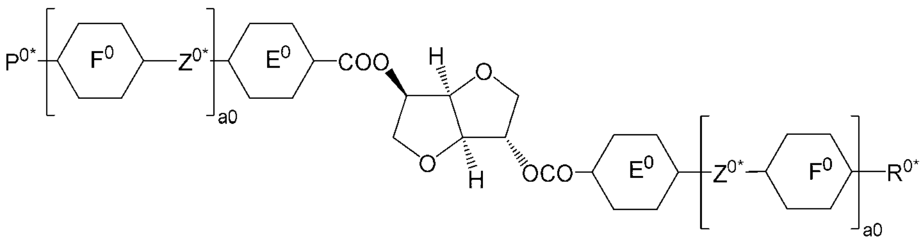

C2

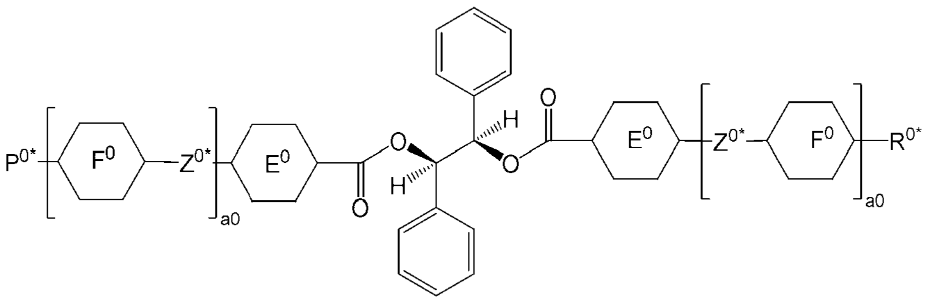

C3

wherein the individual radicals, independently of each other and on each occurrence identically or differently, have the following meanings

$P^{0*}$ a polymerizable group,
$Sp^{0*}$ a spacer group or a single bond
$R^{0*}$ F, Cl, CN, alkyl, alkoxy, thioalkyl, alkylcarbonyl, alkoxycarbonyl, alkylcarbonyloxy or alkoxycarbonyloxy with 1 to 15, preferably 1 to 6 C atoms, $P^{0*}$- or $P^{0*}$-Sp*-,
$A^0$, $B^0$, $E^0$, $F^0$ 1,4-phenylene that is unsubstituted or substituted with 1, 2, 3 or 4 groups L, or trans-1,4-cyclohexylene,
L F, Cl, CN, P-Sp-, or alkyl, alkoxy, thioalkyl, alkylcarbonyl, alkoxycarbonyl, alkylcarbonyloxy or alkoxycarbonyloxy with 1 to 5 C atoms that is optionally fluorinated,
$X^1$, $X^2$ -O-, -COO-, -OCO-, -O-CO-O- or a single bond,
$Z^{0*}$ -COO-, -OCO-, -O-CO-O-, $-OCH_2-$, $-CH_2O-$, $-CF_2O-$, $-OCF_2-$, $-CH_2CH_2-$, - $(CH_2)_4$-, $-CF_2CH_2-$, $-CH_2CF_2-$, $-CF_2CF_2-$, -C≡C-, -CH=CH-, -CH=CH-COO-, -OCO-CH=CH- or a single bond, preferably -COO-, -OCO- or a single bond,
a0 0, 1 or 2, preferably 0 or 1,
b0 0 or an integer from 1 to 12, preferably 1 to 6,
to 0, 1, 2 or 3,
z0 0 or 1, preferably 1,

and wherein the naphthalene rings can additionally be substituted with one or more identical or different groups L.

**12.** The DOE according to one or more of Claims 1 to 11, **characterized in that** the chiral RM mixture contains a photoinitiator selected from oxime esters, preferably from carbazole oxime esters.

**13.** An optical, electrooptical or electronic device or a component thereof, comprising a DOE according to one or more of Claims 1 to 12.

**14.** The component of Claim 13, which is selected from optical retardation films like quarter-wave plates (QWP) or half-wave plates (HWP), polarizers, optical compensators, reflective films, diffraction or surface gratings such as Bragg polarization gratings (Bragg PG), polarization volume gratings (PVG), polarization volume holograms (PVH), Pancharatnam Berry (PB) gratings, furthermore nonmechanical beam steering elements, optical waveguides, optical couplers, deflectors or combiners, polarization beam splitters, partial mirrors, reflective films, alignment layers, colour filters, antistatic protection sheets, electromagnetic interference protection sheets, lenses for light guides, focusing and optical effects, polarization controlled lenses, PB deflectors, PB lenses and IR reflection films.

**15.** The device of Claim 13, which is selected from liquid crystal displays, organic light emitting diodes, non-linear optic (NLO) devices, autostereoscopic 3D displays, head-up-displays, see-through near-eye displays, AR/VR systems, goggles for AR/VR applications, switchable windows, spatial light modulators, optical data storage devices, optical sensors, holographic devices, spectrometers, optical telecommunication systems, polarimeters or front-/backlights.

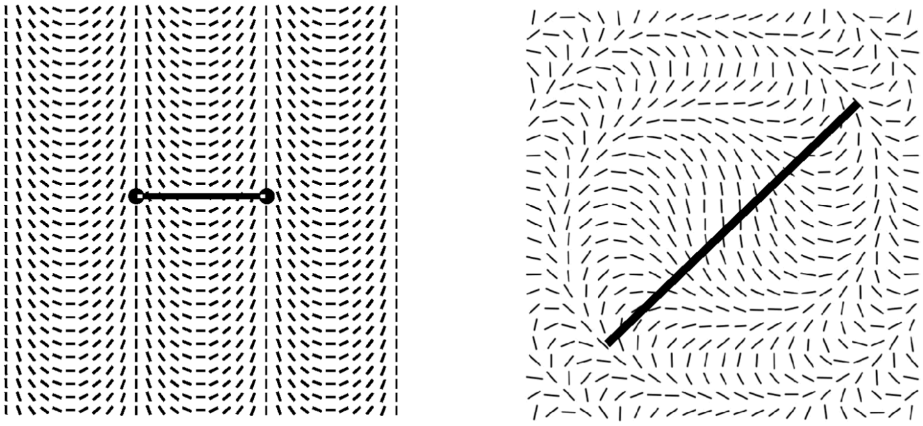

(a) (b)

Fig. 1

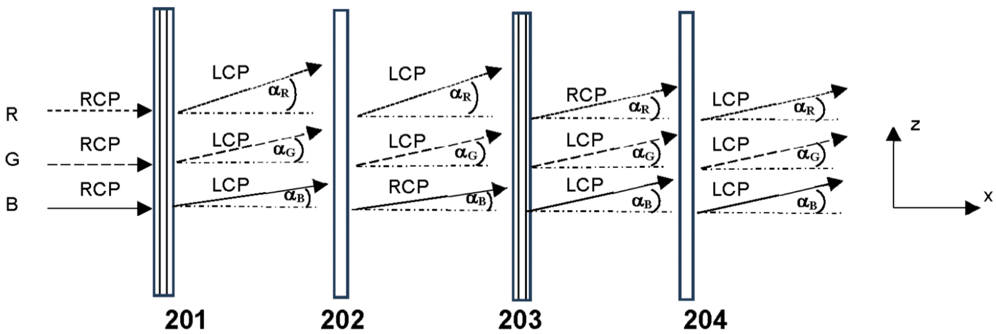
R
G
B
RCP
RCP
RCP
LCP
LCP
LCP
$\alpha_R$
$\alpha_G$
$\alpha_B$
LCP
LCP
RCP
RCP
LCP
LCP
LCP
LCP
LCP
z
x
201
202
203
204

Fig. 2

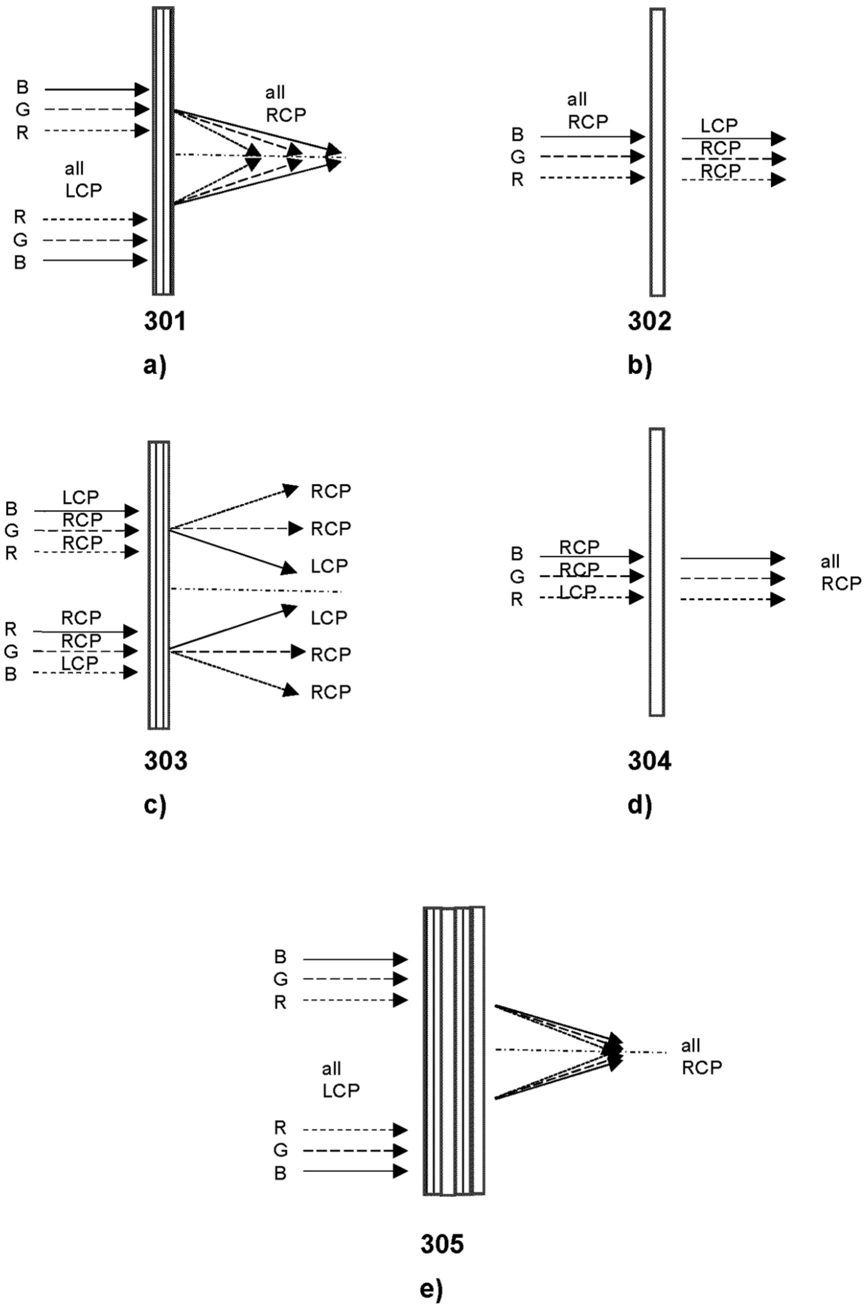
B
G
R
all
RCP
all
LCP
R
G
B
301
a)
all
RCP
B
G
R
LCP
RCP
RCP
302
b)
B
G
R
LCP
RCP
RCP
RCP
RCP
LCP
R
G
B
RCP
RCP
LCP
LCP
RCP
RCP
303
c)
B
G
R
RCP
RCP
LCP
all
RCP
304
d)
B
G
R
all
LCP
R
G
B
all
RCP
305
e)

Fig. 3

Europäisches Patentamt
European Patent Office
Office européen des brevets

# EUROPEAN SEARCH REPORT

Application Number
EP 25 22 4216

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2016/033698 A1 (ESCUTI MICHAEL J [US] ET AL) 4 February 2016 (2016-02-04) * paragraphs [0077] - [0104]; figures 1-6 * ----- | 1-15 | INV. G02B5/18 G02B5/30 |
| A | US 2013/335683 A1 (ESCUTI MICHAEL J [US] ET AL) 19 December 2013 (2013-12-19) * paragraphs [0045] - [0069]; figures 1, 2 * ----- | 1-15 | |

TECHNICAL FIELDS SEARCHED (IPC)
G02B
C09K

The present search report has been drawn up for all claims

1

| Place of search | Date of completion of the search | Examiner |
|---|---|---|
| Munich | 24 April 2026 | Wolf, Steffen |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
.....................................................
& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 22 4216

This annex lists the patent family members relating to the patent documents cited in the above-mentioned European search report. The members are as contained in the European Patent Office EDP file on
The European Patent Office is in no way liable for these particulars which are merely given for the purpose of information.

24-04-2026

| Patent document cited in search report | Publication date | Patent family member(s) | Publication date |
|---|---|---|---|
| US 2016033698 A1 | 04-02-2016 | CN 106575007 A | 19-04-2017 |
| | | EP 3123215 A1 | 01-02-2017 |
| | | EP 4215960 A1 | 26-07-2023 |
| | | JP 6726110 B2 | 22-07-2020 |
| | | JP 2017522601 A | 10-08-2017 |
| | | KR 20170037884 A | 05-04-2017 |
| | | US 2016033698 A1 | 04-02-2016 |
| | | WO 2016019123 A1 | 04-02-2016 |
| US 2013335683 A1 | 19-12-2013 | CN 102246089 A | 16-11-2011 |
| | | EP 2350736 A1 | 03-08-2011 |
| | | JP 5651595 B2 | 14-01-2015 |
| | | JP 2012505430 A | 01-03-2012 |
| | | KR 20110084212 A | 21-07-2011 |
| | | US 2013335683 A1 | 19-12-2013 |
| | | WO 2010042089 A1 | 15-04-2010 |



For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 202233908 A1
- EP 1389199 A1
- WO 9800428 A1
- GB 2328207 A
- GB 2314839 A
- WO 0240614 A1
- US 5602661 A
- US 5389698 A
- US 6717644 B


### Non-patent literature cited in the description


- **YUN-HAN LEE et al.** *Opt. Data Process. Storage;*, 2017, vol. 3, 79-88
- **Z. LUO et al.** *Light: Science & Applications*, 2023, vol. 12, 230
- *Pure Appl. Chem.*, 2001, vol. 73 (5), 888
- **C. TSCHIERSKE** ; **G. PELZL** ; **S. DIELE**. *Angew. Chem.*, 2004, vol. 116, 6340-6368
- *Jap. J. Appl. Phys.*, 2003, vol. 42, 3463
- **I. SAGE**. Thermotropic Liquid Crystals. John Wiley & Sons, 1987, 75-77
- **T. UCHIDA** ; **H. SEKI**. Liquid Crystals - Applications and Uses. World Scientific Publishing, 1992, vol. 3, 1-63
- **J. COGNARD**. *Mol. Cryst. Liq. Cryst.*, 1981, vol. 78 (1), 1-77
- Merck Liquid Crystals, Physical Properties of Liquid Crystals. *Merck KGaA*, November 1997